# EUROPEAN PATENT APPLICATION

(11) **EP 4 832 725 A1**
(43) Date of publication of application: **28.10.2026**
(21) Application number: 24908342.9
(22) Date of filing: 18.12.2024
(51) Int. Cl.: H10K 77/10, H10K 71/50, H10K 59/12, B23K 26/06, B23K 26/073, B23K 26/0622

(54) **DISPLAY DEVICE, LASER DEVICE FOR MANUFACTURING DISPLAY DEVICE, METHOD FOR MANUFACTURING DISPLAY DEVICE BY USING LASER DEVICE, AND ELECTRONIC DEVICE COMPRISING DISPLAY DEVICE**

(30) Priority: 21.12.2023 KR 20230188883
(71) Applicant: Samsung Display Co., Ltd., Yongin-si, Gyeonggi-do 17113 (KR)
(72) Inventor: KIM, Hyung Sik, Yongin-si, Gyeonggi-do 17113 (KR); MISHCHIK, Konstantin, Yongin-si, Gyeonggi-do 17113 (KR); KIM, Jeong Ho, Yongin-si, Gyeonggi-do 17113 (KR); ROH, Cheol Lae, Yongin-si, Gyeonggi-do 17113 (KR); RYU, Je Kil, Yongin-si, Gyeonggi-do 17113 (KR); YOU, Jung Hwa, Yongin-si, Gyeonggi-do 17113 (KR); JANG, Seung Hoon, Yongin-si, Gyeonggi-do 17113 (KR); JEONG, Seong Ho, Yongin-si, Gyeonggi-do 17113 (KR); JUNG, Woo Hyun, Yongin-si, Gyeonggi-do 17113 (KR); HWANG, Se Yeon, Yongin-si, Gyeonggi-do 17113 (KR)
(74) Representative: Dr. Weitzel & Partner
(86) International application number: PCT/KR2024/097092
(87) International publication number: WO 2025/136038

(57) **Abstract**

Provided are a display device, a laser device for fabricating the display device, a method for fabricating the display device using the laser device, and an electronic device including the display device. The display device includes a glass substrate including a first surface, a second surface facing the first surface, and a plurality of side surfaces located between the first surface and the second surface; and a light emitting element layer located on the first surface of the glass substrate and including light emitting elements that emit light. The plurality of side surfaces of the glass substrate include a first side surface and a second side surface. A radius of curvature measured at a center of the first side surface, an upper end of the first side surface, and an upper center between the center and the upper end of the first side surface is defined as a first upper radius of curvature. A radius of curvature measured at a center of the second side surface, an upper end of the second side surface, and an upper center between the center and the upper end of the second side surface is defined as a second upper radius of curvature. A difference between the first upper radius of curvature and the second upper radius of curvature is 30 µm or less.

## Description

### [Technical Field]

The present disclosure relates to a display device, a laser device for fabricating the display device, a method for fabricating the display device using the laser device, and an electronic device including the display device.

### [Background Art]

With the advancement of the information-oriented society, increasing demands are placed on display devices for displaying images in various ways. The display device may be a flat panel display device such as a liquid crystal display, a field emission display and a light emitting display.

The display device includes a display area for displaying an image and a non-display area located around the display area, for example, to surround the display area. Recently, the width of the non-display area has been gradually reduced to increase immersion in the display area and enhance the aesthetics of the display device.

In the fabricating process of the display device, the display device may be formed by cutting a plurality of display cells formed on a mother substrate including the plurality of display cells. In this case, to improve the mechanical strength of the substrate, side surfaces of the substrate of each of the plurality of display cells are processed using a computer numerical control (CNC) polishing device or the like such that the side surfaces of the substrate have a rounded cross-section. However, it is difficult to process the substrate such that the side surfaces of the substrate have cross-sections having substantially the same radius of curvature.

### [Summary of Invention]

### [Technical Problem]

Aspects of the present disclosure provide a display device capable of minimizing a difference in curvature between side surfaces of a substrate.

Aspects of the present disclosure also provide a laser device for fabricating the display device capable of minimizing a difference in curvature between side surfaces of a substrate.

Aspects of the present disclosure also provide a method for fabricating a display device by using a laser device capable of minimizing a difference in curvature between side surfaces of a substrate.

Aspects of the present disclosure also provide an electronic device including a display device capable of minimizing a difference in curvature between side surfaces of a substrate.

It should be noted that aspects of the present disclosure are not limited to the above-mentioned aspects, and other unmentioned aspects of the present disclosure will be clearly understood by those skilled in the art from the following descriptions.

### [Technical Solution]

According to one embodiment of the present disclosure, there is provided a display device comprising: a glass substrate comprising a first surface, a second surface facing the first surface, and a plurality of side surfaces located between the first surface and the second surface; and a light emitting element layer located on the first surface of the glass substrate and comprising light emitting elements that emit light, wherein the plurality of side surfaces of the glass substrate comprise a first side surface and a second side surface, a radius of curvature measured at a center of the first side surface, an upper end of the first side surface, and an upper center between the center and the upper end of the first side surface is defined as a first upper radius of curvature, a radius of curvature measured at a center of the second side surface, an upper end of the second side surface, and an upper center between the center and the upper end of the second side surface is defined as a second upper radius of curvature, and a difference between the first upper radius of curvature and the second upper radius of curvature is 30 µm or less.

According to one embodiment of the present disclosure, there is provided a display device comprising: a glass substrate comprising a first surface, a second surface facing the first surface, and a plurality of side surfaces located between the first surface and the second surface; and a light emitting element layer located on the first surface of the glass substrate and comprising light emitting elements that emit light, wherein each of the plurality of side surfaces of the glass substrate comprises a first sub-side surface having a planar shape and a second sub-side surface having a curved shape, a length of the second sub-side surface is greater than a length of the first sub-side surface, the first sub-side surface is in contact with the first surface, and the second sub-side surface is in contact with the second surface.

According to one embodiment of the present disclosure, there is provided a display device comprising: a first substrate comprising a first surface and a second surface facing the first surface; a second substrate located on the first surface of the first substrate; and a light emitting element layer located on one surface of the second substrate and comprising light emitting elements that emit light, wherein the first substrate comprises glass and the second substrate comprises a polymer resin, the first substrate comprises a first sub-substrate and a second sub-substrate spaced apart from each other, a radius of curvature measured at a center of a first side surface of the first sub-substrate, an upper end of the first side surface, and an upper center between the center and the upper end of the first side surface is defined as a first upper radius of curvature, a radius of curvature measured at a center of a second side surface of the first sub-substrate, an upper end of the second side surface, and an upper center between the center and the upper end of the second side surface is defined as a second upper radius of curvature, and a difference between the first upper radius of curvature and the second upper radius of curvature is 30 µm or less.

According to one embodiment of the present disclosure, there is provided a display device comprising: a first substrate comprising a first surface and a second surface facing the first surface; a second substrate located on the first surface of the first substrate; and a light emitting element layer located on one surface of the second substrate and comprising light emitting elements that emit light, wherein the first substrate comprises glass and the second substrate comprises a polymer resin, the first substrate comprises a first sub-substrate and a second sub-substrate spaced apart from each other, each of a plurality of side surfaces of the first sub-substrate comprises a first sub-side surface having a planar shape and a second sub-side surface having a curved shape, a length of the second sub-side surface is greater than a length of the first sub-side surface, and the first sub-side surface is in contact with the first surface, and the second sub-side surface is in contact with the second surface.

According to one embodiment of the present disclosure, there is provided a laser device comprising: a light source configured to output a laser beam; a diffractive element comprising diffraction patterns configured to diffract the laser beam; a relay lens configured to transmit the laser beam diffracted by the diffraction patterns at a selected ratio; a phase retardation plate configured to retard a phase of the laser beam incident from the diffractive element; and an objective lens configured to focus the laser beam incident from the phase retardation plate, wherein the diffractive element is rotated by a selected angle.

According to one embodiment of the present disclosure, there is provided a laser device comprising: a light source configured to output a laser beam; a diffractive element comprising diffraction patterns configured to diffract the laser beam; a prism configured to rotate so as to rotate a laser beam incident from the diffractive element; a phase retardation plate configured to retard a phase of the laser beam incident from the prism; and an objective lens configured to focus the laser beam incident from the phase retardation plate, wherein the prism and the phase retardation plate are rotated simultaneously by a selected angle.

According to one embodiment of the present disclosure, there is provided a method for fabricating a display device, comprising: forming a plurality of display cells on a first surface of a mother substrate; forming a plurality of laser spots arranged along edges of the plurality of display cells by irradiating a laser beam on a second surface of the mother substrate facing the first surface using a laser device; reducing a thickness of the mother substrate by spraying an etchant onto the second surface of the mother substrate at a first rate without a mask; and reducing the thickness of the mother substrate by spraying the etchant onto the second surface of the mother substrate at a second rate without the mask, wherein the first rate is higher than the second rate.

According to one embodiment of the present disclosure, there is provided an electronic device comprising a display device configured to display an image, wherein the display device comprises: a glass substrate comprising a first surface, a second surface facing the first surface, and a plurality of side surfaces located between the first surface and the second surface; and a light emitting element layer located on the first surface of the glass substrate and comprising light emitting elements that emit light, wherein the plurality of side surfaces of the glass substrate comprise a first side surface and a second side surface, a radius of curvature measured at a center of the first side surface, an upper end of the first side surface, and an upper center between the center and the upper end of the first side surface is defined as a first upper radius of curvature, a radius of curvature measured at a center of the second side surface, an upper end of the second side surface, and an upper center between the center and the upper end of the second side surface is defined as a second upper radius of curvature, and a difference between the first upper radius of curvature and the second upper radius of curvature is 30 µm or less.

The details of other embodiments are included in the following description and the accompanying drawings.

### [Advantageous Effects of Invention]

According to the display device according to the embodiments, the laser device for fabricating the display device, the method for fabricating the display device using the laser device, and the electronic device including the display device, the mechanical strength of the substrate of the display device may be improved.

According to the display device according to the embodiments, the laser device for fabricating the display device, the method for fabricating the display device using the laser device, and the electronic device including the display device, the substrate may be cut while the thickness of the substrate is simultaneously reduced.

According to the display device according to the embodiments, the laser device for fabricating the display device, the method for fabricating the display device using the laser device, and the electronic device including the display device, a difference in radius of curvature between the side surfaces of the substrate of each of a plurality of display cells may be minimized.

Advantageous effects according to the present disclosure are not limited to those mentioned above, and various other advantageous effects are included herein.

### [Brief Description of Drawings]

FIG. 1 is a perspective view illustrating a display device according to one embodiment.
FIG. 2 is a plan view illustrating a display panel and driving circuits according to one embodiment
FIG. 3 is a block diagram illustrating a display device according to one embodiment.
FIG. 4 is a circuit diagram illustrating a pixel of a display device according to one embodiment.
FIG. 5 is a circuit diagram illustrating a pixel of a display device according to one embodiment.
FIG. 6 is a circuit diagram illustrating a pixel of a display device according to one embodiment.
FIG. 7A is a cross-sectional view illustrating an example of a display device taken along line X1-X1' of FIG. 1.
FIG. 7B is a cross-sectional view showing an example of a display device in which the circuit board in FIG. 7A is bent.
FIG. 8A is a cross-sectional view illustrating an example of a display device taken along line X1-X1' of FIG. 1.
FIG. 8B is a cross-sectional view showing an example of a display device in which the circuit board in FIG. 8A is bent.
FIG. 9A is a cross-sectional view illustrating an example of a display area of a display panel according to one embodiment.
FIG. 9B is a cross-sectional view illustrating an example of a display area of a display panel according to another embodiment.
FIG. 10 is a cross-sectional view illustrating an example of a display area of a display panel according to another embodiment.
FIG. 11 is a cross-sectional view illustrating in detail the light emitting diode element of FIG. 10.
FIG. 12 is a cross-sectional view illustrating an example of a display area of a display panel according to another embodiment.
FIG. 13 is a layout view showing in detail an example of area A of FIG. 2.
FIG. 14 is a layout view showing in detail an example of area B of FIG. 2.
FIG. 15 is a layout view showing in detail an example of area C of FIG. 2.
FIG. 16 is a layout view showing in detail an example of area D of FIG. 2.
FIG. 17 is a cross-sectional view illustrating an example of a display panel taken along line X2-X2' of FIG. 13.
FIG. 18 is a cross-sectional view illustrating an example of a display panel taken along line X3-X3' of FIG. 14.
FIG. 19 is a cross-sectional view illustrating an example of a display panel taken along line X4-X4' of FIG. 15.
FIG. 20 is a cross-sectional view illustrating an example of the display panel taken along line X5-X5' of FIG. 16.
FIG. 21 is a cross-sectional view specifically illustrating an example of area E of FIG. 17.
FIG. 22 is a cross-sectional view specifically illustrating an example of area F of FIG. 18.
FIG. 23 is a cross-sectional view specifically illustrating an example of area G of FIG. 19.
FIG. 24 is a cross-sectional view specifically illustrating an example of area H of FIG. 20.
FIGS. 25A to 25D are enlarged cross-sectional views showing examples of the first to fourth side surfaces of the substrate in FIGS. 17 to 20.
FIGS. 26A to 26D are enlarged cross-sectional views showing yet other examples of the first to fourth side surfaces of the substrate in FIGS. 17 to 20.
FIG. 27 is a perspective view illustrating a display device according to still another embodiment.
FIG. 28 is a plan view illustrating a display panel and driving circuits according to still another embodiment.
FIG. 29 is a cross-sectional view illustrating an example of a display panel taken along line X6-X6' of FIG. 27.
FIG. 30 is a cross-sectional view illustrating an example of a display device in which the circuit board is bent in FIG. 29.
FIG. 31 is a layout view showing in detail an example of area I of FIG. 28.
FIG. 32 is a cross-sectional view illustrating an example of the display panel taken along line X7-X7' of FIG. 31.
FIG. 33 is a cross-sectional view illustrating an example of the display panel taken along line X8-X8' of FIG. 31.
FIG. 34 is a cross-sectional view specifically illustrating an example of area J of FIG. 32.
FIGS. 35A to 35D are enlarged cross-sectional views showing examples of the first to fourth hole side surfaces illustrated in FIGS. 32 and 33.
FIGS. 36A to 36D are enlarged cross-sectional views showing yet other examples of the first to fourth hole side surfaces illustrated in FIGS. 32 and 33.
FIG. 37 is a perspective view illustrating a display device according to still another embodiment.
FIG. 38 is a plan view illustrating a display panel and driving circuits according to still another embodiment.
FIG. 39 is a cross-sectional view illustrating an example of a display panel taken along line X9-X9' of FIG. 37.
FIG. 40 is a cross-sectional view illustrating an example of a display device in which the bending area is bent in FIG. 39.
FIG. 41 is a cross-sectional view illustrating an example of a display panel taken along line X10-X10' of FIG. 37.
FIG. 42 is a cross-sectional view illustrating an example of a display panel taken along line X11-X11' of FIG. 37.
FIGS. 43A to 43D are enlarged cross-sectional views showing examples of the first to fourth side surfaces of the first sub-substrate in FIGS. 39 and 41.
FIGS. 44A to 44D are enlarged cross-sectional views showing examples of the first to fourth side surfaces of the second sub-substrate in FIGS. 39 and 42.
FIGS. 45A to 45D are enlarged cross-sectional views showing yet other examples of the first to fourth side surfaces of the first sub-substrate in FIGS. 39 and 41.
FIGS. 46A to 46D are enlarged cross-sectional views showing yet other examples of the first to fourth side surfaces of the second sub-substrate in FIGS. 39 and 42.
FIG. 47 is a perspective view showing a laser device according to one embodiment.
FIGS. 48A and 48B are views illustrating light outputted from a prism when the prism rotates by Φ.
FIG. 49 is a view illustrating polarization of output light in accordance with rotation of the laser device in the embodiment of FIG. 47.
FIG. 50 is another view illustrating polarization of output light in accordance with rotation of the laser device in the embodiment of FIG. 47.
FIGS. 51A to 51C are views illustrating processing patterns of a laser according to a scanning direction and polarization direction of a laser beam.
FIG. 52 is a perspective view showing a laser device according to still another embodiment.
FIG. 53 is a view illustrating polarization of output light in accordance with rotation of the laser device in the embodiment of FIG. 52.
FIG. 54 is a view illustrating polarization of output light in accordance with rotation of the laser device in the embodiment of FIG. 52.
FIG. 55 is a perspective view showing a laser device according to still another embodiment.
FIG. 56 is a view illustrating polarization of output light in accordance with rotation of the laser device in the embodiment of FIG. 55.
FIG. 57 is a perspective view showing a laser device according to still another embodiment.
FIG. 58 is a flowchart illustrating a method for fabricating a display device according to one embodiment.
FIGS. 59 to 63 are perspective views illustrating a method for fabricating a display device according to one embodiment.
FIGS. 64 to 68 are cross-sectional views taken along line X12-X12', illustrating a method for fabricating a display device according to one embodiment.
FIG. 69 is a flowchart showing step S120 of FIG. 58 in detail.
FIGS. 70 to 77 are views illustrating rotation of the laser device according to the embodiments of FIGS. 52 to 54 for a laser scribe line surrounding the edge of a display cell.
FIG. 78 is a side view illustrating arrangement of laser spots formed according to a scanning direction of a laser beam.
FIGS. 79 to 86 are views illustrating rotation of the laser device according to the embodiment of FIGS. 55 and 56 for a laser scribe line surrounding the edge of a display cell.
FIGS. 87A to 87D are views illustrating arrangements, in an XYZ plane, an XY plane, an XZ plane, and a YZ plane, of laser spots irradiated by a laser device according to one embodiment.
FIG. 88 is a view illustrating in detail an arrangement in an XZ plane of laser spots irradiated by a laser device according to one embodiment.
FIGS. 89 and 90 are cross-sectional views taken along line X12-X12', illustrating a method for fabricating a display device according to another embodiment.
FIG. 91 is a view illustrating laser spots irradiated by a laser device according to one embodiment.
FIGS. 92 and 93 are cross-sectional views taken along line X12-X12', illustrating a method for fabricating a display device according to still another embodiment.
FIG. 94 is a view illustrating laser spots irradiated by a laser device according to one embodiment.
FIG. 95 is a flowchart illustrating a method for fabricating a display device according to one embodiment.
FIGS. 96 to 101 are perspective views illustrating a method for fabricating a display device according to one embodiment.
FIGS. 102 to 105 are cross-sectional views taken along line X13-X13', illustrating a method for fabricating a display device according to one embodiment.
FIGS. 106 to 109 are views illustrating rotation of the laser device according to the embodiment of FIGS. 52 to 54 for a laser scribe line surrounding the edge of a through hole of a display cell.
FIGS. 110 to 113 are views illustrating rotation of the laser device according to the embodiments of FIGS. 55 and 56 for a laser scribe line surrounding the edge of a through hole of a display cell.
FIGS. 114 and 115 are cross-sectional views taken along line X13-X13', illustrating a method for fabricating a display device according to another embodiment.
FIGS. 116 and 117 are cross-sectional views taken along line X13-X13', illustrating a method for fabricating a display device according to still another embodiment.
FIG. 118 is a flowchart illustrating a method for fabricating the display device according to one embodiment.
FIGS. 119 to 124 are perspective views illustrating a method for fabricating a display device according to one embodiment.
FIGS. 125 to 128 are cross-sectional views taken along line X14-X14', illustrating a method for fabricating a display device according to one embodiment.
FIGS. 129 and 130 are views illustrating rotation of the laser device according to the embodiment of FIGS. 52 to 54 for laser scketch of a bending area of a display cell.
FIGS. 131 and 132 are views illustrating rotation of the laser device according to the embodiment of FIGS. 55 and 56 for laser scketch of the bending area of a display cell.
FIGS. 133 and 134 are cross-sectional views taken along line X14-X14', illustrating a method for fabricating a display device according to another embodiment.
FIGS. 135 and 136 are cross-sectional views taken along line X14-X14', illustrating a method for fabricating a display device according to still another embodiment.
FIG. 137 is a view illustrating an electronic device including a display device according to one embodiment.
FIG. 138 is a view illustrating an electronic device including a display device according to one embodiment.
FIG. 139 is a view illustrating an electronic device including a display device according to one embodiment.
FIG. 140 is a view illustrating an electronic device including a display device according to one embodiment.
FIG. 141 is a view illustrating an electronic device including a display device according to one embodiment.
FIG. 142 is a view illustrating an electronic device including a display device according to one embodiment.
FIG. 143 is a view illustrating a vehicle instrument panel and center fascia to which an electronic device including a display device according to one embodiment is applied.
FIG. 144 is a view illustrating an electronic device including a display device according to one embodiment.

### [Description of Embodiments]

Advantages and features of the present disclosure and methods of accomplishing the same may be understood more readily by reference to the following detailed description of preferred embodiments and the accompanying drawings. The present disclosure may, however, be embodied in many different forms and should not be construed as being limited to the embodiments set forth herein. Rather, these embodiments are provided so that this disclosure will be thorough and complete and will fully convey the concept of the invention to those skilled in the art, and the present disclosure will only be defined by the appended claims.

When an element or layer is referred to as being "on" another element or layer, it may be directly on the other element or layer or intervening elements or layers may be present. The same reference numbers indicate the same components throughout the specification. The shape, size, ratio, angle, number, and the like shown in the drawings illustrating embodiments are illustrative, so the present disclosure is not limited thereto.

Although the terms first, second, etc. may be used herein to describe various components, these components should not be limited by these terms. These terms are used to distinguish one component from another component. Thus, a first component discussed below could be termed a second component without departing from the teachings of the present disclosure.

Each of the features of the various embodiments of the present disclosure may be combined or combined with each other, in part or in whole, and technically various interlocking and driving are possible. Each embodiment may be implemented independently of each other or may be implemented together in an association.

Hereinafter, embodiments will be described in detail with reference to the accompanying drawings.

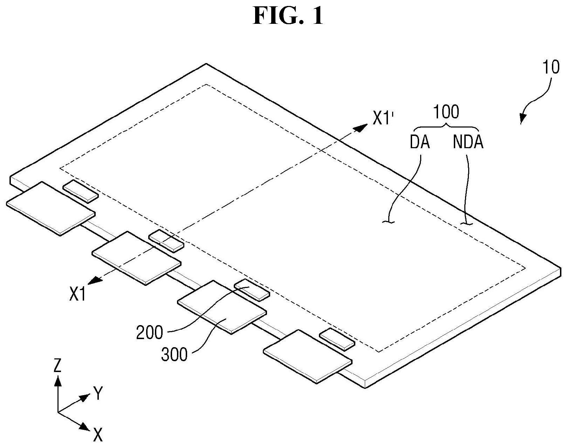

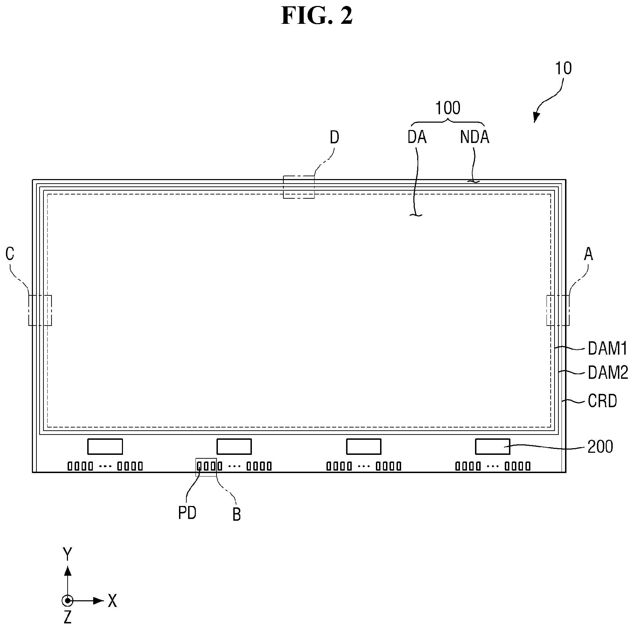

FIG. 1 is a perspective view illustrating a display device according to one embodiment. FIG. 2 is a plan view illustrating a display panel and driving circuits according to one embodiment.

Referring to FIGS. 1 and 2, a display device 10, which is a device for displaying a moving image or a still image, may be used as a display screen of various devices, such as a television, a laptop computer, a monitor, a billboard and an Internet-of-Things (IOT) device, as well as portable electronic devices such as a mobile phone, a smartphone, a tablet personal computer (PC), a smart watch, a watch phone, a mobile communication terminal, an electronic notebook, an electronic book, a portable multimedia player (PMP), a navigation device and an ultra-mobile PC (UMPC).

The display device 10 according to one embodiment may be a light emitting display device such as an organic light emitting display using an organic light emitting diode, a quantum dot light emitting display including a quantum dot light emitting layer, an inorganic light emitting display including an inorganic semiconductor, and a micro or nano light emitting display using a micro or nano light emitting diode (LED). In the following description, it is assumed that the display device 10 is an organic light emitting display device, but the present disclosure is not limited thereto.

The display device 10 according to one embodiment includes a display panel 100, driving circuits 200, and circuit boards 300.

The display panel 100 may be formed in a rectangular shape, in plan view, having long sides in a first direction (X-axis direction) and short sides in a second direction (Y-axis direction) crossing the first direction (X-axis direction). A corner formed by the long side in the first direction (X-axis direction) and the short side in the second direction (Y-axis direction) may be right-angled or rounded with a curvature. The first direction (X-axis direction) and the second direction (Y-axis direction) are a plane parallel to a display area DA and may be orthogonal to each other. The planar shape of the display panel 100 is not limited to the rectangular shape, and may be formed in another polygonal shape, a circular shape or an elliptical shape.

The display panel 100 may be formed to be flat, but is not limited thereto. For example, the display panel 100 may include a curved portion formed at left and right ends and having a constant curvature or a varying curvature. Alternatively, at least a portion of the display panel 100 may be bent, curved, folded, or rolled.

The display panel 100 may include the display area DA displaying an image and a non-display area NDA located around the display area DA. The non-display area NDA may surround the display area DA.

The display area DA may occupy most of the area of the display panel 100. The display area DA may be located at the center of the display panel 100. Pixels each including a plurality of emission areas may be located in the display area DA to display an image.

The non-display area NDA may be located adjacent to the display area DA. The non-display area NDA may be an area outside the display area DA. The non-display area NDA may be located to surround the display area DA. The non-display area NDA may be an edge area of the display panel 100.

Display pads DP may be arranged in the non-display area NDA to be connected to the circuit boards 300. The display pads DP may be located on one side edge of the display panel 100. For example, the display pads DP may be located at the lower edge of the display panel 100.

The display pads DP may be the outermost structures located at the outermost portion on the lower side of the display panel 100. The outermost structure may be a structure located closest to the edge of the display panel 100. The outermost structure may be a structure to drive the display panel 100 or a structure to improve the function of the display panel 100.

The display panel 100 may include a first dam DAM1, a second dam DAM2, and a crack dam CRD.

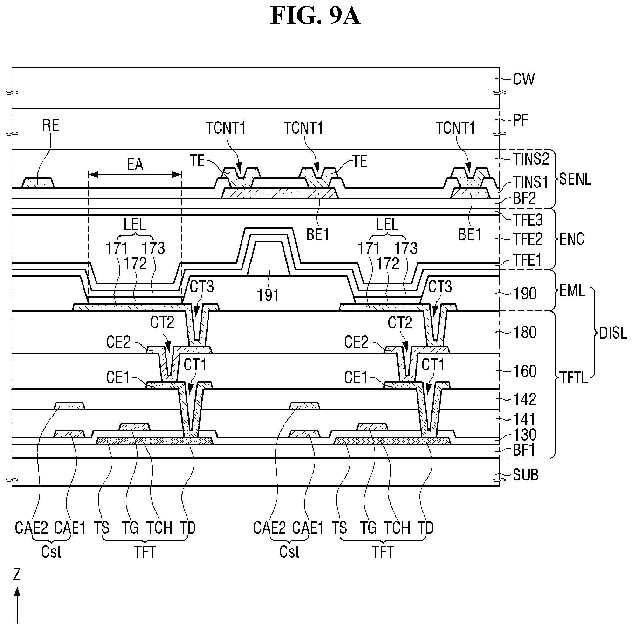

The first dam DAM1 and the second dam DAM2 may be structures for preventing an encapsulation organic film TFE2 (see FIG. 9A) of an encapsulation layer ENC (see FIG. 9A) from overflowing. The first dam DAM1 may be located to surround the display area DA, and the second dam DAM2 may be located to surround the first dam DAM1.

The crack dam CRD may be a structure for preventing cracks of the inorganic films of the encapsulation layer ENC from propagating in a process of cutting a substrate SUB during the fabricating process of the display device 10. The crack dam CRD may be located along left, upper, and right edges of the display panel 100. The crack dam CRD may not be located on the lower edge of the display panel 100. The crack dam CRD may be an outermost structure located at the outermost side on the left side, upper side, and right side of the display panel 100.

The driving circuits 200 may generate data voltages, power voltages, scan timing signals, and the like. The driving circuits 200 may output the data voltages, the power voltages, the scan timing signals, and the like. The driving circuits 200 may be located between the display pads PD and the display area DA in the non-display area NDA.

Each of the driving circuits 200 may be formed as an integrated circuit (IC). Each of the driving circuits 200 may be attached to the non-display area NDA of the display panel 100 in a chip on glass (COG) method. Alternatively, each of the driving circuits 200 may be attached to the circuit board 300 in a chip on plastic (COP) method.

The circuit boards 300 may be located on the display pads DP located on one side edge of the display panel 100. The circuit boards 300 may be attached to the display pads PD by using a conductive adhesive member such as an anisotropic conductive film and an anisotropic conductive adhesive. Accordingly, the circuit boards 300 may be electrically connected to the signal lines of the display panel 100. The circuit boards 300 may be a flexible printed circuit board or a flexible film such as a chip on film.

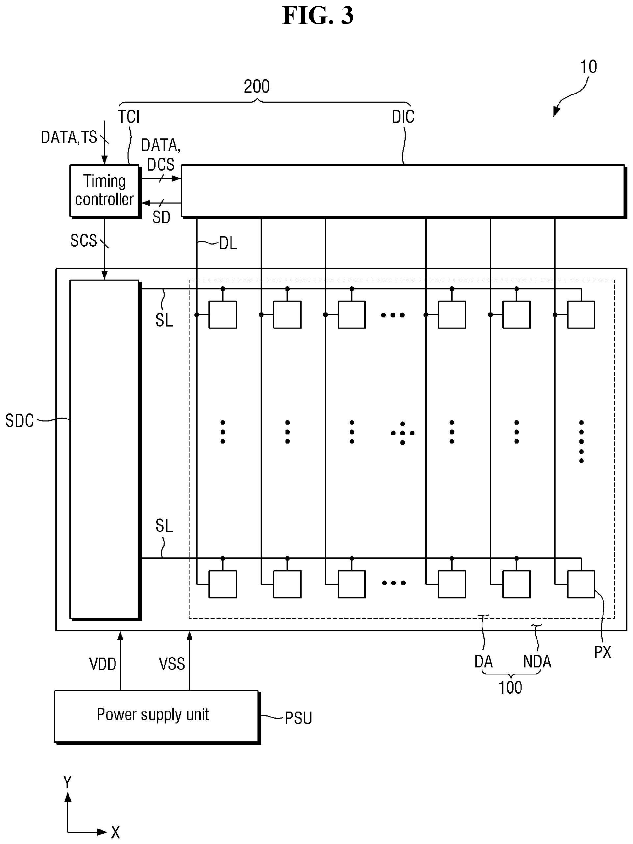

FIG. 3 is a block diagram illustrating a display device according to one embodiment.

Referring to FIG. 3, the display device 10 according to one embodiment includes the display panel 100, a scan driving circuit unit SDC, the driving circuit 200, and a power supply unit PSU.

The display panel 100 includes data lines DL, scan lines SL and pixels PX. The scan lines SL may extend in the first direction (X-axis direction) and may be arranged in the second direction (Y-axis direction). The data lines DL may extend in the second direction (Y-axis direction) and may be arranged in the first direction (X-axis direction).

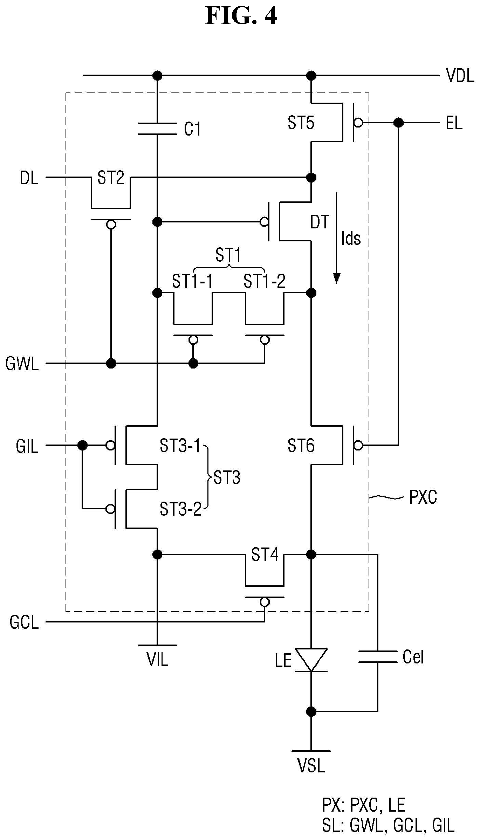

Each of the pixels PX may be connected to at least one of the data lines DL and at least one of the scan lines SL. As shown in FIGS. 4 to 6, each of the pixels PX may include a light emitting element LE and a pixel circuit unit PXC including a plurality of transistors for supplying a driving current to the light emitting element LE. A detailed description of the pixel PX will be made later with reference to FIGS. 4 to 6.

The scan driving circuit unit SDC and the driving circuit 200 may be referred to as a display panel driver. The driving circuit 200 may include a timing control circuit unit TIC and a data driving circuit unit DIC.

The scan driving circuit unit SDC is connected to the scan lines SL and applies scan signals to the scan lines SL. The scan driving circuit unit SDC may generate scan signals according to a scan timing control signal SCS inputted from the timing control circuit unit TIC and output the scan signals to the scan lines SL.

The scan driving circuit unit SDC may include a plurality of transistors. In this case, the scan driving circuit unit SDC may be located in the non-display area NDA located on the left and right sides of the display panel 100.

The data driving circuit unit DIC is connected to the data lines DL and supplies data voltages to the data lines DL. The data driving circuit unit DIC receives digital video data DATA and a data timing control signal DCS from the timing control circuit unit TIC. The data driving circuit unit DIC converts the digital video data DATA into data voltages according to the data timing control signal DCS and outputs the data voltages to the data lines DL.

The timing control circuit unit TIC receives digital video data DATA and timing signals TS. The timing signals TS may include a vertical synchronization signal, a horizontal synchronization signal, a data enable signal, a clock signal such as a dot clock, and the like.

The timing control circuit unit TIC generates control signals for controlling the operation timings of the data driving circuit unit DIC and the scan driving circuit unit SDC. The control signals may include the data timing control signal DCS for controlling the operation timing of the data driving circuit unit DIC, and the scan timing control signal SCS for controlling the operation timing of the scan driving circuit unit SDC.

The timing control circuit unit TIC outputs the digital video data DATA and the data timing control signal DCS to the data driving circuit unit DIC, and outputs the scan timing control signal SCS to the scan driving circuit unit SDC.

The power supply unit PSU may generate a first power voltage VSS corresponding to a low potential voltage and a second power voltage VDD corresponding to a high potential voltage from a main power source applied from the outside. In addition, the power supply unit PSU may supply various driving voltages to the data driving circuit unit DIC, the scan driving circuit unit SDC, and the timing control circuit unit TIC.

FIG. 4 is a circuit diagram illustrating a pixel of a display device according to one embodiment.

Referring to FIG. 4, the pixel PX according to one embodiment may include the pixel circuit unit PXC and the light emitting element LE.

The light emitting element LE emits light by the driving current. A light emission amount of the light emitting element LE may be proportional to the driving current.

The light emitting element LE may be an organic light emitting element including an anode electrode, a cathode electrode, and an organic light emitting layer located between the anode electrode and the cathode electrode. Alternatively, the light emitting element LE may be an inorganic light emitting element including an anode electrode, a cathode electrode, and an inorganic semiconductor located between the anode electrode and the cathode electrode.

The anode electrode of the light emitting element LE may be connected to the first electrode of a fourth transistor ST4 and the second electrode of a sixth transistor ST6, and the cathode electrode may be connected to a first power line VSL for supplying the first power voltage VSS. A parasitic capacitance Cel may be formed between the anode electrode and the cathode electrode of the light emitting element LE.

The pixel circuit unit PXC includes the driving transistor DT, the switch elements, and a capacitor C1. The switch elements include the first to sixth transistors ST1, ST2, ST3, ST4, ST5, and ST6.

The driving transistor DT includes a gate electrode, a first electrode, and a second electrode. The driving transistor DT controls a source-drain current (hereinafter, referred to as "driving current") flowing between the first electrode and the second electrode according to a data voltage applied to the gate electrode.

The capacitor C1 is formed between the second electrode of the driving transistor DT and a second power line VDL for supplying the second power voltage VDD. One electrode of the capacitor C1 may be connected to the second electrode of the driving transistor DT, and the other electrode of the capacitor C1 may be connected to the first power line VDL.

When the first electrode of each of the driving transistor DT and the first to sixth transistors ST1 to ST6 is a source electrode, the second electrode may be a drain electrode. Alternatively, when the first electrode of each of the driving transistor DT and the first to sixth transistors ST1 to ST6 is a drain electrode, the second electrode may be a source electrode.

An active layer of each of the driving transistor DT and the first to sixth transistors ST1 to ST6 may include any one of polysilicon, amorphous silicon, and an oxide semiconductor. When the active layer of each of the driving transistor DT and the first to sixth transistors ST1 to ST6 includes polysilicon, a process for forming the semiconductor layer may be a low temperature polysilicon (LTPS) process.

Further, in FIG. 4, the driving transistor DT and the first to sixth transistors ST1 to ST6 have been described as being formed as a p-type metal oxide semiconductor field effect transistor (MOSFET), but without being limited thereto, they may be formed as an n-type MOSFET.

Furthermore, the first power voltage VSS of the first power line VSL, the second power voltage VDD of the second power line VDL, and a third power voltage (or initialization voltage) of a third power line VIL may be set in consideration of the characteristics of the driving transistor DT, the characteristics of the light emitting element LE, and the like.

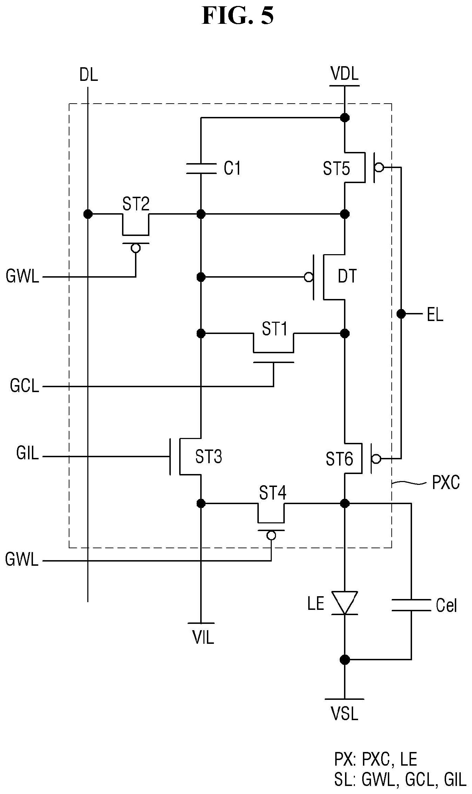

FIG. 5 is a circuit diagram illustrating a pixel of a display device according to one embodiment.

The embodiment of FIG. 5 is different from the embodiment of FIG. 4 in that the driving transistor DT, the second transistor ST2, the fourth transistor ST4, the fifth transistor ST5, and the sixth transistor ST6 are formed as the p-type MOSFETs, and the first transistor ST1 and the third transistor ST3 are formed as the n-type MOSFETs.

Referring to FIG. 5, an active layer of each of the driving transistor DT, the second transistor ST2, the fourth transistor ST4, the fifth transistor ST5 and the sixth transistor ST6 configured as the p-type MOSFETs may include polysilicon, whereas an active layer of each of the first transistor ST1 and the third transistor ST3 configured as the n-type MOSFETs may include an oxide semiconductor.

The embodiment of FIG. 5 is different from the embodiment of FIG. 4 in that the gate electrode of the second transistor ST2 and the gate electrode of the fourth transistor ST4 are connected to a write scan line GWL, and the gate electrode of the first transistor ST1 is connected to a control scan line GCL. Further, in FIG. 5, since the first transistor ST1 and the third transistor ST3 are formed as the n-type MOSFET, the scan signal of a gate high voltage may be applied to the control scan line GCL and an initialization scan line GIL. On the contrary, the second transistor ST2, the fourth transistor ST4, the fifth transistor ST5, and the sixth transistor ST6 are formed as the p-type MOSFETs, so that a scan signal of a gate low voltage may be applied to the write scan line GWL and an emission line EL.

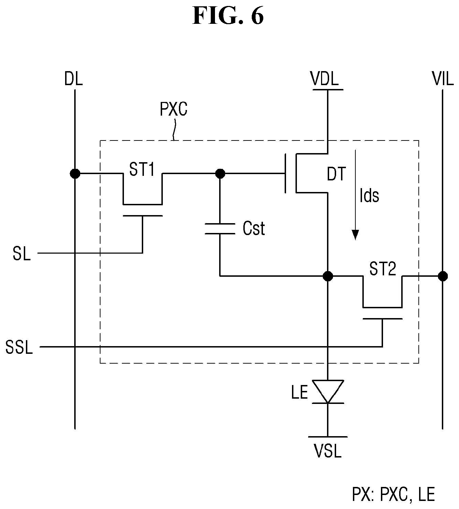

FIG. 6 is a circuit diagram illustrating a pixel of a display device according to one embodiment.

Referring to FIG. 6, the light emitting element LE emits light according to the driving current. A light emission amount of the light emitting element LE may be proportional to the driving current. The anode electrode of the light emitting element LE may be connected to the source electrode of the driving transistor DT, and the cathode electrode may be connected to the first power line VSL to which the first power voltage VSS that is lower than the second power voltage VDD is supplied.

The driving transistor DT adjusts a current flowing from the second power line VDL, to which the second power voltage VDD is applied, to the light emitting element LE according to a voltage difference between a gate electrode and the source electrode. The gate electrode of the driving transistor DT may be connected to the first electrode of the first transistor ST1, the source electrode may be connected to the anode electrode of the light emitting element LE, and the drain electrode may be connected to the first power line VSL.

The first transistor ST1 is turned on by a scan signal applied from the scan line SL to connect the data line DL to the gate electrode of the driving transistor DTR. The gate electrode of the first transistor ST1 may be connected to the scan line SL, the first electrode may be connected to the gate electrode of the driving transistor DT, and the second electrode may be connected to the data line DL.

A second transistor ST2 is turned on by the sensing signal of a sensing signal line SSL to connect an initialization voltage line VIL to the source electrode of the driving transistor DT. The gate electrode of the second transistor ST2 may be connected to the sensing signal line SSL, the first electrode may be connected to the initialization voltage line VIL, and the second electrode may be connected to the source electrode of the driving transistor DT.

The first electrode of each of the first and second transistors ST1 and ST2 may be a source electrode, and the second electrode may be a drain electrode, but it should be noted that the present disclosure is not limited thereto. That is, the first electrode of each of the first and second transistors ST1 and ST2 may be a drain electrode, and the second electrode may be a source electrode.

The capacitor Cst is formed between the gate electrode and the source electrode of the driving transistor DT. The capacitor Cst stores a difference voltage between the gate voltage and the source voltage of the driving transistor DT.

Although FIG. 6 mainly describes the case in which the driving transistor DT and the first and second transistors ST1 and ST2 are formed as n-type metal oxide semiconductor field effect transistors (MOSFETs), but it should be noted that the present disclosure is not limited thereto. The driving transistor DT and the first and second transistors ST1 and ST2 may be formed as p-type MOSFETs.

It should be noted that the pixel PX according to the above-described embodiment of the present specification is not limited to those illustrated in FIGS. 4 to 6. The pixel PX according to the embodiment of the present disclosure may have other known circuit structures that those skilled in the art may employ in addition to the embodiment illustrated in FIGS. 4 to 6.

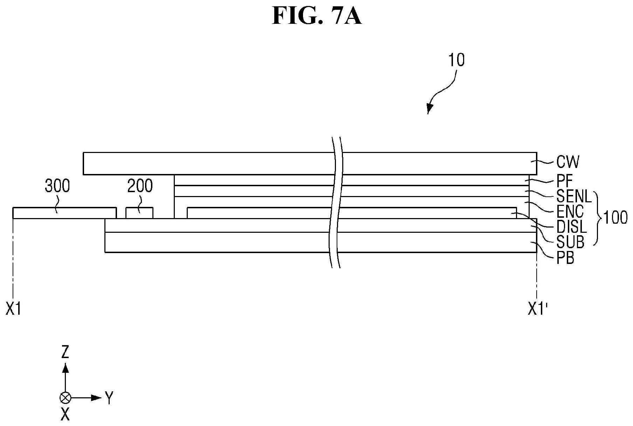

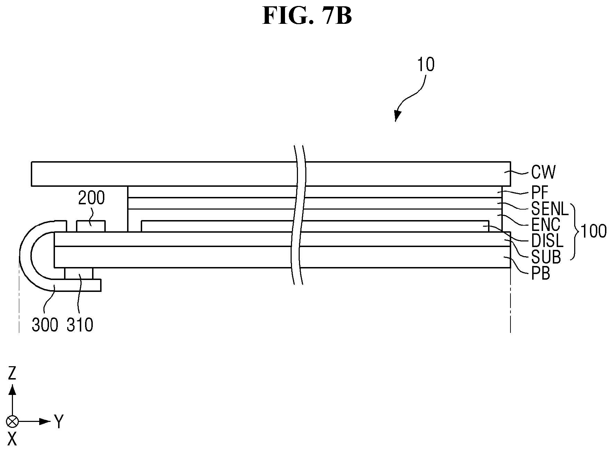

FIG. 7A is a cross-sectional view illustrating an example of a display device taken along line X1-X1' of FIG. 1. FIG. 7B is a cross-sectional view showing an example of a display device in which the circuit board in FIG. 7A is bent.

Referring to FIGS. 7A and 7B, the display device 10 according to one embodiment may include the display panel 100, a polarizing film PF, a cover window CW, and a panel lower cover PB. The display panel 100 may include the substrate SUB, a display layer DISL, the encapsulation layer ENC, and a sensor electrode layer SENL.

The substrate SUB may have a hard material. For example, the substrate SUB may include glass. That is, the substrate SUB may be a glass substrate. The substrate SUB may include ultra thin glass (UTG) having a thickness of approximately 250 µm or less.

The display layer DISL may be located on the first surface of the substrate SUB. The display layer DISL may be a layer displaying an image. The display layer DISL may include a thin film transistor layer TFTL in which thin film transistors are formed, and a light emitting element layer EML in which light emitting elements emitting light are located in emission areas.

In the display area DA of the display layer DISL, scan lines, data lines, power lines, or the like for the emission areas to emit light may be located. In the non-display area NDA of the display layer DISL, a scan driving circuit unit outputting scan signals to the scan lines, fan-out lines connecting the data lines and the driving circuit 200, and the like may be located.

The encapsulation layer ENC may be a layer for encapsulating the light emitting element layer EML of the display layer DISL to prevent permeation of oxygen or moisture into the light emitting element layer EML of the display layer DISL. The encapsulation layer ENC may be located on the display layer DISL. The encapsulation layer ENC may be located on the top surfaces and the side surfaces of the display layer DISL. The encapsulation layer ENC may be located to cover the display layer DISL.

The sensor electrode layer SENL may be located on the display layer DISL. The sensor electrode layer SENL may include sensor electrodes. The sensor electrode layer SENL may sense a user's touch using sensor electrodes.

The polarizing film PF may be located on the display panel 100 to prevent a decrease in the visibility of an image displayed on the display panel 100 due to external light being reflected from the display panel 100. The polarizing film PF may include a first base member, a linear polarization plate, a phase retardation film such as a quarter-wave plate (λ/4 plate), and a second base member. The first base member, the phase retardation film, the linear polarization plate, and the second base member of the polarizing film PF may be sequentially stacked on the display panel 100.

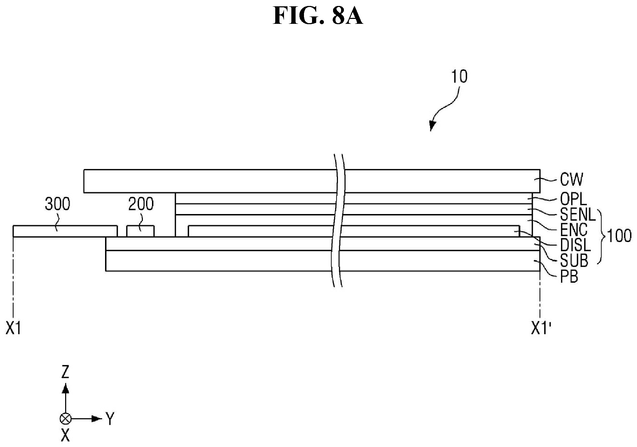

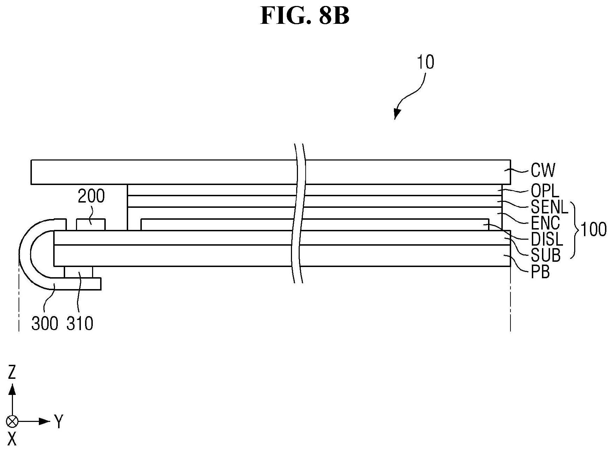

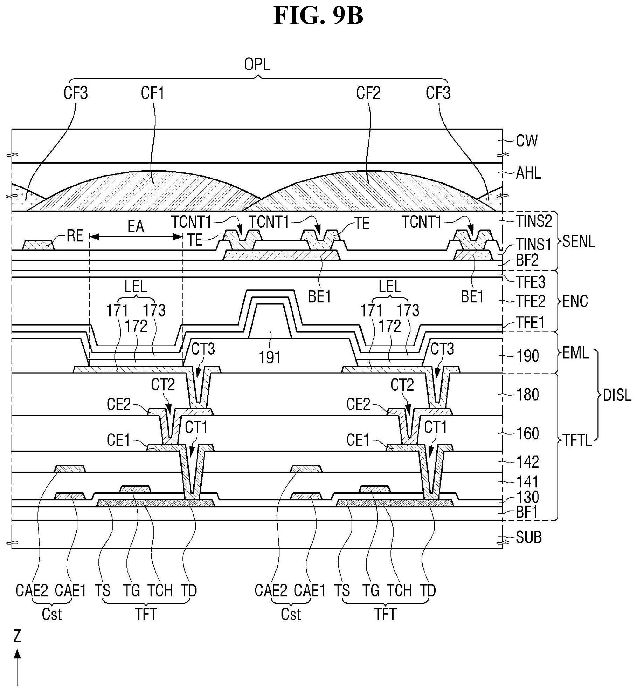

However, the embodiment of the present disclosure is not limited thereto, and the polarizing film PF may be omitted. In this case, as shown in FIG. 8A, FIG. 8B, and FIG. 9B, an optical layer OPL including a plurality of color filters CF1, CF2, and CF3 may be located instead of the polarizing film PF. A planarization layer and/or an adhesive layer AHL may be located between the optical layer OPL and the cover window CW. Although the case in which the optical layer OPL is located on the sensor electrode layer SENL of the display panel 100 has been exemplified in FIGS. 8A, 8B, and 9B, the embodiment of the present disclosure is not limited thereto. For example, the optical layer OPL may be located between the encapsulation layer ENC and the sensor electrode layer SENL.

The cover window CW may be located on the polarizing film PF. The cover window CW may be attached to the polarizing film PF by a transparent adhesive member such as an optically clear adhesive (OCA) film.

The panel lower cover PB may be located on a second surface of the substrate SUB of the display panel 100. The second surface of the substrate SUB may be a surface opposite to the first surface. The panel lower cover PB may be attached to the second surface of the substrate SUB of the display panel 100 through an adhesive member. The adhesive member may be a pressure sensitive adhesive (PSA).

The panel lower cover PB may include at least one selected from a light blocking member for absorbing light incident from the outside, a buffer member for absorbing an impact from the outside, and a heat dissipation member for efficiently dissipating heat from the display panel 100.

The light blocking member may be located under the display panel 100. The light blocking member blocks light transmission, thereby preventing components (e.g., a circuit board 300 and the like) located under the light blocking member from being viewed from the top of the display panel 100. The light blocking member may include a light absorbing material such as a black pigment, black dyes or the like.

The buffer member may be located under the light blocking member. The buffer member absorbs an external impact to prevent the display panel 100 from being damaged. The buffer member may be formed as a single layer or multiple layers. For example, the buffer member may include polymer resin such as polyurethane (PU), polycarbonate (PC), polypropylene (PP), or polyethylene (PE) or may include an elastic material such as a foamed sponge obtained from rubber, a urethane-based material, or an acrylic material.

The heat dissipation member may be located under the buffer member. The heat dissipation member may include a first heat dissipation layer containing graphite, carbon nanotubes or the like, and a second heat dissipation layer formed as a metal thin film containing, for example, copper, nickel, ferrite, or silver which can shield electromagnetic waves and has excellent thermal conductivity.

The circuit board 300 may be bent toward the bottom of the display panel 100 as shown in FIG. 7B. The circuit board 300 may be attached to the bottom surface of the panel lower cover PB by an adhesive member 310. The adhesive member 310 may be a pressure sensitive adhesive.

FIGS. 9A and 9B are cross-sectional views illustrating an example of a display area of a display panel according to one embodiment.

Referring to FIGS. 9A and 9B, the display panel 100 according to one embodiment may be an organic light emitting display panel having a light emitting element LEL including an organic light emitting layer 172.

The display layer DISL may include the thin film transistor layer TFTL including a plurality of thin film transistors and the light emitting element layer EML including a plurality of light emitting elements.

A first buffer film BF1 may be located on the substrate SUB. The first buffer film BF1 may include an inorganic material such as a silicon nitride layer, a silicon oxynitride layer, a silicon oxide layer, a titanium oxide layer and an aluminum oxide layer. Alternatively, the first buffer film BF1 may be formed as a multilayer in which a plurality of layers selected from a silicon nitride layer, a silicon oxynitride layer, a silicon oxide layer, a titanium oxide layer and an aluminum oxide layer are alternately stacked.

An active layer including a channel region TCH, a source region TS, and a drain region TD of the thin film transistor TFT may be located on the first buffer film BF1. The active layer may include polycrystalline silicon, monocrystalline silicon, low-temperature polycrystalline silicon, amorphous silicon, or an oxide semiconductor material. When the active layer includes polycrystalline silicon or an oxide semiconductor material, the source region TS and the drain region TD of the active layer may be conductive regions doped with ions or impurities and having conductivity.

A gate insulating film 130 may be located on the active layer of the thin film transistor TFT. The gate insulating film 130 may be formed as an inorganic film, for example, a silicon nitride layer, a silicon oxynitride layer, a silicon oxide layer, a titanium oxide layer, or an aluminum oxide layer.

A first gate metal layer including a gate electrode TG of the thin film transistor TFT, a first capacitor electrode CAE1 of the capacitor Cst, and scan lines may be located on the gate insulating film 130. The gate electrode TG of the thin film transistor TFT may overlap the channel region TCH in the third direction (Z-axis direction). In one embodiment, the third direction (Z-axis direction) may be the thickness direction of the display panel 100 or the thickness direction of the substrate SUB. The third direction (Z-axis direction) may be orthogonal to a plane parallel to the display area DA of the display panel 100. The first gate metal layer may be formed as a single layer or multiple layers including any one of molybdenum (Mo), aluminum (Al), chromium (Cr), gold (Au), titanium (Ti), nickel (Ni), neodymium (Nd) and copper (Cu) or an alloy thereof.

A first interlayer insulating film 141 may be located on the first gate metal layer. The first interlayer insulating film 141 may be formed as an inorganic film, for example, a silicon nitride layer, a silicon oxynitride layer, a silicon oxide layer, a titanium oxide layer, or an aluminum oxide layer. The first interlayer insulating film 141 may include a plurality of inorganic films.

A second gate metal layer including a second capacitor electrode CAE2 of the capacitor Cst may be located on the first interlayer insulating film 141. The second capacitor electrode CAE2 may overlap the first capacitor electrode CAE1 in the third direction (Z-axis direction). Therefore, the capacitor Cst may be formed by the first capacitor electrode CAE1, the second capacitor electrode CAE2, and an inorganic insulating dielectric film located between the first capacitor electrode CAE1 and the second capacitor electrode CAE2 to serve as a dielectric film. The second gate metal layer may be formed as a single layer or multiple layers including any one of molybdenum (Mo), aluminum (Al), chromium (Cr), gold (Au), titanium (Ti), nickel (Ni), neodymium (Nd) and copper (Cu) or an alloy thereof.

A second interlayer insulating film 142 may be located on the second gate metal layer and the first interlayer insulating film 141. The second interlayer insulating film 142 may be formed as an inorganic film, for example, a silicon nitride layer, a silicon oxynitride layer, a silicon oxide layer, a titanium oxide layer, or an aluminum oxide layer. The second interlayer insulating film 142 may include a plurality of inorganic films.

The first data metal layer including a first connection electrode CE1 and the data lines may be located on the second interlayer insulating film 142. The first connection electrode CE1 may be connected to the drain region TD through a first contact hole CT1 penetrating the gate insulating film 130, the first interlayer insulating film 141, and the second interlayer insulating film 142. The first data metal layer may be formed as a single layer or multiple layers including any one of molybdenum (Mo), aluminum (Al), chromium (Cr), gold (Au), titanium (Ti), nickel (Ni), neodymium (Nd) and copper (Cu) or an alloy thereof.

A first organic film 160 for planarizing a step caused by the thin film transistors TFT may be located on the first data metal layer including the first connection electrode CE1 and the second interlayer insulating film 142. The first organic film 160 may be formed as an organic film such as acrylic resin, epoxy resin, phenolic resin, polyamide resin, polyimide resin, or the like.

The second data metal layer including a second connection electrode CE2 may be located on the first organic film 160. The second data metal layer may be connected to the first connection electrode CE1 through a second contact hole CT2 penetrating the first organic film 160. The second data metal layer may be formed as a single layer or multiple layers including any one of molybdenum (Mo), aluminum (Al), chromium (Cr), gold (Au), titanium (Ti), nickel (Ni), neodymium (Nd) and copper (Cu) or an alloy thereof.

A second organic film 180 may be located on the second data metal layer including the second connection electrode CE2 and the first organic film 160. The second organic film 180 may be formed as an organic film such as acrylic resin, epoxy resin, phenolic resin, polyamide resin, polyimide resin, or the like.

The second data metal layer including the second connection electrode CE2 and the second organic film 180 may be omitted.

The light emitting element layer EML is located on the thin film transistor layer TFTL. The light emitting element layer EML may include light emitting elements LEL and a bank 190.

Each of the light emitting elements LEL may include a pixel electrode 171, a light emitting layer 172, and a common electrode 173. Each of the emission areas EA is an area in which the pixel electrode 171, the light emitting layer 172, and the common electrode 173 are sequentially stacked such that the holes from the pixel electrode 171 and the electrons from the common electrode 173 are combined with each other in the light emitting layer 172 to emit light. In this case, the pixel electrode 171 may be an anode electrode, and the common electrode 173 may be a cathode electrode.

A pixel electrode layer including the pixel electrode 171 may be formed on the second organic film 180. The pixel electrode 171 may be connected to the second connection electrode CE2 through a third contact hole CT3 penetrating the second organic film 180. The pixel electrode layer may be formed as a single layer or multiple layers including any one of molybdenum (Mo), aluminum (Al), chromium (Cr), gold (Au), titanium (Ti), nickel (Ni), neodymium (Nd) and copper (Cu) or an alloy thereof.

In a top emission structure that emits light toward the common electrode 173 with respect to the light emitting layer 172, the pixel electrode 171 may be formed as a single layer of any one of molybdenum (Mo), titanium (Ti), copper (Cu), and aluminum (Al), or may be formed as any one of a stacked structure of aluminum and titanium (Ti/Al/Ti), a stacked structure of aluminum and indium tin oxide (ITO) (ITO/Al/ITO), an APC alloy, and a stacked structure of APC alloy and ITO (ITO/APC/ITO) to increase the reflectivity. The APC alloy is an alloy of silver (Ag), palladium (Pd) and copper (Cu).

The bank 190 serves to define the emission areas EA of the pixels. To this end, the bank 190 may be formed to expose a partial region of the pixel electrode 171 on the second organic film 180. The bank 190 may cover the edge of the pixel electrode 171. The bank 190 may be located in the third contact hole CT3. That is, the third contact hole CT3 may be filled with the bank 190. The bank 190 may be formed as an organic film such as acrylic resin, epoxy resin, phenolic resin, polyamide resin, or polyimide resin.

A spacer 191 may be located on the bank 190. The spacer 191 may serve to support a mask during a process of fabricating the light emitting layer 172. The spacer 191 may be formed as an organic film such as acrylic resin, epoxy resin, phenolic resin, polyamide resin, or polyimide resin.

The light emitting layer 172 is formed on the pixel electrode 171. The light emitting layer 172 may include an organic material to emit light of a selected color. For example, the light emitting layer 172 may include a hole transporting layer, an organic material layer, and an electron transporting layer. The organic material layer may include a host and a dopant. The organic material layer may include a material that emits selected light, and may be formed using a phosphorescent material or a fluorescent material.

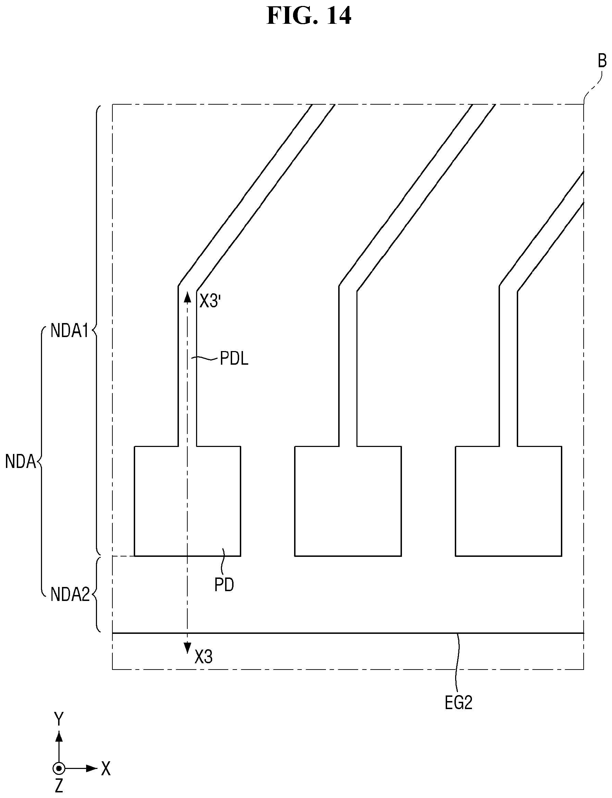

The common electrode 173 is formed on the light emitting layer 172, the bank 190, and the spacer 191. The common electrode 173 may be formed to cover the light emitting layer 172, the bank 190, and the spacer 191. As shown in FIG. 14, the common electrode 173 may be a common layer which is commonly formed in the emission areas EA1, EA2, EA3, and EA4. A capping layer may be formed on the common electrode 173.

In the top emission structure, the common electrode 173 may include a transparent conductive material (TCO) such as ITO or IZO capable of transmitting light or a semi-transmissive conductive material such as magnesium (Mg), silver (Ag), or an alloy of magnesium (Mg) and silver (Ag). When the common electrode 173 includes a semi-transmissive conductive material, the light emission efficiency may be increased due to a micro-cavity effect.

The encapsulation layer ENC may be formed on the light emitting element layer EML. The encapsulation layer ENC may include at least one inorganic film TFE1 and TFE3 to prevent oxygen or moisture from permeating into the light emitting element layer EML. In addition, the encapsulation layer ENC may include at least one organic film TFE2 to protect the light emitting element layer EML from foreign substances such as dust. For example, the encapsulation layer ENC may include a first encapsulation inorganic film TFE1, an encapsulation organic film TFE2, and a second encapsulation inorganic film TFE3.

The first encapsulation inorganic film TFE1 may be located on the common electrode 173, the encapsulation organic film TFE2 may be located on the first encapsulation inorganic film TFE1, and the second encapsulation inorganic film TFE3 may be located on the encapsulation organic film TFE2. The first encapsulation inorganic film TFE1 and the second encapsulation inorganic film TFE3 may be formed as a multilayer in which one or more inorganic films of a silicon nitride layer, a silicon oxynitride layer, a silicon oxide layer, a titanium oxide layer and an aluminum oxide layer are stacked alternately. The encapsulation organic film TFE2 may be an organic film such as acrylic resin, epoxy resin, phenolic resin, polyamide resin, polyimide resin, or the like.

The sensor electrode layer SENL is located on the encapsulation layer ENC. The sensor electrode layer SENL may include sensor electrodes TE and RE.

A second buffer film BF2 may be located on the encapsulation layer ENC. The second buffer film BF2 may include at least one inorganic film. For example, the second buffer film BF2 may be formed as a multilayer in which one or more inorganic films of a silicon nitride layer, a silicon oxynitride layer, a silicon oxide layer, a titanium oxide layer and an aluminum oxide layer are alternately stacked. The second buffer film BF2 may be omitted.

First connection portions BE1 may be located on the second buffer film BF2. The first connection portions BE1 may be formed as a single layer of any one of molybdenum (Mo), titanium (Ti), copper (Cu), and aluminum (Al), or may be formed as any one of a stacked structure of aluminum and titanium (Ti/Al/Ti), a stacked structure of aluminum and ITO (ITO/Al/ITO), an Ag-Pd-Cu (APC) alloy, and a stacked structure of APC alloy and ITO (ITO/APC/ITO).

A first sensor insulating film TINS1 may be located on the first connection portions BE1. The first sensor insulating film TINS1 may be formed as an inorganic film, for example, a silicon nitride layer, a silicon oxynitride layer, a silicon oxide layer, a titanium oxide layer, or an aluminum oxide layer.

The sensor electrodes, that is, the driving electrodes TE and the sensing electrodes RE may be located on the first sensor insulating film TNIS1. In addition, dummy patterns may be located on the first sensor insulating film TNIS1. The driving electrodes TE, the sensing electrodes RE, and the dummy patterns do not overlap the emission areas EA. The driving electrodes TE, the sensing electrodes RE, and the dummy patterns may be formed as a single layer of any one of molybdenum (Mo), titanium (Ti), copper (Cu), and aluminum (Al), or may be formed as any one of a stacked structure of aluminum and titanium (Ti/Al/Ti), a stacked structure of aluminum and ITO (ITO/Al/ITO), an Ag-Pd-Cu (APC) alloy, and a stacked structure of APC alloy and ITO (ITO/APC/ITO).

A second sensor insulating film TINS2 may be located on the driving electrodes TE, the sensing electrodes RE, the dummy patterns, and the first sensor insulating film TINS1. The second sensor insulating film TINS2 may include at least one of an inorganic film or an organic film. The inorganic film may be a silicon nitride layer, a silicon oxynitride layer, a silicon oxide layer, a titanium oxide layer, or an aluminum oxide layer. The organic film may include acrylic resin, epoxy resin, phenolic resin, polyamide resin, or polyimide resin.

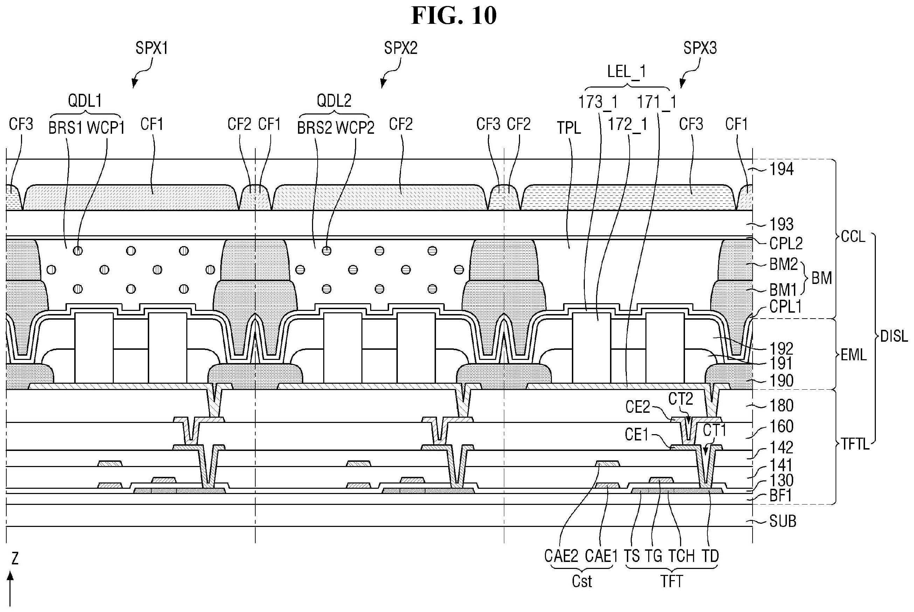

FIG. 10 is a cross-sectional view illustrating an example of a display area of a display panel according to another embodiment.

Referring to FIG. 10, the display panel 100 according to one embodiment may be a light emitting diode display panel having a light emitting element LEL_1 including a light emitting diode element 172_1 extending in the third direction (Z-axis direction). The light emitting diode element 172_1 may have a length or size in micrometer units and may be a micro light emitting diode including an inorganic material, and in this case, the display panel 100 according to one embodiment may be a micro light emitting diode display panel.

Since the display panel 100 according to one embodiment includes the light emitting diode element 172_1 including an inorganic material, an encapsulation structure is not required. Therefore, the display panel 100 according to one embodiment may not include the encapsulation layer ENC.

In addition, when the light emitting diode element 172_1 of the display panel 100 according to one embodiment emits the same light, a color control layer CCL may be included. In a case where the light emitting diode element 172_1 of the display panel 100 according to one embodiment is divided into elements that emit a plurality of colors, the color control layer CCL may be omitted.

Furthermore, in FIG. 10, the polarizing film PF and the cover window CW are deleted for simplicity of description. The polarizing film PF may be located on the color control layer CCL, and the cover window CW may be located on the polarizing film PF.

The display layer DISL of the display panel 100 according to one embodiment includes the thin film transistor layer TFTL, the light emitting element layer EML, and the color control layer CCL. Since the thin film transistor layer TFTL illustrated in FIG. 10 is substantially the same as the thin film transistor layer TFTL described in conjunction with FIGS. 9A and 9B, the description of the thin film transistor layer TFTL is omitted in FIG. 10.

The light emitting element layer EML may include light emitting elements LEL_1, the bank 190, a third organic film 191, and a fourth organic film 192.

Each of the light emitting elements LEL_1 may include a pixel electrode 171_1, the light emitting diode element 172_1, and a common electrode 173_1. Since the pixel electrode 171_1 is substantially the same as the pixel electrode 171 described in conjunction with FIGS. 9A and 9B, the description of the pixel electrode 171_1 is omitted in FIG. 10.

The bank 190 may be located to cover the edge of the pixel electrode 171_1. The bank 190 may be formed as an organic film such as acrylic resin, epoxy resin, phenolic resin, polyamide resin, polyimide resin, or the like. The bank 190 may include a light blocking material to prevent light from the light emitting diode element 172_1 of any one sub-pixel from traveling to a sub-pixel adjacent thereto. For example, the bank 190 may contain an organic block pigment or an inorganic black pigment such as carbon black or the like.

A plurality of light emitting diode elements 172_1 may be located on the pixel electrode 171_1 that is exposed without being covered by the bank 190. Each of the plurality of light emitting diode elements 172_1 is illustrated as a vertical type micro LED extending in the third direction (Z-axis direction). In this case, each of the plurality of light emitting diode elements 172_1 may have a rectangular or reverse tapered cross-sectional shape. However, each of the plurality of light emitting diode elements 172_1 is not limited to a vertical micro LED, and may be a flip type micro LED.

Each of the plurality of light emitting diode elements 172_1 may include an inorganic material such as GaN. Each of the plurality of light emitting diode elements 172_1 may have a length of several to several hundred µm in each of the first direction (X-axis direction), the second direction (Y-axis direction), and the third direction (Z-axis direction). For example, each of the plurality of light emitting diode elements 172_1 may have a length of approximately 100 µm or less in each of the first direction (X-axis direction), the second direction (Y-axis direction), and the third direction (Z-axis direction). However, the embodiment of the present disclosure is not limited thereto, and a plurality of light emitting diode elements 172_1 may have a size in nanometers.

Each of the plurality of light emitting diode elements 172_1 may be grown and formed on a semiconductor substrate such as a silicon wafer. Each of the plurality of light emitting diode elements 172_1 may be moved directly from the silicon wafer onto the pixel electrode 171_1 of the substrate SUB. Alternatively, each of the plurality of light emitting diode elements 172_1 may be transferred onto the pixel electrodes171_1 of the substrate SUB through an electrostatic method using an electrostatic head or a stamping method using an elastic polymer material such as PDMS or silicon as a transfer substrate.

The light emitting diode element 172_1 may be an inorganic light emitting diode including an inorganic material and having a length or size in micrometer or nanometer units. The light emitting diode element 172_1 may have a shape extending in one direction. Each of the plurality of light emitting diode elements 172_1 may have a cylindrical shape, a rod shape, a wire shape, a tube shape, or the like. However, the shape of the light emitting diode elements 172_1 is not limited thereto, and the light emitting diode elements 172_1 and 172_2 may have a polygonal prism shape such as a regular cube, a rectangular parallelepiped and a hexagonal prism, or a shape extending in one direction and having a partially inclined outer surface.

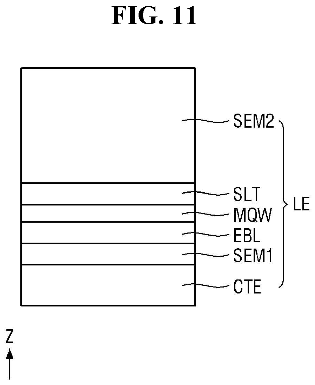

Each of the plurality of light emitting diode elements 172_1 may include a contact electrode CTE, a first semiconductor layer SEM1, an electron blocking layer EBL, an active layer MQW, a superlattice layer SLT, and a second semiconductor layer SEM2, as shown in FIG. 11.

The contact electrode CTE may be located on the pixel electrode 171_1. The contact electrode CTE and the pixel electrode 171_1 may be melted and bonded by heat and pressure. Alternatively, the contact electrode CTE and the pixel electrode 171_1 may be bonded to each other through a conductive adhesive material such as an anisotropic conductive film or an anisotropic conductive adhesive. Alternatively, the contact electrode CTE and the pixel electrode 171_1 may be bonded to each other through a soldering process. For example, the contact electrode CTE may include at least one selected from gold (Au), copper (Cu), aluminum (Al), and tin (Sn).

The first semiconductor layer SEM1 may be located on the contact electrode CTE. The first semiconductor layer SEM1 may include GaN doped with a first conductivity type dopant such as Mg, Zn, Ca, Sr, or Ba.

The electron blocking layer EBL may be located on the first semiconductor layer SEM1. The electron blocking layer EBL may be a layer for suppressing or preventing too many electrons from flowing into the active layer MQW. For example, the electron blocking layer EBL may be p-AlGaN doped with p-type Mg. The electron blocking layer EBL may be omitted.

The active layer MQW may be located on the electron blocking layer EBL. The active layer MQW may emit light by coupling of electron-hole pairs according to an electrical signal applied through the first semiconductor layer SEM1 and the second semiconductor layer SEM2.

The active layer MQW may include a material having a single or multiple quantum well structure. When the active layer MQW includes a material having a multiple quantum well structure, the active layer MQW may have a structure in which a plurality of well layers and barrier layers are alternately stacked. At this time, the well layer may include InGaN, and the barrier layer may include GaN or AlGaN, but the present disclosure is not limited thereto. Alternatively, the active layer MQW may have a structure in which semiconductor materials having large band gap energy and semiconductor materials having small band gap energy are alternately stacked, and may include other group III to V semiconductor materials according to the wavelength band of the emitted light.

When the active layer MQW includes InGaN, the color of emitted light may vary depending on the content of indium (In). For example, as the content of indium (In) increases, the wavelength band of the light emitted by the active layer MQW may shift to the red wavelength band, and as the content of indium (In) decreases, the wavelength band of the light emitted by the active layer MQW may shift to the blue wavelength band. For example, the content of indium (In) in the active layer MQW of the light emitting diode element 172_1 emitting light in the blue wavelength band may be approximately 10 wt% to 20 wt%.

The superlattice layer SLT may be located on the active layer MQW. The superlattice layer SLT may be a layer for relieving stress between the second semiconductor layer SEM2 and the active layer MQW. For example, the superlattice layer SLT may include InGaN or GaN. The superlattice layer SLT may be omitted.

The second semiconductor layer SEM2 may be located on the superlattice layer SLT. The second semiconductor layer SEM2 may be doped with a second conductive dopant such as Si, Ge, Sn, or the like. For example, the second semiconductor layer SEM2 may be n-GaN doped with n-type Si.

The third organic film 191 may be located on the bank 190 and the pixel electrode 171_1 that is not covered by the plurality of light emitting diode elements 172_1. The third organic film 191 may be located to cover a part of the top surface and the side surface of the bank 190. The height of the third organic film 191 may be greater than the height of the bank 190. The third organic film 191 may be located on a part of the side surface of each of the plurality of light emitting diode elements 172_1. The height of the third organic film 191 may be less than the height of each of the plurality of light emitting diode elements 172_1. The third organic film 191 may be formed as an organic film such as acrylic resin, epoxy resin, phenolic resin, polyamide resin, polyimide resin and the like.

The fourth organic film 192 may be located on the third organic film 191 to partially cover the side surfaces and the top surface of the third organic film. The fourth organic film 192 may be located on a part of the side surface of each of the plurality of light emitting diode elements 172_1. The fourth organic film 192 may partially cover the top surface of the bank 190. The sum of the height of the third organic film 191 and the height of the fourth organic film 192 may be less than the height of each of the plurality of light emitting diode elements 172_1. The fourth organic film 192 may be formed as an organic film such as acrylic resin, epoxy resin, phenolic resin, polyamide resin, or polyimide resin.

The third organic film 191 and the fourth organic film 192 are layers for planarizing a step due to the plurality of light emitting diode elements 172_1. If the height of each of the plurality of light emitting diode elements 172_1 is similar to the height of the third organic film 191, the fourth organic film 192 may be omitted.

The common electrode 173_1 may be located on the top surface of each of the plurality of light emitting diode elements 172_1 and the top surface of the fourth organic film 192. The common electrode 173_1 may be located on the bank 190 that is exposed without being covered by the third organic film 191 and the fourth organic film 192. The common electrode 173_1 may be a common layer commonly formed for the first sub-pixel SPX1, the second sub-pixel SPX2, and the third sub-pixel SPX3. The common electrode 173_1 may include a transparent conductive material (TCO) such as indium tin oxide (ITO) and indium zinc oxide (IZO) capable of transmitting light.

The color control layer CCL may include a first capping layer CPL1, a light blocking layer BM, a first light conversion layer QDL1, a second light conversion layer QDL2, a light transmitting layer TPL, a second capping layer CPL2, a fifth organic film 193, a plurality of color filters CF1, CF2, and CF3, and a sixth organic film 194.

The first capping layer CPL1 may be located on the common electrode 173_1. The first capping layer CPL1 may be formed as an inorganic film, for example, a silicon nitride layer, a silicon oxynitride layer, a silicon oxide layer, a titanium oxide layer, or an aluminum oxide layer.

The light blocking layer BM, the first light conversion layer QDL1, the second light conversion layer QDL2, and the light transmitting layer TPL may be arranged on the first capping layer CPL1. The first light conversion layer QDL1, the second light conversion layer QDL2, and the light transmitting layer TPL may be formed by partitioning the light blocking layer BM. Therefore, the first light conversion layer QDL1 may be located on the first capping layer CPL1 in the first sub-pixel SPX1 that outputs a first light, the second light conversion layer QDL2 may be located on the first capping layer CPL1 in the second sub-pixel SPX2 that outputs a second light, and the light transmitting layer TPL may be located on the first capping layer CPL1 in the third sub-pixel SPX3 that outputs a third light. The light blocking layer BM may overlap the bank 190 in the sixth direction DR6 and may not overlap a plurality of light emitting diode elements 172_2.

The first light conversion layer QDL1 may convert a part of light in the blue wavelength band incident from the light emitting diode element 172_2 into light in the red wavelength band. The first light conversion layer QDL1 may include a first base resin BRS1 and first wavelength conversion particles WCP1. The first base resin BRS1 may include a light-transmissive organic material. For example, the first base resin BRS1 may contain epoxy resin, acrylic resin, cardo resin, or imide resin. The first wavelength conversion particle WCP1 may convert a part of light in the blue wavelength band incident from the light emitting diode element 172_2 into light in the red wavelength band. The first wavelength conversion particle WCP1 may include a quantum dot (QD), a quantum rod, a fluorescent material, or a phosphorescent material.

The second light conversion layer QDL2 may convert a part of light in the blue wavelength band incident from the light emitting diode element 172_2 into light in the green wavelength band. The second light conversion layer QDL2 may include a second base resin BRS2 and second wavelength conversion particles WCP2. The second base resin BRS2 may contain a light-transmissive organic material. For example, the second base resin BRS2 may contain epoxy resin, acrylic resin, cardo resin, or imide resin. The second wavelength conversion particle WCP2 may convert a part of light in the blue wavelength band incident from the light emitting diode element 172_2 into light in the green wavelength band. The second wavelength conversion particle WCP2 may include a quantum dot (QD), a quantum rod, a fluorescent material, or a phosphorescent material.

The light transmitting layer TPL may include a light-transmissive organic material. For example, the light transmitting layer TPL may include an organic film such as epoxy resin, acrylic resin, cardo resin, or imide resin.

The light blocking layer BM may include a first light blocking layer BM1 and a second light blocking layer BM2 that are sequentially stacked. The length of the first light blocking layer BM1 in the first direction (X-axis direction) or the length of the first light blocking layer BM1 in the second direction (Y-axis direction) may be greater than the length of the second light blocking layer BM2 in the first direction (X-axis direction) or the length of the second light blocking layer BM2 in the second direction (Y-axis direction). The first light blocking layer BM1 and the second light blocking layer BM2 may be formed as organic films such as acrylic resin, epoxy resin, phenolic resin, polyamide resin, or polyimide resin. The first light blocking layer BM1 and the second light blocking layer BM2 may include a light blocking material to prevent light of the light emitting diode element 172_2 of any one sub-pixel from traveling to the neighboring sub-pixel. For example, the first light blocking layer BM1 and the second light blocking layer BM2 may contain an organic block pigment or an inorganic black pigment such as carbon black or the like.

The second capping layer CPL2 may be located on the light blocking layer BM, the first light conversion layer QDL1, the second light conversion layer QDL2, and the light transmitting layer TPL. The second capping layer CPL2 may be formed as an inorganic film, for example, a silicon nitride layer, a silicon oxynitride layer, a silicon oxide layer, a titanium oxide layer, or an aluminum oxide layer. The light blocking layer BM, the first light conversion layer QDL1, the second light conversion layer QDL2, and the light transmitting layer TPL may be encapsulated by the first capping layer CPL1 and the second capping layer CPL2.

The fifth organic film 193 may be located on the second capping layer CPL2. The fifth organic film 193 may include any one of acrylic resin, epoxy resin, phenolic resin, polyamide resin, and polyimide resin.

A plurality of color filters CF1, CF2, and CF3 may be located on the fifth organic film 193. The plurality of color filters CF1, CF2 and CF3 may include first color filters CF1, second color filters CF2, and third color filters CF3.

Each of the first color filters CF1 located in the first sub-pixel SPX1 may transmit light in a red wavelength band and absorb or block light in a blue wavelength band. Therefore, each of the first color filter CF1 may transmit light in the red wavelength band converted by the first light conversion layer QDL1 among the light in the blue wavelength band emitted from the light emitting diode element 172_2, and absorb or block light in the blue wavelength band that is not converted by the first light conversion layer QDL1. Therefore, the first sub-pixel SPX1 may emit light in the red wavelength band.

Each of the second color filters CF2 located in the second sub-pixel SPX2 may transmit light in a green wavelength band and absorb or block light in a blue wavelength band. Therefore, each of the second color filters CF2 may transmit light in the green wavelength band converted by the second light conversion layer QDL2 among the light in the blue wavelength band emitted from the light emitting diode element 172_2, and absorb or block light in the blue wavelength band that is not converted by the second light conversion layer QDL2. Therefore, the second sub-pixel SPX2 may emit light in the green wavelength band.

Each of the third color filters CF3 located in the third sub-pixel SPX3 may transmit light in the blue wavelength band. Therefore, each of the third color filters CF3 may transmit light in the blue wavelength band emitted from the light emitting diode element 172_2 and passing through the light transmitting layer TPL. Therefore, the third sub-pixel SPX3 may emit light in the blue wavelength band.

A sixth organic film 194 for planarization may be located on the plurality of color filters CF1, CF2, and CF3. The sixth organic film 194 may include acrylic resin, epoxy resin, phenolic resin, polyamide resin, or polyimide resin.

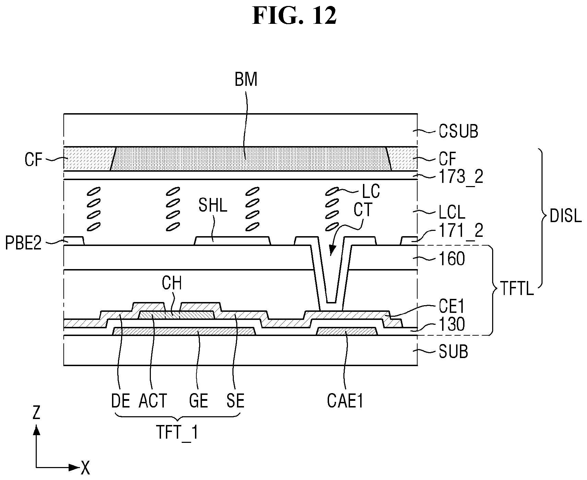

FIG. 12 is a cross-sectional view illustrating an example of a display area of a display panel according to another embodiment.

Referring to FIG. 12, the display panel 100 according to one embodiment may be a liquid crystal display panel having a liquid crystal layer LCL including a liquid crystal LC.

A gate metal layer including a scan line, the first capacitor electrode CAE1, and a gate electrode GE may be located on the substrate SUB. The gate metal layer may include any one selected from the group consisting of molybdenum (Mo), aluminum (Al), platinum (Pt), palladium (Pd), silver (Ag), magnesium (Mg), gold (Au), nickel (Ni), neodymium (Nd), iridium (Ir), chromium (Cr), titanium (Ti), tantalum (Ta), tungsten (W) and copper (Cu), or an alloy thereof. Alternatively, the gate conductive layer may have a two-layer structure of molybdenum/aluminum-neodymium, molybdenum/aluminum or copper/titanium.

The gate insulating film 130 may be located on the gate metal layer. The gate insulating film 130 may include silicon oxide, silicon nitride, silicon oxynitride, aluminum oxide, tantalum oxide, hafnium oxide, zirconium oxide, titanium oxide, or a combination thereof.

An active layer ACT may be located on the gate insulating film GI. The active layer ACT may include a channel region CH located between a source electrode SE and a drain electrode DE in the first direction (X-axis direction). The channel region CH may overlap the gate electrode GE.

The active layer ACT may include a silicon-based semiconductor material such as amorphous silicon, polycrystalline silicon, monocrystalline silicon, or the like. Alternatively, the active layer ACT may include an oxide semiconductor.

An ohmic contact layer may be located on the active layer ACT. Specifically, the ohmic contact layer may be located between the source electrode SE and the active layer ACT and between the drain electrode DE and the active layer ACT. The ohmic contact layer may lower contact resistance by lowering the Schottky barrier, or work function, between the metal and silicon. The ohmic contact layer may include amorphous silicon doped with n-type impurities at a high concentration.

A data metal layer including a data line, the source electrode SE, the drain electrode DE, and the first connection electrode CE1 may be located on the gate insulating film 130. The source electrode SE and drain electrode DE may be located on the active layer ACT. The source electrode SE and the first connection electrode CE1 may be integrally formed. The data metal layer may include any one selected from the group consisting of molybdenum (Mo), aluminum (Al), platinum (Pt), palladium (Pd), silver (Ag), magnesium (Mg), gold (Au), nickel (Ni), neodymium (Nd), iridium (Ir), chromium (Cr), titanium (Ti), tantalum (Ta), tungsten (W) and copper (Cu), or an alloy thereof. Alternatively, the data metal layer may have a two-layer structure of molybdenum/aluminum-neodymium, molybdenum/aluminum or copper/titanium, or a three-layer structure of molybdenum/titanium/molybdenum or molybdenum/aluminum/molybdenum.

The first organic film 160 may be located on the data metal layer and the active layer ACT. The first organic film 160 may include an organic insulating material or an inorganic insulating material. For example, the first organic film 160 may be an overcoat layer including an organic insulating material.

A pixel electrode layer including a pixel electrode 171_2 may be located on the first organic film 160. The pixel electrode 171_2 may be connected to the first connection electrode CE1 through a contact hole CT penetrating the first organic film 160. The pixel electrode layer may include a transparent material through which light may pass. For example, the pixel electrode layer may include indium tin oxide (ITO), indium zinc oxide (IZO), or indium tin zinc oxide (ITZO), but is not limited thereto. Any material that is transparent and conductive may be used as the pixel electrode layer.

A color filter substrate CSUB opposing the substrate SUB may be a transparent insulating substrate similar to the substrate SUB. For example, the color filter substrate CSUB may include glass.

The light blocking layer BM may be located on one surface of the color filter substrate CSUB facing the substrate SUB. The light blocking layer BM may overlap a thin film transistor TFT_1 and the contact hole CT. The light blocking layer BM may include a light blocking pigment such as carbon black or an opaque metal material such as chromium (Cr). Alternatively, the light blocking layer BM may include a photosensitive organic material. The light blocking layer BM may be located on the substrate SUB.

A common electrode 173_2 may be located on one surface of the light blocking layer BM facing the substrate SUB. The common electrode 173 may include a transparent conductive material such as indium tin oxide (ITO), indium zinc oxide (IZO) or indium tin zinc oxide (ITZO) or the like. The common electrode 173 may be entirely formed across the entire surface of the color filter substrate CSUB.

The liquid crystal layer LCL may be located between the substrate SUB and the color filter substrate CSUB. The liquid crystal layer LCL may include the liquid crystals LC having dielectric anisotropy. When a data voltage is applied to the pixel electrode 171_2 and a common voltage is applied to the common electrode 173_2, an electric field may be formed between the pixel electrode 171_2 and the common electrode 173_2. The arrangement of the liquid crystals LC in the liquid crystal layer LCL may be changed according to the electric field between the pixel electrode 171_2 and the common electrode 173_2, and thus the transmittance of light passing through the liquid crystal layer LCL may be controlled.

Specifically, when an electric field is formed between the pixel electrode 171_2 and the common electrode 173_2, the liquid crystals LC may rotate in a specific direction to adjust the phase retardation value of the light passing through the liquid crystal layer LCL. Depending on how much the phase retardation value changes due to the rotation of the liquid crystals LC, the quantity of light, which has passed through the lower polarizing film located on the bottom surface of the substrate SUB, passing the upper polarizing film located on the top surface of the color filter substrate CSUB may change. Therefore, the transmittance of light passing through the liquid crystal layer LCL may be controlled.

As seen in FIGS. 9A, 9B, 10, and 12, the display panel 100 according to one embodiment may be an organic light emitting display panel, a micro light emitting diode display panel, a nano light emitting diode display panel, or a liquid crystal display panel. Alternatively, the display panel 100 according to one embodiment may be an electroluminescent display panel using an electroluminescent element or an electrochromic display panel using an electrochromic element. Hereinafter, for simplicity of description, the description will be mainly on the fact that the display panel 100 according to one embodiment is an organic light emitting display panel.

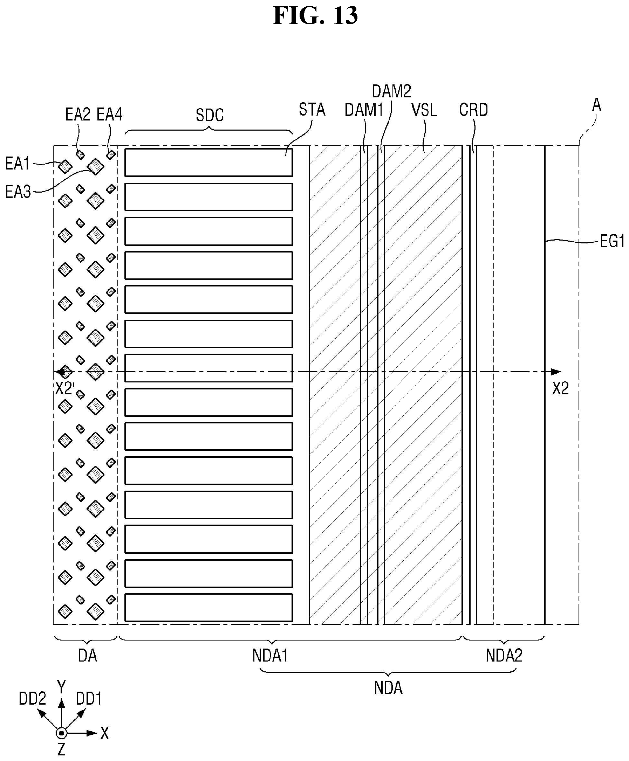

FIG. 13 is a layout view showing in detail an example of area A of FIG. 2. FIG. 13 is a layout view showing the display area DA and the non-display area NDA located on a first side, for example, the right side, of the display panel 100 according to one embodiment.

Referring to FIG. 13, the display area DA may include a plurality of emission areas EA1, EA2, EA3, and EA4. The plurality of emission areas EA1, EA2, EA3, and EA4 may include the first emission area EA1 emitting light of a first color, the second emission area EA2 and the fourth emission area EA4 emitting light of a second color, and the third emission area EA3 emitting light of a third color. For example, light of the first color may be light in a red wavelength band of approximately 600 nm to 750 nm, light of the second color may be light in a green wavelength band of approximately 480 nm to 560 nm, and light of the third color may be light in a blue wavelength band of approximately 370 nm to 460 nm, but the embodiment of the present disclosure is not limited thereto.

Although FIG. 13 illustrates that the second emission area EA2 and the fourth emission area EA4 emit light of the same color, that is, light of the second color, the embodiment of the present disclosure is not limited thereto. The second emission area EA2 and the fourth emission area EA4 may emit light of different colors. For example, the second emission area EA2 may emit light of the second color, and the fourth emission area EA4 may emit light of a fourth color.

In addition, in FIG. 13, although it is illustrated that each of the first emission areas EA1, the second emission areas EA2, the third emission areas EA3, and the fourth emission areas EA4 has a rectangular planar shape, the embodiment of the present disclosure is not limited thereto. Each of the first emission areas EA1, the second emission areas EA2, the third emission areas EA3, and the fourth emission areas EA4 may have a polygonal shape other than a quadrilateral shape, a circular shape, or an elliptical shape in plan view. In addition, the first emission areas EA1, the second emission areas EA2, the third emission areas EA3, and the fourth emission area EA4 may have the same or different shapes from each other. For example, the second emission areas EA2 and the fourth emission areas EA4 have the same size, but the first emission areas EA1 and the third emission areas EA3 may have different sizes and shapes from each other. In addition, each of the first emission areas EA1 and the third emission areas EA3 may have sizes and shapes different from the second emission areas EA2 and the fourth emission area EA4.

In addition, as shown in FIG. 13, the third emission area EA3 may have the largest area, and the second emission area EA2 and the fourth emission area EA4 may have the smallest areas. The size of the second emission area EA2 may be the same as the size of the fourth emission area EA4.

The second emission areas EA2 and the fourth emission areas EA4 may be alternately located in the first direction (X-axis direction). The second emission areas EA2 may be located in the second direction (Y-axis direction). The fourth emission areas EA4 may be located in the second direction (Y-axis direction). Each of the fourth emission areas EA4 may have a long side in a first diagonal direction DD1 and a short side in a second diagonal direction DD2, while each of the second emission areas EA2 may have a long side in the second diagonal direction DD2 and a short side in the first diagonal direction DD1. The first diagonal direction DD1 may refer to a diagonal direction between the first direction (X-axis direction) and the second direction (Y-axis direction), and the second diagonal direction DD2 may be a direction orthogonal to the first diagonal direction DD1.

The first emission areas EA1 and the third emission areas EA3 may be alternately located in the first direction (X-axis direction). The first emission areas EA1 may be located in the second direction (Y-axis direction). The third emission areas EA3 may be located in the second direction (Y-axis direction). Each of the first emission areas EA1 and the third emission areas EA3 may have a square planar shape, but the embodiment of the present disclosure is not limited thereto. In this case, each of the first emission areas EA1 and the third emission areas EA3 may include two sides parallel to each other in the first diagonal direction DD1 and two sides parallel to each other in the second diagonal direction DD2.

The non-display area NDA includes a first non-display area NDA1 and a second non-display area NDA2. The first non-display area NDA1 may be an area in which structures for driving pixels of the display area DA are located. The second non-display area NDA2 may be located outside the first non-display area NDA1. The second non-display area NDA2 may be an edge area of the non-display area NDA. In addition, the second non-display area NDA2 may be an edge area of the display panel 100.

The first non-display area NDA1 may include the scan driving circuit unit SDC, the first power line VSL, the first dam DAM1, and the second dam DAM2.

The scan driving circuit unit SDC may include a plurality of stages STA. The plurality of stages STA may be connected to scan lines SL of the display area DA extending in the first direction (X-axis direction), respectively. That is, the plurality of stages STA may be connected one-to-one to the scan lines SL of the display area DA extending in the first direction (X-axis direction). The plurality of stages STA may sequentially apply scan signals to the plurality of scan lines SL.

The first power line VSL may be located outside the scan driving circuit unit SDC. That is, the first power line VSL may be located closer to a first side edge EG1 of the display panel 100 than the scan driving circuit unit SDC. The first power line VSL may extend in the second direction (Y-axis direction) in the non-display area NDA on the right side of the display panel 100.

The first power line VSL may be electrically connected to the common electrode 173, so that the common electrode 173 may be supplied with the first power voltage from the first power line VSL.

The first dam DAM1 and the second dam DAM2 are structures for preventing the overflow of the encapsulation organic film TFE2 of the encapsulation layer ENC into the first side edge EG1 of the display panel 100. The first dam DAM1 and the second dam DAM2 may extend in the second direction (Y-axis direction) in the non-display area NDA on the right side of the display panel 100. The second dam DAM2 may be located outside the first dam DAM1. The first dam DAM1 may be located closer to the scan driving circuit unit SDC than the second dam DAM2, and the second dam DAM2 may be located closer to the first side edge EG1 of the display panel 100 than the first dam DAM1.

Although FIG. 13 illustrates that the first dam DAM1 and the second dam DAM2 are located on the first power line VSL, the embodiment of the present disclosure is not limited thereto. For example, either one of the first dam DAM1 and the second dam DAM2 may not be located on the first power line VSL. Alternatively, neither the first dam DAM1 nor the second dam DAM2 may be located on the first power line VSL. In this case, the first dam DAM1 and the second dam DAM2 may be located outside the first power line VSL1.

Although FIG. 13 illustrates that the display panel 100 according to one embodiment includes two dams DAM1 and DAM2, the embodiment of the present disclosure is not limited thereto. That is, the display panel 100 according to one embodiment may include three or more dams.

The second non-display area NDA2 may include the crack dam CRD. The crack dam CRD may extend in the second direction (Y-axis direction) in the non-display area NDA at a first side (e.g., right side) of the display panel 100. The width of the crack dam CRD may be approximately 30 µm or less.

FIG. 14 is a layout view showing in detail an example of area B of FIG. 2. FIG. 14 is a layout view showing the non-display area NDA located on a second side, for example, the lower side, of the display panel 100 according to one embodiment.

Referring to FIG. 14, the first non-display area NDA1 may include a plurality of display pads PD and a plurality of pad lines PDL.

The plurality of display pads PD may be electrically connected to the circuit board 300 through a conductive adhesive member such as an anisotropic conductive film and an anisotropic conductive adhesive. Each of the plurality of display pads PD may be connected to the pad line PDL. The pad line PDL may connect the display pad PD to a driving pad connected to the driving circuit 200. A plurality of driving pads may be electrically connected to the driving circuit 200 through a conductive adhesive member such as an anisotropic conductive film and an anisotropic conductive adhesive.

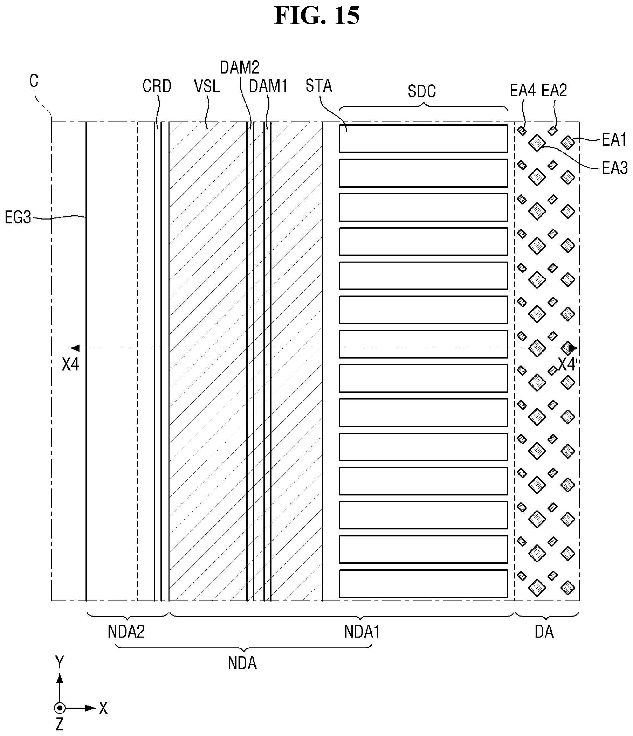

FIG. 15 is a layout view showing in detail an example of area C of FIG. 2. FIG. 15 is a layout view showing the display area DA and the non-display area NDA located on a third side, for example, the left side, of the display panel 100 according to one embodiment.

Area C of FIG. 15 may be substantially identical to area A illustrated in FIG. 13, which is left-right symmetric. For example, area A of FIG. 13 and area C of FIG. 15 may be symmetrical with respect to an imaginary line extending in the second direction (Y-axis direction) passing through the center of the display panel 100. Therefore, a detailed description of FIG. 15 is omitted.

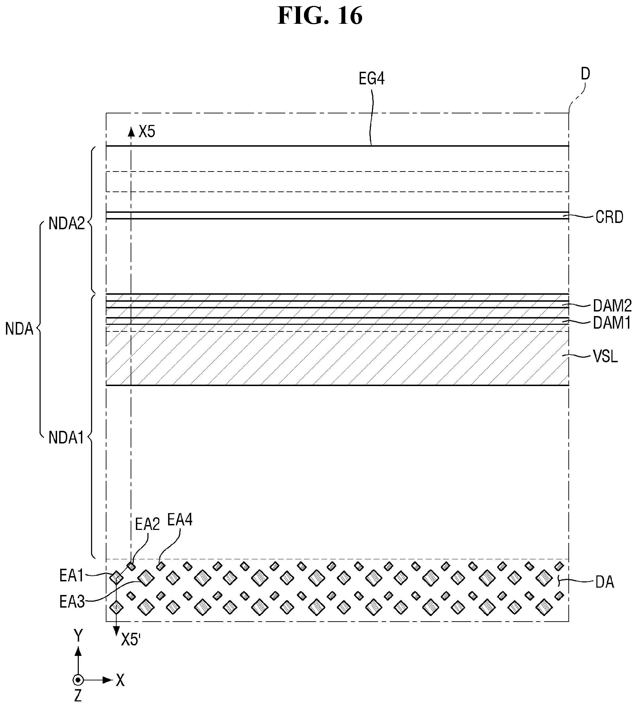

FIG. 16 is a layout view showing in detail an example of area D of FIG. 2. FIG. 16 is a layout view showing the display area DA and the non-display area NDA located on a fourth side, for example, the upper side, of the display panel 100 according to one embodiment.

Referring to FIG. 16, the first non-display area NDA1 may include the first power line VSL, the first dam DAM1, and the second dam DAM2. The first non-display area NDA1 may not include the scan driving circuit unit SDC.

The first power line VSL may extend in the first direction (X-axis direction) in the non-display area NDA on the upper side of the display panel 100. The first power line VSL may be electrically connected to the common electrode 173, so that the common electrode 173 may be supplied with the first power voltage from the first power line VSL.

The first dam DAM1 and the second dam DAM2 may extend in the first direction (X-axis direction) in the non-display area NDA on the upper side of the display panel 100. The second dam DAM2 may be located outside the first dam DAM1. The first dam DAM1 may be located closer to the display area DA than the second dam DAM2, and the second dam DAM2 may be located closer to a fourth side edge EG4 of the display panel 100 than the first dam DAM1.

Although FIG. 16 illustrates that the first dam DAM1 and the second dam DAM2 are located on the first power line VSL, the embodiment of the present disclosure is not limited thereto. For example, either one of the first dam DAM1 and the second dam DAM2 may not be located on the first power line VSL. Alternatively, neither the first dam DAM1 nor the second dam DAM2 may be located on the first power line VSL. In this case, the first dam DAM1 and the second dam DAM2 may be located outside the first power line VSL1.

The second non-display area NDA2 may include the crack dam CRD. The crack dam CRD may be an outermost structure located at the outermost side on the fourth side of the display panel 100, for example, on the upper side. The crack dam CRD may extend in the first direction (X-axis direction) in the non-display area NDA at a fourth side of the display panel 100.

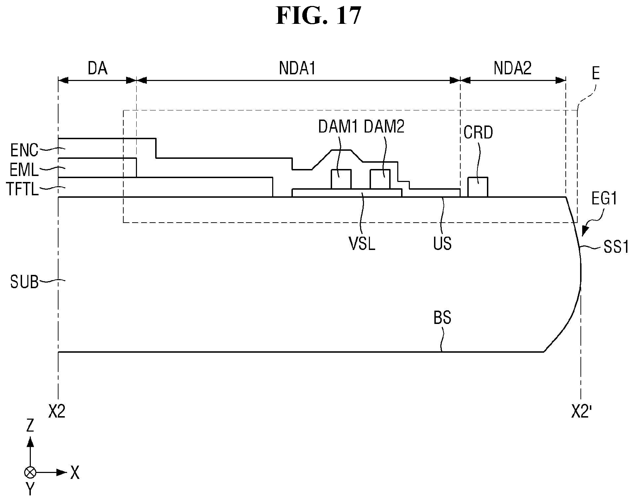

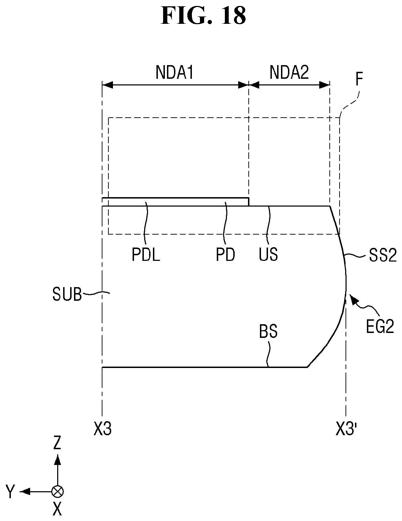

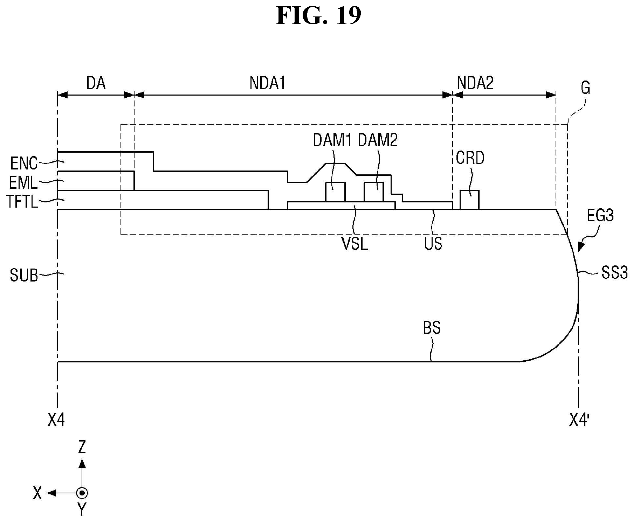

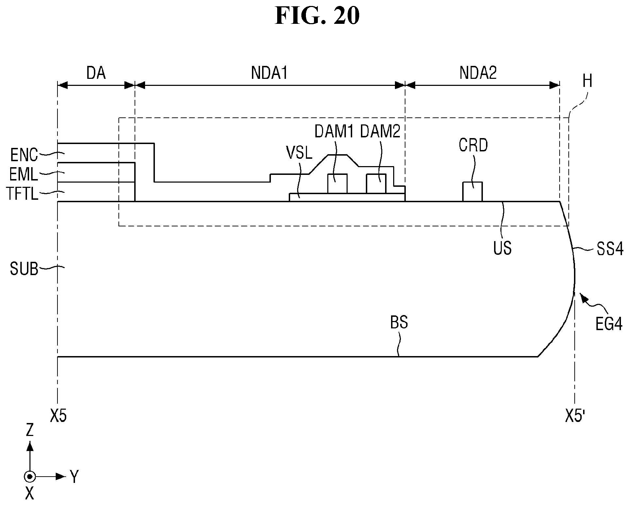

FIG. 17 is a cross-sectional view illustrating an example of a display panel taken along line X2-X2' of FIG. 13. FIG. 18 is a cross-sectional view illustrating an example of a display panel taken along line X3-X3' of FIG. 14. FIG. 19 is a cross-sectional view illustrating an example of a display panel taken along line X4-X4' of FIG. 15. FIG. 20 is a cross-sectional view illustrating an example of the display panel taken along line X5-X5' of FIG. 16.

FIG. 17 shows an example of a cross-section of the first side edge EG1 corresponding to the right edge of the display panel 100, and FIG. 18 shows an example of a cross-section of a second side edge EG2 corresponding to the lower edge of the display panel 100. FIG. 19 shows an example of a cross-section of a third side edge EG3 corresponding to the left edge of the display panel 100, and FIG. 20 shows an example of a cross-section of the fourth side edge EG4 corresponding to the upper edge of a display panel 100.

Referring to FIGS. 17 to 20, the crack dam CRD may be a structure for preventing cracks from occurring in a process of cutting the substrate SUB during the fabricating process of the display device 10. The crack dam CRD may be an outermost structure located at the outermost side at each of the first side edge EG1, third side edge EG3, and fourth side edge EG4 of the display panel 100. The minimum distance from the crack dam CRD to the first side edge EG1 of the display panel 100 may be approximately 130 µm or less. In addition, the minimum distance from the crack dam CRD to the third side edge EG3 of the display panel 100 may be approximately 130 µm or less. In addition, the minimum distance from the crack dam CRD to the fourth side edge EG4 of the display panel 100 may be approximately 130 µm or less.

The display pad PD may be the outermost structure located at the outermost side at the second side edge EG2 of the display panel 100. The minimum distance from the display pad PD to the second side edge EG2 of the display panel 100 may be approximately 80 µm or less.

When the substrate SUB of the display panel 100 is cut by spraying an etchant after irradiating a laser beam during the fabricating process of the display panel 100, at least partial areas of a first side surface SS1, a second side surface SS2, a third side surface SS3, and a fourth side surface SS4 of the display panel 100 may be etched by the etchant. Accordingly, the roughness of at least partial areas of the first side surface SS1, the second side surface SS2, the third side surface SS3, and the fourth side surface SS4 of the display panel 100 may be less than the roughness of the remaining area unetched by the etchant.

At least a partial area of the first side surface SS1 of the display panel 100, which is etched by the etchant, may be a lower area of the first side surface SS1. The length of at least a partial area of the first side surface SS1 of the display panel 100, which is etched by the etchant, may be 0.5 to 0.8 times the total length of the first side surface SS1.

The first power line VSL may be a first outer structure located in the first non-display area NDA1. The first outer structure may be located farther from the first side edge EG1, the third side edge EG3, and the fourth side edge EG4 of the display panel 100 than the outermost structure. That is, the distance from the first power line VSL, which is the first outer structure, to the first side edge EG1 of the display panel 100 may be greater than the distance from the crack dam CRD, which is the outermost structure, to the first side edge EG1 of the display panel 100. Further, the distance from the first power line VSL, which is the first outer structure, to the third side edge EG3 of the display panel 100 may be greater than the distance from the crack dam CRD, which is the outermost structure, to the third side edge EG3 of the display panel 100. Further, the distance from the first power line VSL, which is the first outer structure, to the fourth side edge EG4 of the display panel 100 may be greater than the distance from the crack dam CRD, which is the outermost structure, to the fourth side edge EG4 of the display panel 100.

The distance from the first power line VSL to the crack dam CRD at the first side edge EG1 and the third side edge EG3 of the display panel 100 may be less than the distance from the first power line VSL to the crack dam CRD at the fourth side edge EG4 of the display panel 100. Therefore, the distance from the first power line VSL to the first side edge EG1 of the display panel 100 may be less than the distance from the first power line VSL to the fourth side edge EG4 of the display panel 100. In addition, the distance from the first power line VSL to the third side edge EG3 of the display panel 100 may be less than the distance from the first power line VSL to the fourth side edge EG4 of the display panel 100. For example, the distance from the first power line VSL to the first side edge EG1 of the display panel 100 and the distance from the first power line VSL to the third side edge EG3 of the display panel 100 may be approximately 160 µm or less. In contrast, the distance from the first power line VSL to the fourth side edge EG4 of the display panel 100 may be approximately 445 µm or less.

The second dam DAM2 may be a second outer structure located in the first non-display area NDA1. The second outer structure may be located farther from the first side edge EG1, the third side edge EG3, and the fourth side edge EG4 of the display panel 100 than the first outer structure. That is, the distance from the second dam DAM2, which is the second outer structure, to the first side edge EG1 of the display panel 100 may be greater than the distance from the first power line VSL, which is the first outer structure, to the first side edge EG1 of the display panel 100. Further, the distance from the second dam DAM2 to the third side edge EG3 of the display panel 100 may be greater than the distance from the first power line VSL to the third side edge EG3 of the display panel 100. Further, the distance from the second dam DAM2 to the fourth side edge EG4 of the display panel 100 may be greater than the distance from the first power line VSL to the fourth side edge EG4 of the display panel 100.

The distance from the second dam DAM2 to the crack dam CRD at the first side edge EG1 or the third side edge EG3 of the display panel 100 may be less than the distance from the second dam DAM2 to the crack dam CRD at the fourth side edge EG4 of the display panel 100. Therefore, the distance from the second dam DAM2 to the first side edge EG1 or the third side edge EG3 of the display panel 100 may be less than the distance from the second dam DAM2 to the fourth side edge EG4 of the display panel 100. For example, the distance from the second dam DAM2 to the first side edge EG1 or the third side edge EG3 of the display panel 100 may be approximately 220 µm or less. In addition, the distance from the second dam DAM2 to the fourth side edge EG4 of the display panel 100 may be approximately 445 µm or less.

In FIGS. 17 to 20, the crack dam CRD is illustrated as the outermost structure of the first side edge EG1, the third side edge EG3, and the fourth side edge EG4 of the display panel 100, and the display pad PD is illustrated as the outermost structure of the second side edge EG2 of the display panel 100, but the embodiment of the present disclosure is not limited thereto. The outermost structure may be a structure located most adjacent to the first side edge EG1, the second side edge EG2, the third side edge EG3, and the fourth side edge EG4 of the display panel 100, and may be a structure for driving the display panel 100 or a structure for improving the function of the display panel 100. The outermost structure may be a structure located away from the first side edge EG1, second side edge EG2, third side edge EG3, and fourth side edge EG4 of the display panel 100. That is, the outermost structure is not a structure located at the first side edge EG1, the second side edge EG2, the third side edge EG3, and the fourth side edge EG4 of the display panel 100.

When the crack dam CRD is omitted or deleted, the outermost structure may be a power line (e.g., the first power line VSL) for driving the display panel 100. Alternatively, when the crack dam CRD is omitted or deleted, the outermost structure may be a signal line. The signal line may be a signal line for driving the scan driving circuit unit SDC. Alternatively, when the crack dam CRD is omitted or deleted, the outermost structure may be a line or an organic film structure (e.g., the first dam DAM1 and the second dam DAM2) for improving the function of the display panel 100.

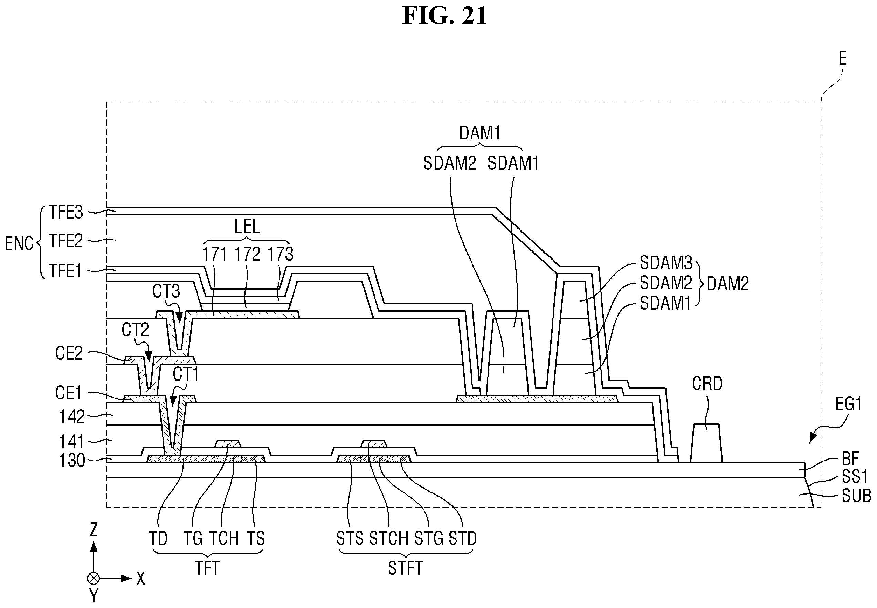

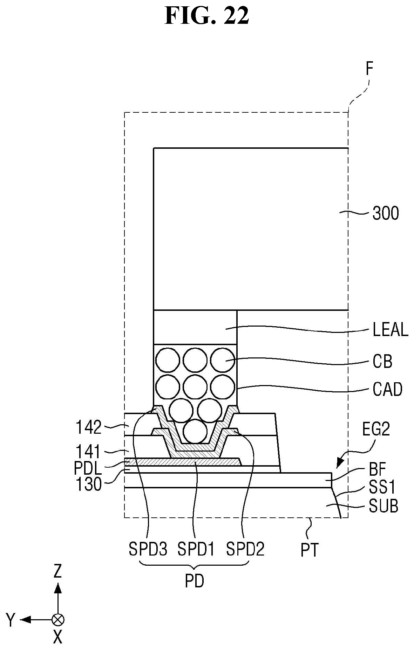

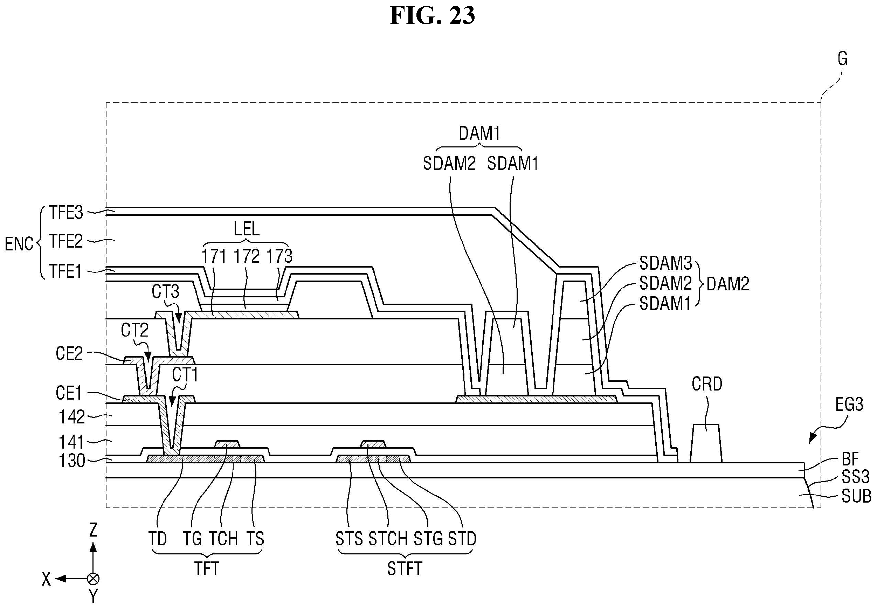

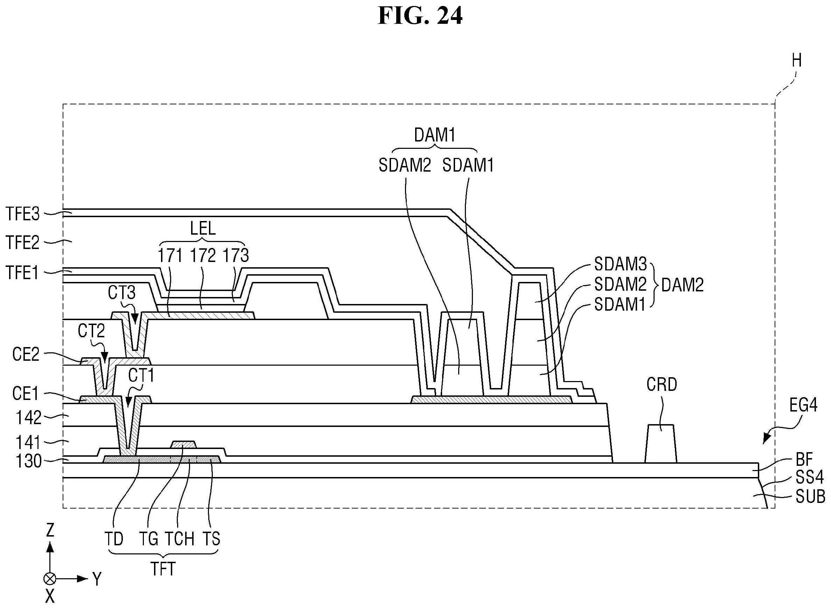

FIG. 21 is a cross-sectional view specifically illustrating an example of area E of FIG. 17. FIG. 22 is a cross-sectional view specifically illustrating an example of area F of FIG. 18. FIG. 23 is a cross-sectional view specifically illustrating an example of area G of FIG. 19. FIG. 24 is a cross-sectional view specifically illustrating an example of area H of FIG. 20.

Referring to FIG. 9A, 9B and FIG. 21 through 24, the crack dam CRD may include the same material as the first organic film 160 and may be located on the same layer. The crack dam CRD may be located on the second interlayer insulating film 142. The crack dam CRD may be formed as an organic film such as acrylic resin, epoxy resin, phenolic resin, polyamide resin, polyimide resin, or the like.

Although FIG. 21 illustrates that the crack dam CRD includes one organic layer, the embodiment of the present disclosure is not limited thereto. For example, the crack dam CRD may further include another organic film including the same material as the second organic film 180. Alternatively, the crack dam CRD may further include another organic film including the same material as the bank 190. Alternatively, the crack dam CRD may further include another organic film including the same material as the spacer 191.

The first power line VSL may include the same material as the first data metal layer including the first connection electrode CE1 and the data lines and may be located on the same layer. The first power line VSL may be located on the second interlayer insulating film 142. The first power line VSL may be formed as a single layer or multiple layers including any one of molybdenum (Mo), aluminum (Al), chromium (Cr), gold (Au), titanium (Ti), nickel (Ni), neodymium (Nd), and copper (Cu) or an alloy thereof.

The first dam DAM1 and the second dam DAM2 may be located on the first power line VSL. The first dam DAM1 may include a first sub-dam SDAM1 and a second sub-dam SDAM2, and the second dam DAM2 may include a first sub-dam SDAM1, a second sub-dam SDAM2, and a third sub-dam SDAM3. The first sub-dam SDAM1 and the first organic film 160 may include the same material, and may be located on the same layer. The second sub-dam SDAM2 and the second organic film 180 may include the same material, and may be located on the same layer. The third sub-dam SDAM3 may include the same material as the bank 190 and may be located on the same layer.

The height of the first dam DAM1 may be lower than the height of the second dam DAM2, but the embodiment of the present disclosure is not limited thereto. The height of the first dam DAM1 may be substantially the same as the height of the second dam DAM2 or may be higher than the height of the second dam DAM2.

The common electrode 173 may be connected to the first power line VSL exposed without being covered by the first organic film 160, the second organic film 180, and the first dam DAM1. Accordingly, the common electrode 173 may be supplied with the first power voltage of the first power line VSL.

The first encapsulation inorganic film TFE1 may cover the first dam DAM1 and the second dam DAM2 in the non-display area NDA of the display panel 100. The encapsulation organic film TFE2 may be located to cover the top surface of the first dam DAM1 without covering the top surface of the second dam DAM2. However, the embodiment of the present disclosure is not limited thereto. The encapsulation organic film TFE2 may not cover both the top surface of the first dam DAM1 and the top surface of the second dam DAM2. The encapsulation organic film TFE2 may not overflow to the first side edge EG1, the third side edge EG3, and the fourth side edge EG4 of the display panel 100 due to the first dam DAM1 and the second dam DAM2, and may not overflow to the display pads PD of the display panel 100. The second encapsulation inorganic film TFE3 may cover the first dam DAM1 and the second dam DAM2 in the non-display area NDA of the display panel 100.

In an area adjacent to the second dam DAM2, an inorganic encapsulation area in which the first encapsulation inorganic film TFE1 and the second encapsulation inorganic film TFE3 are in contact with each other may be formed. The inorganic encapsulation area may be located to surround the second dam DAM2.

Further, FIGS. 21 and 23 illustrate a scan thin film transistor STFT of the scan driving circuit unit SDC. Since the scan thin film transistor STFT is substantially the same as the thin film transistor TFT described in conjunction with FIGS. 9A and 9B, a description of the scan thin film transistor STFT will be omitted.

The display pad PD may include a first sub-pad SPD1, a second sub-pad SPD2, and a third sub-pad SPD3, as shown in FIG. 22.

The first sub-pad SPD1 may include the same material as the first gate metal layer including the gate electrode TG, the first capacitor electrode CAE1 of the capacitor Cst, and scan lines, and may be located on the same layer as the first gate metal layer. The first sub-pad SPD1 may be located on the gate insulating film 130. The first sub-pad SPD1 may be formed as a single layer or multiple layers including any one of molybdenum (Mo), aluminum (Al), chromium (Cr), gold (Au), titanium (Ti), nickel (Ni), neodymium (Nd) and copper (Cu) or an alloy thereof.

The second sub-pad SPD2 may include the same material as the second gate metal layer including the second capacitor electrode CAE2 and may be located on the same layer. The second sub-pad SPD2 may be located on the first interlayer insulating film 141. The second sub-pad SPD2 may be formed as a single layer or multiple layers including any one of molybdenum (Mo), aluminum (Al), chromium (Cr), gold (Au), titanium (Ti), nickel (Ni), neodymium (Nd) and copper (Cu) or an alloy thereof.

The third sub-pad SPD3 may include the same material as the first data metal layer including the first connection electrode CE1 and the data lines and may be located on the same layer. The third sub-pad SPD3 may be located on the second interlayer insulating film 142. The third sub-pad SPD3 may be formed as a single layer or multiple layers including any one of molybdenum (Mo), aluminum (Al), chromium (Cr), gold (Au), titanium (Ti), nickel (Ni), neodymium (Nd) and copper (Cu) or an alloy thereof.

The third sub-pad SPD3 may be electrically connected to a lead line LEAL of the circuit board 300 through a conductive adhesive member CAD, such as an anisotropic conductive film or an anisotropic conductive adhesive.

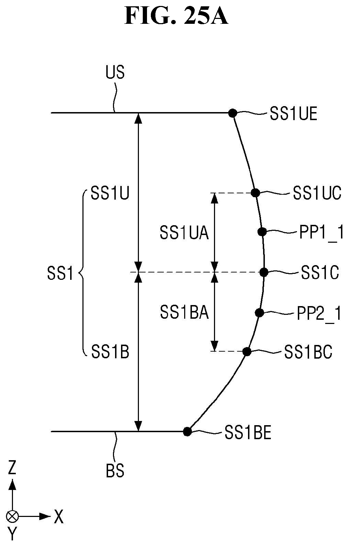

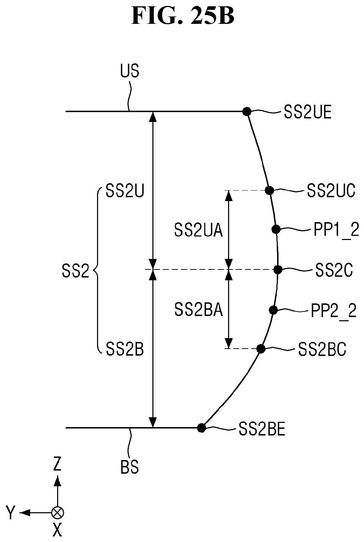

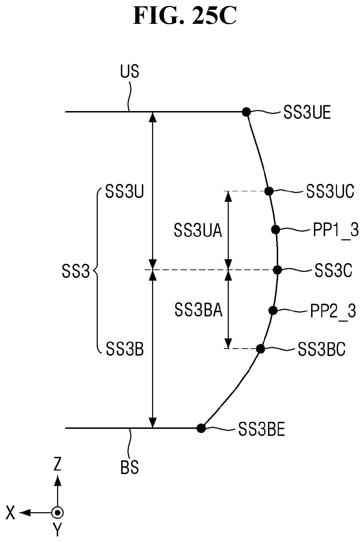

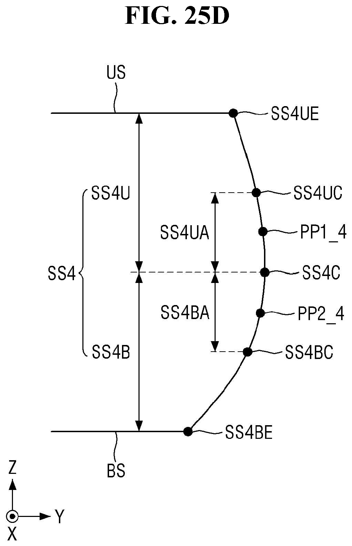

FIGS. 25A to 25D are enlarged cross-sectional views showing examples of the first to fourth side surfaces of the substrate in FIGS. 17 to 20. FIG. 25A shows a cross-section of the first side surface SS1, FIG. 25B shows a cross-section of the second side surface SS2, FIG. 25C shows a cross-section of the third side surface SS3, and FIG. 25D shows a cross-section of the fourth side surface SS4.

Referring to FIG. 25A, the first side surface SS1 may have a curved shape with a changing radius of curvature. The curved shape of an upper portion SS1U (e.g., first upper portion) of the first side surface SS1 and the curved shape of a lower portion SS1B (e.g., first lower portion) of the first side surface SS1 may be different. The upper portion SS1U of the first side surface SS1 refers to an area located above a center SS1C (e.g., first center) of the first side surface SS1. The lower portion SS1B of the first side surface SS1 refers to an area located below the center SS1C of the first side surface SS1.

The radius of curvature of the upper portion SS1U of the first side surface SS1 and the radius of curvature of the lower portion SS1B of the first side surface SS1 may be different. For example, the radius of curvature of the lower portion SS1B of the first side surface SS1 may be less than the radius of curvature of the upper portion SS1U of the first side surface SS1.

The radius of curvature of the upper portion SS1U of the first side surface SS1 may be defined as the radius of curvature of a curve passing through the center SS1C of the first side surface SS1, an upper end SS1UE of the first side surface SS1, and an upper center SS1UC (e.g., first upper center) of the first side surface SS1. The radius of curvature of the lower portion SS1B of the first side surface SS1 may be defined as the radius of curvature of a curve passing through the center SS1C of the first side surface SS1, a lower end SS1BE of the first side surface SS1, and a lower center SS1BC (e.g., first lower center) of the first side surface SS1.

In addition, the radius of curvature of the central area of the first side surface SS1 may be different from the radius of curvature of the upper portion SS1U of the first side surface SS1 and the radius of curvature of the lower portion SS1B of the first side surface SS1. The radius of curvature of the central area of the first side surface SS1 may be defined as the radius of curvature of a curve passing through the center SS1C of the first side surface SS1, the upper center SS1UC of the first side surface SS1, and the lower center SS1BC of the first side surface SS1.

In addition, the difference between the radius of curvature of an upper central area SS1UA of the first side surface SS1 and the radius of curvature of a lower central area SS1BA of the first side surface SS1 may be less than the difference between the radius of curvature of the upper portion SS1U of the first side surface SS1 and the radius of curvature of the lower portion SS1B of the first side surface SS1. The radius of curvature of the upper central area SS1UA of the first side surface SS1 and the radius of curvature of the lower central area SS1BA of the first side surface SS1 may be substantially the same. Alternatively, the difference between the radius of curvature of the upper central area SS1UA of the first side surface SS1 and the radius of curvature of the lower central area SS1BA of the first side surface SS1 may be 30 µm or less.

The radius of curvature of the upper central area SS1UA of the first side surface SS1 may be defined as the radius of curvature of a curve passing through the center SS1C of the first side surface SS1, the upper center SS1UC of the first side surface SS1, and a first point PP1_1 of the first side surface SS1. The radius of curvature of the lower central area SS1BA of the first side surface SS1 may be defined as the radius of curvature of a curve passing through the center SS1C of the first side surface SS1, the lower center SS1BC of the first side surface SS1, and a second point PP2_1 of the first side surface SS1. The first point PP1_1 of the first side surface SS1 may be defined as an intermediate point between the center SS1C of the first side surface SS1 and the upper center SS1UC of the first side surface SS1. The second point PP2_1 of the first side surface SS1 may be defined as an intermediate point between the center SS1C of the first side surface SS1 and the lower center SS1BC of the first side surface SS1.

Referring to FIG. 25B, the second side surface SS2 may have a curved shape with a changing radius of curvature. The curved shape of an upper portion SS2U (e.g., second upper portion) of the second side surface SS2 and the curved shape of a lower portion SS2B (e.g., second lower portion) of the second side surface SS2 may be different. The upper portion SS2U of the second side surface SS2 refers to an area located above a center SS2C (e.g., second center) of the second side surface SS2. The lower portion SS2B of the second side surface SS2 refers to an area located below the center SS2C of the second side surface SS2.

The radius of curvature of the upper portion SS2U of the second side surface SS2 and the radius of curvature of the lower portion SS2B of the second side surface SS2 may be different. For example, the radius of curvature of the lower portion SS2B of the second side surface SS2 may be less than the radius of curvature of the upper portion SS2U of the second side surface SS2.

The radius of curvature of the upper portion SS2U of the second side surface SS2 may be defined as the radius of curvature of a curve passing through the center SS2C of the second side surface SS2, an upper end SS2UE of the second side surface SS2, and an upper center SS2UC (e.g., second upper center) of the second side surface SS2. The radius of curvature of the lower portion SS2B of the second side surface SS2 may be defined as the radius of curvature of a curve passing through the center SS2C of the second side surface SS2, a lower end SS2BE of the second side surface SS2, and a lower center SS2BC (e.g., second lower center) of the second side surface SS2.

In addition, the radius of curvature of the central area of the second side surface SS2 may be different from the radius of curvature of the upper portion SS2U of the second side surface SS2 and the radius of curvature of the lower portion SS2B of the second side surface SS2. The radius of curvature of the central area of the second side surface SS2 may be defined as the radius of curvature of a curve passing through the center SS2C of the second side surface SS2, the upper center SS2UC of the second side surface SS2, and the lower center SS2BC of the second side surface SS2.

In addition, the difference between the radius of curvature of an upper central area SS2UA of the second side surface SS2 and the radius of curvature of a lower central area SS2BA of the second side surface SS2 may be less than the difference between the radius of curvature of the upper portion SS2U of the second side surface SS2 and the radius of curvature of the lower portion SS2B of the second side surface SS2. The radius of curvature of the upper central area SS2UA of the second side surface SS2 and the radius of curvature of the lower central area SS2BA of the second side surface SS2 may be substantially the same. Alternatively, the difference between the radius of curvature of the upper central area SS2UA of the second side surface SS2 and the radius of curvature of the lower central area SS2BA of the second side surface SS2 may be 30 µm or less.

The radius of curvature of the upper central area SS2UA of the second side surface SS2 may be defined as the radius of curvature of a curve passing through the center SS2C of the second side surface SS2, the upper center SS2UC of the second side surface SS2, and a first point PP1_2 of the second side surface SS2. The radius of curvature of the lower central area SS2BA of the second side surface SS2 may be defined as the radius of curvature of a curve passing through the center SS2C of the second side surface SS2, the lower center SS2BC of the second side surface SS2, and a second point PP2_2 of the second side surface SS2. The first point PP1_2 of the second side surface SS2 may be defined as an intermediate point between the center SS2C of the second side surface SS2 and the upper center SS2UC of the second side surface SS2. The second point PP2_2 of the second side surface SS2 may be defined as an intermediate point between the center SS2C of the second side surface SS2 and the lower center SS2BC of the second side surface SS2.

Referring to FIG. 25C, the third side surface SS3 may have a curved shape with a changing radius of curvature. The curved shape of an upper portion SS3U (e.g., third upper portion) of the third side surface SS3 and the curved shape of a lower portion SS3B (e.g., third lower portion) of the third side surface SS3 may be different. The upper portion SS3U of the third side surface SS3 refers to an area located above a center SS3C (e.g., third center) of the third side surface SS3. The lower portion SS3B of the third side surface SS3B refers to an area located below the center SS3C of the third side surface SS3.

The radius of curvature of the upper portion SS3U of the third side surface SS3 and the radius of curvature of the lower portion SS3B of the third side surface SS3 may be different. For example, the radius of curvature of the lower portion SS3B of the third side surface SS3 may be less than the radius of curvature of the upper portion SS3U of the third side surface SS3.

The radius of curvature of the upper portion SS3U of the third side surface SS3 may be defined as the radius of curvature of a curve passing through the center SS3C of the third side surface SS3, an upper end SS3UE of the third side surface SS3, and an upper center SS3UC (e.g., third upper center) of the third side surface SS3. The radius of curvature of the lower portion SS3B of the third side surface SS3 may be defined as the radius of curvature of a curve passing through the center SS3C of the third side surface SS3, a lower end SS3BE of the third side surface SS3, and a lower center SS3BC (e.g., third lower center) of the third side surface SS3.

In addition, the radius of curvature of the central area of the third side surface SS3 may be different from the radius of curvature of the upper portion SS3U of the third side surface SS3 and the radius of curvature of the lower portion SS3B of the third side surface SS3. The radius of curvature of the central area of the third side surface SS3 may be defined as the radius of curvature of a curve passing through the center SS3C of the third side surface SS3, the upper center SS3UC of the third side surface SS3, and the lower center SS3BC of the third side surface SS3.

In addition, the difference between the radius of curvature of an upper central area SS3UA of the third side surface SS3 and the radius of curvature of a lower central area SS3BA of the third side surface SS3 may be less than the difference between the radius of curvature of the upper portion SS3U of the third side surface SS3 and the radius of curvature of the lower portion SS3B of the third side surface SS3. The radius of curvature of the upper central area SS3UA of the third side surface SS3 and the radius of curvature of the lower central area SS3BA of the third side surface SS3 may be substantially the same. Alternatively, the difference between the radius of curvature of the upper central area SS3UA of the third side surface SS3 and the radius of curvature of the lower central area SS3BA of the third side surface SS3 may be 30 µm or less.

The radius of curvature of the upper central area SS3UA of the third side surface SS3 may be defined as the radius of curvature of a curve passing through the center SS3C of the third side surface SS3, the upper center SS3UC of the third side surface SS3, and a first point PP1_3 of the third side surface SS3. The radius of curvature of the lower central area SS3BA of the third side surface SS3 may be defined as the radius of curvature of a curve passing through the center SS3C of the third side surface SS3, the lower center SS3BC of the third side surface SS3, and a second point PP2_3 of the third side surface SS3. The first point PP1_3 of the third side surface SS3 may be defined as an intermediate point between the center SS3C of the third side surface SS3 and the upper center SS3UC of the third side surface SS3. The second point PP2_3 of the third side surface SS3 may be defined as an intermediate point between the center SS3C of the third side surface SS3 and the lower center SS3BC of the third side surface SS3.

Referring to FIG. 25D, the fourth side surface SS4 may have a curved shape with a changing radius of curvature. The curved shape of an upper portion SS4U (e.g., fourth upper portion) of the fourth side surface SS4 and the curved shape of a lower portion SS4B (e.g., fourth lower portion) of the fourth side surface SS4 may be different. The upper portion SS4U of the fourth side surface SS4 refers to an area located above a center SS4C (e.g., fourth center) of the fourth side surface SS4. The lower portion SS4 of the fourth side surface SS4B refers to an area located below the center SS4C of the fourth side surface SS4.

The radius of curvature of the upper portion SS4U of the fourth side surface SS4 and the radius of curvature of the lower portion SS4B of the fourth side surface SS4 may be different. For example, the radius of curvature of the lower portion SS4B of the fourth side surface SS4 may be less than the radius of curvature of the upper portion SS4U of the fourth side surface SS4.

The radius of curvature of the upper portion SS4U of the fourth side surface SS4 may be defined as the radius of curvature of a curve passing through the center SS4C of the fourth side surface SS4, an upper end SS4UE of the fourth side surface SS4, and an upper center SS4UC (e.g., fourth upper center) of the fourth side surface SS4. The radius of curvature of the lower portion SS4B of the fourth side surface SS4 may be defined as the radius of curvature of a curve passing through the center SS4C of the fourth side surface SS4, a lower end SS4BE of the fourth side surface SS4, and a lower center SS4BC (e.g., fourth lower center) of the fourth side surface SS4.

In addition, the radius of curvature of the central area of the fourth side surface SS4 may be different from the radius of curvature of the upper portion SS4U of the fourth side surface SS4 and the radius of curvature of the lower portion SS4B of the fourth side surface SS4. The radius of curvature of the central area of the fourth side surface SS4 may be defined as the radius of curvature of a curve passing through the center SS4C of the fourth side surface SS4, the upper center SS4UC of the fourth side surface SS4, and the lower center SS4BC of the fourth side surface SS4.

In addition, the difference between the radius of curvature of an upper central area SS4UA of the fourth side surface SS4 and the radius of curvature of a lower central area SS4BA of the fourth side surface SS4 may be less than the difference between the radius of curvature of the upper portion SS4U of the fourth side surface SS4 and the radius of curvature of the lower portion SS4B of the fourth side surface SS4. The radius of curvature of the upper central area SS4UA of the fourth side surface SS4 and the radius of curvature of the lower central area SS4BA of the fourth side surface SS4 may be substantially the same. Alternatively, the difference between the radius of curvature of the upper central area SS4UA of the fourth side surface SS4 and the radius of curvature of the lower central area SS4BA of the fourth side surface SS4 may be 30 µm or less.

The radius of curvature of the upper central area SS4UA of the fourth side surface SS4 may be defined as the radius of curvature of a curve passing through the center SS4C of the fourth side surface SS4, the upper center SS4UC of the fourth side surface SS4, and a first point PP1_4 of the fourth side surface SS4. The radius of curvature of the lower central area SS4BA of the fourth side surface SS4 may be defined as the radius of curvature of a curve passing through the center SS4C of the fourth side surface SS4, the lower center SS4BC of the fourth side surface SS4, and a second point PP2_4 of the fourth side surface SS4. The first point PP1_4 of the fourth side surface SS4 may be defined as an intermediate point between the center SS4C of the fourth side surface SS4 and the upper center SS4UC of the fourth side surface SS4. The second point PP2_4 of the fourth side surface SS4 may be defined as an intermediate point between the center SS4C of the fourth side surface SS4 and the lower center SS4BC of the fourth side surface SS4.

Referring to FIGS. 25A to 25D, the radius of curvature of the upper portion SS1U of the first side surface SS1, the radius of curvature of the upper portion SS2U of the second side surface SS2, the radius of curvature of the upper portion SS3U of the third side surface SS3, and the radius of curvature of the upper portion SS4U of the fourth side surface SS4 may be similar to each other. For example, the radius of curvature of the upper portion SS1U of the first side surface SS1, the radius of curvature of the upper portion SS2U of the second side surface SS2, the radius of curvature of the upper portion SS3U of the third side surface SS3, and the radius of curvature of the upper portion SS4U of the fourth side surface SS4 may be 150 µm to 350 µm.

The difference between the radius of curvature of the upper portion SS1U of the first side surface SS1 and the radius of curvature of the upper portion SS2U of the second side surface SS2 may be less than approximately 30 µm. The difference between the radius of curvature of the upper portion SS1U of the first side surface SS1 and the radius of curvature of the upper portion SS3U of the third side surface SS3 may be less than approximately 30 µm. The difference between the radius of curvature of the upper portion SS1U of the first side surface SS1 and the radius of curvature of the upper portion SS4U of the fourth side surface SS4 may be less than approximately 30 µm. The difference between the radius of curvature of the upper portion SS2U of the second side surface SS2 and the radius of curvature of the upper portion SS3U of the third side surface SS3 may be less than approximately 30 µm. The difference between the radius of curvature of the upper portion SS2U of the second side surface SS2 and the radius of curvature of the upper portion SS4U of the fourth side surface SS4 may be less than approximately 30 µm. The difference between the radius of curvature of the upper portion SS3U of the third side surface SS3 and the radius of curvature of the upper portion SS4U of the fourth side surface SS4 may be less than approximately 30 µm.

As shown in FIGS. 25A to 25D, the difference in radius of curvature between the side surfaces SS1, SS2, SS3, and SS4 of the substrate SUB of the display panel 100 may be negligible. Accordingly, mechanical strength may be uniformly maintained according to the positions of the side surfaces SS1, SS2, SS3, and SS4 of the substrate SUB of the display panel 100.

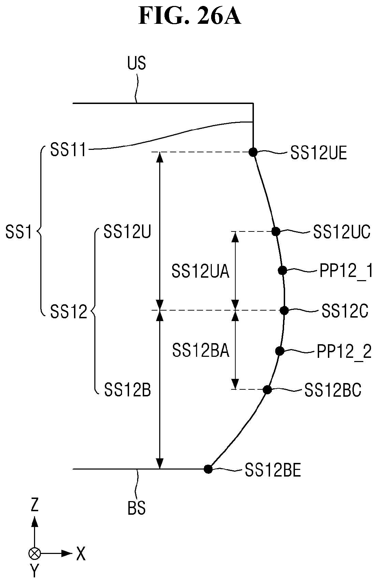

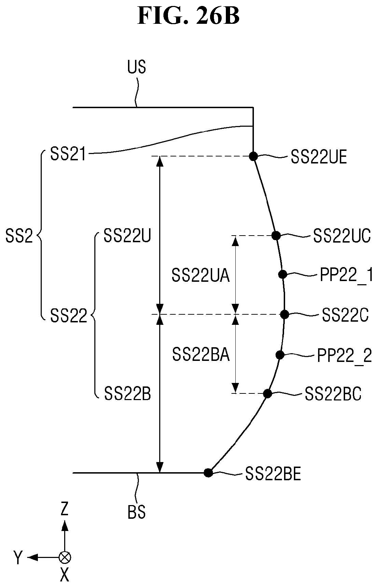

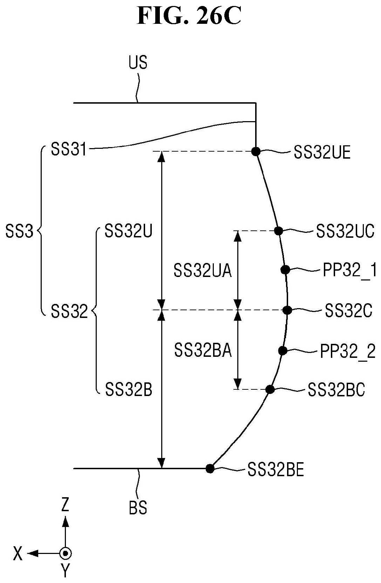

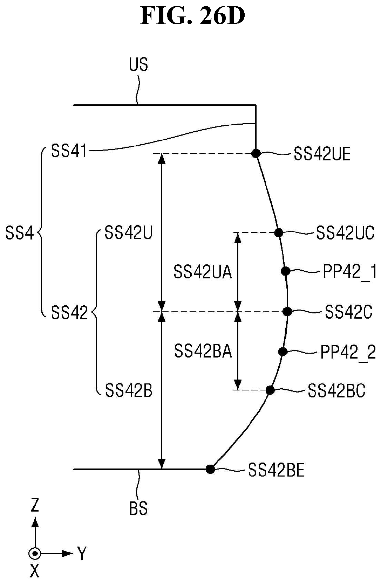

FIGS. 26A to 26D are enlarged cross-sectional views showing yet other examples of the first to fourth side surfaces of the substrate in FIGS. 17 to 20. FIG. 26A shows a cross-section of the first side surface SS1, FIG. 26B shows a cross-section of the second side surface SS2, FIG. 26C shows a cross-section of the third side surface SS3, and FIG. 26D shows a cross-section of the fourth side surface SS4.

Referring to FIG. 26A, the first side surface SS1 may have a first sub-side surface SS11 having a planar shape or a curved shape and a second sub-side surface SS12 having a curved shape with a changing radius of curvature. The length of the first sub-side surface SS11 may be less than the length of the second sub-side surface SS12.

The first sub-side surface SS11 may be connected to a top surface US, and the second sub-side surface SS12 may be connected to a bottom surface BS. The angle between the first sub-side surface SS11 and the top surface US may be a right angle or an obtuse angle close to a right angle.

The curved shape of an upper portion SS12U of the second sub-side surface SS12 and the curved shape of a lower portion SS12B of the second sub-side surface SS12 may be different. The upper portion SS12U of the second sub-side surface SS12 refers to an area located above a center SS12C of the second sub-side surface SS12. The lower portion SS12B of the second sub-side surface SS12 refers to an area located below the center SS12C of the second sub-side surface SS12.

The radius of curvature of the upper portion SS12U of the second sub-side surface SS12 and the radius of curvature of the lower portion SS12B of the second sub-side surface SS12 may be different. For example, the radius of curvature of the lower portion SS12B of the second sub-side surface SS12 may be less than the radius of curvature of the upper portion SS12U of the second sub-side surface SS12.

The radius of curvature of the upper portion SS12U of the second sub-side surface SS12 may be defined as the radius of curvature of a curve passing through the center SS12C of the second sub-side surface SS12, an upper end SS12UE of the second sub-side surface SS12, and an upper center SS12UC of the second sub-side surface SS12. The radius of curvature of the lower portion SS12B of the second sub-side surface SS12 may be defined as the radius of curvature of a curve passing through the center SS12C of the second sub-side surface SS12, a lower end SS12BE of the second sub-side surface SS12, and a lower center SS12BC of the second sub-side surface SS12.

In addition, the radius of curvature of the central area of the second sub-side surface SS12 may be different from the radius of curvature of the upper portion SS12U of the second sub-side surface SS12 and the radius of curvature of the lower portion SS12B of the second sub-side surface SS12. The radius of curvature of the central area of the second sub-side surface SS12 may be defined as the radius of curvature of a curve passing through the center SS12C of the second sub-side surface SS12, the upper center SS12UC of the second sub-side surface SS12, and the lower center SS12BC of the second sub-side surface SS12.

In addition, the difference between the radius of curvature of an upper central area SS12UA of the second sub-side surface SS12 and the radius of curvature of a lower central area SS12BA of the second sub-side surface SS12 may be less than the difference between the radius of curvature of the upper portion SS12U of the second sub-side surface SS12 and the radius of curvature of the lower portion SS12B of the second sub-side surface SS12. The radius of curvature of the upper central area SS12UA of the second sub-side surface SS12 and the radius of curvature of the lower central area SS12BA of the second sub-side surface SS12 may be substantially the same. Alternatively, the difference between the radius of curvature of the upper central area SS12UA of the second sub-side surface SS12 and the radius of curvature of the lower central area SS12BA of the second sub-side surface SS12 may be 30 µm or less.

The radius of curvature of the upper central area SS12UA of the second sub-side surface SS12 may be defined as the radius of curvature of a curve passing through the center SS12C of the second sub-side surface SS12, the upper center SS12UC of the second sub-side surface SS12, and a first point PP12_1 of the second sub-side surface SS12. The radius of curvature of the lower central area SS12BA of the second sub-side surface SS12 may be defined as the radius of curvature of a curve passing through the center SS12C of the second sub-side surface SS12, the lower center SS12BC of the second sub-side surface SS12, and a second point PP12_2 of the second sub-side surface SS12. The first point PP12_1 of the second sub-side surface SS12 may be defined as an intermediate point between the center SS12C of the second sub-side surface SS12 and the upper center SS12UC of the second sub-side surface SS12. The second point PP12_2 of the second sub-side surface SS12 may be defined as an intermediate point between the center SS12C of the second sub-side surface SS12 and the lower center SS12BC of the second sub-side surface SS12.

Referring to FIG. 26B, the second side surface SS2 may have a third sub-side surface SS21 having a planar shape or a curved shape and a fourth sub-side surface SS22 having a curved shape with a changing radius of curvature. The length of the third sub-side surface SS21 may be less than the length of the fourth sub-side surface SS22.

The third sub-side surface SS21 may be connected to the top surface US, and the fourth sub-side surface SS22 may be connected to the bottom surface BS. The angle between the third sub-side surface SS21 and the top surface US may be a right angle or an obtuse angle close to a right angle.

The curved shape of an upper portion SS22U of the fourth sub-side surface SS22 and the curved shape of a lower portion SS22B of the fourth sub-side surface SS22 may be different. The upper portion SS22U of the fourth sub-side surface SS22 refers to an area located above a center SS22C of the fourth sub-side surface SS22. The lower portion SS22B of the fourth sub-side surface SS22 refers to an area located below the center SS22C of the fourth sub-side surface SS22.

The radius of curvature of the upper portion SS22U of the fourth sub-side surface SS22 and the radius of curvature of the lower portion SS22B of the fourth sub-side surface SS22 may be different. For example, the radius of curvature of the lower portion SS22B of the fourth sub-side surface SS22 may be less than the radius of curvature of the upper portion SS22U of the fourth sub-side surface SS22.

The radius of curvature of the upper portion SS22U of the fourth sub-side surface SS22 may be defined as the radius of curvature of a curve passing through the center SS22C of the fourth sub-side surface SS22, an upper end SS22UE of the fourth sub-side surface SS22, and an upper center SS22UC of the fourth sub-side surface SS22. The radius of curvature of the lower portion SS22B of the fourth sub-side surface SS22 may be defined as the radius of curvature of a curve passing through the center SS22C of the fourth sub-side surface SS22, a lower end SS22BE of the fourth sub-side surface SS22, and a lower center SS22BC of the fourth sub-side surface SS22.

In addition, the radius of curvature of the central area of the fourth sub-side surface SS22 may be different from the radius of curvature of the upper portion SS22U of the fourth sub-side surface SS22 and the radius of curvature of the lower portion SS22B of the fourth sub-side surface SS22. The radius of curvature of the central area of the fourth sub-side surface SS22 may be defined as the radius of curvature of a curve passing through the center SS22C of the fourth sub-side surface SS22, the upper center SS22UC of the fourth sub-side surface SS22, and the lower center SS22BC of the fourth sub-side surface SS22.

In addition, the difference between the radius of curvature of an upper central area SS22UA of the fourth sub-side surface SS22 and the radius of curvature of a lower central area SS22BA of the fourth sub-side surface SS22 may be less than the difference between the radius of curvature of the upper portion SS22U of the fourth sub-side surface SS22 and the radius of curvature of the lower portion SS22B of the fourth sub-side surface SS22. The radius of curvature of the upper central area SS22UA of the fourth sub-side surface SS22 and the radius of curvature of the lower central area SS22BA of the fourth sub-side surface SS22 may be substantially the same. Alternatively, the difference between the radius of curvature of the upper central area SS22UA of the fourth sub-side surface SS22 and the radius of curvature of the lower central area SS22BA of the fourth sub-side surface SS22 may be 30 µm or less.

The radius of curvature of the upper central area SS22UA of the fourth sub-side surface SS22 may be defined as the radius of curvature of a curve passing through the center SS22C of the fourth sub-side surface SS22, the upper center SS22UC of the fourth sub-side surface SS22, and a first point PP22_1 of the fourth sub-side surface SS22. The radius of curvature of the lower central area SS22BA of the fourth sub-side surface SS22 may be defined as the radius of curvature of a curve passing through the center SS22C of the fourth sub-side surface SS22, the lower center SS22BC of the fourth sub-side surface SS22, and a second point PP22_2 of the fourth sub-side surface SS22. The first point PP22_1 of the fourth sub-side surface SS22 may be defined as an intermediate point between the center SS22C of the fourth sub-side surface SS22 and the upper center SS22UC of the fourth sub-side surface SS22. The second point PP22_2 of the fourth sub-side surface SS22 may be defined as an intermediate point between the center SS22C of the fourth sub-side surface SS22 and the lower center SS22BC of the fourth sub-side surface SS22.

Referring to FIG. 26C, the third side surface SS3 may have a fifth sub-side surface SS31 having a planar shape or a curved shape and a sixth sub-side surface SS32 having a curved shape with a changing radius of curvature. The length of the fifth sub-side surface SS31 may be less than the length of the sixth sub-side surface SS32.

The fifth sub-side surface SS31 may be connected to the top surface US, and the sixth sub-side surface SS32 may be connected to the bottom surface BS. The angle between the fifth sub-side surface SS31 and the top surface US may be a right angle or an obtuse angle close to a right angle.

The curved shape of an upper portion SS32U of the sixth sub-side surface SS32 and the curved shape of a lower portion SS32B of the sixth sub-side surface SS32 may be different. The upper portion SS32U of the sixth sub-side surface SS32 refers to an area located above a center SS32C of the sixth sub-side surface SS32. The lower portion SS32B of the sixth sub-side surface SS32 refers to an area located below the center SS32C of the sixth sub-side surface SS32.

The radius of curvature of the upper portion SS32U of the sixth sub-side surface SS32 and the radius of curvature of the lower portion SS32B of the sixth sub-side surface SS32 may be different. For example, the radius of curvature of the lower portion SS32B of the sixth sub-side surface SS32 may be less than the radius of curvature of the upper portion SS32U of the sixth sub-side surface SS32.

The radius of curvature of the upper portion SS32U of the sixth sub-side surface SS32 may be defined as the radius of curvature of a curve passing through the center SS32C of the sixth sub-side surface SS32, an upper end SS32UE of the sixth sub-side surface SS32, and an upper center SS32UC of the sixth sub-side surface SS32. The radius of curvature of the lower portion SS32B of the sixth sub-side surface SS32 may be defined as the radius of curvature of a curve passing through the center SS32C of the sixth sub-side surface SS32, a lower end SS32BE of the sixth sub-side surface SS32, and a lower center SS32BC of the sixth sub-side surface SS32.

In addition, the radius of curvature of the central area of the sixth sub-side surface SS32 may be different from the radius of curvature of the upper portion SS32U of the sixth sub-side surface SS32 and the radius of curvature of the lower portion SS32B of the sixth sub-side surface SS32. The radius of curvature of the central area of the sixth sub-side surface SS32 may be defined as the radius of curvature of a curve passing through the center SS32C of the sixth sub-side surface SS32, the upper center SS32UC of the sixth sub-side surface SS32, and the lower center SS32BC of the sixth sub-side surface SS32.

In addition, the difference between the radius of curvature of an upper central area SS32UA of the sixth sub-side surface SS32 and the radius of curvature of a lower central area SS32BA of the sixth sub-side surface SS32 may be less than the difference between the radius of curvature of the upper portion SS32U of the sixth sub-side surface SS32 and the radius of curvature of the lower portion SS32B of the sixth sub-side surface SS32. The radius of curvature of the upper central area SS32UA of the sixth sub-side surface SS32 and the radius of curvature of the lower central area SS32BA of the sixth sub-side surface SS32 may be substantially the same. Alternatively, the difference between the radius of curvature of the upper central area SS32UA of the sixth sub-side surface SS32 and the radius of curvature of the lower central area SS32BA of the sixth sub-side surface SS32 may be 30 µm or less.

The radius of curvature of the upper central area SS32UA of the sixth sub-side surface SS32 may be defined as the radius of curvature of a curve passing through the center SS32C of the sixth sub-side surface SS32, the upper center SS32UC of the sixth sub-side surface SS32, and a first point PP32_1 of the sixth sub-side surface SS32. The radius of curvature of the lower central area SS32BA of the sixth sub-side surface SS32 may be defined as the radius of curvature of a curve passing through the center SS32C of the sixth sub-side surface SS32, the lower center SS32BC of the sixth sub-side surface SS32, and a second point PP32_2 of the sixth sub-side surface SS32. The first point PP32_1 of the sixth sub-side surface SS32 may be defined as an intermediate point between the center SS32C of the sixth sub-side surface SS32 and the upper center SS32UC of the sixth sub-side surface SS32. The second point PP32_2 of the sixth sub-side surface SS32 may be defined as an intermediate point between the center SS32C of the sixth sub-side surface SS32 and the lower center SS32BC of the sixth sub-side surface SS32.

Referring to FIG. 26D, the fourth side surface SS4 may have a seventh sub-side surface SS41 having a planar shape or a curved shape and an eighth sub-side surface SS42 having a curved shape with a changing radius of curvature. The length of the seventh sub-side surface SS41 may be less than the length of the eighth sub-side surface SS42.

The seventh sub-side surface SS41 may be connected to the top surface US, and the eighth sub-side surface SS42 may be connected to the bottom surface BS. The angle between the seventh sub-side surface SS41 and the top surface US may be a right angle or an obtuse angle close to a right angle.

The curved shape of the upper portion SS42U of the eighth sub-side surface SS42 and the curved shape of the lower portion SS42B of the eighth sub-side surface SS42 may be different. The upper portion SS42U of the eighth sub-side surface SS42 refers to an area located above a center SS42C of the eighth sub-side surface SS42. The lower portion SS42B of the eighth sub-side surface SS42 refers to an area located below the center SS42C of the eighth sub-side surface SS42.

The radius of curvature of the upper portion SS42U of the eighth sub-side surface SS42 and the radius of curvature of the lower portion SS42B of the eighth sub-side surface SS42 may be different. For example, the radius of curvature of the lower portion SS42B of the eighth sub-side surface SS42 may be less than the radius of curvature of the upper portion SS42U of the eighth sub-side surface SS42.

The radius of curvature of the upper portion SS42U of the eighth sub-side surface SS42 may be defined as the radius of curvature of a curve passing through the center SS42C of the eighth sub-side surface SS42, an upper end SS42UE of the eighth sub-side surface SS42, and an upper center SS42UC of the eighth sub-side surface SS42. The radius of curvature of the lower portion SS42B of the eighth sub-side surface SS42 may be defined as the radius of curvature of a curve passing through the center SS42C of the eighth sub-side surface SS42, a lower end SS42BE of the eighth sub-side surface SS42, and a lower center SS42BC of the eighth sub-side surface SS42.

In addition, the radius of curvature of the central area of the eighth sub-side surface SS42 may be different from the radius of curvature of the upper portion SS42U of the eighth sub-side surface SS42 and the radius of curvature of the lower portion SS42B of the eighth sub-side surface SS42. The radius of curvature of the central area of the eighth sub-side surface SS42 may be defined as the radius of curvature of a curve passing through the center SS42C of the eighth sub-side surface SS42, the upper center SS42UC of the eighth sub-side surface SS42, and the lower center SS42BC of the eighth sub-side surface SS42.

In addition, the difference between the radius of curvature of an upper central area SS42UA of the eighth sub-side surface SS42 and the radius of curvature of a lower central area SS42BA of the eighth sub-side surface SS42 may be less than the difference between the radius of curvature of the upper portion SS42U of the eighth sub-side surface SS42 and the radius of curvature of the lower portion SS42B of the eighth sub-side surface SS42. The radius of curvature of the upper central area SS42UA of the eighth sub-side surface SS42 and the radius of curvature of the lower central area SS42BA of the eighth sub-side surface SS42 may be substantially the same. Alternatively, the difference between the radius of curvature of the upper central area SS42UA of the eighth sub-side surface SS42 and the radius of curvature of the lower central area SS42BA of the eighth sub-side surface SS42 may be 30 µm or less.

The radius of curvature of the upper central area SS42UA of the eighth sub-side surface SS42 may be defined as the radius of curvature of a curve passing through the center SS42C of the eighth sub-side surface SS42, the upper center SS42UC of the eighth sub-side surface SS42, and a first point PP42_1 of the eighth sub-side surface SS42. The radius of curvature of the lower central area SS42BA of the eighth sub-side surface SS42 may be defined as the radius of curvature of a curve passing through the center SS42C of the eighth sub-side surface SS42, the lower center SS42BC of the eighth sub-side surface SS42, and a second point PP42_2 of the eighth sub-side surface SS42. The first point PP42_1 of the eighth sub-side surface SS42 may be defined as an intermediate point between the center SS42C of the eighth sub-side surface SS42 and the upper center SS42UC of the eighth sub-side surface SS42. The second point PP42_2 of the eighth sub-side surface SS42 may be defined as an intermediate point between the center SS42C of the eighth sub-side surface SS42 and the lower center SS42BC of the eighth sub-side surface SS42.

Referring to FIGS. 26A to 26D, the length of the first sub-side surface SS11 of the first side surface SS1, the length of the third sub-side surface SS21 of the second side surface SS2, the length of the fifth sub-side surface SS31 of the third side surface SS3, and the length of the seventh sub-side surface SS41 of the fourth side surface SS4 may be similar to each other. For example, each of the length of the first sub-side surface SS11 of the first side surface SS1, the length of the third sub-side surface SS21 of the second side surface SS2, the length of the fifth sub-side surface SS31 of the third side surface SS3, and the length of the seventh sub-side surface SS41 of the fourth side surface SS4 may be greater than 10 µm and less than 30 µm.

For example, the difference between the length of the first sub-side surface SS11 of the first side surface SS1 and the length of the third sub-side surface SS21 of the second side surface SS2 may be less than approximately 10 µm. The difference between the length of the first sub-side surface SS11 of the first side surface SS1 and the length of the fifth sub-side surface SS31 of the third side surface SS3 may be less than approximately 10 µm. The difference between the length of the first sub-side surface SS11 of the first side surface SS1 and the length of the sixth sub-side surface SS41 of the fourth side surface SS4 may be less than approximately 10 µm. The difference between the length of the third sub-side surface SS21 of the second side surface SS2 and the length of the fifth sub-side surface SS31 of the third side surface SS3 may be less than approximately 10 µm. The difference between the length of the third sub-side surface SS21 of the second side surface SS2 and the length of the seventh sub-side surface SS41 of the fourth side surface SS4 may be less than approximately 10 µm. The difference between the length of the fifth sub-side surface SS31 of the third side surface SS3 and the length of the seventh sub-side surface SS41 of the fourth side surface SS4 may be less than approximately 10 µm.

The radius of curvature of the upper portion SS12U of the second sub-side surface SS12 of the first side surface SS1, the radius of curvature of the upper portion SS22U of the fourth sub-side surface SS22 of the second side surface SS2, the radius of curvature of the upper portion SS32U of the sixth sub-side surface SS32 of the third side surface SS3, and the radius of curvature of the upper portion SS42U of the eighth sub-side surface SS42 of the fourth side surface SS4 may be similar to each other.

For example, the difference between the radius of curvature of the upper portion SS12U of the second sub-side surface SS12 of the first side surface SS1 and the radius of curvature of the upper portion SS22U of the fourth sub-side surface SS22 of the second side surface SS2 may be less than approximately 30 µm. The difference between the radius of curvature of the upper portion SS12U of the second sub-side surface SS12 of the first side surface SS1 and the radius of curvature of the upper portion SS32U of the sixth sub-side surface SS32 of the third side surface SS3 may be less than approximately 30 µm. The difference between the radius of curvature of the upper portion SS12U of the second sub-side surface SS12 of the first side surface SS1 and the radius of curvature of the upper portion SS42U of the eighth sub-side surface SS42 of the fourth side surface SS4 may be less than approximately 30 µm. The difference between the radius of curvature of the upper portion SS22U of the fourth sub-side surface SS22 of the second side surface SS2 and the radius of curvature of the upper portion SS32U of the sixth sub-side surface SS32 of the third side surface SS3 may be less than approximately 30 µm. The difference between the radius of curvature of the upper portion SS22U of the fourth sub-side surface SS22 of the second side surface SS2 and the radius of curvature of the upper portion SS42U of the eighth sub-side surface SS42 of the fourth side surface SS4 may be less than approximately 30 µm. The difference between the radius of curvature of the upper portion SS32U of the sixth sub-side surface SS32 of the third side surface SS3 and the radius of curvature of the upper portion SS42U of the eighth sub-side surface SS42 of the fourth side surface SS4 may be less than approximately 30 µm.

As shown in FIGS. 26A to 26D, the difference in radius of curvature between the side surfaces SS1, SS2, SS3, and SS4 of the substrate SUB of the display panel 100 may be negligible. Accordingly, mechanical strength may be uniformly maintained according to the positions of the side surfaces SS1, SS2, SS3, and SS4 of the substrate SUB of the display panel 100.

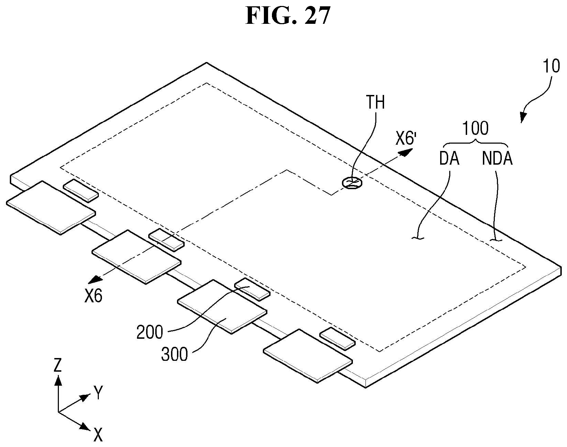

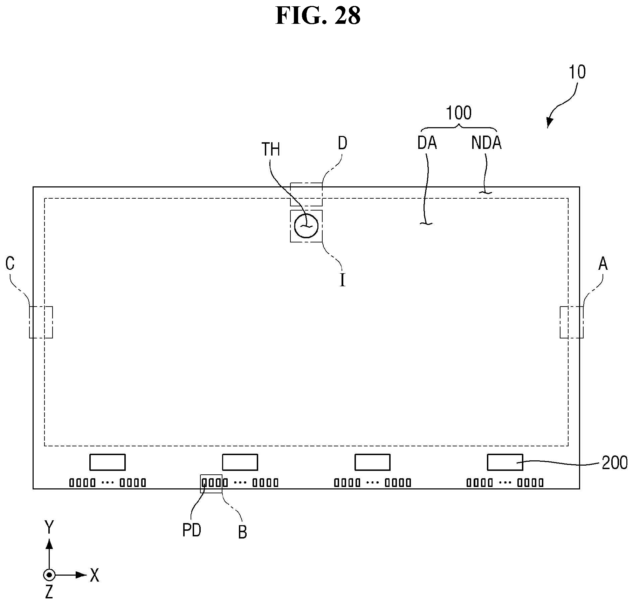

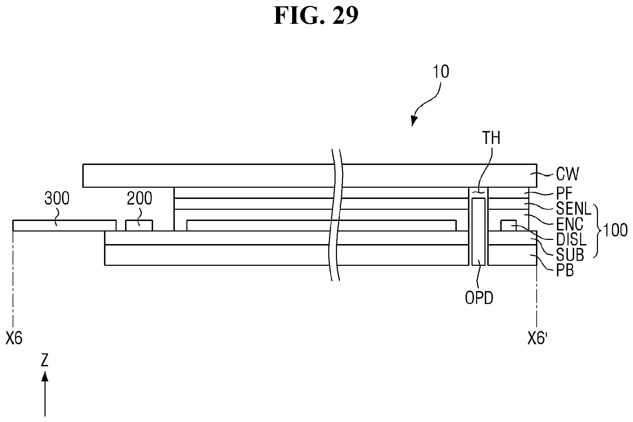

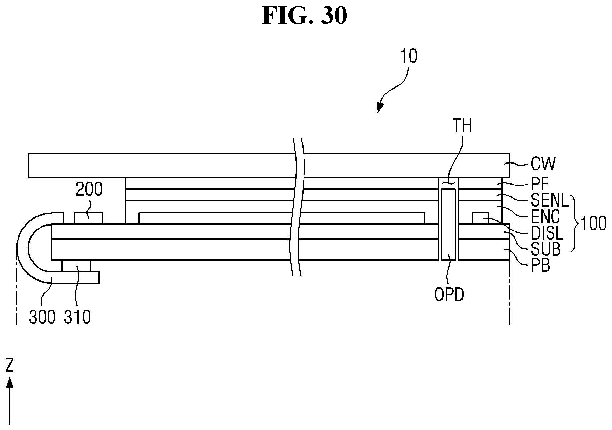

FIG. 27 is a perspective view illustrating a display device according to still another embodiment. FIG. 28 is a plan view illustrating a display panel and driving circuits according to still another embodiment. FIG. 29 is a cross-sectional view illustrating an example of a display panel taken along line X6-X6' of FIG. 27. FIG. 30 is a cross-sectional view illustrating an example of a display device in which the circuit board is bent in FIG. 29.

Referring to FIGS. 27 to 30, the display device 10 according to one embodiment may include a through hole TH. The through hole TH may be a hole capable of transmitting light, and may be a physical hole penetrating not only the display panel 100 but also the panel lower cover PB and the polarizing film PF. However, the embodiment of the present disclosure is not limited thereto, and the through hole TH may be an optical hole that transmits light without penetrating the display panel 100 and the polarizing film PF while penetrating the panel lower cover PB. The cover window CW may be located to cover the through hole TH.

The through hole TH may penetrate the substrate SUB, the thin film transistor layer TFTL, the encapsulation layer ENC, and the sensor electrode layer SENL of the display panel 100.

An electronic device including the display device 10 according to one embodiment may further include an optical device OPD located in the through hole TH. The electronic device according to one embodiment may be a portable electronic device such as a mobile phone, a smart phone, a tablet personal computer (PC), a smart watch, a watch phone, a mobile communication terminal, an electronic notebook, an electronic book, a portable multimedia player (PMP), a navigation device, and an ultra mobile PC (UMPC), as well as a television, a laptop computer, a monitor, a billboard, an Internet of Things (IOT) device.

The optical device OPD may be spaced apart from the display panel 100, the panel lower cover PB, and the polarizing film PF. The optical device OPD may be an optical sensor that senses light incident through the through hole TH, such as a proximity sensor, an illuminance sensor, and a camera sensor.

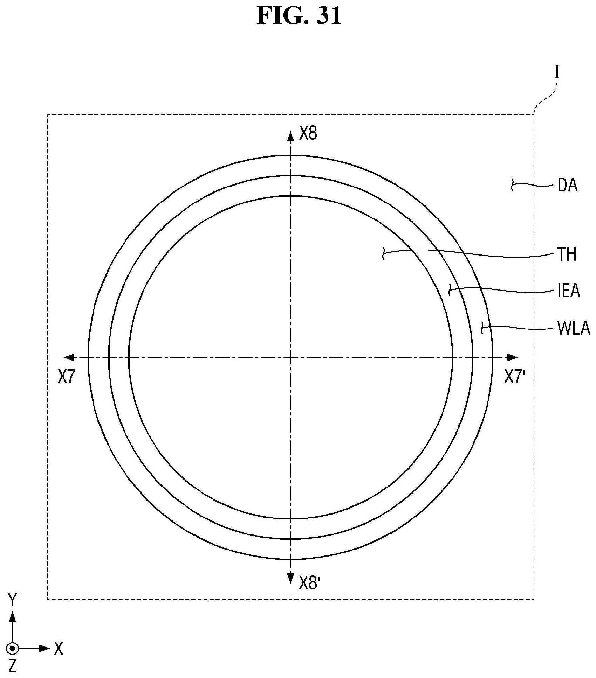

FIG. 31 is a layout view showing in detail an example of area I of FIG. 28. FIG. 31 shows an example of a layout of a through hole, an inorganic encapsulation area, a wiring area, and a display area of a display panel according to one embodiment.

Referring to FIG. 31, the display panel 100 according to one embodiment includes an inorganic encapsulation area IEA surrounding the through hole TH and a wiring area WLA surrounding the inorganic encapsulation area IEA.

The first encapsulation inorganic film TFE1 and the second encapsulation inorganic film TFE3 of the encapsulation layer ENC may be in contact with each other, so that the inorganic encapsulation area IEA may be a layer for preventing oxygen or moisture from permeating into the light emitting element layer EML of the display layer DISL due to the through hole TH.

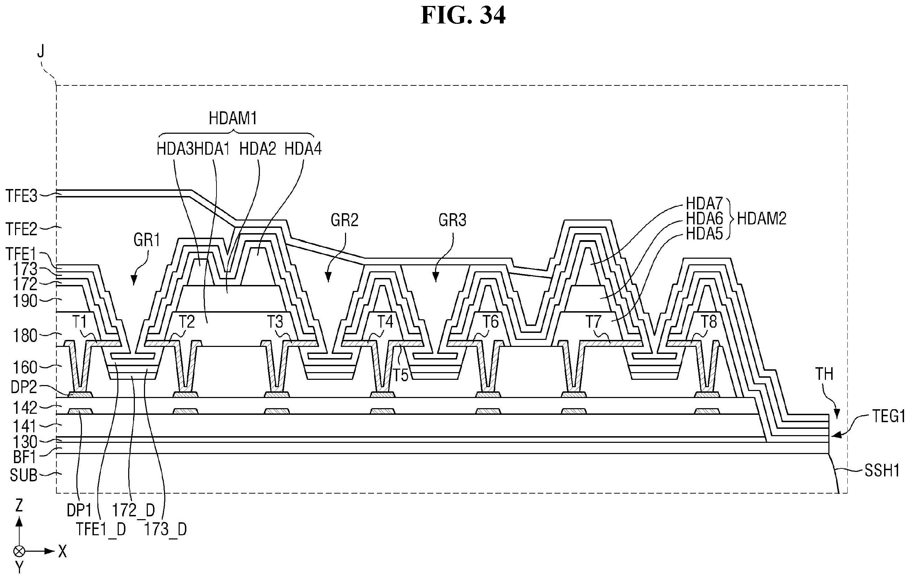

The inorganic encapsulation area IEA may include at least one dam, at least one tip, and at least one groove. For example, as illustrated in FIG. 34, the inorganic encapsulation area IEA may include a first dam HDAM1, a second dam HDAM2, first to eighth tips T1 to T8, and first to third grooves GR1 to GR3.

The first tip T1 and the second tip T2 may be located closer to the wiring area WLA than the first dam HDAM1. The first tip T1 may be located closer to the wiring area WLA than the second tip T2. The second tip T2 may be located between the first tip T1 and the first dam HDAM1.

The third tip T3, the fourth tip T4, the fifth tip T5, and the sixth tip T6 may be located between the first dam HDAM1 and the second dam HDAM2. At least a part of the third tip T3 may overlap the first dam HDAM1 in the third direction (Z-axis direction).

The seventh tip T7 and the eighth tip T8 may be located closer to the through hole TH than the second dam HDAM2. At least a part of the seventh tip T7 may overlap the second dam HDAM2 in the third direction (Z-axis direction). A distance between the eighth tip T8 and the through hole TH may be approximately 50 µm.

The first groove GR1 may be located between the first tip T1 and the second tip T2. The second groove GR2 may be located between the third tip T3 and the fourth tip T4. The third groove GR3 may be located between the fifth tip T5 and the sixth tip T6.

The wiring area WLA may be an area in which detour lines due to the through hole TH are located. Some of the detour lines may be connected to data lines, and others of the detour lines may be connected to a second power line to which a second power voltage higher than the first power voltage is applied. Still others of the detour lines may be connected to the scan lines. The wiring area WLA may be surrounded by the display area DA.

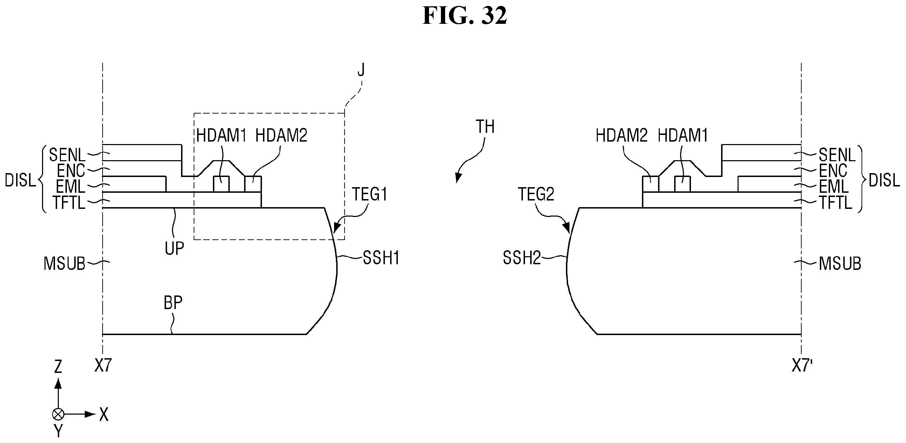

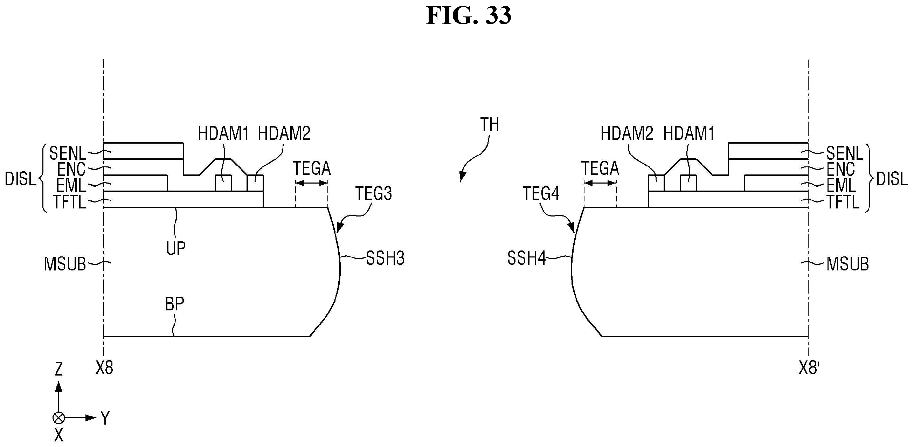

FIG. 32 is a cross-sectional view illustrating an example of the display panel taken along line X7-X7' of FIG. 31. FIG. 33 is a cross-sectional view illustrating an example of the display panel taken along line X8-X8' of FIG. 31. FIG. 34 is a cross-sectional view specifically illustrating an example of area J of FIG. 32.

FIG. 32 shows a first side edge TEG1 and a second side edge TEG2 of the through hole TH facing each other in the first direction (X-axis direction). FIG. 33 shows a third side edge TEG3 and a fourth side edge TEG4 of the through hole TH facing each other in the second direction (Y-axis direction).

Referring to FIG. 32 and FIG. 33, a first hole side surface SSH1 formed at the first side edge TEG1 of the through hole TH, a second hole side surface SSH2 formed at the second side edge TEG2 of the through hole TH, a third hole side surface SSH3 formed at the third side edge TEG3 of the through hole TH, and a fourth hole side surface SSH4 formed at the fourth side edge TEG4 of the through hole TH may have a curved shape. Here, the first side edge TEG1 of the through hole TH may refer to the left edge of the through hole TH, and the second side edge TEG2 of the through hole TH may refer to the right edge of the through hole TH. In addition, the third side edge TEG3 of the through hole TH may refer to the upper edge of the through hole TH, and the fourth side edge TEG4 of the through hole TH may refer to the lower edge of the through hole TH. In one embodiment, when the through hole TH is circular or elliptical as shown in FIG. 31, the through hole TH is described as having a plurality of hole side surfaces including the first to fourth hole side surfaces SSH1, SSH2, SSH3, and SSH4 as well as a plurality of side surface edges including the first to fourth side edges TEG1, TEG2, TEG3, and TEG4, but the through hole TH may be regarded as being defined as a single continuous side surface. However, as shown in FIG. 32 and FIG. 33, each inner edge of the through hole TH in a cross-section taken along a diameter or an axis (a major axis or a minor axis) may be referred to as one side edge TEG1, TEG2, TEG3, or TEG4 at which the corresponding hole side surface SSH1, SSH2, SSH3, or SSH4 is formed.

Referring to FIGS. 9A, 9B and 34, the first dummy pattern DP1 may include the same material as the second gate metal layer including the second capacitor electrode CAE2 of the capacitor Cst and may be located on the same layer. For example, the first dummy pattern DP1 may be located on the first interlayer insulating film 141. The first dummy pattern DP1 may be formed as a single layer or multiple layers including any one of molybdenum (Mo), aluminum (Al), chromium (Cr), gold (Au), titanium (Ti), nickel (Ni), neodymium (Nd) and copper (Cu) or an alloy thereof.

The second dummy pattern DP2 may include the same material as the first data metal layer including the first connection electrode CE1 and the data lines and may be located on the same layer. For example, the second dummy pattern DP2 may be located on the second interlayer insulating film 142. The second dummy pattern DP2 may be formed as a single layer or multiple layers including any one of molybdenum (Mo), aluminum (Al), chromium (Cr), gold (Au), titanium (Ti), nickel (Ni), neodymium (Nd) and copper (Cu) or an alloy thereof.

The second dummy pattern DP2 may overlap the first dummy pattern DP1 in the third direction (Z-axis direction).

The first to eighth tips T1 to T8 may include the same material as the second data metal layer including the second connection electrode CE2 and may be located on the same layer. For example, the first to eighth tips T1 to T8 may be located on the first organic film 160. The first to eighth tips T1 to T8 may be formed as a single layer or multiple layers including any one of molybdenum (Mo), aluminum (Al), chromium (Cr), gold (Au), titanium (Ti), nickel (Ni), neodymium (Nd) and copper (Cu) or an alloy thereof.

Each of the first to eighth tips T1 to T8 may be connected to the second dummy pattern DP2 through a contact hole penetrating the first organic film 160. Each of the first to eighth tips T1 to T8 may include an eaves structure in which the top surface and the bottom surface are exposed without being covered by the first organic film 160, the second organic film 180, the first dam HDAM1, and the second dam HDAM2. The fourth tip T4 and the fifth tip T5 may be integrally formed. Each of the first to eighth tips T1 to T8 may be a protruding pattern or a trench pattern for forming a groove (or trench).

The eighth tip T8 may be an outermost structure adjacent to the first side edge TEG1 of the through hole TH. A distance from the eighth tip T8, which is the outermost structure, to the first side edge TEG1 of the through hole TH may be approximately 300 µm.

In FIG. 34, the eighth tip T8 is illustrated as an outermost structure adjacent to the first side edge TEG1 of the through hole TH, but the embodiment of the present disclosure is not limited thereto. For example, if the seventh tip T7 and the eighth tip T8 are omitted, the outermost structure adjacent to the first side edge TEG1 of the through hole TH may be the second dam HDAM2 for preventing overflow of the encapsulation organic film TFE2 of the encapsulation layer ENC. Alternatively, if the seventh tip T7 and the eighth tip T8 are omitted, the outermost structure adjacent to the first side edge TEG1 of the through hole TH may be a groove for disconnecting the light emitting layer 172 and the common electrode 173.

The first groove GR1 may be formed between the first tip T1 and the second tip T2, the second groove GR2 may be formed between the third tip T3 and the fourth tip T4, and the third groove GR3 may be formed between the fifth tip T5 and the sixth tip T6. The first groove GR1 may have an eaves structure formed by the first tip T1 and the second tip T2, the second groove GR2 may have an eaves structure formed by the third tip T3 and the fourth tip T4, and the third groove GR3 may have an eaves structure formed by the fifth tip T5 and the sixth tip T6.

Since the light emitting layer 172 is deposited by evaporation and the common electrode 173 is deposited by sputtering, the light emitting layer 172 and the common electrode 173 may be located to be disconnected at each of the first to third grooves GR1, GR2, and GR3 because the step coverage is low. In contrast, the first encapsulation inorganic film TFE1 and the third encapsulation inorganic film TFE3 may be deposited by chemical vapor deposition, atomic layer deposition, or the like, and thus may be formed to be continuous without being disconnected in each of the first to third grooves GR1, GR2, and GR3 because the step coverage is high. Step coverage refers to the ratio of the degree of thin film coated on an inclined portion to the degree of thin film coated on a flat portion. The light emitting layer 172, a disconnected light emitting layer remnant 172_D, the common electrode 173, and a disconnected common electrode remnant 173_D may be located in the first to third grooves GR1, GR2, and GR3, respectively. A partial remnant TFE1_D of the first encapsulation inorganic film TFE1 located in each of the first to third grooves GR1, GR2, and GR3 is illustrated in FIG. 34.

The first dam HDAM1 may include first to fourth sub-dams HDA1, HDA2, HDA3, and HDA4. The first sub-dam HDA1 may be located on the first organic film 160 and may include the same material as the second organic film 180. The first sub-dam HDA1 may be located on the second tip T2 and the third tip T3. The second sub-dam HDA2 may be located on the first sub-dam HDA1 and may include the same material as the bank 190. The third sub-dam HDA3 and the fourth sub-dam HDA4 may be located on the second sub-dam HDA2 and may include the same material as the spacer 191, but are not limited thereto. The fourth sub-dam HDA4 may be located closer to the through hole TH than the third sub-dam HDA3. The thickness of the fourth sub-dam HDA4 may be greater than the thickness of the third sub-dam HDA3.

The second dam HDAM2 may include fifth to seventh sub-dams HDA5, HDA6, and HDA7. The fifth sub-dam HDA5 may be located on the first organic film 160 and may include the same material as the second organic film 180. The fifth sub-dam HDA5 may be located on the seventh tip T7. The sixth sub-dam HDA6 may be located on the fifth sub-dam HDA5 and may include the same material as the bank 190. The seventh sub-dam HDA7 may be located on the sixth sub-dam HDA6 and may include the same material as the spacer 191, but is not limited thereto.

The overflow of the encapsulation organic film TFE2 into the through hole TH may be prevented by the first dam HDAM1 and the second dam HDAM2.

The light emitting layer remnant 172_D, the common electrode remnant 173_D, the first encapsulation inorganic film TFE1, and the second encapsulation inorganic film TFE3 may extend to the edge TEG of the through hole TH. The end of the light emitting layer remnant 172_D, the end of the common electrode remnant 173_D, the end of the first encapsulation inorganic film TFE1, or the end of the second encapsulation inorganic film TFE3 may coincide with the edge TEG of the through hole TH.

As illustrated in FIG. 34, since the light emitting layer 172 and the common electrode 173 are broken in the first to third grooves GR1, GR2, and GR3 formed by the first to eighth tips T1 to T8, respectively, it is possible to prevent the light emitting layer 172 and the common electrode 173 exposed through the through hole TH from being a path through which oxygen, moisture, or the like permeates.

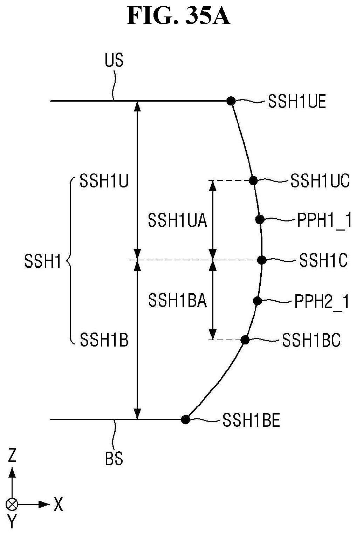

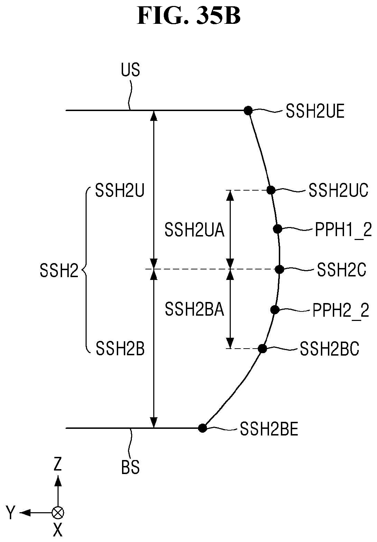

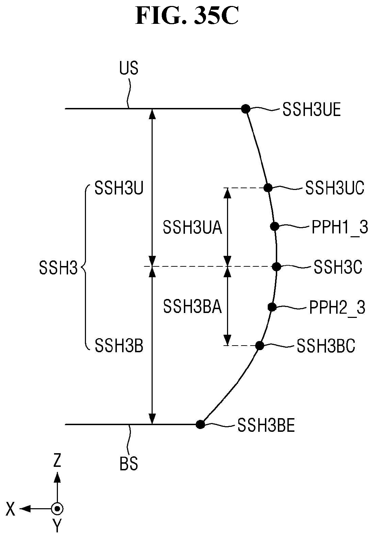

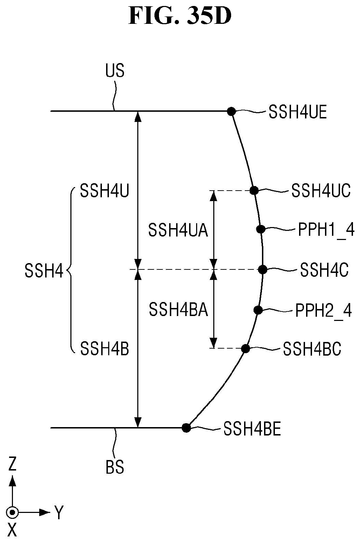

FIGS. 35A to 35D are enlarged cross-sectional views showing examples of the first to fourth hole side surfaces illustrated in FIGS. 32 and 33. FIG. 35A shows a cross-section of the first hole side surface SSH1 located at the first side edge TEG1 of the through hole TH, FIG. 35B shows a cross-section of the second hole side surface SSH2 located at the second side edge TEG2 of the through hole TH, FIG. 35C shows a cross-section of the third hole side surface SSH3 located at the third side edge TEG3 of the through hole TH, and FIG. 35D shows a cross-section of the fourth hole side surface SSH4 located at the fourth side edge TEG4 of the through hole TH.

Referring to FIG. 35A, the first hole side surface SSH1 may have a curved shape with a changing radius of curvature. The curved shape of an upper portion SSH1U (e.g., first hole upper portion) of the first hole side surface SSH1 and the curved shape of a lower portion SSH1B (e.g., first hole lower portion) of the first hole side surface SSH1 may be different. The upper portion SSH1U of the first hole side surface SSH1 refers to an area located above a center SSH1C (e.g., first hole center) of the first hole side surface SSH1. The lower portion SSH1B of the first hole side surface SSH1 refers to an area located below the center SSH1C of the first hole side surface SSH1.

The radius of curvature of the upper portion SSH1U of the first hole side surface SSH1 and the radius of curvature of the lower portion SSH1B of the first hole side surface SSH1 may be different. For example, the radius of curvature of the lower portion SSH1B of the first hole side surface SSH1 may be less than the radius of curvature of the upper portion SSH1U of the first hole side surface SSH1.

The radius of curvature of the upper portion SSH1U of the first hole side surface SSH1 may be defined as the radius of curvature of a curve passing through the center SSH1C of the first hole side surface SSH1, an upper end SSH1UE of the first hole side surface SSH1, and an upper center SSH1UC (e.g., first hole upper center) of the first hole side surface SSH1. The radius of curvature of the lower portion SSH1B of the first hole side surface SSH1 may be defined as the radius of curvature of a curve passing through the center SSH1C of the first hole side surface SSH1, a lower end SSH1BE of the first hole side surface SSH1, and a lower center SSH1BC (e.g., first hole lower center) of the first hole side surface SSH1.

In addition, the radius of curvature of the central area of the first hole side surface SSH1 may be different from the radius of curvature of the upper portion SSH1U of the first hole side surface SSH1 and the radius of curvature of the lower portion SSH1B of the first hole side surface SSH1. The radius of curvature of the central area of the first hole side surface SSH1 may be defined as the radius of curvature of a curve passing through the center SSH1C of the first hole side surface SSH1, the upper center SSH1UC of the first hole side surface SSH1, and the lower center SSH1BC of the first hole side surface SSH1.

In addition, the difference between the radius of curvature of an upper central area SSH1UA of the first hole side surface SSH1 and the radius of curvature of a lower central area SSH1BA of the first hole side surface SSH1 may be less than the difference between the radius of curvature of the upper portion SSH1U of the first hole side surface SSH1 and the radius of curvature of the lower portion SSH1B of the first hole side surface SSH1. The radius of curvature of the upper central area SSH1UA of the first hole side surface SSH1 and the radius of curvature of the lower central area SSH1BA of the first hole side surface SSH1 may be substantially the same. Alternatively, the difference between the radius of curvature of the upper central area SSH1UA of the first hole side surface SSH1 and the radius of curvature of the lower central area SSH1BA of the first hole side surface SSH1 may be 30 µm or less.

The radius of curvature of the upper central area SSH1UA of the first hole side surface SSH1 may be defined as the radius of curvature of a curve passing through the center SSH1C of the first hole side surface SSH1, the upper center SSH1UC of the first hole side surface SSH1, and a first point PPH1_1 of the first hole side surface SSH1. The radius of curvature of the lower central area SSH1BA of the first hole side surface SSH1 may be defined as the radius of curvature of a curve passing through the center SSH1C of the first hole side surface SSH1, the lower center SSH1BC of the first hole side surface SSH1, and a second point PPH2_1 of the first hole side surface SSH1. The first point PPH1_1 of the first hole side surface SSH1 may be defined as an intermediate point between the center SSH1C of the first hole side surface SSH1 and the upper center SSH1UC of the first hole side surface SSH1. The second point PPH2_1 of the first hole side surface SSH1 may be defined as an intermediate point between the center SSH1C of the first hole side surface SSH1 and the lower center SSH1BC of the first hole side surface SSH1.

Referring to FIG. 35B, the second hole side surface SSH2 may have a curved shape with a changing radius of curvature. The curved shape of an upper portion SSH2U (e.g., second hole upper portion) of the second hole side surface SSH2 and the curved shape of a lower portion SSH2B (e.g., second hole lower portion) of the second hole side surface SSH2 may be different. The upper portion SSH2U of the second hole side surface SSH2 refers to an area located above a center SSH2C (e.g., second hole center) of the second hole side surface SSH2. The lower portion SSH2B of the second hole side surface SSH2 refers to an area located below the center SSH2C of the second hole side surface SSH2.

The radius of curvature of the upper portion SSH2U of the second hole side surface SSH2 and the radius of curvature of the lower portion SSH2B of the second hole side surface SSH2 may be different. For example, the radius of curvature of the lower portion SSH2B of the second hole side surface SSH2 may be less than the radius of curvature of the upper portion SSH2U of the second hole side surface SSH2.

The radius of curvature of the upper portion SSH2U of the second hole side surface SSH2 may be defined as the radius of curvature of a curve passing through the center SSH2C of the second hole side surface SSH2, an upper end SSH2UE of the second hole side surface SSH2, and an upper center SSH2UC (e.g., second hole upper center) of the second hole side surface SSH2. The radius of curvature of the lower portion SSH2B of the second hole side surface SSH2 may be defined as the radius of curvature of a curve passing through the center SSH2C of the second hole side surface SSH2, a lower end SSH2BE of the second hole side surface SSH2, and a lower center SSH2BC (e.g., second hole lower center) of the second hole side surface SSH2.

In addition, the radius of curvature of the central area of the second hole side surface SSH2 may be different from the radius of curvature of the upper portion SSH2U of the second hole side surface SSH2 and the radius of curvature of the lower portion SSH2B of the second hole side surface SSH2. The radius of curvature of the central area of the second hole side surface SSH2 may be defined as the radius of curvature of a curve passing through the center SSH2C of the second hole side surface SSH2, the upper center SSH2UC of the second hole side surface SSH2, and the lower center SSH2BC of the second hole side surface SSH2.

In addition, the difference between the radius of curvature of an upper central area SSH2UA of the second hole side surface SSH2 and the radius of curvature of a lower central area SSH2BA of the second hole side surface SSH2 may be less than the difference between the radius of curvature of the upper portion SSH2U of the second hole side surface SSH2 and the radius of curvature of the lower portion SSH2B of the second hole side surface SSH2. The radius of curvature of the upper central area SSH2UA of the second hole side surface SSH2 and the radius of curvature of the lower central area SSH2BA of the second hole side surface SSH2 may be substantially the same. Alternatively, the difference between the radius of curvature of the upper central area SSH2UA of the second hole side surface SSH2 and the radius of curvature of the lower central area SSH2BA of the second hole side surface SSH2 may be 30 µm or less.

The radius of curvature of the upper central area SSH2UA of the second hole side surface SSH2 may be defined as the radius of curvature of a curve passing through the center SSH2C of the second hole side surface SSH2, the upper center SSH2UC of the second hole side surface SSH2, and a first point PPH1_2 of the second hole side surface SSH2. The radius of curvature of the lower central area SSH2BA of the second hole side surface SSH2 may be defined as the radius of curvature of a curve passing through the center SSH2C of the second hole side surface SSH2, the lower center SSH2BC of the second hole side surface SSH2, and a second point PPH2_2 of the second hole side surface SSH2. The first point PPH1_2 of the second hole side surface SSH2 may be defined as an intermediate point between the center SSH2C of the second hole side surface SSH2 and the upper center SSH2UC of the second hole side surface SSH2. The second point PPH2_2 of the second hole side surface SSH2 may be defined as an intermediate point between the center SSH2C of the second hole side surface SSH2 and the lower center SSH2BC of the second hole side surface SSH2.

Referring to FIG. 35C, the third hole side surface SSH3 may have a curved shape with a changing radius of curvature. The curved shape of an upper portion SSH3U (e.g., third hole upper portion) of the third hole side surface SSH3 and the curved shape of a lower portion SSH3B (e.g., third hole lower portion) of the third hole side surface SSH3 may be different. The upper portion SSH3U of the third hole side surface SSH3 refers to an area located above a center SSH3C (e.g., third hole center) of the third hole side surface SSH3. The lower portion SSH3B of the third hole side surface SSH3 refers to an area located below the center SSH3C of the third hole side surface SSH3.

The radius of curvature of the upper portion SSH3U of the third hole side surface SSH3 and the radius of curvature of the lower portion SSH3B of the third hole side surface SSH3 may be different. For example, the radius of curvature of the lower portion SSH3B of the third hole side surface SSH3 may be less than the radius of curvature of the upper portion SSH3U of the third hole side surface SSH3.

The radius of curvature of the upper portion SSH3U of the third hole side surface SSH3 may be defined as the radius of curvature of a curve passing through the center SSH3C of the third hole side surface SSH3, an upper end SSH3UE of the third hole side surface SSH3, and an upper center SSH3UC (e.g., third hole upper center) of the third hole side surface SSH3. The radius of curvature of the lower portion SSH3B of the third hole side surface SSH3 may be defined as the radius of curvature of a curve passing through the center SSH3C of the third hole side surface SSH3, a lower end SSH3BE of the third hole side surface SSH3, and a lower center SSH3BC (e.g., third hole lower center) of the third hole side surface SSH3.

In addition, the radius of curvature of the central area of the third hole side surface SSH3 may be different from the radius of curvature of the upper portion SSH3U of the third hole side surface SSH3 and the radius of curvature of the lower portion SSH3B of the third hole side surface SSH3. The radius of curvature of the central area of the third hole side surface SSH3 may be defined as the radius of curvature of a curve passing through the center SSH3C of the third hole side surface SSH3, the upper center SSH3UC of the third hole side surface SSH3, and the lower center SSH3BC of the third hole side surface SSH3.

In addition, the difference between the radius of curvature of an upper central area SSH3UA of the third hole side surface SSH3 and the radius of curvature of a lower central area SSH3BA of the third hole side surface SSH3 may be less than the difference between the radius of curvature of the upper portion SSH3U of the third hole side surface SSH3 and the radius of curvature of the lower portion SSH3B of the third hole side surface SSH3. The radius of curvature of the upper central area SSH3UA of the third hole side surface SSH3 and the radius of curvature of the lower central area SSH3BA of the third hole side surface SSH3 may be substantially the same. Alternatively, the difference between the radius of curvature of the upper central area SSH3UA of the third hole side surface SSH3 and the radius of curvature of the lower central area SSH3BA of the third hole side surface SSH3 may be 30 µm or less.

The radius of curvature of the upper central area SSH3UA of the third hole side surface SSH3 may be defined as the radius of curvature of a curve passing through the center SSH3C of the third hole side surface SSH3, the upper center SSH3UC of the third hole side surface SSH3, and a first point PPH1_3 of the third hole side surface SSH3. The radius of curvature of the lower central area SSH3BA of the third hole side surface SSH3 may be defined as the radius of curvature of a curve passing through the center SSH3C of the third hole side surface SSH3, the lower center SSH3BC of the third hole side surface SSH3, and a second point PPH2_3 of the third hole side surface SSH3. The first point PPH1_3 of the third hole side surface SSH3 may be defined as an intermediate point between the center SSH3C of the third hole side surface SSH3 and the upper center SSH3UC of the third hole side surface SSH3. The second point PPH2_3 of the third hole side surface SSH3 may be defined as an intermediate point between the center SSH3C of the third hole side surface SSH3 and the lower center SSH3BC of the third hole side surface SSH3.

Referring to FIG. 35D, the fourth hole side surface SSH4 may have a curved shape with a changing radius of curvature. The curved shape of an upper portion SSH4U (e.g., fourth hole upper portion) of the fourth hole side surface SSH4 and the curved shape of a lower portion SSH4B (e.g., fourth hole lower portion) of the fourth hole side surface SSH4 may be different. The upper portion SSH4U of the fourth hole side surface SSH4 refers to an area located above a center SSH4C (e.g., fourth hole center) of the fourth hole side surface SSH4. The lower portion SSH4B of the fourth hole side surface SSH4 refers to an area located below the center SSH4C of the fourth hole side surface SSH4.

The radius of curvature of the upper portion SSH4U of the fourth hole side surface SSH4 and the radius of curvature of the lower portion SSH4B of the fourth hole side surface SSH4 may be different. For example, the radius of curvature of the lower portion SSH4B of the fourth hole side surface SSH4 may be less than the radius of curvature of the upper portion SSH4U of the fourth hole side surface SSH4.

The radius of curvature of the upper portion SSH4U of the fourth hole side surface SSH4 may be defined as the radius of curvature of a curve passing through the center SSH4C of the fourth hole side surface SSH4, an upper end SSH4UE of the fourth hole side surface SSH4, and an upper center SSH4UC (e.g., fourth hole upper center) of the fourth hole side surface SSH4. The radius of curvature of the lower portion SSH4B of the fourth hole side surface SSH4 may be defined as the radius of curvature of a curve passing through the center SSH4C of the fourth hole side surface SSH4, a lower end SSH4BE of the fourth hole side surface SSH4, and a lower center SSH4BC (e.g., fourth hole lower center) of the fourth hole side surface SSH4.

In addition, the radius of curvature of the central area of the fourth hole side surface SSH4 may be different from the radius of curvature of the upper portion SSH4U of the fourth hole side surface SSH4 and the radius of curvature of the lower portion SSH4B of the fourth hole side surface SSH4. The radius of curvature of the central area of the fourth hole side surface SSH4 may be defined as the radius of curvature of a curve passing through the center SSH4C of the fourth hole side surface SSH4, the upper center SSH4UC of the fourth hole side surface SSH4, and the lower center SSH4BC of the fourth hole side surface SSH4.

In addition, the difference between the radius of curvature of an upper central area SSH4UA of the fourth hole side surface SSH4 and the radius of curvature of a lower central area SSH4BA of the fourth hole side surface SSH4 may be less than the difference between the radius of curvature of the upper portion SSH4U of the fourth hole side surface SSH4 and the radius of curvature of the lower portion SSH4B of the fourth hole side surface SSH4. The radius of curvature of the upper central area SSH4UA of the fourth hole side surface SSH4 and the radius of curvature of the lower central area SSH4BA of the fourth hole side surface SSH4 may be substantially the same. Alternatively, the difference between the radius of curvature of the upper central area SSH4UA of the fourth hole side surface SSH4 and the radius of curvature of the lower central area SSH4BA of the fourth hole side surface SSH4 may be 30 µm or less.

The radius of curvature of the upper central area SSH4UA of the fourth hole side surface SSH4 may be defined as the radius of curvature of a curve passing through the center SSH4C of the fourth hole side surface SSH4, the upper center SSH4UC of the fourth hole side surface SSH4, and a first point PPH1_4 of the fourth hole side surface SSH4. The radius of curvature of the lower central area SSH4BA of the fourth hole side surface SSH4 may be defined as the radius of curvature of a curve passing through the center SSH4C of the fourth hole side surface SSH4, the lower center SSH4BC of the fourth hole side surface SSH4, and a second point PPH2_4 of the fourth hole side surface SSH4. The first point PPH1_4 of the fourth hole side surface SSH4 may be defined as an intermediate point between the center SSH4C of the fourth hole side surface SSH4 and the upper center SSH4UC of the fourth hole side surface SSH4. The second point PPH2_4 of the fourth hole side surface SSH4 may be defined as an intermediate point between the center SSH4C of the fourth hole side surface SSH4 and the lower center SSH4BC of the fourth hole side surface SSH4.

Referring to FIGS. 35A to 35D, the radius of curvature of the upper portion SSH1U of the first hole side surface SSH1, the radius of curvature of the upper portion SSH2U of the second hole side surface SSH2, the radius of curvature of the upper portion SSH3U of the third hole side surface SSH3, and the radius of curvature of the upper portion SSH4U of the fourth hole side surface SSH4 may be similar to each other. For example, the radius of curvature of the upper portion SSH1U of the first hole side surface SSH1, the radius of curvature of the upper portion SSH2U of the second hole side surface SSH2, the radius of curvature of the upper portion SSH3U of the third hole side surface SSH3, and the radius of curvature of the upper portion SSH4U of the fourth hole side surface SSH4 may be 150 µm to 350 µm.

The difference between the radius of curvature of the upper portion SSH1U of the first hole side surface SSH1 and the radius of curvature of the upper portion SSH2U of the second hole side surface SSH2 may be less than approximately 30 µm. The difference between the radius of curvature of the upper portion SSH1U of the first hole side surface SSH1 and the radius of curvature of the upper portion SSH3U of the third hole side surface SSH3 may be less than approximately 30 µm. The difference between the radius of curvature of the upper portion SSH1U of the first hole side surface SSH1 and the radius of curvature of the upper portion SSH4U of the fourth hole side surface SSH4 may be less than approximately 30 µm. The difference between the radius of curvature of the upper portion SSH2U of the second hole side surface SSH2 and the radius of curvature of the upper portion SSH3U of the third hole side surface SSH3 may be less than approximately 30 µm. The difference between the radius of curvature of the upper portion SSH2U of the second hole side surface SSH2 and the radius of curvature of the upper portion SSH4U of the fourth hole side surface SSH4 may be less than approximately 30 µm. The difference between the radius of curvature of the upper portion SSH3U of the third hole side surface SSH3 and the radius of curvature of the upper portion SSH4U of the fourth hole side surface SSH4 may be less than approximately 30 µm.

In addition, referring to FIGS. 25A to 25D and FIGS. 35A to 35D, each of the radius of curvature of the upper portion SSH1U of the first hole side surface SSH1, the radius of curvature of the upper portion SSH2U of the second hole side surface SSH2, the radius of curvature of the upper portion SSH3U of the third hole side surface SSH3, and the radius of curvature of the upper portion SSH4U of the fourth hole side surface SSH4 may be similar to the radius of curvature of the upper portion SS1U of the first side surface SS1, the radius of curvature of the upper portion SS2U of the second side surface SS2, the radius of curvature of the upper portion SS3U of the third side surface SS3, and the radius of curvature of the upper portion SS4U of the fourth side surface SS4. For example, the difference between each of the radius of curvature of the upper portion SSH1U of the first hole side surface SSH1, the radius of curvature of the upper portion SSH2U of the second hole side surface SSH2, the radius of curvature of the upper portion SSH3U of the third hole side surface SSH3, and the radius of curvature of the upper portion SSH4U of the fourth hole side surface SSH4, and any one of the radius of curvature of the upper portion SS1U of the first side surface SS1, the radius of curvature of the upper portion SS2U of the second side surface SS2, the radius of curvature of the upper portion SS3U of the third side surface SS3, and the radius of curvature of the upper portion SS4U of the fourth side surface SS4 may be less than approximately 30 µm.

As shown in FIGS. 35A to 35D, the difference in radius of curvature between the hole side surfaces SSH1, SSH2, SSH3, and SSH4 of the substrate SUB of the display panel 100 may be negligible. Accordingly, mechanical strength may be uniformly maintained according to the positions of the hole side surfaces SSH1, SSH2, SSH3, and SSH4 of the substrate SUB of the display panel 100.

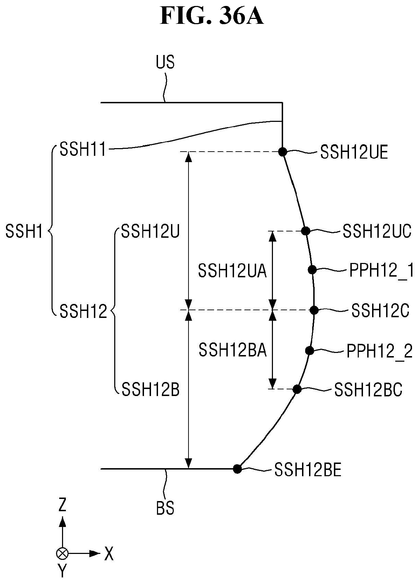

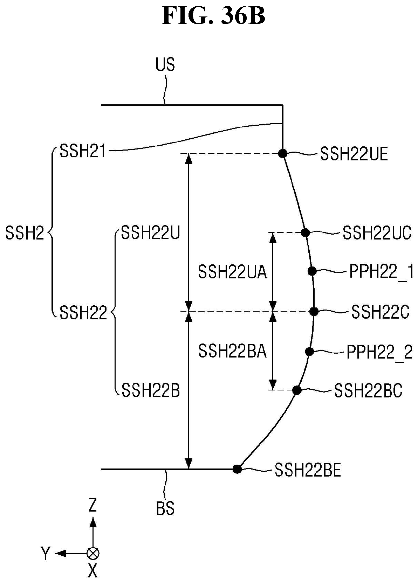

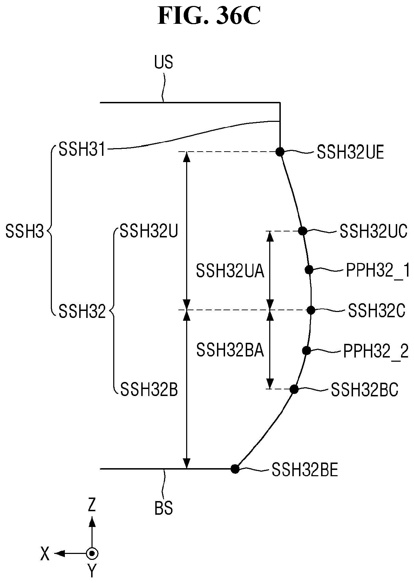

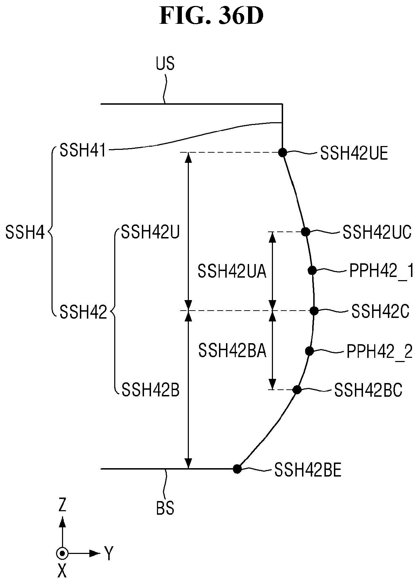

FIGS. 36A to 36D are enlarged cross-sectional views showing yet other examples of the first to fourth hole side surfaces illustrated in FIGS. 32 and 33. FIG. 36A shows a cross-section of the first hole side surface SSH1, FIG. 36B shows a cross-section of the second hole side surface SSH2, FIG. 36C shows a cross-section of the third side surface SS3, and FIG. 36D shows a cross-section of the fourth side surface SSH4.

Referring to FIG. 36A, the first hole side surface SSH1 may have a first sub-hole side surface SSH11 having a planar shape or a curved shape and a second sub-hole side surface SSH12 having a curved shape with a changing radius of curvature. The length of the first sub-hole side surface SSH11 may be less than the length of the second sub-hole side surface SSH12.

The first sub-hole side surface SSH11 may be connected to the top surface US, and the second sub-hole side surface SSH12 may be connected to the bottom surface BS. The angle between the first sub-hole side surface SSH11 and the top surface US may be a right angle or an obtuse angle close to a right angle.

The curved shape of an upper portion SSH12U of the second sub-hole side surface SSH12 and the curved shape of a lower portion SSH12B of the second sub-hole side surface SSH12 may be different. The upper portion SSH12U of the second sub-hole side surface SSH12 refers to an area located above a center SSH12C of the second sub-hole side surface SSH12. The lower portion SSH12B of the second sub-hole side surface SSH12 refers to an area located below the center SSH12C of the second sub-hole side surface SSH12.

The radius of curvature of the upper portion SSH12U of the second sub-hole side surface SSH12 and the radius of curvature of the lower portion SSH12B of the second sub-hole side surface SSH12 may be different. For example, the radius of curvature of the lower portion SSH12B of the second sub-hole side surface SSH12 may be less than the radius of curvature of the upper portion SSH12U of the second sub-hole side surface SSH12.

The radius of curvature of the upper portion SSH12U of the second sub-hole side surface SSH12 may be defined as the radius of curvature of a curve passing through the center SSH12C of the second sub-hole side surface SSH12, an upper end SSH12UE of the second sub-hole side surface SSH12, and an upper center SSH12UC of the second sub-hole side surface SSH12. The radius of curvature of the lower portion SSH12B of the second sub-hole side surface SSH12 may be defined as the radius of curvature of a curve passing through the center SSH12C of the second sub-hole side surface SSH12, a lower end SSH12BE of the second sub-hole side surface SSH12, and a lower center SSH12BC of the second sub-hole side surface SSH12.

In addition, the radius of curvature of the central area of the second sub-hole side surface SSH12 may be different from the radius of curvature of the upper portion SSH12U of the second sub-hole side surface SSH12 and the radius of curvature of the lower portion SSH12B of the second sub-hole side surface SSH12. The radius of curvature of the central area of the second sub-hole side surface SSH12 may be defined as the radius of curvature of a curve passing through the center SSH12C of the second sub-hole side surface SSH12, the upper center SSH12UC of the second sub-hole side surface SSH12, and the lower center SSH12BC of the second sub-hole side surface SSH12.

In addition, the difference between the radius of curvature of an upper central area SSH12UA of the second sub-hole side surface SSH12 and the radius of curvature of a lower central area SSH12BA of the second sub-hole side surface SSH12 may be less than the difference between the radius of curvature of the upper portion SSH12U of the second sub-hole side surface SSH12 and the radius of curvature of the lower portion SSH12B of the second sub-hole side surface SSH12. The radius of curvature of the upper central area SSH12UA of the second sub-hole side surface SSH12 and the radius of curvature of the lower central area SSH12BA of the second sub-hole side surface SSH12 may be substantially the same. Alternatively, the difference between the radius of curvature of the upper central area SSH12UA of the second sub-hole side surface SSH12 and the radius of curvature of the lower central area SSH12BA of the second sub-hole side surface SSH12 may be 30 µm or less.

The radius of curvature of the upper central area SSH12UA of the second sub-hole side surface SSH12 may be defined as the radius of curvature of a curve passing through the center SSH12C of the second sub-hole side surface SSH12, the upper center SSH12UC of the second sub-hole side surface SSH12, and a first point PPH12_1 of the second sub-hole side surface SSH12. The radius of curvature of the lower central SSH12BA of the second sub-hole side surface SSH12 may be defined as the radius of curvature of a curve passing through the center SSH12C of the second sub-hole side surface SSH12, the lower center area SSH12BC of the second sub-hole side surface SSH12, and a second point PPH12_2 of the second sub-hole side surface SSH12. The first point PPH12_1 of the second sub-hole side surface SSH12 may be defined as an intermediate point between the center SSH12C of the second sub-hole side surface SSH12 and the upper center SSH12UC of the second sub-hole side surface SSH12. The second point PPH12_2 of the second sub-hole side surface SSH12 may be defined as an intermediate point between the center SSH12C of the second sub-hole side surface SSH12 and the lower center SSH12BC of the second sub-hole side surface SSH12.

Referring to FIG. 36B, the second hole side surface SSH2 may have a third sub-hole side surface SSH21 having a planar shape or a curved shape and a fourth sub-hole side surface SSH22 having a curved shape with a changing radius of curvature. The length of the third sub-hole side surface SSH21 may be less than the length of the fourth sub-hole side surface SSH22.

The third sub-hole side surface SSH21 may be connected to the top surface US, and the fourth sub-hole side surface SSH22 may be connected to the bottom surface BS. The angle between the third sub-hole side surface SSH21 and the top surface US may be a right angle or an obtuse angle close to a right angle.

The curved shape of an upper portion SSH22U of the fourth sub-hole side surface SSH22 and the curved shape of a lower portion SSH22B of the fourth sub-hole side surface SSH22 may be different. The upper portion SSH22U of the fourth sub-hole side surface SSH22 refers to an area located above a center SSH22C of the fourth sub-hole side surface SSH22. The lower portion SSH22B of the fourth sub-hole side surface SSH22 refers to an area located below the center SSH22C of the fourth sub-hole side surface SSH22.

The radius of curvature of the upper portion SSH22U of the fourth sub-hole side surface SSH22 and the radius of curvature of the lower portion SSH22B of the fourth sub-hole side surface SSH22 may be different. For example, the radius of curvature of the lower portion SSH22B of the fourth sub-hole side surface SSH22 may be less than the radius of curvature of the upper portion SSH22U of the fourth sub-hole side surface SSH22.

The radius of curvature of the upper portion SSH22U of the fourth sub-hole side surface SSH22 may be defined as the radius of curvature of a curve passing through the center SSH22C of the fourth sub-hole side surface SSH22, an upper end SSH22UE of the fourth sub-hole side surface SSH22, and an upper center SSH22UC of the fourth sub-hole side surface SSH22. The radius of curvature of the lower portion SSH22B of the fourth sub-hole side surface SSH22 may be defined as the radius of curvature of a curve passing through the center SSH22C of the fourth sub-hole side surface SSH22, a lower end SSH22BE of the fourth sub-hole side surface SSH22, and a lower center SSH22BC of the fourth sub-hole side surface SSH22.

In addition, the radius of curvature of the central area of the fourth sub-hole side surface SSH22 may be different from the radius of curvature of the upper portion SSH22U of the fourth sub-hole side surface SSH22 and the radius of curvature of the lower portion SSH22B of the fourth sub-hole side surface SSH22. The radius of curvature of the central area of the fourth sub-hole side surface SSH22 may be defined as the radius of curvature of a curve passing through the center SSH22C of the fourth sub-hole side surface SSH22, the upper center SSH22UC of the fourth sub-hole side surface SSH22, and the lower center SSH22BC of the fourth sub-hole side surface SSH22.

In addition, the difference between the radius of curvature of an upper central area SSH22UA of the fourth sub-hole side surface SSH22 and the radius of curvature of a lower central area SSH22BA of the fourth sub-hole side surface SSH22 may be less than the difference between the radius of curvature of the upper portion SSH22U of the fourth sub-hole side surface SSH22 and the radius of curvature of the lower portion SSH22B of the fourth sub-hole side surface SSH22. The radius of curvature of the upper central area SSH22UA of the fourth sub-hole side surface SSH22 and the radius of curvature of the lower central area SSH22BA of the fourth sub-hole side surface SSH22 may be substantially the same. Alternatively, the difference between the radius of curvature of the upper central area SSH22UA of the fourth sub-hole side surface SSH22 and the radius of curvature of the lower central area SSH22BA of the fourth sub-hole side surface SSH22 may be 30 µm or less.

The radius of curvature of the upper central area SSH22UA of the fourth sub-hole side surface SSH22 may be defined as the radius of curvature of a curve passing through the center SSH22C of the fourth sub-hole side surface SSH22, the upper center SSH22UC of the fourth sub-hole side surface SSH22, and a first point PPH22_1 of the fourth sub-hole side surface SSH22. The radius of curvature of the lower central area SSH22BA of the fourth sub-hole side surface SSH22 may be defined as the radius of curvature of a curve passing through the center SSH22C of the fourth sub-hole side surface SSH22, the lower center SSH22BC of the fourth sub-hole side surface SSH22, and a second point PPH22_2 of the fourth sub-hole side surface SSH22. The first point PPH22_1 of the fourth sub-hole side surface SSH22 may be defined as an intermediate point between the center SSH22C of the fourth sub-hole side surface SSH22 and the upper center SSH22UC of the fourth sub-hole side surface SSH22. The second point PPH22_2 of the fourth sub-hole side surface SSH22 may be defined as an intermediate point between the center SSH22C of the fourth sub-hole side surface SSH22 and the lower center SSH22BC of the fourth sub-hole side surface SSH22.

Referring to FIG. 36C, the third hole side surface SSH3 may have a fifth sub-hole side surface SSH31 having a planar shape or a curved shape and a sixth sub-hole side surface SSH32 having a curved shape with a changing radius of curvature. The length of the fifth sub-hole side surface SSH31 may be less than the length of the sixth sub-hole side surface SSH32.

The fifth sub-hole side surface SSH31 may be connected to the top surface US, and the sixth sub-hole side surface SSH32 may be connected to the bottom surface BS. The angle between the fifth sub-hole side surface SSH31 and the top surface US may be a right angle or an obtuse angle close to a right angle.

The curved shape of an upper portion SSH32U of the sixth sub-hole side surface SSH32 and the curved shape of a lower portion SSH32B of the sixth sub-hole side surface SSH32 may be different. The upper portion SSH32U of the sixth sub-hole side surface SSH32 refers to an area located above a center SSH32C of the sixth sub-hole side surface SSH32. The lower portion SSH32B of the sixth sub-hole side surface SSH32 refers to an area located below the center SSH32C of the sixth sub-hole side surface SSH32.

The radius of curvature of the upper portion SSH32U of the sixth sub-hole side surface SSH32 and the radius of curvature of the lower portion SSH32B of the sixth sub-hole side surface SSH32 may be different. For example, the radius of curvature of the lower portion SSH32B of the sixth sub-hole side surface SSH32 may be less than the radius of curvature of the upper portion SSH32U of the sixth sub-hole side surface SSH32.

The radius of curvature of the upper portion SSH32U of the sixth sub-hole side surface SSH32 may be defined as the radius of curvature of a curve passing through the center SSH32C of the sixth sub-hole side surface SSH32, an upper end SSH32UE of the sixth sub-hole side surface SSH32, and an upper center SSH32UC of the sixth sub-hole side surface SSH32. The radius of curvature of the lower portion SSH32B of the sixth sub-hole side surface SSH32 may be defined as the radius of curvature of a curve passing through the center SSH32C of the sixth sub-hole side surface SSH32, a lower end SSH32BE of the sixth sub-hole side surface SSH32, and a lower center SSH32BC of the sixth sub-hole side surface SSH32.

In addition, the radius of curvature of the central area of the sixth sub-hole side surface SSH32 may be different from the radius of curvature of the upper portion SSH32U of the sixth sub-hole side surface SSH32 and the radius of curvature of the lower portion SSH32B of the sixth sub-hole side surface SSH32. The radius of curvature of the central area of the sixth sub-hole side surface SSH32 may be defined as the radius of curvature of a curve passing through the center SSH32C of the sixth sub-hole side surface SSH32, the upper center SSH32UC of the sixth sub-hole side surface SSH32, and the lower center SSH32BC of the sixth sub-hole side surface SSH32.

In addition, the difference between the radius of curvature of an upper central area SSH32UA of the sixth sub-hole side surface SSH32 and the radius of curvature of a lower central area SSH32BA of the sixth sub-hole side surface SSH32 may be less than the difference between the radius of curvature of the upper portion SSH32U of the sixth sub-hole side surface SSH32 and the radius of curvature of the lower portion SSH32B of the sixth sub-hole side surface SSH32. The radius of curvature of the upper central area SSH32UA of the sixth sub-hole side surface SSH32 and the radius of curvature of the lower central area SSH32BA of the sixth sub-hole side surface SSH32 may be substantially the same. Alternatively, the difference between the radius of curvature of the upper central area SSH32UA of the sixth sub-hole side surface SSH32 and the radius of curvature of the lower central area SSH32BA of the sixth sub-hole side surface SSH32 may be 30 µm or less.

The radius of curvature of the upper central area SSH32UA of the sixth sub-hole side surface SSH32 may be defined as the radius of curvature of a curve passing through the center SSH32C of the sixth sub-hole side surface SSH32, the upper center SSH32UC of the sixth sub-hole side surface SSH32, and a first point PPH32_1 of the sixth sub-hole side surface SSH32. The radius of curvature of the lower central area SSH32BA of the sixth sub-hole side surface SSH32 may be defined as the radius of curvature of a curve passing through the center SSH32C of the sixth sub-hole side surface SSH32, the lower center SSH32BC of the sixth sub-hole side surface SSH32, and a second point PPH32_2 of the sixth sub-hole side surface SSH32. The first point PPH32_1 of the sixth sub-hole side surface SSH32 may be defined as an intermediate point between the center SSH32C of the sixth sub-hole side surface SSH32 and the upper center SSH32UC of the sixth sub-hole side surface SSH32. The second point PPH32_2 of the sixth sub-hole side surface SSH32 may be defined as an intermediate point between the center SSH32C of the sixth sub-hole side surface SSH32 and the lower center SSH32BC of the sixth sub-hole side surface SSH32.

Referring to FIG. 36D, the fourth hole side surface SSH4 may have a seventh sub-hole side surface SSH41 having a planar shape or a curved shape and an eighth sub-hole side surface SSH42 having a curved shape with a changing radius of curvature. The length of the seventh sub-hole side surface SSH41 may be less than the length of the eighth sub-hole side surface SSH42.

The seventh sub-hole side surface SSH41 may be connected to the top surface US, and the eighth sub-hole side surface SSH42 may be connected to the bottom surface BS. The angle between the seventh sub-hole side surface SSH41 and the top surface US may be a right angle or an obtuse angle close to a right angle.

The curved shape of an upper portion SSH42U of the eighth sub-hole side surface SSH42 and the curved shape of a lower portion SSH42B of the eighth sub-hole side surface SSH42 may be different. The upper portion SSH42U of the eighth sub-hole side surface SSH42 refers to an area located above a center SSH42C of the eighth sub-hole side surface SSH42. The lower portion SSH42B of the eighth sub-hole side surface SSH42 refers to an area located below the center SSH42C of the eighth sub-hole side surface SSH42.

The radius of curvature of the upper portion SSH42U of the eighth sub-hole side surface SSH42 and the radius of curvature of the lower portion SSH42B of the eighth sub-hole side surface SSH42 may be different. For example, the radius of curvature of the lower portion SSH42B of the eighth sub-hole side surface SSH42 may be less than the radius of curvature of the upper portion SSH42U of the eighth sub-hole side surface SSH42.

The radius of curvature of the upper portion SSH42U of the eighth sub-hole side surface SSH42 may be defined as the radius of curvature of a curve passing through the center SSH42C of the eighth sub-hole side surface SSH42, an upper end SSH42UE of the eighth sub-hole side surface SSH42, and an upper center SSH42UC of the eighth sub-hole side surface SSH42. The radius of curvature of the lower portion SSH42B of the eighth sub-hole side surface SSH42 may be defined as the radius of curvature of a curve passing through the center SSH42C of the eighth sub-hole side surface SSH42, a lower end SSH42BE of the eighth sub-hole side surface SSH42, and a lower center SSH42BC of the eighth sub-hole side surface SSH42.

In addition, the radius of curvature of the central area of the eighth sub-hole side surface SSH42 may be different from the radius of curvature of the upper portion SSH42U of the eighth sub-hole side surface SSH42 and the radius of curvature of the lower portion SSH42B of the eighth sub-hole side surface SSH42. The radius of curvature of the central area of the eighth sub-hole side surface SSH42 may be defined as the radius of curvature of a curve passing through the center SSH42C of the eighth sub-hole side surface SSH42, the upper center SSH42UC of the eighth sub-hole side surface SSH42, and the lower center SSH42BC of the eighth sub-hole side surface SSH42.

In addition, the difference between the radius of curvature of an upper central area SSH42UA of the eighth sub-hole side surface SSH42 and the radius of curvature of a lower central area SSH42BA of the eighth sub-hole side surface SSH42 may be less than the difference between the radius of curvature of the upper portion SSH42U of the eighth sub-hole side surface SSH42 and the radius of curvature of the lower portion SSH42B of the eighth sub-hole side surface SSH42. The radius of curvature of the upper central area SSH42UA of the eighth sub-hole side surface SSH42 and the radius of curvature of the lower central area SSH42BA of the eighth sub-hole side surface SSH42 may be substantially the same. Alternatively, the difference between the radius of curvature of the upper central area SSH42UA of the eighth sub-hole side surface SSH42 and the radius of curvature of the lower central area SSH42BA of the eighth sub-hole side surface SSH42 may be 30 µm or less.

The radius of curvature of the upper central area SSH42UA of the eighth sub-hole side surface SSH42 may be defined as the radius of curvature of a curve passing through the center SSH42C of the eighth sub-hole side surface SSH42, the upper center SSH42UC of the eighth sub-hole side surface SSH42, and a first point PPH42_1 of the eighth sub-hole side surface SSH42. The radius of curvature of the lower central area SSH42BA of the eighth sub-hole side surface SSH42 may be defined as the radius of curvature of a curve passing through the center SSH42C of the eighth sub-hole side surface SSH42, the lower center SSH42BC of the eighth sub-hole side surface SSH42, and a second point PPH42_2 of the eighth sub-hole side surface SSH42. The first point PPH42_1 of the eighth sub-hole side surface SSH42 may be defined as an intermediate point between the center SSH42C of the eighth sub-hole side surface SSH42 and the upper center SSH42UC of the eighth sub-hole side surface SSH42. The second point PPH42_2 of the eighth sub-hole side surface SSH42 may be defined as an intermediate point between the center SSH42C of the eighth sub-hole side surface SSH42 and the lower center SSH42BC of the eighth sub-hole side surface SSH42.

Referring to FIGS. 36A to 36D, the length of the first sub-hole side surface SSH11 of the first hole side surface SSH1, the length of the third sub-hole side surface SSH21 of the second hole side surface SSH2, the length of the fifth sub-hole side surface SSH31 of the third hole side surface SSH3, and the length of the seventh sub-hole side surface SSH41 of the fourth hole side surface SSH4 may be similar to each other. For example, each of the length of the first sub-hole side surface SSH11 of the first hole side surface SSH1, the length of the third sub-hole side surface SSH21 of the second hole side surface SSH2, the length of the fifth sub-hole side surface SSH31 of the third hole side surface SSH3, and the length of the seventh sub-hole side surface SSH41 of the fourth hole side surface SSH4 may be greater than 10 µm and less than 30 µm.

For example, the difference between the length of the first sub-hole side surface SSH11 of the first hole side surface SSH1 and the length of the third sub-hole side surface SSH21 of the second hole side surface SSH2 may be less than approximately 10 µm. The difference between the length of the first sub-hole side surface SSH11 of the first hole side surface SSH1 and the length of the fifth sub-hole side surface SSH31 of the third hole side surface SSH3 may be less than approximately 10 µm. The difference between the length of the first sub-hole side surface SSH11 of the first hole side surface SSH1 and the length of the seventh sub-hole side surface SSH41 of the fourth hole side surface SSH4 may be less than approximately 10 µm. The difference between the length of the third sub-hole side surface SSH21 of the second hole side surface SSH2 and the length of the fifth sub-hole side surface SSH31 of the third hole side surface SSH3 may be less than approximately 10 µm. The difference between the length of the third sub-hole side surface SSH21 of the second hole side surface SSH2 and the length of the seventh sub-hole side surface SSH41 of the fourth hole side surface SSH4 may be less than approximately 10 µm. The difference between the length of the fifth sub-hole side surface SSH31 of the third hole side surface SSH3 and the length of the seventh sub-hole side surface SSH41 of the fourth hole side surface SSH4 may be less than approximately 10 µm.

The radius of curvature of the upper portion SSH12U of the second sub-hole side surface SSH12 of the first hole side surface SSH1, the radius of curvature of the upper portion SSH22U of the fourth sub-hole side surface SSH22 of the second hole side surface SSH2, the radius of curvature of the upper portion SSH32U of the sixth sub-hole side surface SSH32 of the third hole side surface SSH3, and the radius of curvature of the upper portion SSH42U of the eighth sub-hole side surface SSH42 of the fourth hole side surface SSH4 may be similar to each other. For example, the radius of curvature of the upper portion SSH12U of the second sub-hole side surface SSH12 of the first hole side surface SSH1, the radius of curvature of the upper portion SSH22U of the fourth sub-hole side surface SSH22 of the second hole side surface SSH2, the radius of curvature of the upper portion SSH32U of the sixth sub-hole side surface SSH32 of the third hole side surface SSH3, and the radius of curvature of the upper portion SSH42U of the eighth sub-hole side surface SSH42 of the fourth hole side surface SSH4 may be 150 µm to 350 µm.

The difference between the radius of curvature of the upper portion SSH12U of the second sub-hole side surface SSH12 of the first hole side surface SSH1 and the radius of curvature of the upper portion SSH22U of the fourth sub-hole side surface SSH22 of the second hole side surface SSH2 may be less than approximately 30 µm. The difference between the radius of curvature of the upper portion SSH12U of the second sub-hole side surface SSH12 of the first hole side surface SSH1 and the radius of curvature of the upper portion SSH32U of the sixth sub-hole side surface SSH32 of the third hole side surface SSH3 may be less than approximately 30 µm. The difference between the radius of curvature of the upper portion SSH12U of the second sub-hole side surface SSH12 of the first hole side surface SSH1 and the radius of curvature of the upper portion SSH42U of the eighth sub-hole side surface SSH42 of the fourth hole side surface SSH4 may be less than approximately 30 µm. The difference between the radius of curvature of the upper portion SSH22U of the fourth sub-hole side surface SSH22 of the second hole side surface SSH2 and the radius of curvature of the upper portion SSH32U of the sixth sub-hole side surface SSH32 of the third hole side surface SSH3 may be less than approximately 30 µm. The difference between the radius of curvature of the upper portion SSH22U of the fourth sub-hole side surface SSH22 of the second hole side surface SSH2 and the radius of curvature of the upper portion SSH42U of the eighth sub-hole side surface SSH42 of the fourth hole side surface SSH4 may be less than approximately 30 µm. The difference between the radius of curvature of the upper portion SSH32U of the sixth sub-hole side surface SSH32 of the third hole side surface SSH3 and the radius of curvature of the upper portion SSH42U of the eighth sub-hole side surface SSH42 of the fourth hole side surface SSH4 may be less than approximately 30 µm.

In addition, referring to FIGS. 26A to 26D and FIGS. 36A to 36D, each of the radius of curvature of the upper portion SSH12U of the second sub-hole side surface SSH12 of the first hole side surface SSH1, the radius of curvature of the upper portion SSH22U of the fourth sub-hole side surface SSH22 of the second hole side surface SSH2, the radius of curvature of the upper portion SSH32U of the sixth sub-hole side surface SSH32 of the third hole side surface SSH3, and the radius of curvature of the upper portion SSH42U of the eighth sub-hole side surface SSH42 of the fourth hole side surface SSH4 may be similar to the radius of curvature of the upper portion SS12U of the second sub-side surface SS12 of the first side surface SS1, the radius of curvature of the upper portion SS22U of the fourth sub-side surface SS22 of the second side surface SS2, the radius of curvature of the upper portion SS32U of the sixth sub-side surface SS32 of the third side surface SS3, and the radius of curvature of the upper portion SS42U of the eighth sub-side surface SS42 of the fourth side surface SS4. For example, the difference between each of the radius of curvature of the upper portion SSH12U of the second sub-hole side surface SSH12 of the first hole side surface SSH1, the radius of curvature of the upper portion SSH22U of the fourth sub-hole side surface SSH22 of the second hole side surface SSH2, the radius of curvature of the upper portion SSH32U of the sixth sub-hole side surface SSH32 of the third hole side surface SSH3, and the radius of curvature of the upper portion SSH42U of the eighth sub-hole side surface SSH42 of the fourth hole side surface SSH4, and any one of the radius of curvature of the upper portion SS12U of the second sub-side surface SS12 of the first side surface SS1, the radius of curvature of the upper portion SS22U of the fourth sub-side surface SS22 of the second side surface SS2, the radius of curvature of the upper portion SS32U of the sixth sub-side surface SS32 of the third side surface SS3, and the radius of curvature of the upper portion SS42U of the eighth sub-side surface SS42 of the fourth side surface SS4 may be less than approximately 30 µm.

As shown in FIGS. 36A to 36D, the difference in radius of curvature between the hole side surfaces SSH1, SSH2, SSH3, and SSH4 of the substrate SUB of the display panel 100 may be negligible. Accordingly, mechanical strength may be uniformly maintained according to the positions of the hole side surfaces SSH1, SSH2, SSH3, and SSH4 of the substrate SUB of the display panel 100.

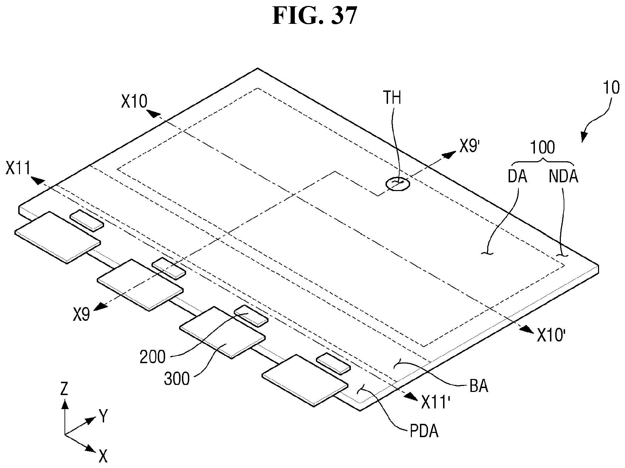

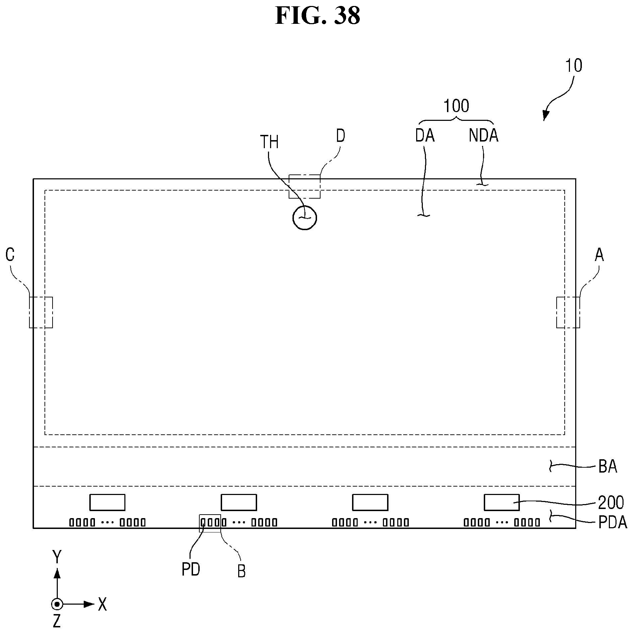

FIG. 37 is a perspective view illustrating a display device according to still another embodiment. FIG. 38 is a plan view illustrating a display panel and driving circuits according to still another embodiment.

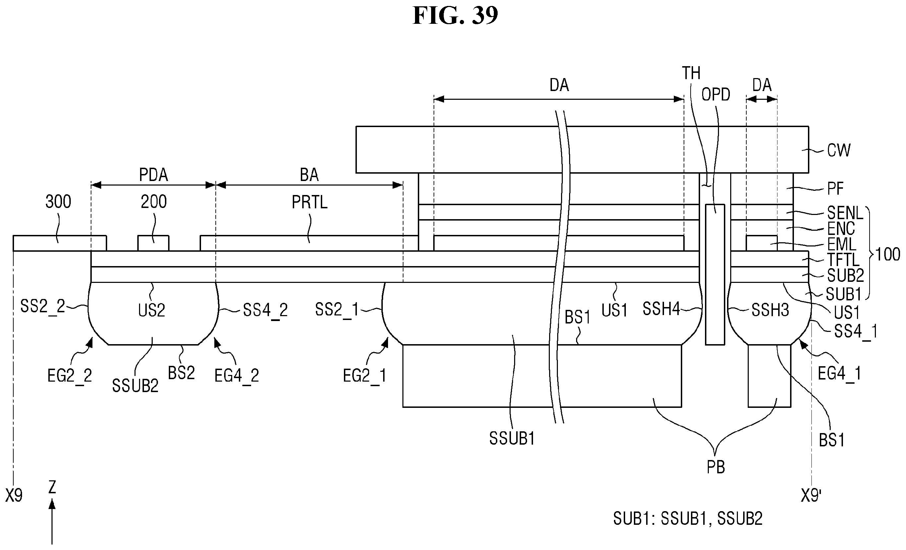

Referring to FIG. 38 and FIG. 39, the display device 10 according to one embodiment may include a bending area BA and a pad area PDA located in the non-display area NDA.

The bending area BA may be located between the display area DA and the pad area PDA in the second direction (Y-axis direction). The bending area BA may extend in the first direction (X-axis direction). The bending area BA refers to an area that bends toward the bottom of the display panel 100. When the bending area BA bends toward the bottom of the display panel 100, the plurality of driving ICs 200 and the circuit board 300 may be located below the display panel 100.

The pad area PDA may be a lower edge area of the display panel 100. The pad area PDA may be the area where display pads PD connected to the circuit board 300 and first and second driving pads DPD1 and DPD2 connected to the driving IC 200 are located.

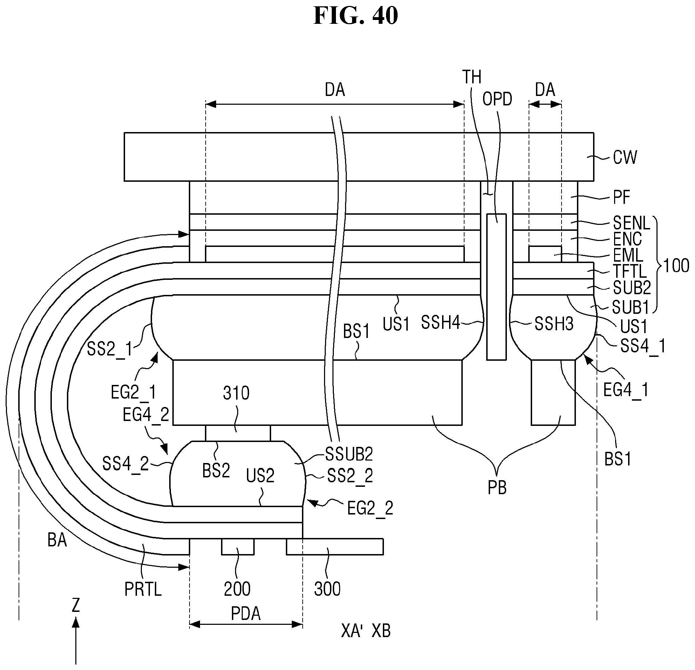

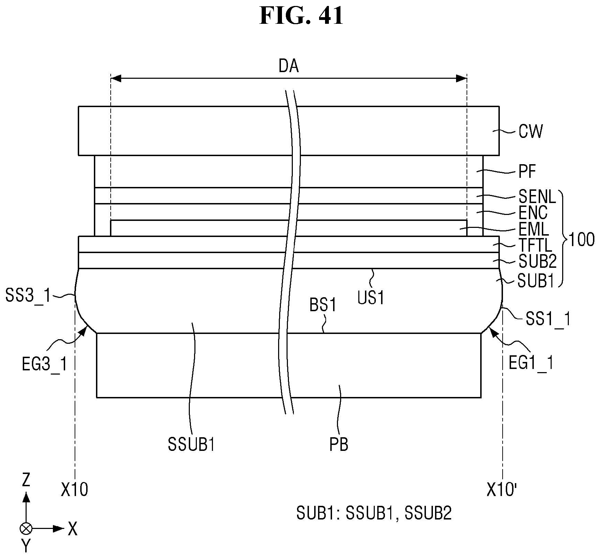

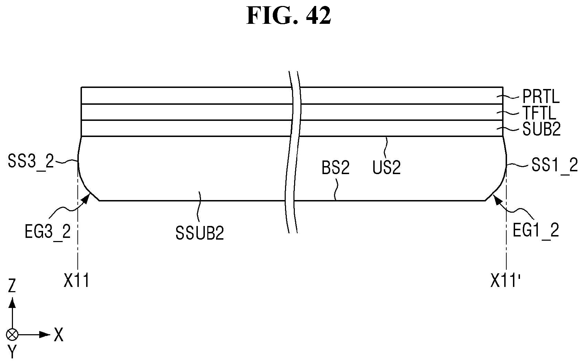

FIG. 39 is a cross-sectional view illustrating an example of a display panel taken along line X9-X9' of FIG. 37. FIG. 40 is a cross-sectional view illustrating an example of a display device in which the bending area is bent in FIG. 39. FIG. 41 is a cross-sectional view illustrating an example of a display panel taken along line X10-X10' of FIG. 37. FIG. 42 is a cross-sectional view illustrating an example of a display panel taken along line X11-X11' of FIG. 37.

Referring to FIGS. 39 to 42, the display panel 100 may include a first substrate SUB1 having a rigid material and a second substrate SUB2 including a polymer resin having a flexible material.

The first substrate SUB1 may include ultra-thin glass (UTG) having a thickness of approximately 500 µm or less, but the embodiment of the present disclosure is not limited thereto. The first substrate SUB1 may include a first sub-substrate SSUB1 located in the display area DA and a second sub-substrate SSUB2 located in the pad area PDA. The area of the first sub-substrate SSUB1 may be greater than the area of the second sub-substrate SSUB2.

The second substrate SUB2 may include a polymer resin having a lower thickness than the first substrate SUB1. For example, the second substrate SUB2 may include an organic material such as acrylic resin, epoxy resin, phenolic resin, polyamide resin, polyimide resin or the like. Since the second substrate SUB2 includes a polymer resin, it may be referred to as a plastic substrate. Alternatively, since the second substrate SUB2 includes an organic material, it may be referred to as an organic film.

The first substrate SUB1 may not be located in the bending area BA. That is, since the bending area BA includes only the second substrate SUB2 having a flexible material, it may be easily bent.

The thin film transistor layer TFTL may be located in the display area DA, the bending area BA, and the pad area PDA.

A protective film PRTL may be located on the thin film transistor layer TFTL in the bending area BA. The protective film PRTL may be a layer for protecting the exposed thin film transistor layer TFTL, which is exposed to the outside in the bending area BA. The protective film PRTL may include an organic material such as acrylic resin, epoxy resin, phenolic resin, polyamide resin, polyimide resin or the like.

The first sub-substrate SSUB1 includes the top surface US, the bottom surface BS, and first to fourth side surfaces SS1_1, SS2_1, SS3_1, and SS4_1, and the second sub-substrate SSUB2 includes the top surface US, the bottom surface BS, and first to fourth side surfaces SS1_2, SS2_2, SS3_2, and SS4_2.

The first side surface SS1_1 of the first sub-substrate SSUB1 refers to a side surface located at a first side edge EG1_1 of the first sub-substrate SSUB1, and the second side surface SS2_1 of the first sub-substrate SSUB1 refers to a side surface located at a second side edge EG2_1 of the first sub-substrate SSUB1. The third side surface SS3_1 of the first sub-substrate SSUB1 refers to a side surface located at a third side edge EG3_1 of the first sub-substrate SSUB1, and the fourth side surface SS4_1 of the first sub-substrate SSUB1 refers to a side surface located at a fourth side edge EG4_1 of the first sub-substrate SSUB1.

The first side surface SS1_2 of the second sub-substrate SSUB2 refers to a side surface located at a first side edge EG1_2 of the second sub-substrate SSUB2, and the second side surface SS2_2 of the second sub-substrate SSUB2 refers to a side surface located at a second side edge EG2_2 of the second sub-substrate SSUB2. The third side surface SS3_2 of the second sub-substrate SSUB2 refers to a side surface located at a third side edge EG3_2 of the second sub-substrate SSUB2, and the fourth side surface SS4_2 of the second sub-substrate SSUB2 refers to a side surface located at a fourth side edge EG4_2 of the second sub-substrate SSUB2.

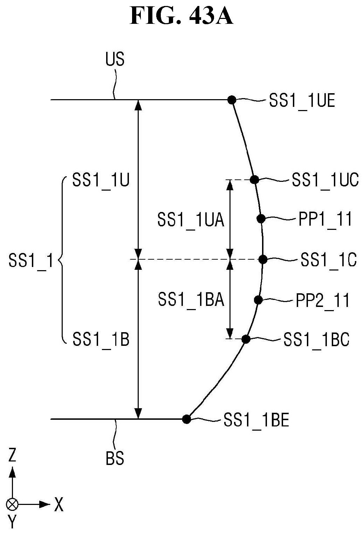

Hereinafter, the first to fourth side surfaces SS1_1, SS2_1, SS3_1, and SS4_1 of the first sub-substrate SSUB1 and the first to fourth side surfaces SS1_2, SS2_2, SS3_2, and SS4_2 of the second sub-substrate SSUB2 will be described in detail in conjunction with FIGS. 43A to 43D, FIGS. 44A to 44D, FIGS. 45A to 45D, and FIGS. 46A to 46D.

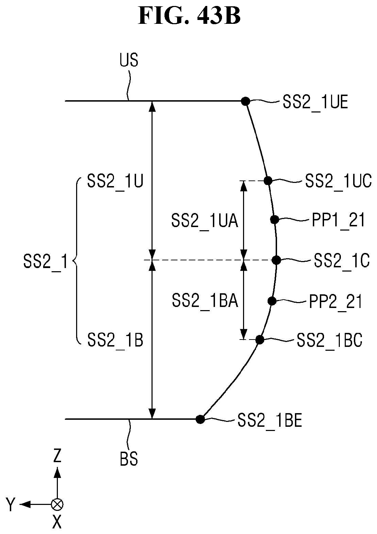

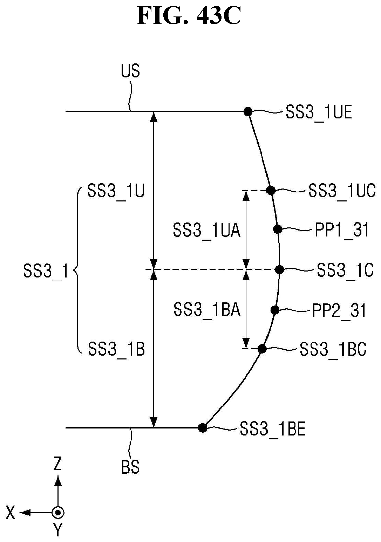

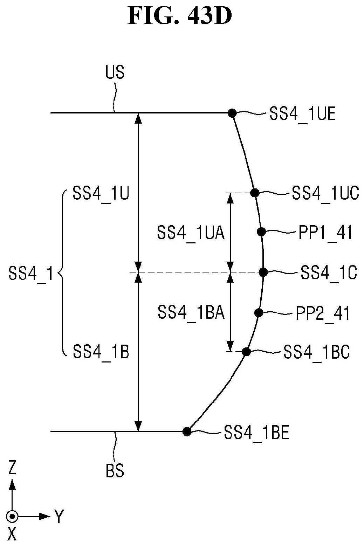

FIGS. 43A to 43D are enlarged cross-sectional views showing examples of the first to fourth side surfaces of the first sub-substrate in FIGS. 39 and 41. FIG. 43A shows a cross-section of the first side surface SS1_1 of the first sub-substrate SSUB1, FIG. 43B shows a cross-section of the second side surface SS2_1 of the first sub-substrate SSUB1, FIG. 43C shows a cross-section of the third side surface SS3_1 of the first sub-substrate SSUB1, and FIG. 43D shows a cross-section of the fourth side surface SS4_1 of the first sub-substrate SSUB1.

Referring to FIG. 43A, the first side surface SS1_1 of the first sub-substrate SSUB1 may have a curved shape with a changing radius of curvature. The curved shape of an upper portion SS1_1U and the curved shape of a lower portion SS1_1B of the first side surface SS1_1 of the first sub-substrate SSUB1 may be different. The upper portion SS1_1U of the first side surface SS1_1 of the first sub-substrate SSUB1 refers to an area located above a center SS1_1C of the first side surface SS1_1 of the first sub-substrate SSUB1. The lower portion SS1_1B of the first side surface SS1_1 of the first sub-substrate SSUB1 refers to an area located below the center SS1_1C of the first side surface SS1_1 of the first sub-substrate SSUB1.

The radius of curvature of the upper portion SS1_1U of the first side surface SS1_1 of the first sub-substrate SSUB1 and the radius of curvature of the lower portion SS1_1B of the first side surface SS1_1 of the first sub-substrate SSUB1 may be different. For example, the radius of curvature of the lower portion SS1_1B of the first side surface SS1_1 of the first sub-substrate SSUB1 may be less than the radius of curvature of the upper portion SS1_1U of the first side surface SS1_1 of the first sub-substrate SSUB1.

The radius of curvature of the upper portion SS1_1U of the first side surface SS1_1 of the first sub-substrate SSUB1 may be defined as the radius of curvature of a curve passing through the center SS1_1C of the first side surface SS1_1 of the first sub-substrate SSUB1, an upper end SS1_1UE of the first side surface SS1_1 of the first sub-substrate SSUB1, and an upper center SS1_1UC of the first side surface SS1_1 of the first sub-substrate SSUB1. The radius of curvature of the lower portion SS1_1B of the first side surface SS1_1 of the first sub-substrate SSUB1 may be defined as the radius of curvature of a curve passing through the center SS1_1C of the first side surface SS1_1 of the first sub-substrate SSUB1, a lower end SS1_1BE of the first side surface SS1_1 of the first sub-substrate SSUB1, and a lower center SS1_1BC of the first side surface SS1_1 of the first sub-substrate SSUB1.

In addition, the radius of curvature of the central area of the first side surface SS1_1 of the first sub-substrate SSUB1 may be different from the radius of curvature of the upper portion SS1_1U of the first side surface SS1_1 of the first sub-substrate SSUB1 and the radius of curvature of the lower portion SS1_1B of the first side surface SS1_1 of the first sub-substrate SSUB1. The radius of curvature of the central area of the first side surface SS1_1 of the first sub-substrate SSUB1 may be defined as the radius of curvature of a curve passing through the center SS1_1C, the upper center SS1_1UC, and the lower center SS1_1BC of the first side surface SS1_1 of the first sub-substrate SSUB1.

In addition, the difference between the radius of curvature of an upper central area SS1_1UA of the first side surface SS1_1 of the first sub-substrate SSUB1 and the radius of curvature of a lower central area SS1_1BA of the first side surface SS1_1 of the first sub-substrate SSUB1 may be less than the difference between the radius of curvature of the upper portion SS1_1U of the first side surface SS1_1 of the first sub-substrate SSUB1 and the radius of curvature of the lower portion SS1_1B of the first side surface SS1_1 of the first sub-substrate SSUB1. The radius of curvature of the upper central area SS1_1UA of the first side surface SS1_1 of the first sub-substrate SSUB1 and the radius of curvature of the lower central area SS1_1BA of the first side surface SS1_1 of the first sub-substrate SSUB1 may be substantially the same. Alternatively, the difference between the radius of curvature of the upper central area SS1_1UA of the first side surface SS1_1 of the first sub-substrate SSUB1 and the radius of curvature of the lower central area SS1_1BA of the first side surface SS1_1 of the first sub-substrate SSUB1 may be 30 µm or less.

The radius of curvature of the upper central area SS1_1UA of the first side surface SS1_1 of the first sub-substrate SSUB1 may be defined as the radius of curvature of a curve passing through the center SS1_1C, the upper center SS1_1UC, and a first point PP1_11 of the first side surface SS1_1 of the first sub-substrate SSUB1. The radius of curvature of the lower central area SS1_1BA of the first side surface SS1_1 of the first sub-substrate SSUB1 may be defined as the radius of curvature of a curve passing through the center SS1_1C, the lower center SS1_1BC, and a second point PP2_11 of the first side surface SS1_1 of the first sub-substrate SSUB1. The first point PP1_11 of the first side surface SS1_1 of the first sub-substrate SSUB1 may be defined as an intermediate point between the center SS1_1C and the upper center SS1_1UC of the first side surface SS1_1 of the first sub-substrate SSUB1. The second point PP2_11 of the first side surface SS1_1 of the first sub-substrate SSUB1 may be defined as an intermediate point between the center SS1_1C and the lower center SS1_1BC of the first side surface SS1_1 of the first sub-substrate SSUB1.

Referring to FIG. 43B, the second side surface SS2_1 of the first sub-substrate SSUB1 may have a curved shape with a changing radius of curvature. The curved shape of an upper portion SS2_1U and the curved shape of a lower portion SS2_1B of the second side surface SS2_1 of the first sub-substrate SSUB1 may be different. The upper portion SS2_1U of the second side surface SS2_1 of the first sub-substrate SSUB1 refers to an area located above a center SS2_1C of the second side surface SS2_1 of the first sub-substrate SSUB1. The lower portion SS2_1B of the second side surface SS2_1 of the first sub-substrate SSUB1 refers to an area located below the center SS2_1C of the second side surface SS2_1 of the first sub-substrate SSUB1.

The radius of curvature of the upper portion SS2_1U of the second side surface SS2_1 of the first sub-substrate SSUB1 and the radius of curvature of the lower portion SS2_1B of the second side surface SS2_1 of the first sub-substrate SSUB1 may be different. For example, the radius of curvature of the lower portion SS2_1B of the second side surface SS2_1 of the first sub-substrate SSUB1 may be less than the radius of curvature of the upper portion SS2_1U of the second side surface SS2_1 of the first sub-substrate SSUB1.

The radius of curvature of the upper portion SS2_1U of the second side surface SS2_1 of the first sub-substrate SSUB1 may be defined as the radius of curvature of a curve passing through the center SS2_1C of the second side surface SS2_1 of the first sub-substrate SSUB1, an upper end SS2_1UE of the second side surface SS2_1 of the first sub-substrate SSUB1, and an upper center SS2_1UC of the second side surface SS2_1 of the first sub-substrate SSUB1. The radius of curvature of the lower portion SS2_1B of the second side surface SS2_1 of the first sub-substrate SSUB1 may be defined as the radius of curvature of a curve passing through the center SS2_1C of the second side surface SS2_1 of the first sub-substrate SSUB1, a lower end SS2_1BE of the second side surface SS2_1 of the first sub-substrate SSUB1, and a lower center SS2_1BC of the second side surface SS2_1 of the first sub-substrate SSUB1.

In addition, the radius of curvature of the central area of the second side surface SS2_1 of the first sub-substrate SSUB1 may be different from the radius of curvature of the upper portion SS2_1U of the second side surface SS2_1 of the first sub-substrate SSUB1 and the radius of curvature of the lower portion SS2_1B of the second side surface SS2_1 of the first sub-substrate SSUB1. The radius of curvature of the central area of the second side surface SS2_1 of the first sub-substrate SSUB1 may be defined as the radius of curvature of a curve passing through the center SS2_1C, the upper center SS2_1UC, and the lower center SS2_1BC of the second side surface SS2_1 of the first sub-substrate SSUB1.

In addition, the difference between the radius of curvature of an upper central area SS2_1UA of the second side surface SS2_1 of the first sub-substrate SSUB1 and the radius of curvature of a lower central area SS2_1BA of the second side surface SS2_1 of the first sub-substrate SSUB1 may be less than the difference between the radius of curvature of the upper portion SS2_1U of the second side surface SS2_1 of the first sub-substrate SSUB1 and the radius of curvature of the lower portion SS2_1B of the second side surface SS2_1 of the first sub-substrate SSUB1. The radius of curvature of the upper central area SS2_1UA of the second side surface SS2_1 of the first sub-substrate SSUB1 and the radius of curvature of the lower central area SS2_1BA of the second side surface SS2_1 of the first sub-substrate SSUB1 may be substantially the same. Alternatively, the difference between the radius of curvature of the upper central area SS2_1UA of the second side surface SS2_1 of the first sub-substrate SSUB1 and the radius of curvature of the lower central area SS2_1BA of the second side surface SS2_1 of the first sub-substrate SSUB1 may be 30 µm or less.

The radius of curvature of the upper central SS2_1UA of the second side surface SS2_1 of the first sub-substrate SSUB1 may be defined as the radius of curvature of a curve passing through the center SS2_1C, the upper center SS2_1UC, and a first point PP1_21 of the second side surface SS2_1 of the first sub-substrate SSUB1. The radius of curvature of the lower central SS2_1BA of the second side surface SS2_1 of the first sub-substrate SSUB1 may be defined as the radius of curvature of a curve passing through the center SS2_1C, the lower center SS2_1BC, and a second point PP2_21 of the second side surface SS2_1 of the first sub-substrate SSUB1. The first point PP1_21 of the second side surface SS2_1 of the first sub-substrate SSUB1 may be defined as an intermediate point between the center SS2_1C and the upper center SS2_1UC of the second side surface SS2_1 of the first sub-substrate SSUB1. The second point PP2_21 of the second side surface SS2_1 of the first sub-substrate SSUB1 may be defined as an intermediate point between the center SS2_1C and the lower center SS2_1BC of the second side surface SS2_1 of the first sub-substrate SSUB1.

Referring to FIG. 43C, the third side surface SS3_1 of the first sub-substrate SSUB1 may have a curved shape with a changing radius of curvature. The curved shape of an upper portion SS3_1U and the curved shape of a lower portion SS3_1B of the third side surface SS3_1 of the first sub-substrate SSUB1 may be different. The upper portion SS3_1U of the third side surface SS3_1 of the first sub-substrate SSUB1 refers to an area located above a center SS3_1C of the third side surface SS3_1 of the first sub-substrate SSUB1. The lower portion SS3_1B of the third side surface SS3_1 of the first sub-substrate SSUB1 refers to an area located below the center SS3_1C of the third side surface SS3_1 of the first sub-substrate SSUB1.

The radius of curvature of the upper portion SS3_1U of the third side surface SS3_1 of the first sub-substrate SSUB1 and the radius of curvature of the lower portion SS3_1B of the third side surface SS3_1 of the first sub-substrate SSUB1 may be different. For example, the radius of curvature of the lower portion SS3_1B of the third side surface SS3_1 of the first sub-substrate SSUB1 may be less than the radius of curvature of the upper portion SS3_1U of the third side surface SS3_1 of the first sub-substrate SSUB1.

The radius of curvature of the upper portion SS3_1U of the third side surface SS3_1 of the first sub-substrate SSUB1 may be defined as the radius of curvature of a curve passing through the center SS3_1C of the third side surface SS3_1 of the first sub-substrate SSUB1, an upper end SS3_1UE of the third side surface SS3_1 of the first sub-substrate SSUB1, and an upper center SS3_1UC of the third side surface SS3_1 of the first sub-substrate SSUB1. The radius of curvature of the lower portion SS3_1B of the third side surface SS3_1 of the first sub-substrate SSUB1 may be defined as the radius of curvature of a curve passing through the center SS3_1C of the third side surface SS3_1 of the first sub-substrate SSUB1, a lower end SS3_1BE of the third side surface SS3_1 of the first sub-substrate SSUB1, and a lower center SS3_1BC of the third side surface SS3_1 of the first sub-substrate SSUB1.

In addition, the radius of curvature of the central area of the third side surface SS3_1 of the first sub-substrate SSUB1 may be different from the radius of curvature of the upper portion SS3_1U of the third side surface SS3_1 of the first sub-substrate SSUB1 and the radius of curvature of the lower portion SS3_1B of the third side surface SS3_1 of the first sub-substrate SSUB1. The radius of curvature of the central area of the third side surface SS3_1 of the first sub-substrate SSUB1 may be defined as the radius of curvature of a curve passing through the center SS3_1C, the upper center SS3_1UC, and the lower center SS3_1BC of the third side surface SS3_1 of the first sub-substrate SSUB1.

In addition, the difference between the radius of curvature of an upper central area SS3_1UA of the third side surface SS3_1 of the first sub-substrate SSUB1 and the radius of curvature of a lower central area SS3_1BA of the third side surface SS3_1 of the first sub-substrate SSUB1 may be less than the difference between the radius of curvature of the upper portion SS3_1U of the third side surface SS3_1 of the first sub-substrate SSUB1 and the radius of curvature of the lower portion SS3_1B of the third side surface SS3_1 of the first sub-substrate SSUB1. The radius of curvature of the upper central area SS3_1UA of the third side surface SS3_1 of the first sub-substrate SSUB1 and the radius of curvature of the lower central area SS3_1BA of the third side surface SS3_1 of the first sub-substrate SSUB1 may be substantially the same. Alternatively, the difference between the radius of curvature of the upper central area SS3_1UA of the third side surface SS3_1 of the first sub-substrate SSUB1 and the radius of curvature of the lower central area SS3_1BA of the third side surface SS3_1 of the first sub-substrate SSUB1 may be 30 µm or less.

The radius of curvature of the upper central area SS3_1UA of the third side surface SS3_1 of the first sub-substrate SSUB1 may be defined as the radius of curvature of a curve passing through the center SS3_1C, the upper center SS3_1UC, and a first point PP1_31 of the third side surface SS3_1 of the first sub-substrate SSUB1. The radius of curvature of the lower central area SS3_1BA of the third side surface SS3_1 of the first sub-substrate SSUB1 may be defined as the radius of curvature of a curve passing through the center SS3_1C, the lower center SS3_1BC, and a second point PP2_31 of the third side surface SS3_1 of the first sub-substrate SSUB1. The first point PP1_31 of the third side surface SS3_1 of the first sub-substrate SSUB1 may be defined as an intermediate point between the center SS3_1C and the upper center SS3_1UC of the third side surface SS3_1 of the first sub-substrate SSUB1. The second point PP2_31 of the third side surface SS3_1 of the first sub-substrate SSUB1 may be defined as an intermediate point between the center SS3_1C and the lower center SS3_1BC of the third side surface SS3_1 of the first sub-substrate SSUB1.

Referring to FIG. 43D, the fourth side surface SS4_1 of the first sub-substrate SSUB1 may have a curved shape with a changing radius of curvature. The curved shape of an upper portion SS4_1U and the curved shape of a lower portion SS4_1B of the fourth side surface SS4_1 of the first sub-substrate SSUB1 may be different. The upper portion SS4_1U of the fourth side surface SS4_1 of the first sub-substrate SSUB1 refers to an area located above a center SS4_1C of the fourth side surface SS4_1 of the first sub-substrate SSUB1. The lower portion SS4_1B of the fourth side surface SS4_1 of the first sub-substrate SSUB1 refers to an area located below the center SS4_1C of the fourth side surface SS4_1 of the first sub-substrate SSUB1.

The radius of curvature of the upper portion SS4_1U of the fourth side surface SS4_1 of the first sub-substrate SSUB1 and the radius of curvature of the lower portion SS4_1B of the fourth side surface SS4_1 of the first sub-substrate SSUB1 may be different. For example, the radius of curvature of the lower portion SS4_1B of the fourth side surface SS4_1 of the first sub-substrate SSUB1 may be less than the radius of curvature of the upper portion SS4_1U of the fourth side surface SS4_1 of the first sub-substrate SSUB1.

The radius of curvature of the upper portion SS4_1U of the fourth side surface SS4_1 of the first sub-substrate SSUB1 may be defined as the radius of curvature of a curve passing through the center SS4_1C of the fourth side surface SS4_1 of the first sub-substrate SSUB1, an upper end SS4_1UE of the fourth side surface SS4_1 of the first sub-substrate SSUB1, and an upper center SS4_1UC of the fourth side surface SS4_1 of the first sub-substrate SSUB1. The radius of curvature of the lower portion SS4_1B of the fourth side surface SS4_1 of the first sub-substrate SSUB1 may be defined as the radius of curvature of a curve passing through the center SS4_1C of the fourth side surface SS4_1 of the first sub-substrate SSUB1, a lower end SS4_1BE of the fourth side surface SS4_1 of the first sub-substrate SSUB1, and a lower center SS4_1BC of the fourth side surface SS4_1 of the first sub-substrate SSUB1.

In addition, the radius of curvature of the central area of the fourth side surface SS4_1 of the first sub-substrate SSUB1 may be different from the radius of curvature of the upper portion SS4_1U of the fourth side surface SS4_1 of the first sub-substrate SSUB1 and the radius of curvature of the lower portion SS4_1B of the fourth side surface SS4_1 of the first sub-substrate SSUB1. The radius of curvature of the central area of the fourth side surface SS4_1 of the first sub-substrate SSUB1 may be defined as the radius of curvature of a curve passing through the center SS4_1C, the upper center SS4_1UC, and the lower center SS4_1BC of the fourth side surface SS4_1 of the first sub-substrate SSUB1.

In addition, the difference between the radius of curvature of an upper central area SS4_1UA of the fourth side surface SS4_1 of the first sub-substrate SSUB1 and the radius of curvature of a lower central area SS4_1BA of the fourth side surface SS4_1 of the first sub-substrate SSUB1 may be less than the difference between the radius of curvature of the upper portion SS4_1U of the fourth side surface SS4_1 of the first sub-substrate SSUB1 and the radius of curvature of the lower portion SS4_1B of the fourth side surface SS4_1 of the first sub-substrate SSUB1. The radius of curvature of the upper central area SS4_1UA of the fourth side surface SS4_1 of the first sub-substrate SSUB1 and the radius of curvature of the lower central area SS4_1BA of the fourth side surface SS4_1 of the first sub-substrate SSUB1 may be substantially the same. Alternatively, the difference between the radius of curvature of the upper central area SS4_1UA of the fourth side surface SS4_1 of the first sub-substrate SSUB1 and the radius of curvature of the lower central area SS4_1BA of the fourth side surface SS4_1 of the first sub-substrate SSUB1 may be 30 µm or less.

The radius of curvature of the upper central area SS4_1UA of the fourth side surface SS4_1 of the first sub-substrate SSUB1 may be defined as the radius of curvature of a curve passing through the center SS4_1C, the upper center SS4_1UC, and a first point PP1_41 of the fourth side surface SS4_1 of the first sub-substrate SSUB1. The radius of curvature of the lower central area SS4_1BA of the fourth side surface SS4_1 of the first sub-substrate SSUB1 may be defined as the radius of curvature of a curve passing through the center SS4_1C, the lower center SS4_1BC, and a second point PP2_41 of the fourth side surface SS4_1 of the first sub-substrate SSUB1. The first point PP1_41 of the fourth side surface SS4_1 of the first sub-substrate SSUB1 may be defined as an intermediate point between the center SS4_1C and the upper center SS4_1UC of the fourth side surface SS4_1 of the first sub-substrate SSUB1. The second point PP2_41 of the fourth side surface SS4_1 of the first sub-substrate SSUB1 may be defined as an intermediate point between the center SS4_1C and the lower center SS4_1BC of the fourth side surface SS4_1 of the first sub-substrate SSUB1.

Referring to FIGS. 43A to 43D, the radius of curvature of the upper portion SS1_1U of the first side surface SS1_1, the radius of curvature of the upper portion SS2_1U of the second side surface SS2_1, the radius of curvature of the upper portion SS3_1U of the third side surface SS3_1, and the radius of curvature of the upper portion SS4_1U of the fourth side surface SS4_1 of the first sub-substrate SSUB1 may be similar to each other. For example, the radius of curvature of the upper portion SS1_1U of the first side surface SS1_1, the radius of curvature of the upper portion SS2_1U of the second side surface SS2_1, the radius of curvature of the upper portion SS3_1U of the third side surface SS3_1, and the radius of curvature of the upper portion SS4_1U of the fourth side surface SS4_1 of the first sub-substrate SSUB1 may be 150 µm to 350 µm.

The difference between the radius of curvature of the upper portion SS1_1U of the first side surface SS1_1 and the radius of curvature of the upper portion SS2_1U of the second side surface SS2_1 of the first sub-substrate SSUB1 may be less than approximately 30 µm. The difference between the radius of curvature of the upper portion SS1_1U of the first side surface SS1_1 and the radius of curvature of the upper portion SS3_1U of the third side surface SS3_1 of the first sub-substrate SSUB1 may be less than approximately 30 µm. The difference between the radius of curvature of the upper portion SS1_1U of the first side surface SS1_1 and the radius of curvature of the upper portion SS4_1U of the fourth side surface SS4_1 of the first sub-substrate SSUB1 may be less than approximately 30 µm. The difference between the radius of curvature of the upper portion SS2_1U of the second side surface SS2_1 and the radius of curvature of the upper portion SS3_1U of the third side surface SS3_1 of the first sub-substrate SSUB1 may be less than approximately 30 µm. The difference between the radius of curvature of the upper portion SS2_1U of the second side surface SS2_1 and the radius of curvature of the upper portion SS4_1U of the fourth side surface SS4_1 of the first sub-substrate SSUB1 may be less than approximately 30 µm. The difference between the radius of curvature of the upper portion SS3_1U of the third side surface SS3_1 and the radius of curvature of the upper portion SS4_1U of the fourth side surface SS4_1 of the first sub-substrate SSUB1 may be less than approximately 30 µm.

In addition, referring to FIGS. 25A to 25D and FIGS. 43A to 43D, each of the radius of curvature of the upper portion SS1_1U of the first side surface SS1_1, the radius of curvature of the upper portion SS2_1U of the second side surface SS2_1, the radius of curvature of the upper portion SS3_1U of the third side surface SS3_1, and the radius of curvature of the upper portion SS4_1U of the fourth side surface SS4_1 of the first sub-substrate SSUB1 may be similar to the radius of curvature of the upper portion SS1U of the first side surface SS1, the radius of curvature of the upper portion SS2U of the second side surface SS2, the radius of curvature of the upper portion SS3U of the third side surface SS3, and the radius of curvature of the upper portion SS4U of the fourth side surface SS4. For example, the difference between each of the radius of curvature of the upper portion SS1_1U of the first side surface SS1_1, the radius of curvature of the upper portion SS2_1U of the second side surface SS2_1, the radius of curvature of the upper portion SS3_1U of the third side surface SS3_1, and the radius of curvature of the upper portion SS4_1U of the fourth side surface SS4_1 of the first sub-substrate SSUB1, and any one of the radius of curvature of the upper portion SS1U of the first side surface SS1, the radius of curvature of the upper portion SS2U of the second side surface SS2, the radius of curvature of the upper portion SS3U of the third side surface SS3, and the radius of curvature of the upper portion SS4U of the fourth side surface SS4 may be less than approximately 30 µm.

In addition, referring to FIGS. 35A to 35D and FIGS. 43A to 43D, each of the radius of curvature of the upper portion SS1_1U of the first side surface SS1_1, the radius of curvature of the upper portion SS2_1U of the second side surface SS2_1, the radius of curvature of the upper portion SS3_1U of the third side surface SS3_1, and the radius of curvature of the upper portion SS4_1U of the fourth side surface SS4_1 of the first sub-substrate SSUB1 may be similar to the radius of curvature of the upper portion SSH1U of the first hole side surface SSH1, the radius of curvature of the upper portion SSH2U of the second hole side surface SSH2, the radius of curvature of the upper portion SSH3U of the third hole side surface SSH3, and the radius of curvature of the upper portion SSH4U of the fourth hole side surface SSH4. For example, the difference between each of the radius of curvature of the upper portion SS1_1U of the first side surface SS1_1, the radius of curvature of the upper portion SS2_1U of the second side surface SS2_1, the radius of curvature of the upper portion SS3_1U of the third side surface SS3_1, and the radius of curvature of the upper portion SS4_1U of the fourth side surface SS4_1 of the first sub-substrate SSUB1, and any one of the radius of curvature of the upper portion SSH1U of the first hole side surface SSH1, the radius of curvature of the upper portion SSH2U of the second hole side surface SSH2, the radius of curvature of the upper portion SSH3U of the third hole side surface SSH3, and the radius of curvature of the upper portion SSH4U of the fourth hole side surface SSH4 may be less than approximately 30 µm.

As shown in FIGS. 43A to 43D, the difference in radius of curvature between the side surfaces SS1_1, SS2_1, SS3_1, and SS4_1 of the first sub-substrate SSUB1 of the display panel 100 may be negligible. Accordingly, mechanical strength may be uniformly maintained according to the positions of the side surfaces SS1_1, SS2_1, SS3_1, and SS4_1 of the first sub-substrate SSUB1 of the display panel 100.

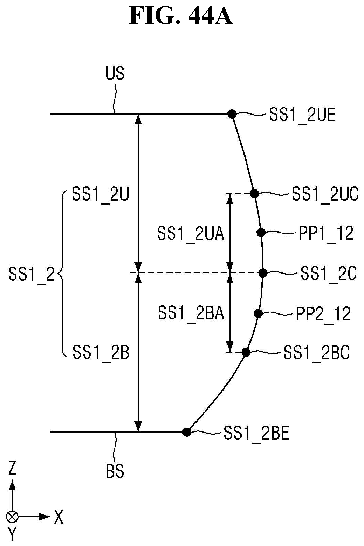

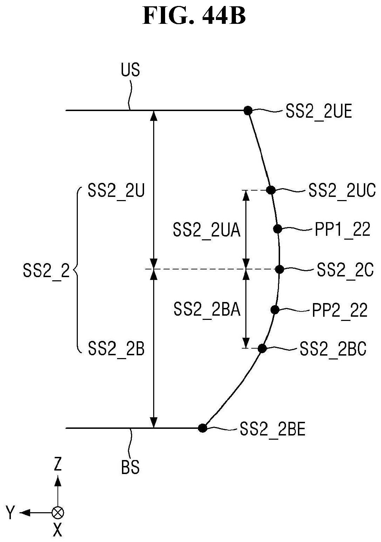

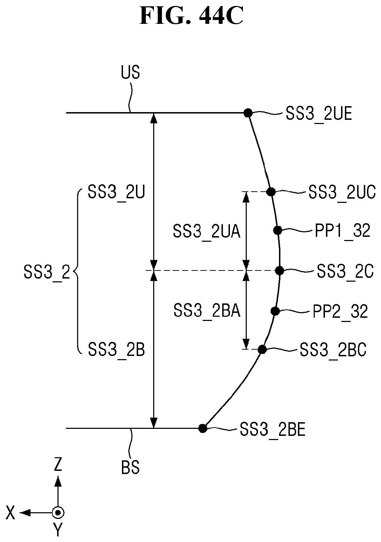

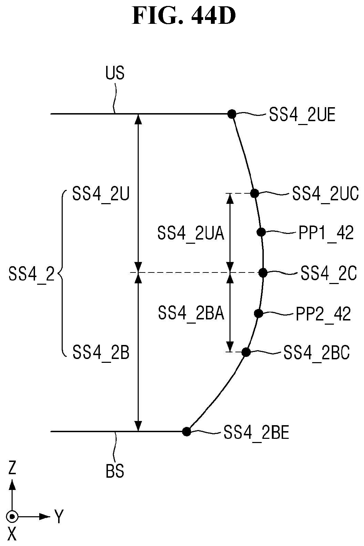

FIGS. 44A to 44D are enlarged cross-sectional views showing examples of the first to fourth side surfaces of the second sub-substrate in FIGS. 39 and 42. FIG. 44A shows a cross-section of the first side surface SS1_2 of the second sub-substrate SSUB2, FIG. 44B shows a cross-section of the second side surface SS2_2 of the second sub-substrate SSUB2, FIG. 44C shows a cross-section of the third side surface SS3_2 of the second sub-substrate SSUB2, and FIG. 44D shows a cross-section of the fourth side surface SS4_2 of the second sub-substrate SSUB2.

Referring to FIG. 44A, the first side surface SS1_2 of the second sub-substrate SSUB2 may have a curved shape with a changing radius of curvature. The curved shape of an upper portion SS1_2U and the curved shape of a lower portion SS1_2B of the first side surface SS1_2 of the second sub-substrate SSUB2 may be different. The upper portion SS1_2U of the first side surface SS1_2 of the second sub-substrate SSUB2 refers to an area located above a center SS1_2C of the first side surface SS1_2 of the second sub-substrate SSUB2. The lower portion SS1_2B of the first side surface SS1_2 of the second sub-substrate SSUB2 refers to an area located below the center SS1_2C of the first side surface SS1_2 of the second sub-substrate SSUB2.

The radius of curvature of the upper portion SS1_2U of the first side surface SS1_2 of the second sub-substrate SSUB2 and the radius of curvature of the lower portion SS1_2B of the first side surface SS1_2 of the second sub-substrate SSUB2 may be different. For example, the radius of curvature of the lower portion SS1_2B of the first side surface SS1_2 of the second sub-substrate SSUB2 may be less than the radius of curvature of the upper portion SS1_2U of the first side surface SS1_2 of the second sub-substrate SSUB2.

The radius of curvature of the upper portion SS1_2U of the first side surface SS1_2 of the second sub-substrate SSUB2 may be defined as the radius of curvature of a curve passing through the center SS1_2C of the first side surface SS1_2 of the second sub-substrate SSUB2, an upper end SS1_2UE of the first side surface SS1_2 of the second sub-substrate SSUB2, and an upper center SS1_2UC of the first side surface SS1_2 of the first sub-substrate SSUB2. The radius of curvature of the lower portion SS1_2B of the first side surface SS1_2 of the second sub-substrate SSUB2 may be defined as the radius of curvature of a curve passing through the center SS1_2C of the first side surface SS1_2 of the second sub-substrate SSUB2, a lower end SS1_2BE of the first side surface SS1_2 of the second sub-substrate SSUB2, and a lower center SS1_2BC of the first side surface SS1_2 of the second sub-substrate SSUB2.

In addition, the radius of curvature of the central area of the first side surface SS1_2 of the second sub-substrate SSUB2 may be different from the radius of curvature of the upper portion SS1_2U of the first side surface SS1_2 of the second sub-substrate SSUB2 and the radius of curvature of the lower portion SS1_2B of the first side surface SS1_2 of the second sub-substrate SSUB2. The radius of curvature of the central area of the first side surface SS1_2 of the second sub-substrate SSUB2 may be defined as the radius of curvature of a curve passing through the center SS1_2C, the upper center SS1_2UC, and the lower center SS1_2BC of the first side surface SS1_2 of the second sub-substrate SSUB2.

In addition, the difference between the radius of curvature of an upper central area SS1_2UA of the first side surface SS1_2 of the second sub-substrate SSUB2 and the radius of curvature of a lower central area SS1_2BA of the first side surface SS1_2 of the second sub-substrate SSUB2 may be less than the difference between the radius of curvature of the upper portion SS1_2U of the first side surface SS1_2 of the second sub-substrate SSUB2 and the radius of curvature of the lower portion SS1_2B of the first side surface SS1_2 of the second sub-substrate SSUB2. The radius of curvature of the upper central area SS1_2UA of the first side surface SS1_2 of the second sub-substrate SSUB2 and the radius of curvature of the lower central area SS1_2BA of the first side surface SS1_2 of the second sub-substrate SSUB2 may be substantially the same. Alternatively, the difference between the radius of curvature of the upper central area SS1_2UA of the first side surface SS1_2 of the second sub-substrate SSUB2 and the radius of curvature of the lower central area SS1_2BA of the first side surface SS1_2 of the second sub-substrate SSUB2 may be 30 µm or less.

The radius of curvature of the upper central area SS1_2UA of the first side surface SS1_2 of the second sub-substrate SSUB2 may be defined as the radius of curvature of a curve passing through the center SS1_2C, the upper center SS1_2UC, and a first point PP1_12 of the first side surface SS1_2 of the second sub-substrate SSUB2. The radius of curvature of the lower central area SS1_2BA of the first side surface SS1_2 of the second sub-substrate SSUB2 may be defined as the radius of curvature of a curve passing through the center SS1_2C, the lower center SS1_2BC, and a second point PP2_12 of the first side surface SS1_2 of the second sub-substrate SSUB2. The first point PP1_12 of the first side surface SS1_2 of the second sub-substrate SSUB2 may be defined as an intermediate point between the center SS1_2C and the upper center SS1_2UC of the first side surface SS1_2 of the first second sub-substrate SSUB2. The second point PP2_12 of the first side surface SS1_2 of the second sub-substrate SSUB2 may be defined as an intermediate point between the center SS1_2C and the lower center SS1_2BC of the first side surface SS1_2 of the second sub-substrate SSUB2.

Referring to FIG. 44B, the second side surface SS2_2 of the second sub-substrate SSUB2 may have a curved shape with a changing radius of curvature. The curved shape of an upper portion SS2_2U and the curved shape of a lower portion SS2_2B of the second side surface SS2_2 of the second sub-substrate SSUB2 may be different. The upper portion SS2_2U of the second side surface SS2_2 of the second sub-substrate SSUB2 refers to an area located above a center SS2_2C of the second side surface SS2_2 of the second sub-substrate SSUB2. The lower portion SS2_2B of the second side surface SS2_2 of the second sub-substrate SSUB2 refers to an area located below the center SS2_2C of the second side surface SS2_2 of the second sub-substrate SSUB2.

The radius of curvature of the upper portion SS2_2U of the second side surface SS2_2 of the second sub-substrate SSUB2 and the radius of curvature of the lower portion SS2_2B of the second side surface SS2_2 of the second sub-substrate SSUB2 may be different. For example, the radius of curvature of the lower portion SS2_2B of the second side surface SS2_2 of the second sub-substrate SSUB2 may be less than the radius of curvature of the upper portion SS2_2U of the second side surface SS2_2 of the second sub-substrate SSUB2.

The radius of curvature of the upper portion SS2_2U of the second side surface SS2_2 of the second sub-substrate SSUB2 may be defined as the radius of curvature of a curve passing through the center SS2_2C of the second side surface SS2_2 of the second sub-substrate SSUB2, an upper end SS2_2UE of the second side surface SS2_2 of the second sub-substrate SSUB2, and an upper center SS2_2UC of the second side surface SS2_2 of the second sub-substrate SSUB2. The radius of curvature of the lower portion SS2_2B of the second side surface SS2_2 of the second sub-substrate SSUB2 may be defined as the radius of curvature of a curve passing through the center SS2_2C of the second side surface SS2_2 of the second sub-substrate SSUB2, a lower end SS2_2BE of the second side surface SS2_2 of the second sub-substrate SSUB2, and a lower center SS2_2BC of the second side surface SS2_2 of the second sub-substrate SSUB2.

In addition, the radius of curvature of the central area of the second side surface SS2_2 of the second sub-substrate SSUB2 may be different from the radius of curvature of the upper portion SS2_2U of the second side surface SS2_2 of the second sub-substrate SSUB2 and the radius of curvature of the lower portion SS2_2B of the second side surface SS2_2 of the second sub-substrate SSUB2. The radius of curvature of the central area of the second side surface SS2_2 of the second sub-substrate SSUB2 may be defined as the radius of curvature of a curve passing through the center SS2_2C, the upper center SS2_2UC, and the lower center SS2_2BC of the second side surface SS2_2 of the second sub-substrate SSUB2.

In addition, the difference between the radius of curvature of an upper central area SS2_2UA of the second side surface SS2_2 of the second sub-substrate SSUB2 and the radius of curvature of a lower central area SS2_2BA of the second side surface SS2_2 of the second sub-substrate SSUB2 may be less than the difference between the radius of curvature of the upper portion SS2_2U of the second side surface SS2_2 of the second sub-substrate SSUB2 and the radius of curvature of the lower portion SS2_2B of the second side surface SS2_2 of the second sub-substrate SSUB2. The radius of curvature of the upper central area SS2_2UA of the second side surface SS2_2 of the second sub-substrate SSUB2 and the radius of curvature of the lower central area SS2_2BA of the second side surface SS2_2 of the second sub-substrate SSUB2 may be substantially the same. Alternatively, the difference between the radius of curvature of the upper central area SS2_2UA of the second side surface SS2_2 of the second sub-substrate SSUB2 and the radius of curvature of the lower central area SS2_2BA of the second side surface SS2_2 of the second sub-substrate SSUB2 may be 30 µm or less.

The radius of curvature of the upper central area SS2_2UA of the second side surface SS2_2 of the second sub-substrate SSUB2 may be defined as the radius of curvature of a curve passing through the center SS2_2C, the upper center SS2_2UC, and a first point PP1_22 of the second side surface SS2_2 of the second sub-substrate SSUB2. The radius of curvature of the lower central area SS2_2BA of the second side surface SS2_2 of the second sub-substrate SSUB2 may be defined as the radius of curvature of a curve passing through the center SS2_2C, the lower center SS2_2BC, and a second point PP2_22 of the second side surface SS2_2 of the second sub-substrate SSUB2. The first point PP1_22 of the second side surface SS2_2 of the second sub-substrate SSUB2 may be defined as an intermediate point between the center SS2_2C and the upper center SS2_2UC of the second side surface SS2_2 of the second sub-substrate SSUB2. The second point PP2_22 of the second side surface SS2_2 of the second sub-substrate SSUB2 may be defined as an intermediate point between the center SS2_2C and the lower center SS2_2BC of the second side surface SS2_2 of the second sub-substrate SSUB the second sub-substrate SSUB2.

Referring to FIG. 44C, the third side surface SS3_2 of the second sub-substrate SSUB2 may have a curved shape with a changing radius of curvature. The curved shape of an upper portion SS3_2U and the curved shape of a lower portion SS3_2B of the third side surface SS3_2 of the second sub-substrate SSUB2 may be different. The upper portion SS3_2U of the third side surface SS3_2 of the second sub-substrate SSUB2 refers to an area located above a center SS3_2C of the third side surface SS3_2 of the second sub-substrate SSUB2. The lower portion SS3_2B of the third side surface SS3_2 of the second sub-substrate SSUB2 refers to an area located below the center SS3_2C of the third side surface SS3_2 of the second sub-substrate SSUB2.

The radius of curvature of the upper portion SS3_2U of the third side surface SS3_2 of the second sub-substrate SSUB2 and the radius of curvature of the lower portion SS3_2B of the third side surface SS3_2 of the second sub-substrate SSUB2 may be different. For example, the radius of curvature of the lower portion SS3_2B of the third side surface SS3_2 of the second sub-substrate SSUB2 may be less than the radius of curvature of the upper portion SS3_2U of the third side surface SS3_2 of the second sub-substrate SSUB2.

The radius of curvature of the upper portion SS3_2U of the third side surface SS3_2 of the second sub-substrate SSUB2 may be defined as the radius of curvature of a curve passing through the center SS3_2C of the third side surface SS3_2 of the second sub-substrate SSUB2, an upper end SS3_2UE of the third side surface SS3_2 of the second sub-substrate SSUB2, and an upper center SS3_2UC of the third side surface SS3_2 of the second sub-substrate SSUB2. The radius of curvature of the lower portion SS3_2B of the third side surface SS3_2 of the second sub-substrate SSUB2 may be defined as the radius of curvature of a curve passing through the center SS3_2C of the third side surface SS3_2 of the second sub-substrate SSUB2, a lower end SS3_2BE of the third side surface SS3_2 of the second sub-substrate SSUB2, and a lower center SS3_2BC of the third side surface SS3_2 of the second sub-substrate SSUB2.

In addition, the radius of curvature of the central area of the third side surface SS3_2 of the second sub-substrate SSUB2 may be different from the radius of curvature of the upper portion SS3_2U of the third side surface SS3_2 of the second sub-substrate SSUB2 and the radius of curvature of the lower portion SS3_2B of the third side surface SS3_2 of the second sub-substrate SSUB2. The radius of curvature of the central area of the third side surface SS3_2 of the second sub-substrate SSUB2 may be defined as the radius of curvature of a curve passing through the center SS3_2C, the upper center SS3_2UC, and the lower center SS3_2BC of the third side surface SS3_2 of the second sub-substrate SSUB2.

In addition, the difference between the radius of curvature of an upper central area SS3_2UA of the third side surface SS3_2 of the second sub-substrate SSUB2 and the radius of curvature of a lower central area SS3_2BA of the third side surface SS3_2 of the second sub-substrate SSUB2 may be less than the difference between the radius of curvature of the upper portion SS3_2U of the third side surface SS3_2 of the second sub-substrate SSUB2 and the radius of curvature of the lower portion SS3_2B of the third side surface SS3_2 of the second sub-substrate SSUB2. The radius of curvature of the upper central area SS3_2UA of the third side surface SS3_2 of the second sub-substrate SSUB2 and the radius of curvature of the lower central area SS3_2BA of the third side surface SS3_2 of the second sub-substrate SSUB2 may be substantially the same. Alternatively, the difference between the radius of curvature of the upper central area SS3_2UA of the third side surface SS3_2 of the second sub-substrate SSUB2 and the radius of curvature of the lower central area SS3_2BA of the third side surface SS3_2 of the second sub-substrate SSUB2 may be 30 µm or less.

The radius of curvature of the upper central area SS3_2UA of the third side surface SS3_2 of the second sub-substrate SSUB2 may be defined as the radius of curvature of a curve passing through the center SS3_2C, the upper center SS3_2UC, and a first point PP1_32 of the third side surface SS3_2 of the second sub-substrate SSUB2. The radius of curvature of the lower central area SS3_2BA of the third side surface SS3_2 of the second sub-substrate SSUB2 may be defined as the radius of curvature of a curve passing through the center SS3_2C, the lower center SS3_2BC, and a second point PP2_32 of the third side surface SS3_2 of the second sub-substrate SSUB2. The first point PP1_32 of the third side surface SS3_2 of the second sub-substrate SSUB2 may be defined as an intermediate point between the center SS3_2C and the upper center SS3_2UC of the third side surface SS3_2 of the second sub-substrate SSUB2. The second point PP2_32 of the third side surface SS3_2 of the second sub-substrate SSUB2 may be defined as an intermediate point between the center SS3_2C and the lower center SS3_2BC of the third of the first sub-substrate SSUB1 the third side surface SS3_2 of the second sub-substrate SSUB2.

Referring to FIG. 44D, the fourth side surface SS4_2 of the second sub-substrate SSUB2 may have a curved shape with a changing radius of curvature. The curved shape of an upper portion SS4_2U and the curved shape of a lower portion SS4_2B of the fourth side surface SS4_2 of the second sub-substrate SSUB2 may be different. The upper portion SS4_2U of the fourth side surface SS4_2 of the second sub-substrate SSUB2 refers to an area located above a center SS4_2C of the fourth side surface SS4_2 of the second sub-substrate SSUB2. The lower portion SS4_2B of the fourth side surface SS4_2 of the second sub-substrate SSUB2 refers to an area located below the center SS4_2C of the fourth side surface SS4_2 of the second sub-substrate SSUB2.

The radius of curvature of the upper portion SS4_2U of the fourth side surface SS4_2 of the second sub-substrate SSUB2 and the radius of curvature of the lower portion SS4_2B of the fourth side surface SS4_2 of the second sub-substrate SSUB2 may be different. For example, the radius of curvature of the lower portion SS4_2B of the fourth side surface SS4_2 of the second sub-substrate SSUB2 may be less than the radius of curvature of the upper portion SS4_2U of the fourth side surface SS4_2 of the second sub-substrate SSUB2.

The radius of curvature of the upper portion SS4_2U of the fourth side surface SS4_2 of the second sub-substrate SSUB2 may be defined as the radius of curvature of a curve passing through the center SS4_2C of the fourth side surface SS4_2 of the second sub-substrate SSUB2, an upper end SS4_2UE of the fourth side surface SS4_2 of the second sub-substrate SSUB2, and an upper center SS4_2UC of the fourth side surface SS4_2 of the second sub-substrate SSUB2. The radius of curvature of the lower portion SS4_2B of the fourth side surface SS4_2 of the second sub-substrate SSUB2 may be defined as the radius of curvature of a curve passing through the center SS4_2C of the fourth side surface SS4_2 of the second sub-substrate SSUB2, a lower end SS4_2BE of the fourth side surface SS4_2 of the second sub-substrate SSUB2, and a lower center SS4_2BC of the fourth side surface SS4_2 of the second sub-substrate SSUB2.

In addition, the radius of curvature of the central area of the fourth side surface SS4_2 of the second sub-substrate SSUB2 may be different from the radius of curvature of the upper portion SS4_2U of the fourth side surface SS4_2 of the second sub-substrate SSUB2 and the radius of curvature of the lower portion SS4_2B of the fourth side surface SS4_2 of the second sub-substrate SSUB2. The radius of curvature of the central area of the fourth side surface SS4_2 of the second sub-substrate SSUB2 may be defined as the radius of curvature of a curve passing through the center SS4_2C, the upper center SS4_2UC, and the lower center SS4_2BC of the fourth side surface SS4_2 of the second sub-substrate SSUB2.

In addition, the difference between the radius of curvature of an upper central area SS4_2UA of the fourth side surface SS4_2 of the second sub-substrate SSUB2 and the radius of curvature of a lower central area SS4_2BA of the fourth side surface SS4_2 of the second sub-substrate SSUB2 may be less than the difference between the radius of curvature of the upper portion SS4_2U of the fourth side surface SS4_2 of the second sub-substrate SSUB2 and the radius of curvature of the lower portion SS4_2B of the fourth side surface SS4_2 of the second sub-substrate SSUB2. The radius of curvature of the upper central area SS4_2UA of the fourth side surface SS4_2 of the second sub-substrate SSUB2 and the radius of curvature of the lower central area SS4_2BA of the fourth side surface SS4_2 of the second sub-substrate SSUB2 may be substantially the same. Alternatively, the difference between the radius of curvature of the upper central area SS4_2UA of the fourth side surface SS4_2 of the second sub-substrate SSUB2 and the radius of curvature of the lower central area SS4_2BA of the fourth side surface SS4_2 of the second sub-substrate SSUB2 may be 30 µm or less.

The radius of curvature of the upper central area SS4_2UA of the fourth side surface SS4_2 of the second sub-substrate SSUB2 may be defined as the radius of curvature of a curve passing through the center SS4_2C, the upper center SS4_2UC, and a first point PP1_42 of the fourth side surface SS4_2 of the second sub-substrate SSUB2. The radius of curvature of the lower central area SS4_2BA of the fourth side surface SS4_2 of the second sub-substrate SSUB2 may be defined as the radius of curvature of a curve passing through the center SS4_2C, the lower center SS4_2BC, and a second point PP2_42 of the fourth side surface SS4_2 of the second sub-substrate SSUB2. The first point PP1_42 of the fourth side surface SS4_2 of the second sub-substrate SSUB2 may be defined as an intermediate point between the center SS4_2C and the upper center SS4_2UC of the fourth side surface SS4_2 of the second sub-substrate SSUB2. The second point PP2_42 of the fourth side surface SS4_2 of the second sub-substrate SSUB2 may be defined as an intermediate point between the center SS4_2C and the lower center SS4_2BC of the fourth side surface SS4_2 of the second sub-substrate SSUB2.

Referring to FIGS. 44A to 44D, the radius of curvature of the upper portion SS1_2U of the first side surface SS1_2, the radius of curvature of the upper portion SS2_2U of the second side surface SS2_2, the radius of curvature of the upper portion SS3_2U of the third side surface SS3_2, and the radius of curvature of the upper portion SS4_2U of the fourth side surface SS4_2 of the second sub-substrate SSUB2 may be similar to each other. For example, the radius of curvature of the upper portion SS1_2U of the first side surface SS1_2, the radius of curvature of the upper portion SS2_2U of the second side surface SS2_2, the radius of curvature of the upper portion SS3_2U of the third side surface SS3_2, and the radius of curvature of the upper portion SS4_2U of the fourth side surface SS4_2 of the second sub-substrate SSUB2 may be 150 µm to 350 µm.

The difference between the radius of curvature of the upper portion SS1_2U of the first side surface SS1_2 and the radius of curvature of the upper portion SS2_2U of the second side surface SS2_2 of the second sub-substrate SSUB2 may be less than approximately 30 µm. The difference between the radius of curvature of the upper portion SS1_2U of the first side surface SS1_2 and the radius of curvature of the upper portion SS3_2U of the third side surface SS3_2 of the second sub-substrate SSUB2 may be less than approximately 30 µm. The difference between the radius of curvature of the upper portion SS1_2U of the first side surface SS1_2 and the radius of curvature of the upper portion SS4_2U of the fourth side surface SS4_2 of the second sub-substrate SSUB2 may be less than approximately 30 µm. The difference between the radius of curvature of the upper portion SS2_2U of the second side surface SS2_2 and the radius of curvature of the upper portion SS3_2U of the third side surface SS3_2 of the second sub-substrate SSUB2 may be less than approximately 30 µm. The difference between the radius of curvature of the upper portion SS2_2U of the second side surface SS2_2 and the radius of curvature of the upper portion SS4_2U of the fourth side surface SS4_2 of the second sub-substrate SSUB2 may be less than approximately 30 µm. The difference between the radius of curvature of the upper portion SS3_2U of the third side surface SS3_2 and the radius of curvature of the upper portion SS4_2U of the fourth side surface SS4_2 of the second sub-substrate SSUB2 may be less than approximately 30 µm.

In addition, referring to FIGS. 25A to 25D and FIGS. 44A to 44D, each of the radius of curvature of the upper portion SS1_2U of the first side surface SS1_2, the radius of curvature of the upper portion SS2_2U of the second side surface SS2_2, the radius of curvature of the upper portion SS3_2U of the third side surface SS3_2, and the radius of curvature of the upper portion SS4_2U of the fourth side surface SS4_2 of the second sub-substrate SSUB2 may be similar to the radius of curvature of the upper portion SS1U of the first side surface SS1, the radius of curvature of the upper portion SS2U of the second side surface SS2, the radius of curvature of the upper portion SS3U of the third side surface SS3, and the radius of curvature of the upper portion SS4U of the fourth side surface SS4. For example, the difference between each of the radius of curvature of the upper portion SS1_2U of the first side surface SS1_2, the radius of curvature of the upper portion SS2_2U of the second side surface SS2_2, the radius of curvature of the upper portion SS3_2U of the third side surface SS3_2, and the radius of curvature of the upper portion SS4_2U of the fourth side surface SS4_2 of the second sub-substrate SSUB2, and any one of the radius of curvature of the upper portion SS1U of the first side surface SS1, the radius of curvature of the upper portion SS2U of the second side surface SS2, the radius of curvature of the upper portion SS3U of the third side surface SS3, and the radius of curvature of the upper portion SS4U of the fourth side surface SS4 may be less than approximately 30 µm.

In addition, referring to FIGS. 35A to 35D and FIGS. 44A to 44D, each of the radius of curvature of the upper portion SS1_2U of the first side surface SS1_2, the radius of curvature of the upper portion SS2_2U of the second side surface SS2_2, the radius of curvature of the upper portion SS3_2U of the third side surface SS3_2, and the radius of curvature of the upper portion SS4_2U of the fourth side surface SS4_2 of the second sub-substrate SSUB2 may be similar to the radius of curvature of the upper portion SSH1U of the first hole side surface SSH1, the radius of curvature of the upper portion SSH2U of the second hole side surface SSH2, the radius of curvature of the upper portion SSH3U of the third hole side surface SSH3, and the radius of curvature of the upper portion SSH4U of the fourth hole side surface SSH4. For example, the difference between each of the radius of curvature of the upper portion SS1_2U of the first side surface SS1_2, the radius of curvature of the upper portion SS2_2U of the second side surface SS2_2, the radius of curvature of the upper portion SS3_2U of the third side surface SS3_2, and the radius of curvature of the upper portion SS4_2U of the fourth side surface SS4_2 of the second sub-substrate SSUB2, and any one of the radius of curvature of the upper portion SSH1U of the first hole side surface SSH1, the radius of curvature of the upper portion SSH2U of the second hole side surface SSH2, the radius of curvature of the upper portion SSH3U of the third hole side surface SSH3, and the radius of curvature of the upper portion SSH4U of the fourth hole side surface SSH4 may be less than approximately 30 µm.

In addition, referring to FIGS. 43A to 43D and FIGS. 44A to 44D, each of the radius of curvature of the upper portion SS1_2U of the first side surface SS1_2, the radius of curvature of the upper portion SS2_2U of the second side surface SS2_2, the radius of curvature of the upper portion SS3_2U of the third side surface SS3_2, and the radius of curvature of the upper portion SS4_2U of the fourth side surface SS4_2 of the second sub-substrate SSUB2 may be similar to the radius of curvature of the upper portion SS1_1U of the first side surface SS1_1, the radius of curvature of the upper portion SS2_1U of the second side surface SS2_1, the radius of curvature of the upper portion SS3_1U of the third side surface SS3_1, and the radius of curvature of the upper portion SS4_1U of the fourth side surface SS4_1 of the first sub-substrate SSUB1. For example, the difference between each of the radius of curvature of the upper portion SS1_2U of the first side surface SS1_2, the radius of curvature of the upper portion SS2_2U of the second side surface SS2_2, the radius of curvature of the upper portion SS3_2U of the third side surface SS3_2, and the radius of curvature of the upper portion SS4_2U of the fourth side surface SS4_2 of the second sub-substrate SSUB2, and any one of the radius of curvature of the upper portion SS1_1U of the first side surface SS1_1, the radius of curvature of the upper portion SS2_1U of the second side surface SS2_1, the radius of curvature of the upper portion SS3_1U of the third side surface SS3_1, and the radius of curvature of the upper portion SS4_1U of the fourth side surface SS4_1 of the first sub-substrate SSUB1 may be less than approximately 30 µm.

As shown in FIGS. 44A to 44D, the difference in radius of curvature between the side surfaces SS1_2, SS2_2, SS3_2, and SS4_2 of the second sub-substrate SSUB2 of the display panel 100 may be negligible. Accordingly, mechanical strength may be uniformly maintained according to the positions of the side surfaces SS1_2, SS2_2, SS3_2, and SS4_2 of the second sub-substrate SSUB2 of the display panel 100.

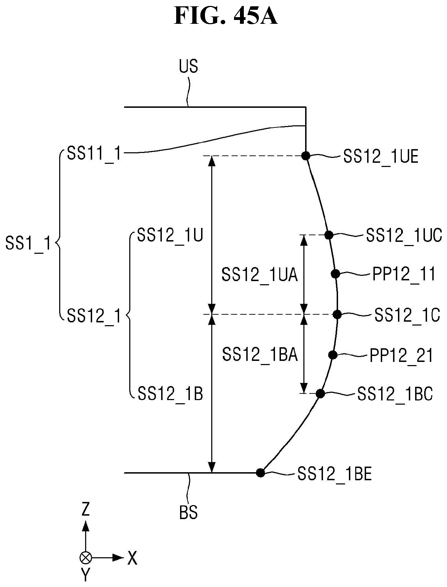

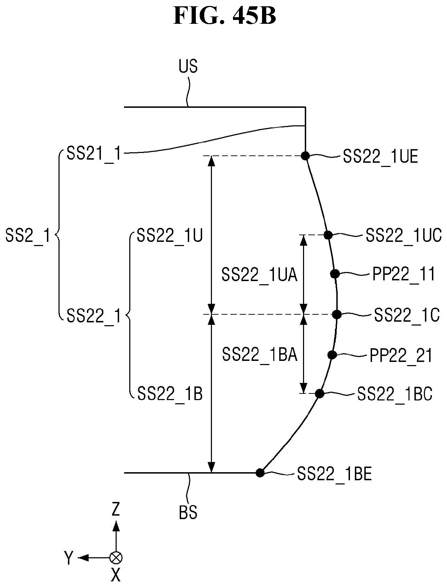

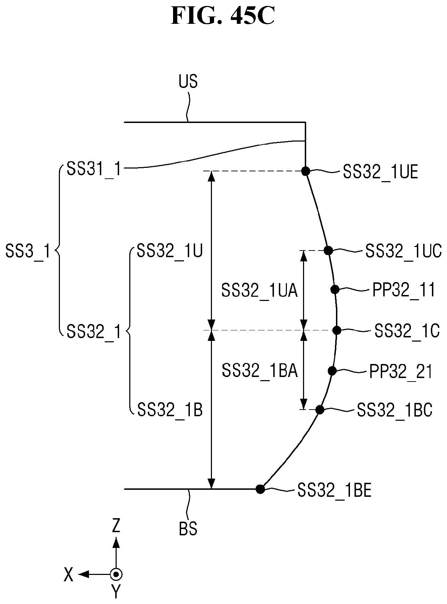

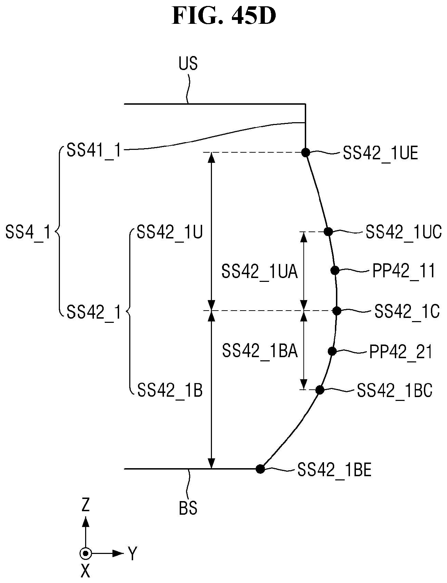

FIGS. 45A to 45D are enlarged cross-sectional views showing yet other examples of the first to fourth side surfaces of the first sub-substrate in FIGS. 39 and 41. FIG. 45A shows a cross-section of the first side surface SS1_1 of the first sub-substrate SSUB1, FIG. 45B shows a cross-section of the second side surface SS2_1 of the first sub-substrate SSUB1, FIG. 45C shows a cross-section of the third side surface SS3_1 of the first sub-substrate SSUB1, and FIG. 45D shows a cross-section of the fourth side surface SS4_1 of the first sub-substrate SSUB1.

Referring to FIG. 45A, the first side surface SS1_1 of the first sub-substrate SSUB1 may have a first sub-side surface SS11_1 having a planar shape or a curved shape and a second sub-side surface SS12_1 having a curved shape with a changing radius of curvature. The length of the first sub-side surface SS11_1 of the first sub-substrate SSUB1 may be less than the length of the second sub-side surface SS12_1.

The first sub-side surface SS11_1 of the first sub-substrate SSUB1 may be connected to the top surface US, and the second sub-side surface SS12_1 of the first sub-substrate SSUB1 may be connected to the bottom surface BS. The angle between the first sub-side surface SS11_1 and the top surface US of the first sub-substrate SSUB1 may be a right angle or an obtuse angle close to a right angle.

The curved shape of an upper portion SS12_1U of the second sub-side surface SS12_1 and the curved shape of a lower portion SS12_1B of the second sub-side surface SS12_1 of the first sub-substrate SSUB1 may be different. The upper portion SS12_1U of the second sub-side surface SS12_1 of the first sub-substrate SSUB1 refers to an area located above a center SS12_1C of the second sub-side surface SS12_1. The lower portion SS12_1B of the second sub-side surface SS12_1 of the first sub-substrate SSUB1 refers to an area located below the center SS12_1C of the second sub-side surface SS12_1.

The radius of curvature of the upper portion SS12_1U of the second sub-side surface SS12_1 and the radius of curvature of the lower portion SS12_1B of the second sub-side surface SS12_1 of the first sub-substrate SSUB1 may be different. For example, the radius of curvature of the lower portion SS12_1B of the second sub-side surface SS12_1 of the first sub-substrate SSUB1 may be less than the radius of curvature of the upper portion SS12_1U of the second sub-side surface SS12_1.

The radius of curvature of the upper portion SS12_1U of the second sub-side surface SS12_1 of the first sub-substrate SSUB1 may be defined as the radius of curvature of a curve passing through the center SS12_1C of the second sub-side surface SS12_1, an upper end SS12_1UE of the second sub-side surface SS12_1, and an upper center SS12_1UC of the second sub-side surface SS12_1. The radius of curvature of the lower portion SS12_1B of the second sub-side surface SS12_1 of the first sub-substrate SSUB1 may be defined as the radius of curvature of a curve passing through the center SS12_1C of the second sub-side surface SS12_1, a lower end SS12_1BE of the second sub-side surface SS12_1, and a lower center SS12_1BC of the second sub-side surface SS12_1.

In addition, the radius of curvature of the central area of the second sub-side surface SS12_1 of the first sub-substrate SSUB1 may be different from the radius of curvature of the upper portion SS12_1U and the radius of curvature of the lower portion SS12_1B of the second sub-side surface SS12_1 of the first sub-substrate SSUB1. The radius of curvature of the central area of the second sub-side surface SS12_1 of the first sub-substrate SSUB1 may be defined as the radius of curvature of a curve passing through the center SS12_1C, the upper center SS12_1UC, and the lower center SS12_1BC of the second sub-side surface SS12_1 of the first sub-substrate SSUB1.

In addition, the difference between the radius of curvature of an upper central area SS12_1UA and the radius of curvature of a lower central area SS12_1BA of the second sub-side surface SS12_1 of the first sub-substrate SSUB1 may be less than the difference between the radius of curvature of the upper portion SS12_1U and the radius of curvature of the lower portion SS12_1B of the second sub-side surface SS12_1 of the first sub-substrate SSUB1. The radius of curvature of the upper central area SS12_1UA and the radius of curvature of the lower central area SS12_1BA of the second sub-side surface SS12_1 of the first sub-substrate SSUB1 may be substantially the same. Alternatively, the difference between the radius of curvature of the upper central area SS12_1UA and the radius of curvature of the lower central area SS12_1BA of the second sub-side surface SS12_1 of the first sub-substrate SSUB1 may be 30 µm or less.

The radius of curvature of the upper central area SS12_1UA of the second sub-side surface SS12_1 of the first sub-substrate SSUB1 may be defined as the radius of curvature of a curve passing through the center SS12_1C, the upper center SS12_1UC, and a first point PP12_11 of the second sub-side surface SS12_1 of the first sub-substrate SSUB1. The radius of curvature of the lower central area SS12_1BA of the second sub-side surface SS12_1 of the first sub-substrate SSUB1 may be defined as the radius of curvature of a curve passing through the center SS12_1C, the lower center SS12_1BC, and a second point PP12_21 of the second sub-side surface SS12_1 of the first sub-substrate SSUB1. The first point PP12_11 of the second sub-side surface SS12_1 of the first sub-substrate SSUB1 may be defined as an intermediate point between the center SS12_1C and the upper center SS12_1UC of the second sub-side surface SS12_1 of the first sub-substrate SSUB1. The second point PP12_21 of the second sub-side surface SS12_1 of the first sub-substrate SSUB1 may be defined as an intermediate point between the center SS12_1C and the lower center SS12_1BC of the second sub-side surface SS12_1 of the first sub-substrate SSUB1.

Referring to FIG. 45B, the second side surface SS2_1 of the first sub-substrate SSUB1 may have a third sub-side surface SS21_1 having a planar shape or a curved shape and a fourth sub-side surface SS22_1 having a curved shape with a changing radius of curvature. The length of the third sub-side surface SS21_1 of the first sub-substrate SSUB1 may be less than the length of the fourth sub-side surface SS22_1.

The third sub-side surface SS21_1 of the first sub-substrate SSUB1 may be connected to the top surface US, and the fourth sub-side surface SS22_1 may be connected to the bottom surface BS. The angle between the third sub-side surface SS21_1 and the top surface US of the first sub-substrate SSUB1 may be a right angle or an obtuse angle close to a right angle.

The curved shape of an upper portion SS22_1U of the fourth sub-side surface SS22_1 and the curved shape of a lower portion SS22_1B of the fourth sub-side surface SS22_1 of the first sub-substrate SSUB1 may be different. The upper portion SS22_1U of the fourth sub-side surface SS22_1 of the first sub-substrate SSUB1 refers to an area located above a center SS22_1C of the fourth sub-side surface SS22_1. The lower portion SS22_1B of the fourth sub-side surface SS22_1 of the first sub-substrate SSUB1 refers to an area located below the center SS22_1C of the fourth sub-side surface SS22_1.

The radius of curvature of the upper portion SS22_1U of the fourth sub-side surface SS22_1 and the radius of curvature of the lower portion SS22_1B of the fourth sub-side surface SS22_1 of the first sub-substrate SSUB1 may be different. For example, the radius of curvature of the lower portion SS22_1B of the fourth sub-side surface SS22_1 of the first sub-substrate SSUB1 may be less than the radius of curvature of the upper portion SS22_1U of the fourth sub-side surface SS22_1.

The radius of curvature of the upper portion SS22_1U of the fourth sub-side surface SS22_1 of the first sub-substrate SSUB1 may be defined as the radius of curvature of a curve passing through the center SS22_1C of the fourth sub-side surface SS22_1, an upper end SS22_1UE of the fourth sub-side surface SS22_1, and an upper center SS22_1UC of the fourth sub-side surface SS22_1. The radius of curvature of the lower portion SS22_1B of the fourth sub-side surface SS22_1 of the first sub-substrate SSUB1 may be defined as the radius of curvature of a curve passing through the center SS22_1C of the fourth sub-side surface SS22_1, a lower end SS22_1BE of the fourth sub-side surface SS22_1, and a lower center SS22_1BC of the fourth sub-side surface SS22_1.

In addition, the radius of curvature of the central area of the fourth sub-side surface SS22_1 of the first sub-substrate SSUB1 may be different from the radius of curvature of the upper portion SS22_1U and the radius of curvature of the lower portion SS22_1B of the fourth sub-side surface SS22_1 of the first sub-substrate SSUB1. The radius of curvature of the central area of the fourth sub-side surface SS22_1 of the first sub-substrate SSUB1 may be defined as the radius of curvature of a curve passing through the center SS22_1C, the upper center SS22_1UC, and the lower center SS22_1BC of the fourth sub-side surface SS22_1 of the first sub-substrate SSUB1.

In addition, the difference between the radius of curvature of an upper central area SS22_1UA and the radius of curvature of a lower central area SS22_1BA of the fourth sub-side surface SS22_1 of the first sub-substrate SSUB1 may be less than the difference between the radius of curvature of the upper portion SS22_1U and the radius of curvature of the lower portion SS22_1B of the fourth sub-side surface SS22_1 of the first sub-substrate SSUB1. The radius of curvature of the upper central area SS22_1UA and the radius of curvature of the lower central area SS22_1BA of the fourth sub-side surface SS22_1 of the first sub-substrate SSUB1 may be substantially the same. Alternatively, the difference between the radius of curvature of the upper central area SS22_1UA and the radius of curvature of the lower central area SS22_1BA of the fourth sub-side surface SS22_1 of the first sub-substrate SSUB1 may be 30 µm or less.

The radius of curvature of the upper central SS22_1UA of the fourth sub-side surface SS22_1 of the first sub-substrate SSUB1 may be defined as the radius of curvature of a curve passing through the center SS22_1C, the upper center SS22_1UC, and a first point PP22_11 of the fourth sub-side surface SS22_1 of the first sub-substrate SSUB1. The radius of curvature of the lower central SS22_1BA of the fourth sub-side surface SS22_1 of the first sub-substrate SSUB1 may be defined as the radius of curvature of a curve passing through the center SS22_1C, the lower center SS22_1BC, and a second point PP22_21 of the fourth sub-side surface SS22_1 of the first sub-substrate SSUB1. The first point PP22_11 of the fourth sub-side surface SS22_1 of the first sub-substrate SSUB1 may be defined as an intermediate point between the center SS22_1C and the upper center SS22_1UC of the fourth sub-side surface SS22_1 of the first sub-substrate SSUB1. The second point PP22_21 of the fourth sub-side surface SS22_1 of the first sub-substrate SSUB1 may be defined as an intermediate point between the center SS22_1C and the lower center SS22_1BC of the fourth sub-side surface SS22_1 of the first sub-substrate SSUB1.

Referring to FIG. 45C, the third side surface SS3_1 of the first sub-substrate SSUB1 may have a fifth sub-side surface SS31_1 having a planar shape or a curved shape and a sixth sub-side surface SS32_1 having a curved shape with a changing radius of curvature. The length of the fifth sub-side surface SS31_1 may be less than the length of the sixth sub-side surface SS32_1.

The fifth sub-side surface SS31_1 of the first sub-substrate SSUB1 may be connected to the top surface US, and the sixth sub-side surface SS32_1 may be connected to the bottom surface BS. The angle between the fifth sub-side surface SS31_1 and the top surface US of the first sub-substrate SSUB1 may be a right angle or an obtuse angle close to a right angle.

The curved shape of an upper portion SS32_1U of the sixth sub-side surface SS32_1 and the curved shape of a lower portion SS32_1B of the sixth sub-side surface SS32_1 of the first sub-substrate SSUB1 may be different. The upper portion SS32_1U of the sixth sub-side surface SS32_1 of the first sub-substrate SSUB1 refers to an area located above a center SS32_1C of the sixth sub-side surface SS32_1. The lower portion SS32_1B of the sixth sub-side surface SS32_1 of the first sub-substrate SSUB1 refers to an area located below the center SS32_1C of the sixth sub-side surface SS32_1.

The radius of curvature of the upper portion SS32_1U of the sixth sub-side surface SS32_1 and the radius of curvature of the lower portion SS32_1B of the sixth sub-side surface SS32_1 of the first sub-substrate SSUB1 may be different. For example, the radius of curvature of the lower portion SS32_1B of the sixth sub-side surface SS32_1 of the first sub-substrate SSUB1 may be less than the radius of curvature of the upper portion SS32_1U of the sixth sub-side surface SS32_1.

The radius of curvature of the upper portion SS32_1U of the sixth sub-side surface SS32_1 of the first sub-substrate SSUB1 may be defined as the radius of curvature of a curve passing through the center SS32_1C of the sixth sub-side surface SS32_1, an upper end SS32_1UE of the sixth sub-side surface SS32_1, and an upper center SS32_1UC of the sixth sub-side surface SS32_1. The radius of curvature of the lower portion SS32_1B of the sixth sub-side surface SS32_1 of the first sub-substrate SSUB1 may be defined as the radius of curvature of a curve passing through the center SS32_1C of the sixth sub-side surface SS32_1, a lower end SS32_1BE of the sixth sub-side surface SS32_1, and a lower center SS32_1BC of the sixth sub-side surface SS32_1.

In addition, the radius of curvature of the central area of the sixth sub-side surface SS32_1 of the first sub-substrate SSUB1 may be different from the radius of curvature of the upper portion SS32_1U and the radius of curvature of the lower portion SS32_1B of the sixth sub-side surface SS32_1 of the first sub-substrate SSUB1. The radius of curvature of the central area of the sixth sub-side surface SS32_1 of the first sub-substrate SSUB1 may be defined as the radius of curvature of a curve passing through the center SS32_1C, the upper center SS32_1UC, and the lower center SS32_1BC of the sixth sub-side surface SS32_1 of the first sub-substrate SSUB1.

In addition, the difference between the radius of curvature of an upper central area SS32_1UA and the radius of curvature of a lower central area SS32_1BA of the sixth sub-side surface SS32_1 of the first sub-substrate SSUB1 may be less than the difference between the radius of curvature of the upper portion SS32_1U and the radius of curvature of the lower portion SS32_1B of the sixth sub-side surface SS32_1 of the first sub-substrate SSUB1. The radius of curvature of the upper central area SS32_1UA and the radius of curvature of the lower central area SS32_1BA of the sixth sub-side surface SS32_1 of the first sub-substrate SSUB1 may be substantially the same. Alternatively, the difference between the radius of curvature of the upper central area SS32_1UA and the radius of curvature of the lower central area SS32_1BA of the sixth sub-side surface SS32_1 of the first sub-substrate SSUB1 may be 30 µm or less.

The radius of curvature of the upper central area SS32_1UA of the sixth sub-side surface SS32_1 of the first sub-substrate SSUB1 may be defined as the radius of curvature of a curve passing through the center SS32_1C, the upper center SS32_1UC, and a first point PP32_11 of the sixth sub-side surface SS32_1 of the first sub-substrate SSUB1. The radius of curvature of the lower central area SS32_1BA of the sixth sub-side surface SS32_1 of the first sub-substrate SSUB1 may be defined as the radius of curvature of a curve passing through the center SS32_1C, the lower center SS32_1BC, and a second point PP32_21 of the sixth sub-side surface SS32_1 of the first sub-substrate SSUB1. The first point PP32_11 of the sixth sub-side surface SS32_1 of the first sub-substrate SSUB1 may be defined as an intermediate point between the center SS32_1C and the upper center SS32_1UC of the sixth sub-side surface SS32_1 of the first sub-substrate SSUB1. The second point PP32_21 of the sixth sub-side surface SS32_1 of the first sub-substrate SSUB1 may be defined as an intermediate point between the center SS32_1C and the lower center SS32_1BC of the sixth sub-side surface SS32_1 of the first sub-substrate SSUB1.

Referring to FIG. 45D, the fourth side surface SS4_1 of the first sub-substrate SSUB1 may have a seventh sub-side surface SS41_1 having a planar shape or a curved shape and an eighth sub-side surface SS42_1 having a curved shape with a changing radius of curvature. The length of the seventh sub-side surface SS41_1 of the first sub-substrate SSUB1 may be less than the length of the eighth sub-side surface SS42_1.

The seventh sub-side surface SS41_1 of the first sub-substrate SSUB1 may be connected to the top surface US, and the eighth sub-side surface SS42_1 may be connected to the bottom surface BS. The angle between the seventh sub-side surface SS41_1 and the top surface US of the first sub-substrate SSUB1 may be a right angle or an obtuse angle close to a right angle.

The curved shape of an upper portion SS42_1U of the eighth sub-side surface SS42_1 and the curved shape of a lower portion SS42_1B of the eighth sub-side surface SS42_1 of the first sub-substrate SSUB1 may be different. The upper portion SS42_1U of the eighth sub-side surface SS42_1 of the first sub-substrate SSUB1 refers to an area located above a center SS42_1C of the eighth sub-side surface SS42_1. The lower portion SS42_1B of the eighth sub-side surface SS42_1 of the first sub-substrate SSUB1 refers to an area located below the center SS42_1C of the eighth sub-side surface SS42_1.

The radius of curvature of the upper portion SS42_1U of the eighth sub-side surface SS42_1 and the radius of curvature of the lower portion SS42_1B of the eighth sub-side surface SS42_1 of the first sub-substrate SSUB1 may be different. For example, the radius of curvature of the lower portion SS42_1B of the eighth sub-side surface SS42_1 of the first sub-substrate SSUB1 may be less than the radius of curvature of the upper portion SS42_1U of the eighth sub-side surface SS42_1.

The radius of curvature of the upper portion SS42_1U of the eighth sub-side surface SS42_1 of the first sub-substrate SSUB1 may be defined as the radius of curvature of a curve passing through the center SS42_1C of the eighth sub-side surface SS42_1, an upper end SS42_1UE of the eighth sub-side surface SS42_1, and an upper center SS42_1UC of the eighth sub-side surface SS42_1. The radius of curvature of the lower portion SS42_1B of the eighth sub-side surface SS42_1 may be defined as the radius of curvature of a curve passing through the center SS42_1C of the eighth sub-side surface SS42_1, a lower end SS42_1BE of the eighth sub-side surface SS42_1, and a lower center SS42_1BC of the eighth sub-side surface SS42_1.

In addition, the radius of curvature of the central area of the eighth sub-side surface SS42_1 of the first sub-substrate SSUB1 may be different from the radius of curvature of the upper portion SS42_1U and the radius of curvature of the lower portion SS42_1B of the eighth sub-side surface SS42_1 of the first sub-substrate SSUB1. The radius of curvature of the central area of the eighth sub-side surface SS42_1 of the first sub-substrate SSUB1 may be defined as the radius of curvature of a curve passing through the center SS42_1C, the upper center SS42_1UC, and the lower center SS42_1BC of the eighth sub-side surface SS42_1 of the first sub-substrate SSUB1.

In addition, the difference between the radius of curvature of an upper central area SS42_1UA and the radius of curvature of a lower central area SS42_1BA of the eighth sub-side surface SS42_1 of the first sub-substrate SSUB1 may be less than the difference between the radius of curvature of the upper portion SS42_1U and the radius of curvature of the lower portion SS42_1B of the eighth sub-side surface SS42_1 of the first sub-substrate SSUB1. The radius of curvature of the upper central area SS42_1UA and the radius of curvature of the lower central area SS42_1BA of the eighth sub-side surface SS42_1 of the first sub-substrate SSUB1 may be substantially the same. Alternatively, the difference between the radius of curvature of the upper central area SS42_1UA and the radius of curvature of the lower central area SS42_1BA of the eighth sub-side surface SS42_1 of the first sub-substrate SSUB1 may be 30 µm or less.

The radius of curvature of the upper central area SS42_1UA of the eighth sub-side surface SS42_1 of the first sub-substrate SSUB1 may be defined as the radius of curvature of a curve passing through the center SS42_1C, the upper center SS42_1UC, and a first point PP42_11 of the eighth sub-side surface SS42_1 of the first sub-substrate SSUB1. The radius of curvature of the lower central area SS42_1BA of the eighth sub-side surface SS42_1 of the first sub-substrate SSUB1 may be defined as the radius of curvature of a curve passing through the center SS42_1C, the lower center SS42_1BC, and a second point PP42_21 of the eighth sub-side surface SS42_1 of the first sub-substrate SSUB1. The first point PP42_11 of the eighth sub-side surface SS42_1 of the first sub-substrate SSUB1 may be defined as an intermediate point between the center SS42_1C and the upper center SS42_1UC of the eighth sub-side surface SS42_1 of the first sub-substrate SSUB1. The second point PP42_21 of the eighth sub-side surface SS42_1 of the first sub-substrate SSUB1 may be defined as an intermediate point between the center SS42_1C and the lower center SS42_1BC of the eighth sub-side surface SS42_1 of the first sub-substrate SSUB1.

Referring to FIGS. 45A to 45D, the length of the first sub-side surface SS11_1 of the first side surface SS1_1, the length of the third sub-side surface SS21_1 of the second side surface SS2_1, the length of the fifth sub-side surface SS31_1 of the third side surface SS3_1, and the length of the seventh sub-side surface SS41_1 of the fourth side surface SS4_1 of the first sub-substrate SSUB1 may be similar to each other. For example, each of the length of the first sub-side surface SS11_1 of the first side surface SS1_1, the length of the third sub-side surface SS21_1 of the second side surface SS2_1, the length of the fifth sub-side surface SS31_1 of the third side surface SS3_1, and the length of the seventh sub-side surface SS41_1 of the fourth side surface SS4_1 of the first sub-substrate SSUB1 may be greater than approximately 10 µm and less than 30 µm.

For example, the difference between the length of the first sub-side surface SS11_1 of the first side surface SS1_1 of the first sub-substrate SSUB1 and the length of the third sub-side surface SS21_1 of the second side surface SS2_1 of the first sub-substrate SSUB1 may be less than approximately 10 µm. The difference between the length of the first sub-side surface SS11_1 of the first side surface SS1_1 of the first sub-substrate SSUB1 and the length of the fifth sub-side surface SS31_1 of the third side surface SS3_1 of the first sub-substrate SSUB1 may be less than approximately 10 µm. The difference between the length of the first sub-side surface SS11_1 of the first side surface SS1_1 of the first sub-substrate SSUB1 and the length of the sixth sub-side surface SS41_1 of the fourth side surface SS4_1 of the first sub-substrate SSUB1 may be less than approximately 10 µm. The difference between the length of the third sub-side surface SS21_1 of the second side surface SS2_1 of the first sub-substrate SSUB1 and the length of the fifth sub-side surface SS31_1 of the third side surface SS3_1 of the first sub-substrate SSUB1 may be less than approximately 10 µm. The difference between the length of the third sub-side surface SS21_1 of the second side surface SS2_1 of the first sub-substrate SSUB1 and the length of the seventh sub-side surface SS41_1 of the fourth side surface SS4_1 of the first sub-substrate SSUB1 may be less than approximately 10 µm. The difference between the length of the fifth sub-side surface SS31_1 of the third side surface SS3_1 of the first sub-substrate SSUB1 and the length of the seventh sub-side surface SS41_1 of the fourth side surface SS4_1 of the first sub-substrate SSUB1 may be less than approximately 10 µm.

The radius of curvature of the upper portion SS12_1U of the second sub-side surface SS12_1 of the first side surface SS1_1, the radius of curvature of the upper portion SS22_1U of the fourth sub-side surface SS22_1 of the second side surface SS2_1, the radius of curvature of the upper portion SS32_1U of the sixth sub-side surface SS32_1 of the third side surface SS3_1, and the radius of curvature of the upper portion SS42_1U of the eighth sub-side surface SS42_1 of the fourth side surface SS4_1 of the first sub-substrate SSUB1 may be similar to each other.

For example, the difference between the radius of curvature of the upper portion SS12_1U of the second sub-side surface SS12_1 of the first side surface SS1_1 of the first sub-substrate SSUB1 and the radius of curvature of the upper portion SS22_1U of the fourth sub-side surface SS22_1 of the second side surface SS2_1 of the first sub-substrate SSUB1 may be less than approximately 30 µm. The difference between the radius of curvature of the upper portion SS12_1U of the second sub-side surface SS12_1 of the first side surface SS1_1 of the first sub-substrate SSUB1 and the radius of curvature of the upper portion SS32_1U of the sixth sub-side surface SS32_1 of the third side surface SS3_1 of the first sub-substrate SSUB1 may be less than approximately 30 µm. The difference between the radius of curvature of the upper portion SS12_1U of the second sub-side surface SS12_1 of the first side surface SS1_1 of the first sub-substrate SSUB1 and the radius of curvature of the upper portion SS42_1U of the eighth sub-side surface SS42_1 of the fourth side surface SS4_1 of the first sub-substrate SSUB1 may be less than approximately 30 µm. The difference between the radius of curvature of the upper portion SS22_1U of the fourth sub-side surface SS22_1 of the second side surface SS2_1 of the first sub-substrate SSUB1 and the radius of curvature of the upper portion SS32_1U of the sixth sub-side surface SS32_1 of the third side surface SS3_1 of the first sub-substrate SSUB1 may be less than approximately 30 µm. The difference between the radius of curvature of the upper portion SS22U_1 of the fourth sub-side surface SS22_1 of the second side surface SS2_1 of the first sub-substrate SSUB1 and the radius of curvature of the upper portion SS42_1U of the eighth sub-side surface SS42_1 of the fourth side surface SS4_1 of the first sub-substrate SSUB1 may be less than approximately 30 µm. The difference between the radius of curvature of the upper portion SS32U_1 of the sixth sub-side surface SS32_1 of the third side surface SS3_1 of the first sub-substrate SSUB1 and the radius of curvature of the upper portion SS42_1U of the eighth sub-side surface SS42_1 of the fourth side surface SS4_1 of the first sub-substrate SSUB1 may be less than approximately 30 µm.

As shown in FIGS. 45A to 45D, the difference in radius of curvature between the side surfaces SS1_1, SS2_1, SS3_1, and SS4_1 of the first sub-substrate SSUB1 of the display panel 100 may be negligible. Accordingly, mechanical strength may be uniformly maintained according to the positions of the side surfaces SS1_1, SS2_1, SS3_1, and SS4_1 of the first sub-substrate SSUB1 of the display panel 100.

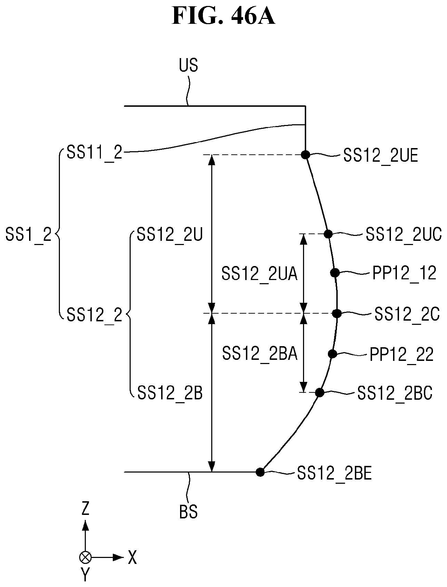

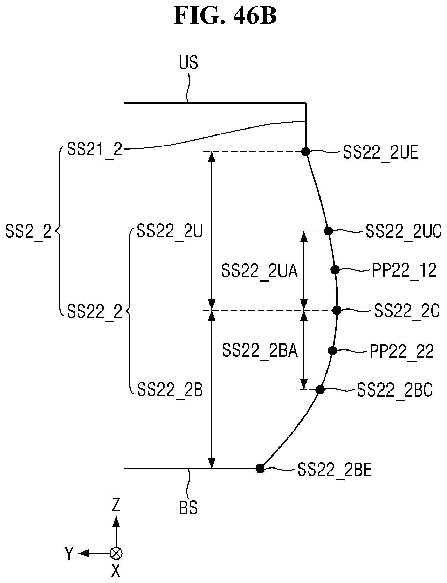

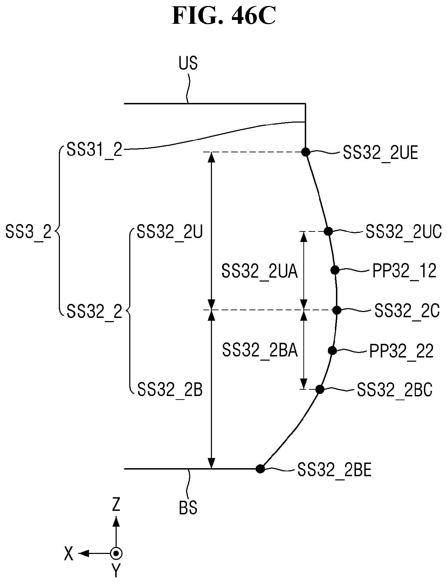

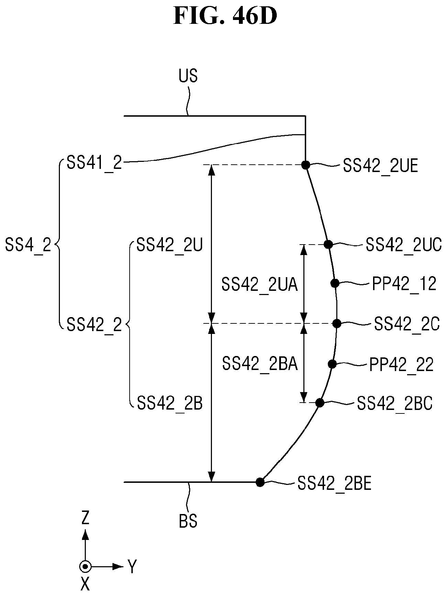

FIGS. 46A to 46D are enlarged cross-sectional views showing yet other examples of the first to fourth side surfaces of the second sub-substrate in FIGS. 39 and 42. FIG. 46A shows a cross-section of the first side surface SS1_2 of the second sub-substrate SSUB2, FIG. 46B shows a cross-section of the second side surface SS2_2 of the second sub-substrate SSUB2, FIG. 46C shows a cross-section of the third side surface SS3_2 of the second sub-substrate SSUB2, and FIG. 46D shows a cross-section of the fourth side surface SS4_2 of the second sub-substrate SSUB2.

Referring to FIG. 46A, the first side surface SS1_2 of the second sub-substrate SSUB2 may have a first sub-side surface SS11_2 having a planar shape or a curved shape and a second sub-side surface SS12_2 having a curved shape with a changing radius of curvature. The length of the first sub-side surface SS11_2 of the second sub-substrate SSUB2 may be less than the length of the second sub-side surface SS12_2.

The first sub-side surface SS11_2 of the second sub-substrate SSUB2 may be connected to the top surface US, and the second sub-side surface SS12_2 of the second sub-substrate SSUB2 may be connected to the bottom surface BS. The angle between the first sub-side surface SS11_2 and the top surface US of the second sub-substrate SSUB2 may be a right angle or an obtuse angle close to a right angle.

The curved shape of an upper portion SS12_2U of the second sub-side surface SS12_2 and the curved shape of a lower portion SS12_2B of the second sub-side surface SS12_2 of the second sub-substrate SSUB2 may be different. The upper portion SS12_2U of the second sub-side surface SS12_2 of the second sub-substrate SSUB2 refers to an area located above a center SS12_2C of the second sub-side surface SS12_2. The lower portion SS12_2B of the second sub-side surface SS12_2 of the second sub-substrate SSUB2 refers to an area located below the center SS12_2C of the second sub-side surface SS12_2.

The radius of curvature of the upper portion SS12_2U of the second sub-side surface SS12_2 and the radius of curvature of the lower portion SS12_2B of the second sub-side surface SS12_2 of the second sub-substrate SSUB2 may be different. For example, the radius of curvature of the lower portion SS12_2B of the second sub-side surface SS12_2 of the second sub-substrate SSUB2 may be less than the radius of curvature of the upper portion SS12_2U of the second sub-side surface SS12_2.

The radius of curvature of the upper portion SS12_2U of the second sub-side surface SS12_2 of the second sub-substrate SSUB2 may be defined as the radius of curvature of a curve passing through the center SS12_2C of the second sub-side surface SS12_2, an upper end SS12_2UE of the second sub-side surface SS12_2, and an upper center SS12_2UC of the second sub-side surface SS12_2. The radius of curvature of the lower portion SS12_2B of the second sub-side surface SS12_2 of the second sub-substrate SSUB2 may be defined as the radius of curvature of a curve passing through the center SS12_2C of the second sub-side surface SS12_2, a lower end SS12_2BE of the second sub-side surface SS12_2, and a lower center SS12_2BC of the second sub-side surface SS12_2.

In addition, the radius of curvature of the central area of the second sub-side surface SS12_2 of the second sub-substrate SSUB2 may be different from the radius of curvature of the upper portion SS12_2U and the radius of curvature of the lower portion SS12_2B of the second sub-side surface SS12_2 of the second sub-substrate SSUB2. The radius of curvature of the central area of the second sub-side surface SS12_2 of the second sub-substrate SSUB2 may be defined as the radius of curvature of a curve passing through the center SS12_2C, the upper center SS12_2UC, and the lower center SS12_2BC of the second sub-side surface SS12_2 of the second sub-substrate SSUB2.

In addition, the difference between the radius of curvature of an upper central area SS12_2UA and the radius of curvature of a lower central area SS12_2BA of the second sub-side surface SS12_2 of the second sub-substrate SSUB2 may be less than the difference between the radius of curvature of the upper portion SS12_2U and the radius of curvature of the lower portion SS12_2B of the second sub-side surface SS12_2 of the second sub-substrate SSUB2. The radius of curvature of the upper central area SS12_2UA and the radius of curvature of the lower central area SS12_2BA of the second sub-side surface SS12_2 of the second sub-substrate SSUB2 may be substantially the same. Alternatively, the difference between the radius of curvature of the upper central area SS12_2UA and the radius of curvature of the lower central area SS12_2BA of the second sub-side surface SS12_2 of the second sub-substrate SSUB2 may be 30 µm or less.

The radius of curvature of the upper central area SS12_2UA of the second sub-side surface SS12_2 of the second sub-substrate SSUB2 may be defined as the radius of curvature of a curve passing through the center SS12_2C, the upper center SS12_2UC, and a first point PP12_12 of the second sub-side surface SS12_2 of the second sub-substrate SSUB2. The radius of curvature of the lower central area SS12_2BA of the second sub-side surface SS12_2 of the second sub-substrate SSUB2 may be defined as the radius of curvature of a curve passing through the center SS12_2C, the lower center SS12_2BC, and a second point PP12_22 of the second sub-side surface SS12_2 of the second sub-substrate SSUB2. The first point PP12_12 of the second sub-side surface SS12_2 of the second sub-substrate SSUB2 may be defined as an intermediate point between the center SS12_2C and the upper center SS12_2UC of the second sub-side surface SS12_2 of the second sub-substrate SSUB2. The second point PP12_22 of the second sub-side surface SS12_2 of the second sub-substrate SSUB2 may be defined as an intermediate point between the center SS12_2C and the lower center SS12_2BC of the second sub-side surface SS12_2 of the second sub-substrate SSUB2.

Referring to FIG. 46B, the second side surface SS2_2 of the second sub-substrate SSUB2 may have a third sub-side surface SS21_2 having a planar shape or a curved shape and a fourth sub-side surface SS22_2 having a curved shape with a changing radius of curvature. The length of the third sub-side surface SS21_2 of the second sub-substrate SSUB2 may be less than the length of the fourth sub-side surface SS22_2.

The third sub-side surface SS21_2 of the second sub-substrate SSUB2 may be connected to the top surface US, and the fourth sub-side surface SS22_2 may be connected to the bottom surface BS. The angle between the third sub-side surface SS21_2 and the top surface US of the second sub-substrate SSUB2 may be a right angle or an obtuse angle close to a right angle.

The curved shape of an upper portion SS22_2U of the fourth sub-side surface SS22_2 and the curved shape of a lower portion SS22_2B of the fourth sub-side surface SS22_2 of the second sub-substrate SSUB2 may be different. The upper portion SS22_2U of the fourth sub-side surface SS22_2 of the second sub-substrate SSUB2 refers to an area located above a center SS22_2C of the fourth sub-side surface SS22_2. The lower portion SS22_2B of the fourth sub-side surface SS22_2 of the second sub-substrate SSUB2 refers to an area located below the center SS22_2C of the fourth sub-side surface SS22_2.

The radius of curvature of the upper portion SS22_2U of the fourth sub-side surface SS22_2 and the radius of curvature of the lower portion SS22_2B of the fourth sub-side surface SS22_2 of the second sub-substrate SSUB2 may be different. For example, the radius of curvature of the lower portion SS22B_2 of the fourth sub-side surface SS22_2 of the second sub-substrate SSUB2 may be less than the radius of curvature of the upper portion SS22_2U of the fourth sub-side surface SS22_2.

The radius of curvature of the upper portion SS22_2U of the fourth sub-side surface SS22_2 of the second sub-substrate SSUB2 may be defined as the radius of curvature of a curve passing through the center SS22_2C of the fourth sub-side surface SS22_2, an upper end SS22_2UE of the fourth sub-side surface SS22_2, and an upper center SS22_2UC of the fourth sub-side surface SS22_2. The radius of curvature of the lower portion SS22_2B of the fourth sub-side surface SS22_2 of the second sub-substrate SSUB2 may be defined as the radius of curvature of a curve passing through the center SS22_2C of the fourth sub-side surface SS22_2, a lower end SS22_2BE of the fourth sub-side surface SS22_2, and a lower center SS22_2BC of the fourth sub-side surface SS22_2.

In addition, the radius of curvature of the central area of the fourth sub-side surface SS22_2 of the second sub-substrate SSUB2 may be different from the radius of curvature of the upper portion SS22_2U and the radius of curvature of the lower portion SS22_2B of the fourth sub-side surface SS22_2 of the second sub-substrate SSUB2. The radius of curvature of the central area of the fourth sub-side surface SS22_2 of the second sub-substrate SSUB2 may be defined as the radius of curvature of a curve passing through the center SS22_2C, the upper center SS22_2UC, and the lower center SS22_2BC of the fourth sub-side surface SS22_2 of the second sub-substrate SSUB2.

In addition, the difference between the radius of curvature of an upper central area SS22_2UA and the radius of curvature of a lower central area SS22_2BA of the fourth sub-side surface SS22_2 of the second sub-substrate SSUB2 may be less than the difference between the radius of curvature of the upper portion SS22_2U and the radius of curvature of the lower portion SS22_2B of the fourth sub-side surface SS22_2 of the second sub-substrate SSUB2. The radius of curvature of the upper central area SS22_2UA and the radius of curvature of the lower central area SS22_2BA of the fourth sub-side surface SS22_2 of the second sub-substrate SSUB2 may be substantially the same. Alternatively, the difference between the radius of curvature of the upper central area SS22_2UA and the radius of curvature of the lower central area SS22_2BA of the fourth sub-side surface SS22_2 of the second sub-substrate SSUB2 may be 30 µm or less.

The radius of curvature of the upper central area SS22_2UA of the fourth sub-side surface SS22_2 of the second sub-substrate SSUB2 may be defined as the radius of curvature of a curve passing through the center SS22_2C, the upper center SS22_2UC, and a first point PP22_12 of the fourth sub-side surface SS22_2 of the second sub-substrate SSUB2. The radius of curvature of the lower central area SS22_2BA of the fourth sub-side surface SS22_2 of the second sub-substrate SSUB2 may be defined as the radius of curvature of a curve passing through the center SS22_2C, the lower center SS22_2BC, and a second point PP22_22 of the fourth sub-side surface SS22_2 of the second sub-substrate SSUB2. The first point PP22_12 of the fourth sub-side surface SS22_2 of the second sub-substrate SSUB2 may be defined as an intermediate point between the center SS22_2C and the upper center SS22_2UC of the fourth sub-side surface SS22_2 of the second sub-substrate SSUB2. The second point PP22_22 of the fourth sub-side surface SS22_2 of the second sub-substrate SSUB2 may be defined as an intermediate point between the center SS22_2C and the lower center SS22_2BC of the fourth sub-side surface SS22_2 of the second sub-substrate SSUB2.

Referring to FIG. 46C, the third side surface SS3_2 of the second sub-substrate SSUB2 may have a fifth sub-side surface SS31_2 having a planar shape or a curved shape and a sixth sub-side surface SS32_2 having a curved shape with a changing radius of curvature. The length of the fifth sub-side surface SS31_2 may be less than the length of the sixth sub-side surface SS32_2.

The fifth sub-side surface SS31_2 of the second sub-substrate SSUB2 may be connected to the top surface US, and the sixth sub-side surface SS32_2 may be connected to the bottom surface BS. The angle between the fifth sub-side surface SS31_2 and the top surface US of the second sub-substrate SSUB2 may be a right angle or an obtuse angle close to a right angle.

The curved shape of an upper portion SS32_2U of the sixth sub-side surface SS32_2 and the curved shape of a lower portion SS32_2B of the sixth sub-side surface SS32_2 of the second sub-substrate SSUB2 may be different. The upper portion SS32_2U of the sixth sub-side surface SS32_2 of the second sub-substrate SSUB2 refers to an area located above a center SS32_2C of the sixth sub-side surface SS32_2. The lower portion SS32_2B of the sixth sub-side surface SS32_2 of the second sub-substrate SSUB2 refers to an area located below the center SS32_2C of the sixth sub-side surface SS32_2.

The radius of curvature of the upper portion SS32_2U of the sixth sub-side surface SS32_2 and the radius of curvature of the lower portion SS32_2B of the sixth sub-side surface SS32_2 of the second sub-substrate SSUB2 may be different. For example, the radius of curvature of the lower portion SS32_2B of the sixth sub-side surface SS32_2 of the second sub-substrate SSUB2 may be less than the radius of curvature of the upper portion SS32_2U of the sixth sub-side surface SS32_2.

The radius of curvature of the upper portion SS32_2U of the sixth sub-side surface SS32_2 of the second sub-substrate SSUB2 may be defined as the radius of curvature of a curve passing through the center SS32_2C of the sixth sub-side surface SS32_2, an upper end SS32_2UE of the sixth sub-side surface SS32_2, and an upper center SS32_2UC of the sixth sub-side surface SS32_2. The radius of curvature of the lower portion SS32_2B of the sixth sub-side surface SS32_2 of the second sub-substrate SSUB2 may be defined as the radius of curvature of a curve passing through the center SS32_2C of the sixth sub-side surface SS32_2, a lower end SS32_2BE of the sixth sub-side surface SS32_2, and a lower center SS32_2BC of the sixth sub-side surface SS32_2.

In addition, the radius of curvature of the central area of the sixth sub-side surface SS32_2 of the second sub-substrate SSUB2 may be different from the radius of curvature of the upper portion SS32_2U and the radius of curvature of the lower portion SS32_2B of the sixth sub-side surface SS32_2 of the second sub-substrate SSUB2. The radius of curvature of the central area of the sixth sub-side surface SS32_2 of the second sub-substrate SSUB2 may be defined as the radius of curvature of a curve passing through the center SS32_2C, the upper center SS32_2UC, and the lower center SS32_2BC of the sixth sub-side surface SS32_2 of the second sub-substrate SSUB2.

In addition, the difference between the radius of curvature of an upper central area SS32_2UA and the radius of curvature of a lower central area SS32_2BA of the sixth sub-side surface SS32_2 of the second sub-substrate SSUB2 may be less than the difference between the radius of curvature of the upper portion SS32_2U and the radius of curvature of the lower portion SS32_2B of the sixth sub-side surface SS32_2 of the second sub-substrate SSUB2. The radius of curvature of the upper central area SS32_2UA and the radius of curvature of the lower central area SS32_2BA of the sixth sub-side surface SS32_2 of the second sub-substrate SSUB2 may be substantially the same. Alternatively, the difference between the radius of curvature of the upper central area SS32_2UA and the radius of curvature of the lower central area SS32_2BA of the sixth sub-side surface SS32_2 of the second sub-substrate SSUB2 may be 30 µm or less.

The radius of curvature of the upper central area SS32_2UA of the sixth sub-side surface SS32_2 of the second sub-substrate SSUB2 may be defined as the radius of curvature of a curve passing through the center SS32_2C, the upper center SS32_2UC, and a first point PP32_12 of the sixth sub-side surface SS32_2 of the second sub-substrate SSUB2. The radius of curvature of the lower central area SS32_2BA of the sixth sub-side surface SS32_2 of the second sub-substrate SSUB2 may be defined as the radius of curvature of a curve passing through the center SS32_2C, the lower center SS32_2BC, and a second point PP32_22 of the sixth sub-side surface SS32_2 of the second sub-substrate SSUB2. The first point PP32_12 of the sixth sub-side surface SS32_2 of the second sub-substrate SSUB2 may be defined as an intermediate point between the center SS32_2C and the upper center SS32_2UC of the sixth sub-side surface SS32_2 of the second sub-substrate SSUB2. The second point PP32_22 of the sixth sub-side surface SS32_2 of the second sub-substrate SSUB2 may be defined as an intermediate point between the center SS32_2C and the lower center SS32_2BC of the sixth sub-side surface SS32_2 of the second sub-substrate SSUB2.

Referring to FIG. 46D, the fourth side surface SS4_2 of the second sub-substrate SSUB2 may have a seventh sub-side surface SS41_2 having a planar shape or a curved shape and an eighth sub-side surface SS42_2 having a curved shape with a changing radius of curvature. The length of the seventh sub-side surface SS41_2 of the second sub-substrate SSUB2 may be less than the length of the eighth sub-side surface SS42_2.

The seventh sub-side surface SS41_2 of the second sub-substrate SSUB2 may be connected to the top surface US, and the eighth sub-side surface SS42_2 may be connected to the bottom surface BS. The angle between the seventh sub-side surface SS41_2 and the top surface US of the second sub-substrate SSUB2 may be a right angle or an obtuse angle close to a right angle.

The curved shape of an upper portion SS42_2U of the eighth sub-side surface SS42_2 and the curved shape of a lower portion SS42_2B of the eighth sub-side surface SS42_2 of the second sub-substrate SSUB2 may be different. The upper portion SS42_2U of the eighth sub-side surface SS42_2 of the second sub-substrate SSUB2 refers to an area located above a center SS42_2C of the eighth sub-side surface SS42_2. The lower portion SS42_2B of the eighth sub-side surface SS42_2 of the second sub-substrate SSUB2 refers to an area located below the center SS42_2C of the eighth sub-side surface SS42_2.

The radius of curvature of the upper portion SS42_2U of the eighth sub-side surface SS42_2 and the radius of curvature of the lower portion SS42_2B of the eighth sub-side surface SS42_2 of the second sub-substrate SSUB2 may be different. For example, the radius of curvature of the lower portion SS42_2B of the eighth sub-side surface SS42_2 of the second sub-substrate SSUB2 may be less than the radius of curvature of the upper portion SS42_2U of the eighth sub-side surface SS42_2.

The radius of curvature of the upper portion SS42_2U of the eighth sub-side surface SS42_2 of the second sub-substrate SSUB2 may be defined as the radius of curvature of a curve passing through the center SS42_2C of the eighth sub-side surface SS42_2, an upper end SS42_2UE of the eighth sub-side surface SS42_2, and an upper center SS42_2UC of the eighth sub-side surface SS42_2. The radius of curvature of the lower portion SS42_2B of the eighth sub-side surface SS42_2 may be defined as the radius of curvature of a curve passing through the center SS42_2C of the eighth sub-side surface SS42_2, a lower end SS42_2BE of the eighth sub-side surface SS42_2, and a lower center SS42_2BC of the eighth sub-side surface SS42_2.

In addition, the radius of curvature of the central area of the eighth sub-side surface SS42_2 of the second sub-substrate SSUB2 may be different from the radius of curvature of the upper portion SS42_2U and the radius of curvature of the lower portion SS42_2B of the eighth sub-side surface SS42_2 of the second sub-substrate SSUB2. The radius of curvature of the central area of the eighth sub-side surface SS42_2 of the second sub-substrate SSUB2 may be defined as the radius of curvature of a curve passing through the center SS42_2C, the upper center SS42_2UC, and the lower center SS42_2BC of the eighth sub-side surface SS42_2 of the second sub-substrate SSUB2.

In addition, the difference between the radius of curvature of an upper central area SS42_2UA and the radius of curvature of a lower central area SS42_2BA of the eighth sub-side surface SS42_2 of the second sub-substrate SSUB2 may be less than the difference between the radius of curvature of the upper portion SS42_2U and the radius of curvature of the lower portion SS42_2B of the eighth sub-side surface SS42_2 of the second sub-substrate SSUB2. The radius of curvature of the upper central area SS42_2UA and the radius of curvature of the lower central area SS42_2BA of the eighth sub-side surface SS42_2 of the second sub-substrate SSUB2 may be substantially the same. Alternatively, the difference between the radius of curvature of the upper central area SS42_2UA and the radius of curvature of the lower central area SS42_2BA of the eighth sub-side surface SS42_2 of the second sub-substrate SSUB2 may be 30 µm or less.

The radius of curvature of the upper central area SS42_2UA of the eighth sub-side surface SS42_2 of the second sub-substrate SSUB2 may be defined as the radius of curvature of a curve passing through the center SS42_2C, the upper center SS42_2UC, and a first point PP42_12 of the eighth sub-side surface SS42_2 of the second sub-substrate SSUB2. The radius of curvature of the lower central area SS42_2BA of the eighth sub-side surface SS42_2 of the second sub-substrate SSUB2 may be defined as the radius of curvature of a curve passing through the center SS42_2C, the lower center SS42_2BC, and a second point PP42_22 of the eighth sub-side surface SS42_2 of the second sub-substrate SSUB2. The first point PP42_12 of the eighth sub-side surface SS42_2 of the second sub-substrate SSUB2 may be defined as an intermediate point between the center SS42_2C and the upper center SS42_2UC of the eighth sub-side surface SS42_2 of the second sub-substrate SSUB2. The second point PP42_22 of the eighth sub-side surface SS42_2 of the second sub-substrate SSUB2 may be defined as an intermediate point between the center SS42_2C and the lower center SS42_2BC of the eighth sub-side surface SS42_2 of the second sub-substrate SSUB2.

Referring to FIGS. 46A to 46D, the length of the first sub-side surface SS11_2 of the first side surface SS1_2, the length of the third sub-side surface SS21_2 of the second side surface SS2_2, the length of the fifth sub-side surface SS31_2 of the third side surface SS3_2, and the length of the seventh sub-side surface SS41_2 of the fourth side surface SS4_2 of the second sub-substrate SSUB2 may be similar to each other.

For example, the difference between the length of the first sub-side surface SS11_2 of the first side surface SS1_2 of the second sub-substrate SSUB2 and the length of the third sub-side surface SS21_2 of the second side surface SS2_2 of the second sub-substrate SSUB2 may be less than approximately 10 µm. The difference between the length of the first sub-side surface SS11_2 of the first side surface SS1_2 of the second sub-substrate SSUB2 and the length of the fifth sub-side surface SS31_2 of the third side surface SS3_2 of the second sub-substrate SSUB2 may be less than approximately 10 µm. The difference between the length of the first sub-side surface SS11_2 of the first side surface SS1_2 of the second sub-substrate SSUB2 and the length of the sixth sub-side surface SS41_2 of the fourth side surface SS4_2 of the second sub-substrate SSUB2 may be less than approximately 10 µm. The difference between the length of the third sub-side surface SS21_2 of the second side surface SS2_2 of the second sub-substrate SSUB2 and the length of the fifth sub-side surface SS31_2 of the third side surface SS3_2 of the second sub-substrate SSUB2 may be less than approximately 10 µm. The difference between the length of the third sub-side surface SS21_2 of the second side surface SS2_2 of the second sub-substrate SSUB2 and the length of the seventh sub-side surface SS41_2 of the fourth side surface SS4_2 of the second sub-substrate SSUB2 may be less than approximately 10 µm. The difference between the length of the fifth sub-side surface SS31_2 of the third side surface SS3_2 of the second sub-substrate SSUB2 and the length of the seventh sub-side surface SS41_2 of the fourth side surface SS4_2 of the second sub-substrate SSUB2 may be less than approximately 10 µm.

The radius of curvature of the upper portion SS12_2U of the second sub-side surface SS12_2 of the first side surface SS1_2, the radius of curvature of the upper portion SS22_2U of the fourth sub-side surface SS22_2 of the second side surface SS2_2, the radius of curvature of the upper portion SS32_2U of the sixth sub-side surface SS32_2 of the third side surface SS3_2, and the radius of curvature of the upper portion SS42_2U of the eighth sub-side surface SS42_2 of the fourth side surface SS4_2 of the second sub-substrate SSUB2 may be similar to each other.

For example, the difference between the radius of curvature of the upper portion SS12_2U of the second sub-side surface SS12_2 of the first side surface SS1_2 of the second sub-substrate SSUB2 and the radius of curvature of the upper portion SS22_2U of the fourth sub-side surface SS22_2 of the second side surface SS2_2 of the second sub-substrate SSUB2 may be less than approximately 30 µm. The difference between the radius of curvature of the upper portion SS12_2U of the second sub-side surface SS12_2 of the first side surface SS1_2 of the second sub-substrate SSUB2 and the radius of curvature of the upper portion SS32_2U of the sixth sub-side surface SS32_2 of the third side surface SS3_2 of the second sub-substrate SSUB2 may be less than approximately 30 µm. The difference between the radius of curvature of the upper portion SS12_2U of the second sub-side surface SS12_2 of the first side surface SS1_2 of the second sub-substrate SSUB2 and the radius of curvature of the upper portion SS42_2U of the eighth sub-side surface SS42_2 of the fourth side surface SS4_2 of the second sub-substrate SSUB2 may be less than approximately 30 µm. The difference between the radius of curvature of the upper portion SS22_2U of the fourth sub-side surface SS22_2 of the second side surface SS2_2 of the second sub-substrate SSUB2 and the radius of curvature of the upper portion SS32_2U of the sixth sub-side surface SS32_2 of the third side surface SS3_2 of the second sub-substrate SSUB2 may be less than approximately 30 µm. The difference between the radius of curvature of the upper portion SS22_2U of the fourth sub-side surface SS22_2 of the second side surface SS2_2 of the second sub-substrate SSUB2 and the radius of curvature of the upper portion SS42_2U of the eighth sub-side surface SS42_2 of the fourth side surface SS4_2 of the second sub-substrate SSUB2 may be less than approximately 30 µm. The difference between the radius of curvature of the upper portion SS32_2U of the sixth sub-side surface SS32_2 of the third side surface SS3_2 of the second sub-substrate SSUB2 and the radius of curvature of the upper portion SS42_2U of the eighth sub-side surface SS42_2 of the fourth side surface SS4_2 of the second sub-substrate SSUB2 may be less than approximately 30 µm.

As shown in FIGS. 46A to 46D, the difference in radius of curvature between the side surfaces SS1_2, SS2_2, SS3_2, and SS4_2 of the second sub-substrate SSUB2 of the display panel 100 may be negligible. Accordingly, mechanical strength may be uniformly maintained according to the positions of the side surfaces SS1_2, SS2_2, SS3_2, and SS4_2 of the second sub-substrate SSUB2 of the display panel 100.

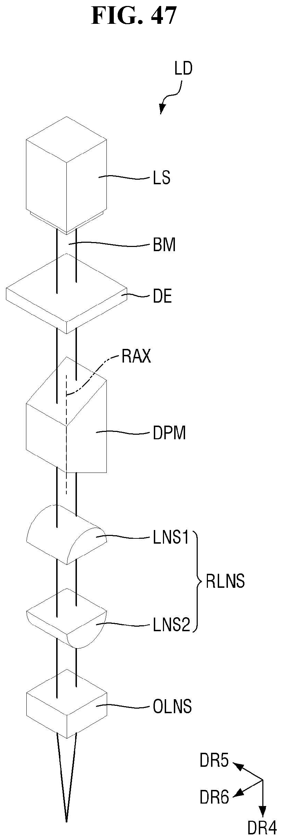

FIG. 47 is a perspective view showing a laser device according to one embodiment.

Referring to FIG. 47, a laser device LD according to one embodiment includes a light source LS, a diffractive element DE, a Dove prism DPM, a relay lens RLNS, and an objective lens OLNS.

The light source LS may be any of various known laser generating devices. The light source LS may emit a laser beam BM. The light source LS may emit the beam BM continuously or discontinuously. The light source LS may output the laser beam BM of a single pulse or the laser beam BM of a burst pulse including a plurality of pulses.

The pulse duration, burst pulse, pulse energy, repetition rate, and the like of the laser beam BM may be adjusted by the light source LS. For example, the pulse duration (or pulse width) of the laser beam BM may be in a range of approximately 3 ps (picoseconds) to 10 ps. The burst pulse of the laser beam BM may be in a range of approximately 1 to 10 pulses. When the burst pulse of the laser beam BM is 1 pulse, the laser beam BM may be a single pulse. The pulse energy of the laser beam BM may be in a range of approximately 2 µJ/spot to 4 µJ/spot. The repetition rate of the laser beam BM may be in a range of approximately 10 kHz to 500 kHz.

Various laser beams may be used as the laser beam BM according to one embodiment, but in the present disclosure, the laser beam BM may be an infrared-based Bessel beam having a wavelength band of approximately 1,000 nm to 1,100 nm.

The diffractive element DE includes a diffraction pattern configured to focus the laser beam BM incident on the diffractive element DE onto laser spots (multi-spots). The diffractive element DE may be a diffractive optical element having a fixed diffraction pattern or a spatial light modulator capable of actively changing the diffraction patterns.

The prism DPM may be located between the diffractive element DE and the relay lens RLNS. The prism DPM may be a Dove prism having a trapezoidal cross-section, but the embodiment of the present disclosure is not limited thereto.

The prism DPM may be rotated by a rotation motor to rotate the laser beam. The rotation of the laser beam refers to rotating the image phase of the laser beam. The prism DPM may be configured to be rotated clockwise or counterclockwise about a longitudinal rotation axis by the rotation motor. The longitudinal rotation axis may be the rotation axis of a fourth direction DR4. The rotation motor may rotate the prism DPM clockwise or counterclockwise about a longitudinal rotation axis RAX. The rotation motor may be any of various known motors such as a hollow motor, a stepping motor, a servo motor, and a brushless motor.

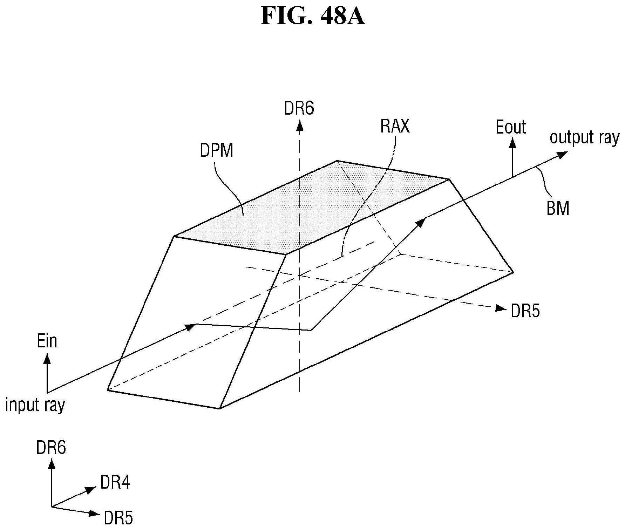

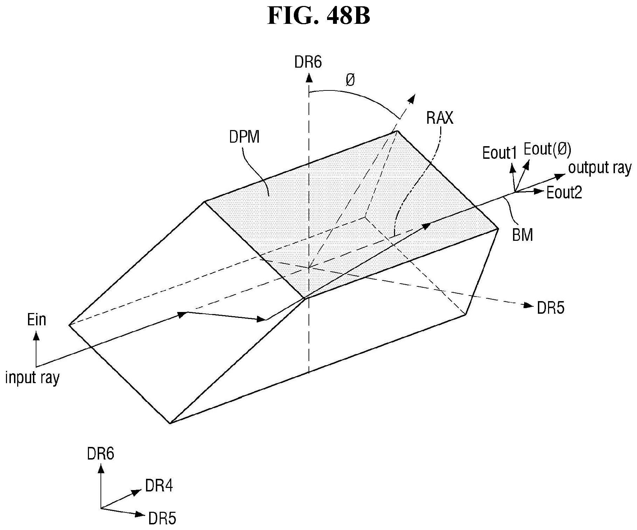

When the prism DPM is a Dove prism having trapezoidal faces as shown in FIGS. 48A and 48B, since the laser beam undergoes two refractions and one total internal reflection within the prism DPM, the rotation angle of the laser beam may be twice the rotation angle of the prism DPM.

The relay lens RLNS may be located between the prism DPM and the objective lens OLNS. The relay lens RLNS includes a first lens LNS1 and a second lens LNS2. The first lens LNS1 may be located adjacent to the prism DPM, and the second lens LNS2 may be located adjacent to the objective lens OLNS. The first lens LNS1 may be a convex lens that is convex toward the prism DPM, and the second lens LNS2 may be a convex lens that is convex toward the objective lens OLNS. The relay lens RLNS may transmit light at a ratio of n (where n is a positive integer):1 or 1:n.

The objective lens OLNS may image the laser beam BM that has passed through the relay lens RLNS, at a selected distance.

The light source LS, the diffractive element DE, the Dove prism DPM, the relay lens RLNS, and the objective lens OLNS of the laser device LD may be aligned in the fourth direction DR4.

FIGS. 48A and 48B are views illustrating light outputted from a prism when the prism rotates by Φ.

Referring to FIGS. 48A and 48B, the prism DPM may be a Dove prism having trapezoidal faces. In this case, the prism DPM has two trapezoidal faces each having a pair of parallel sides extending in the fourth direction DR4.

The fourth direction DR4 is a direction of the parallel sides of the trapezoidal faces of the prism DPM, and a fifth direction DR5 is a direction of the sides connecting the trapezoidal faces of the prism DPM. The fifth direction DR5 may be a direction perpendicular to the fourth direction DR4. A sixth direction DR6 may be a direction perpendicular to both the fourth direction DR4 and the fifth direction DR5, and may be the height direction of the prism DPM shown in FIG. 48A. In FIGS. 48A and 48B, the arrow extending in the fourth direction DR4 represents the optical axis of the laser beam BM and indicates the traveling direction of the laser beam BM.

The prism DPM may rotate about the rotation axis RAX extending in the fourth direction DR4. The rotation axis RAX of the prism DPM may pass through the center of the prism DPM. FIG. 48B shows the prism DPM rotated by a selected angle Φ with respect to the sixth direction DR6 compared to the prism DPM shown in FIG. 48A.

As shown in FIG. 48A, when the polarization direction of incident light Ein is the sixth direction DR6, and the height direction of the prism DPM is aligned with the sixth direction DR6, light Eout outputted from the prism DPM also has a polarization direction in the sixth direction DR6.

As shown in FIG. 48B, when the polarization direction of the incident light Ein is the sixth direction DR6, and the height direction of the prism DPM is rotated by the selected angle Φ with respect to the sixth direction DR6 in a plane defined by the fourth direction DR4 and the sixth direction DR6, the light Eout outputted from the prism DPM includes a polarization component Eout1 in the fourth direction DR4 and a polarization component Eout2 in the fifth direction DR5. Therefore, circularly polarized or elliptically polarized light Eout(Φ) having a polarization direction different from that of the incident light Ein may be outputted in accordance with the rotation of the prism DPM.

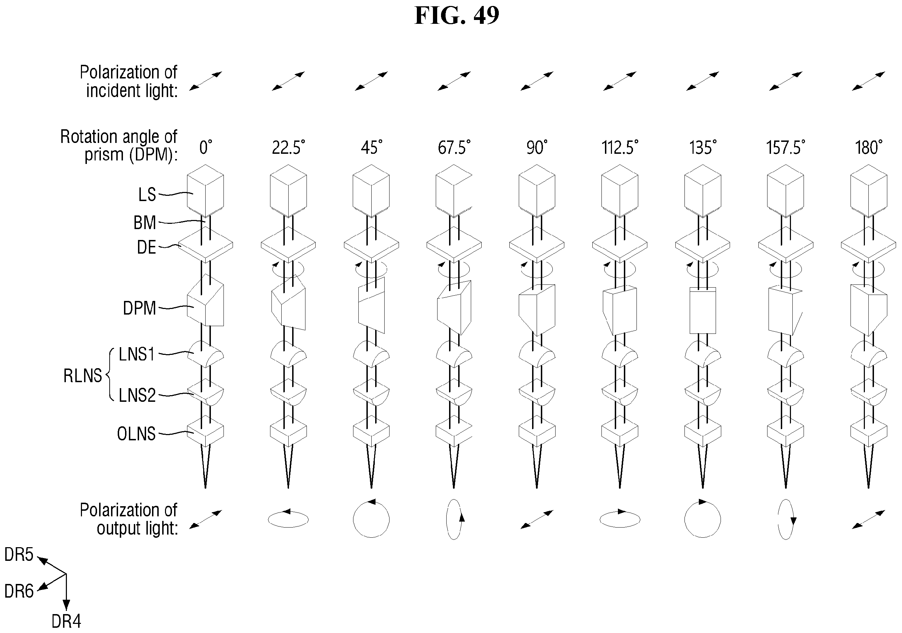

FIG. 49 is a view illustrating polarization of output light in accordance with rotation of the laser device in the embodiment of FIG. 47.

Referring to FIG. 49, when the laser device LD rotates, the light source LS, the diffractive element DE, the relay lens RLNS, and the objective lens OLNS do not rotate, and only the prism DPM rotates. Therefore, regardless of the rotation of the laser device LD, the light source LS outputs the linearly polarized laser beam BM having a polarization direction in the sixth direction DR6.

The prism DPM may rotate from 0° to 180° with respect to the sixth direction DR6 in a plane defined by the fourth direction DR4 and the sixth direction DR6. Since the rotation angle of the laser beam is twice the rotation angle of the prism DPM, when the prism DPM rotates from 0° to 180°, the laser beam may rotate from 0° to 360°.

Hereinafter, when the light source LS outputs the linearly polarized laser beam BM having a polarization direction in the sixth direction DR6, a detailed description will be given of the polarization direction of the laser beam outputted from the laser device LD depending on the degree of clockwise rotation of the prism DPM with respect to the sixth direction DR6. As shown in FIG. 49, the case where the prism DPM is at 0° with respect to the sixth direction DR6 refers to a state in which the light source LS, the diffractive element DE, the relay lens RLNS, and the objective lens OLNS are oriented in the sixth direction DR6. In addition, the case where the prism DPM is rotated clockwise by 22.5° with respect to the sixth direction DR6 refers to a state in which the light source LS, the diffractive element DE, the relay lens RLNS, and the objective lens OLNS are oriented in the sixth direction DR6, and the prism DPM is rotated clockwise by 22.5° with respect to the sixth direction DR6.

First, when the prism DPM is at 0° with respect to the sixth direction DR6, the linearly polarized light having a polarization direction in the sixth direction DR6 incident on the prism DPM is outputted as it is. Therefore, the laser device LD may output the linearly polarized light having a polarization direction in the sixth direction DR6 outputted from the light source LS, as it is.

When the prism DPM is rotated clockwise by 22.5° with respect to the sixth direction DR6, the linearly polarized light having a polarization direction in the sixth direction DR6 incident on the prism DPM is converted into elliptically polarized light having a polarization component in the fifth direction DR5 and a polarization component in the sixth direction DR6. In this case, the polarization component in the sixth direction DR6 may be larger than the polarization component in the fifth direction DR5.

When the prism DPM is rotated clockwise by 45° with respect to the sixth direction DR6, the linearly polarized light having a polarization direction in the sixth direction DR6 incident on the prism DPM is converted into circularly polarized light having a polarization component in the fifth direction DR5 and a polarization component in the sixth direction DR6. In this case, the polarization component in the fifth direction DR5 may be substantially equal to the polarization component in the sixth direction DR6.

When the prism DPM is rotated clockwise by 67.5° with respect to the sixth direction DR6, the linearly polarized light having a polarization direction in the sixth direction DR6 incident on the prism DPM is converted into elliptically polarized light having a polarization component in the fifth direction DR5 and a polarization component in the sixth direction DR6. In this case, the polarization component in the sixth direction DR6 may be smaller than the polarization component in the fifth direction DR5.

When the prism DPM is rotated clockwise by 90° with respect to the sixth direction DR6, the linearly polarized light having a polarization direction in the sixth direction DR6 incident on the prism DPM is outputted as it is. Therefore, the laser device LD may output the linearly polarized light having a polarization direction in the sixth direction DR6 outputted from the light source LS, as it is.

When the prism DPM is rotated clockwise by 112.5° with respect to the sixth direction DR6, the linearly polarized light having a polarization direction in the sixth direction DR6 incident on the prism DPM is converted into elliptically polarized light having a polarization component in the sixth direction DR6 and a polarization component in the direction opposite to the fifth direction DR5. In this case, the polarization component in the direction opposite to the fifth direction DR5 may be larger than the polarization component in the sixth direction DR6.

When the prism DPM is rotated clockwise by 135° with respect to the sixth direction DR6, the linearly polarized light having a polarization direction in the sixth direction DR6 incident on the prism DPM is converted into circularly polarized light having a polarization component in the sixth direction DR6 and a polarization component in the direction opposite to the fifth direction DR5. In this case, the polarization component in the direction opposite to the fifth direction DR5 may be substantially equal to the polarization component in the sixth direction DR6.

When the prism DPM is rotated clockwise by 157.5° with respect to the sixth direction DR6, the linearly polarized light having a polarization direction in the sixth direction DR6 incident on the prism DPM is converted into elliptically polarized light having a polarization component in the sixth direction DR6 and a polarization component in the direction opposite to the fifth direction DR5. In this case, the polarization component in the direction opposite to the fifth direction DR5 may be smaller than the polarization component in the sixth direction DR6.

When the prism DPM is rotated clockwise by 180° with respect to the sixth direction DR6, the linearly polarized light having a polarization direction in the sixth direction DR6 incident on the prism DPM is outputted as it is. Therefore, the laser device LD may output the linearly polarized light having a polarization direction in the sixth direction DR6 outputted from the light source LS, as it is.

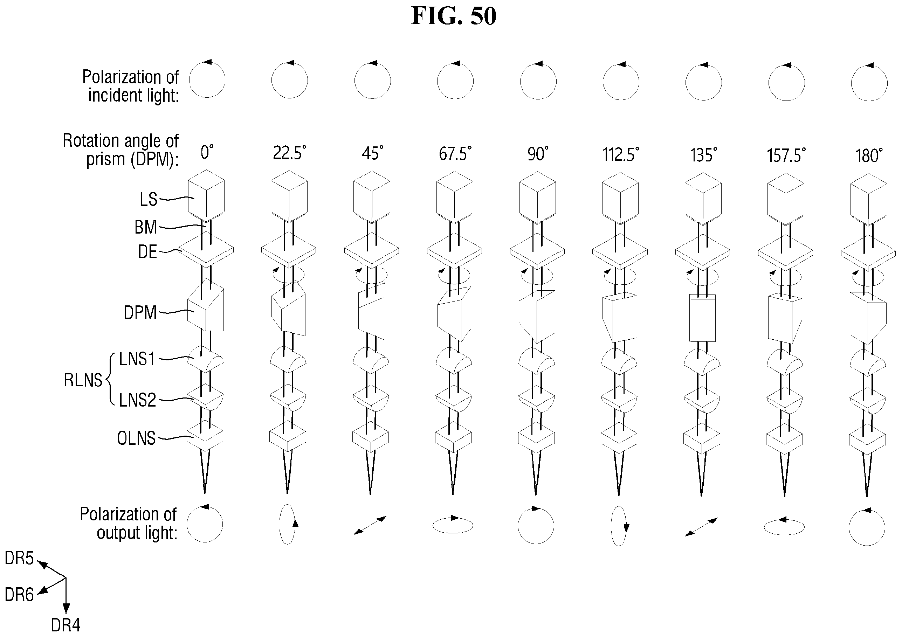

FIG. 50 is another view illustrating polarization of output light in accordance with rotation of the laser device in the embodiment of FIG. 47.

Referring to FIG. 50, when the laser device LD rotates, the light source LS, the diffractive element DE, the relay lens RLNS, and the objective lens OLNS do not rotate, and only the prism DPM rotates. Therefore, regardless of the rotation of the laser device LD, the light source LS outputs the circularly polarized laser beam BM having a polarization component in the fifth direction DR5 and a polarization component in the sixth direction DR6.

The prism DPM may rotate from 0° to 180° in increments of 22.5° with respect to the sixth direction DR6 in a plane defined by the fourth direction DR4 and the sixth direction DR6. Since the rotation angle of the laser beam is twice the rotation angle of the prism DPM, when the prism DPM rotates from 0° to 180°, the laser beam may rotate from 0° to 360°.

Hereinafter, when the light source LS outputs the circularly polarized laser beam BM having a polarization component in the fifth direction DR5 and a polarization component in the sixth direction DR6, a detailed description will be given of the polarization direction of the laser beam outputted from the laser device LD depending on the degree of clockwise rotation of the prism DPM with respect to the sixth direction DR6. As shown in FIG. 50, the case where the prism DPM is at 0° with respect to the sixth direction DR6 refers to a state in which the light source LS, the diffractive element DE, the prism DPM, the relay lens RLNS, and the objective lens OLNS are oriented in the sixth direction DR6. In addition, when the laser device LD rotates clockwise by 22.5° with respect to the sixth direction DR6, the light source LS, the diffractive element DE, the relay lens RLNS, and the objective lens OLNS may be oriented in the sixth direction DR6, and the prism DPM may rotate clockwise by 22.5° with respect to the sixth direction DR6. Although FIG. 50 illustrates the prism DPM rotating clockwise about the rotation axis RAX, the embodiment of the present disclosure is not limited thereto. That is, the prism DPM may also rotate counterclockwise about the rotation axis RAX.

First, when the prism DPM is at 0° with respect to the sixth direction DR6, the circularly polarized light having a polarization component in the fifth direction DR5 and a polarization component in the sixth direction DR6 incident on the prism DPM is outputted as it is. Therefore, the laser device LD may output the circularly polarized light having a polarization component in the fifth direction DR5 and a polarization component in the sixth direction DR6 outputted from the light source LS, as it is.

When the prism DPM is rotated clockwise by 22.5° with respect to the sixth direction DR6, the circularly polarized light having a polarization component in the fifth direction DR5 and a polarization component in the sixth direction DR6 incident on the prism DPM is converted into elliptically polarized light having a polarization component in the fifth direction DR5 and a polarization component in the sixth direction DR6. In this case, the polarization component in the sixth direction DR6 may be smaller than the polarization component in the fifth direction DR5.

When the prism DPM is rotated clockwise by 45° with respect to the sixth direction DR6, the circularly polarized light having a polarization component in the fifth direction DR5 and a polarization component in the sixth direction DR6 incident on the prism DPM is converted into linearly polarized light having a polarization direction in the fifth direction DR5.

When the prism DPM is rotated by 67.5° with respect to the sixth direction DR6, the circularly polarized light having a polarization component in the fifth direction DR5 and a polarization component in the sixth direction DR6 incident on the prism DPM is converted into elliptically polarized light having a polarization component in the fifth direction DR5 and a polarization component in the direction opposite to the sixth direction DR6. In this case, the polarization component in the direction opposite to the sixth direction DR6 may be smaller than the polarization component in the fifth direction DR5.

When the prism DPM is rotated clockwise by 90° with respect to the sixth direction DR6, the circularly polarized light having a polarization component in the fifth direction DR5 and a polarization component in the sixth direction DR6 incident on the prism DPM is converted into circularly polarized light having a polarization component in the fifth direction DR5 and a polarization component in the direction opposite to the sixth direction DR6. In this case, the polarization component in the fifth direction DR5 may be substantially equal to the polarization component in the direction opposite to the sixth direction DR6.

When the prism DPM is rotated clockwise by 112.5° with respect to the sixth direction DR6, the circularly polarized light having a polarization component in the fifth direction DR5 and a polarization component in the sixth direction DR6 incident on the prism DPM is converted into elliptically polarized light having a polarization component in the fifth direction DR5 and a polarization component in the direction opposite to the sixth direction DR6. In this case, the polarization component in the direction opposite to the sixth direction DR6 may be larger than the polarization component in the fifth direction DR5.

When the prism DPM is rotated clockwise by 135° with respect to the sixth direction DR6, the circularly polarized light having a polarization component in the fifth direction DR5 and a polarization component in the sixth direction DR6 incident on the prism DPM is converted into linearly polarized light having a polarization direction in the direction opposite to the sixth direction DR6.

When the prism DPM is rotated clockwise by 157.5° with respect to the sixth direction DR6, the circularly polarized light having a polarization component in the fifth direction DR5 and a polarization component in the sixth direction DR6 incident on the prism DPM is converted into elliptically polarized light having a polarization component in the direction opposite to the sixth direction DR6 and a polarization component in the direction opposite to the fifth direction DR5. In this case, the polarization component in the direction opposite to the sixth direction DR6 may be larger than the polarization component in the direction opposite to the fifth direction DR5.

When the prism DPM is rotated clockwise by 180° with respect to the sixth direction DR6, the circularly polarized light having a polarization component in the fifth direction DR5 and a polarization component in the sixth direction DR6 incident on the prism DPM is converted into circularly polarized light having a polarization component in the direction opposite to the sixth direction DR6 and a polarization component in the direction opposite to the fifth direction DR5. In this case, the polarization component in the direction opposite to the fifth direction DR5 may be substantially equal to the polarization component in the direction opposite to the sixth direction DR6.

As shown in FIGS. 49 and 50, the polarization of the laser beam BM outputted from the laser device LD may be classified into linear polarization, circular polarization, and elliptical polarization depending on the rotation angle of the prism DPM.

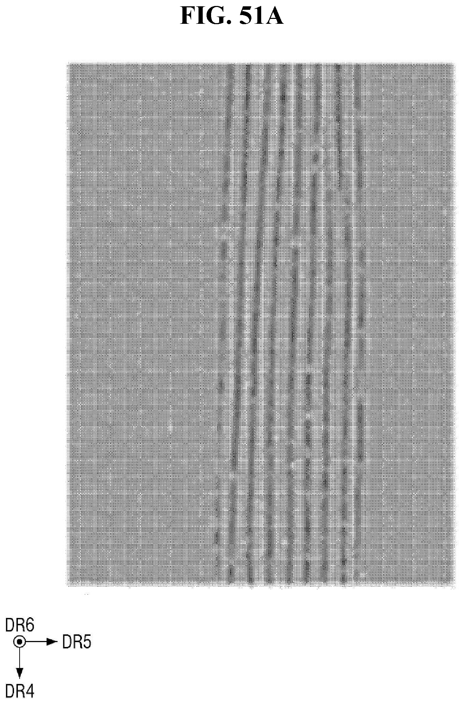

FIGS. 51A to 51C are views illustrating processing patterns of a laser according to a scanning direction and polarization direction of a laser beam.

Referring to FIG. 51A, when the scanning direction of the laser beam BM is in the fourth direction DR4 and the polarization direction of the laser beam BM is in the fifth direction DR5, the processability of the substrate SUB in the fourth direction DR4 may be enhanced.

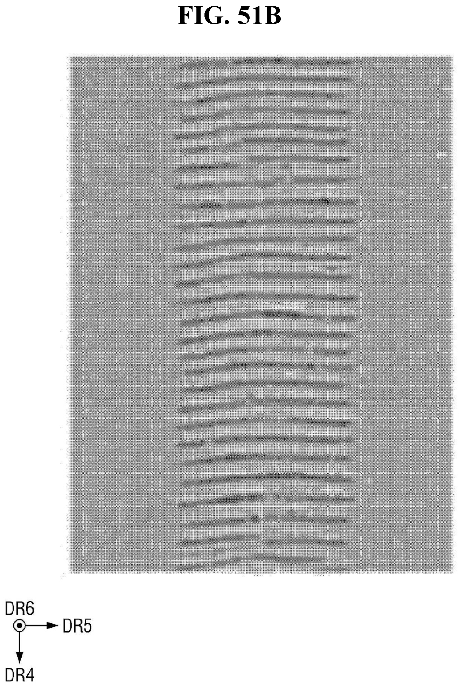

Referring to FIG. 51B, when both the scanning direction of the laser beam BM and the polarization direction of the laser beam BM are in the fourth direction DR4, the processability of the substrate SUB in the fifth direction DR5 may be enhanced.

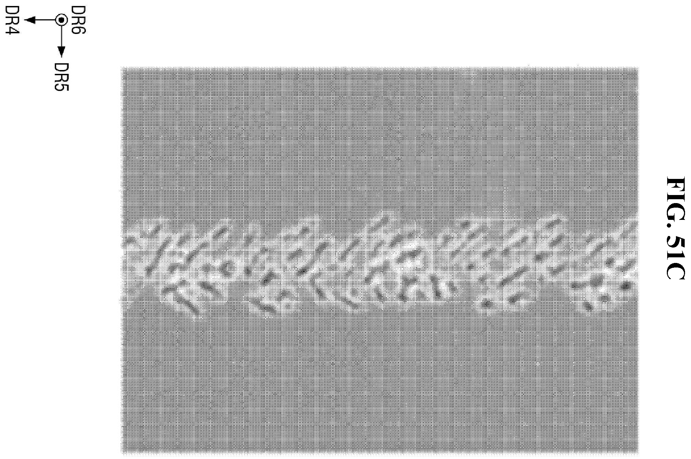

Referring to FIG. 51C, when the scanning direction of the laser beam BM is in the fourth direction DR4 but the laser beam BM is circularly polarized, it is difficult to consider that the processability of the substrate SUB is enhanced in any particular direction.

The scanning direction of the laser beam BM may be a laser scketch direction of the laser beam BM.

In summary, in order to process the side surfaces SS1, SS2, SS3, and SS4 of the substrate SUB of the display panel 100, the hole TH of the substrate SUB, and the bending area BA of the substrate SUB, the laser device LD may emit the laser beam BM onto the substrate SUB of the display panel 100 while rotating.

Differences in processability of the substrate SUB of the display panel 100 may occur depending on whether the laser beam BM is linearly polarized, circularly polarized, or elliptically polarized. That is, depending on whether the laser beam BM is linearly polarized, circularly polarized, or elliptically polarized, differences may occur in the shape, for example, the radius of curvature, of the side surfaces SS1, SS2, SS3, and SS4 of the substrate SUB of the display panel 100, and as a result, the mechanical strength may differ depending on the positions of the side surfaces SS1, SS2, SS3, and SS4 of the substrate SUB of the display panel 100. In such a case, it may be difficult to ensure that the side surfaces SS1, SS2, SS3, and SS4 of the substrate SUB of the display panel 100 have uniform quality against external impact.

Alternatively, depending on whether the laser beam BM is linearly polarized, circularly polarized, or elliptically polarized, differences may occur in the shape, for example, the radius of curvature, of the side surfaces SSH1, SSH2, SSH3, and SSH4 of the hole TH of the substrate SUB of the display panel 100, and as a result, the mechanical strength may differ depending on the positions of the side surfaces SSH1, SSH2, SSH3, and SSH4 of the hole of the substrate SUB of the display panel 100.

Alternatively, depending on whether the laser beam BM is linearly polarized, circularly polarized, or elliptically polarized, differences may occur in the shape, for example, the radius of curvature, of the side surfaces SS1_1, SS2_1, SS3_1, and SS4_1 of the first sub-substrate SSUB1 and the side surfaces SS1_2, SS2_2, SS3_2, and SS4_2 of the second sub-substrate SSUB2 of the display panel 100 distinguished by the bending area BA, and as a result, the mechanical strength may differ depending on the positions of the side surfaces SS1_1, SS2_1, SS3_1, and SS4_1 of the first sub-substrate SSUB1 and the side surfaces SS1_2, SS2_2, SS3_2, and SS4_2 of the second sub-substrate SSUB2 of the display panel 100.

Therefore, in order to maintain uniform shapes of the side surfaces SS1, SS2, SS3, and SS4 of the substrate SUB of the display panel 100, the side surfaces SSH1, SSH2, SSH3, and SSH4 of the hole TH, and the side surfaces SS1_1, SS2_1, SS3_1, and SS4_1 of the first sub-substrate SSUB1 and the side surfaces SS1_2, SS2_2, SS3_2, and SS4_2 of the second sub-substrate SSUB2 of the display panel 100 distinguished by the bending area BA, it is necessary to maintain the polarization of the laser beam BM outputted from the laser device LD as only one of linear polarization, circular polarization, and elliptical polarization.

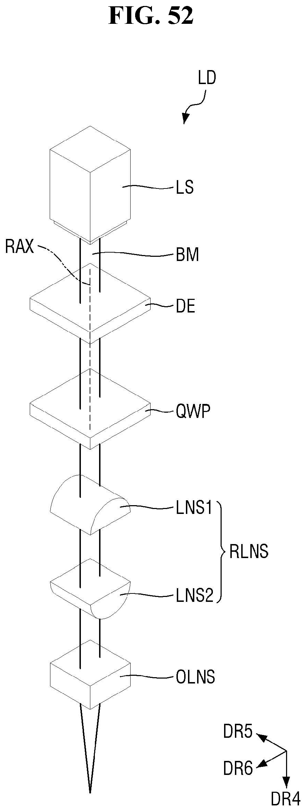

Hereinafter, a detailed description will be given of the laser device LD according to embodiments capable of maintaining the polarization of the laser beam BM as elliptical polarization regardless of the rotation of the laser device LD, with reference to FIGS. 52 to 57.

FIG. 52 is a perspective view showing a laser device according to still another embodiment.

The embodiment of FIG. 52 differs from the embodiment of FIG. 47 in that the prism DPM is omitted, a phase retardation plate QWP is included, and the diffractive element DE and the phase retardation plate QWP are configured to be rotatable. In FIG. 52, redundant description of the parts already described in the embodiment of FIG. 47 will be omitted. In one embodiment, the diffractive element DE and the phase retardation plate QWP may be rotated by the same rotation motor, or may be rotated by separate rotation motors. Alternatively, in one embodiment, only the diffractive element DE may be rotated.

Referring to FIG. 52, the diffractive element DE may be configured to be rotated clockwise or counterclockwise about the rotation axis RAX in the fourth direction DR4 by the rotation motor. The rotation axis RAX of the diffractive element DE may pass through the center of the diffractive element DE. The rotation motor is configured to rotate the diffractive element DE about the rotation axis in the fourth direction DR4. The rotation motor may rotate the diffractive element DE by a desired angle in the range of 0° to 360°. The rotation motor may be any of various known motors such as a hollow motor, a stepping motor, a servo motor, and a brushless motor.

The phase retardation plate QWP may be a quarter-wave plate (λ/4 plate) that retards the phase of incident light by λ/4. Since the phase retardation plate QWP retards the phase of the laser beam BM outputted from the diffractive element DE by λ/4, the laser device LD may output the laser beam BM having elliptical polarization by the phase retardation plate QWP.

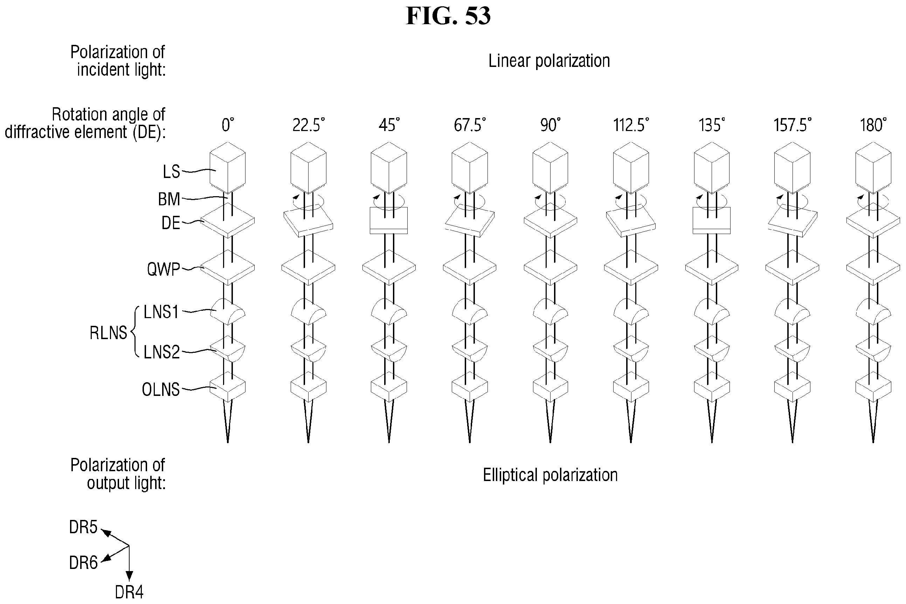

FIG. 53 is a view illustrating polarization of output light in accordance with rotation of the laser device in the embodiment of FIG. 52.

Referring to FIG. 53, when the laser device LD rotates, the light source LS, the phase retardation plate QWP, the relay lens RLNS, and the objective lens OLNS do not rotate, and only the diffractive element DE rotates. Therefore, regardless of the rotation of the laser device LD, the light source LS outputs the linearly polarized laser beam BM having a polarization direction in the sixth direction DR6. The diffractive element DE may rotate from 0° to 360° about the rotation axis RAX with respect to the sixth direction DR6 in a plane defined by the fourth direction DR4 and the sixth direction DR6.

Since the phase retardation plate QWP retards the phase of the linearly polarized, elliptically polarized, or circularly polarized laser beam BM incident thereon by λ/4, the laser beam BM outputted from the phase retardation plate QWP has elliptical polarization. Therefore, when the diffractive element DE is rotated by 0°, 22.5°, 45°, 67.5°, 90°, 112.5°, 135°, 157.5°, and 180° with respect to the sixth direction DR6, the laser device LD outputs elliptically polarized light. That is, regardless of the rotation of the diffractive element DE, the laser device LD outputs elliptically polarized light.

As shown in FIG. 53, in order to prevent the polarization of the laser beam BM from depending on the rotation angle of the laser device LD, the laser device LD according to one embodiment omits the prism DPM and instead rotates the diffractive element DE. Accordingly, even if the light source LS outputs the laser beam BM having linear polarization, the laser device LD may output only the laser beam BM having elliptical polarization despite the rotation. Thus, it is possible to minimize differences in processability of the substrate SUB of the display panel 100 depending on the polarization of the laser beam BM.

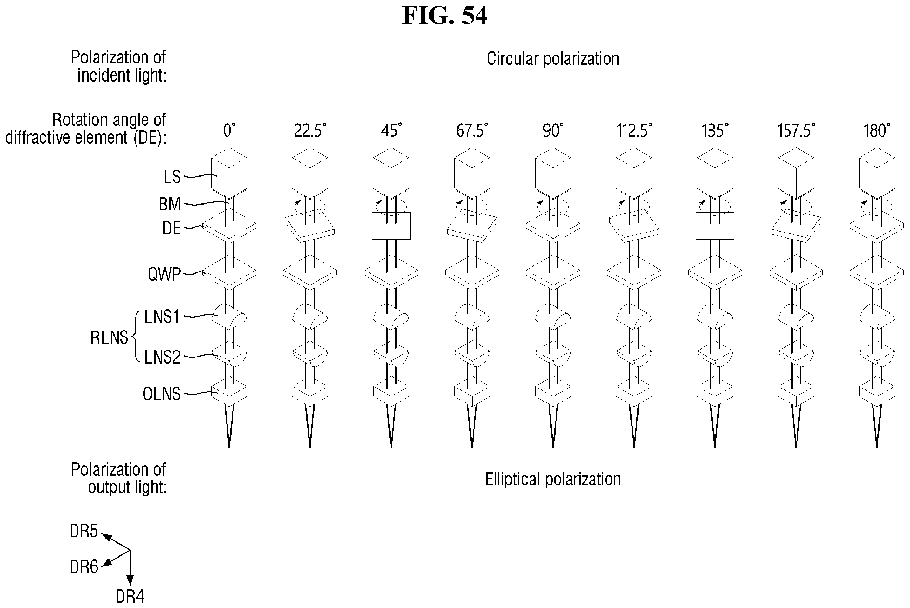

FIG. 54 is a view illustrating polarization of output light in accordance with rotation of the laser device in the embodiment of FIG. 52.

Referring to FIG. 54, when the laser device LD rotates, the light source LS, the phase retardation plate QWP, the relay lens RLNS, and the objective lens OLNS do not rotate, and only the diffractive element DE rotates. Therefore, regardless of the rotation of the laser device LD, the light source LS outputs the circularly polarized laser beam BM. The diffractive element DE may rotate from 0° to 360° about the rotation axis RAX with respect to the sixth direction DR6 in a plane defined by the fourth direction DR4 and the sixth direction DR6.

Since the phase retardation plate QWP retards the phase of the linearly polarized, elliptically polarized, or circularly polarized laser beam BM incident thereon by λ/4, the laser beam BM outputted from the phase retardation plate QWP has elliptical polarization. Therefore, when the diffractive element DE is rotated by 0°, 22.5°, 45°, 67.5°, 90°, 112.5°, 135°, 157.5°, and 180° with respect to the sixth direction DR6, the laser device LD outputs elliptically polarized light. That is, regardless of the rotation of the diffractive element DE, the laser device LD outputs elliptically polarized light.

As shown in FIG. 54, in order to prevent the polarization of the laser beam BM from depending on the rotation angle of the laser device LD, the laser device LD according to one embodiment omits the prism DPM and instead rotates the diffractive element DE. Accordingly, even if the light source LS outputs the laser beam BM having circular polarization, the laser device LD may output only the laser beam BM having elliptical polarization despite the rotation. Thus, it is possible to minimize differences in processability of the substrate SUB of the display panel 100 depending on the polarization of the laser beam BM.

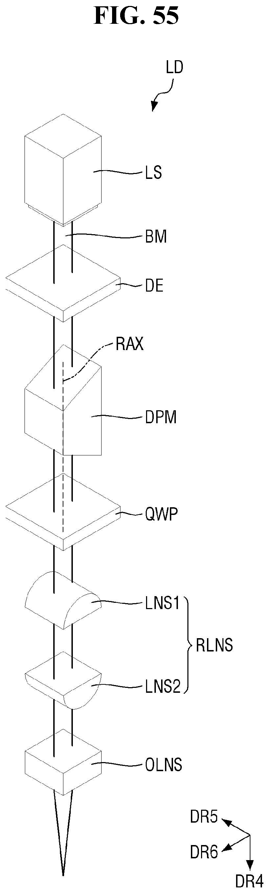

FIG. 55 is a perspective view showing a laser device according to still another embodiment.

The embodiment of FIG. 55 differs from the embodiment of FIG. 47 in that the laser device LD includes the phase retardation plate QWP located between the prism DPM and the relay lens RLNS. In FIG. 55, redundant description of the parts already described in the embodiment of FIG. 47 will be omitted

Referring to FIG. 55, the phase retardation plate QWP may be a quarter-wave plate that retards the phase of incident light by λ/4. Since the phase retardation plate QWP retards the phase of the laser beam BM outputted from the prism DPM by λ/4, the laser device LD may output the laser beam BM having elliptical polarization.

The phase retardation plate QWP may be configured to be rotated clockwise or counterclockwise about the rotation axis RAX in the fourth direction DR4 by the rotation motor. The rotation axis RAX of the phase retardation plate QWP may pass through the center of the phase retardation plate QWP. The rotation motor may rotate the phase retardation plate QWP clockwise or counterclockwise about the rotation axis RAX extending in the fourth direction DR4. The rotation motor may be any of various known motors such as a hollow motor, a stepping motor, a servo motor, and a brushless motor.

The rotation angle of the prism DPM and the rotation angle of the phase retardation plate QWP may be substantially equal. The prism DPM and the phase retardation plate QWP may be rotated simultaneously by a single rotation motor. Alternatively, the prism DPM and the phase retardation plate QWP may be rotated respectively by separate rotation motors.

When the prism DPM is a Dove prism having trapezoidal faces as shown in FIGS. 48A and 48B, since the laser beam undergoes two refractions and one total internal reflection within the prism DPM, the rotation angle of the laser beam may be twice the rotation angle of the prism DPM and the rotation angle of the phase retardation plate QWP.

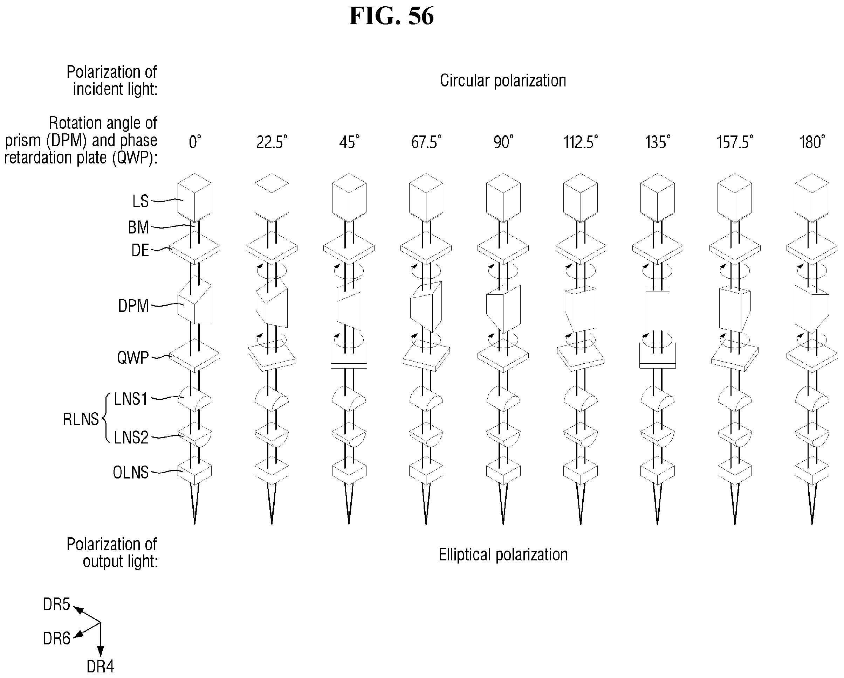

FIG. 56 is a view illustrating polarization of output light in accordance with rotation of the laser device in the embodiment of FIG. 55.

Referring to FIG. 56, when the laser device LD rotates, the light source LS, the diffractive element DE, the relay lens RLNS, and the objective lens OLNS do not rotate, and only the prism DPM and the phase retardation plate QWP rotate. Therefore, regardless of the rotation of the laser device LD, the light source LS outputs the circularly polarized laser beam BM.

The prism DPM and the phase retardation plate QWP may rotate from 0° to 180° about the rotation axis RAX with respect to the sixth direction DR6 in a plane defined by the fourth direction DR4 and the sixth direction DR6. Since the rotation angle of the laser beam is twice the rotation angle of the prism DPM and the rotation angle of the phase retardation plate QWP, when the prism DPM and the phase retardation plate QWP rotate from 0° to 180°, the laser beam may rotate from 0° to 360°.

In FIG. 56, the case where the prism DPM is at 0° with respect to the sixth direction DR6 refers to a state in which the light source LS, the diffractive element DE, the prism DPM, the phase retardation plate QWP, the relay lens RLNS, and the objective lens OLNS are oriented in the sixth direction DR6. In addition, when the laser device LD rotates clockwise by 22.5° with respect to the sixth direction DR6, the light source LS, the diffractive element DE, the relay lens RLNS, and the objective lens OLNS may be oriented in the sixth direction DR6, and the prism DPM and the phase retardation plate QWP may rotate clockwise by 22.5° with respect to the sixth direction DR6. In addition, although FIG. 56 illustrates that the prism DPM rotates clockwise about the rotation axis RAX, but the embodiment of the present disclosure is not limited thereto. That is, the prism DPM may also rotate counterclockwise about the rotation axis RAX.

Since the phase retardation plate QWP retards the phase of the linearly polarized, elliptically polarized, or circularly polarized laser beam BM incident thereon by λ/4, the laser beam BM outputted from the phase retardation plate QWP has elliptical polarization. Therefore, when the prism DPM and the phase retardation plate QWP are rotated by 0°, 22.5°, 45°, 67.5°, 90°, 112.5°, 135°, 157.5°, and 180° with respect to the sixth direction DR6, the laser device LD outputs elliptically polarized light. Therefore, regardless of the rotation of the prism DPM, the laser device LD outputs elliptically polarized light.

As shown in FIG. 56, by arranging the phase retardation plate QWP between the prism DPM and the relay lens RLNS to retard the phase of the linearly polarized, elliptically polarized, or circularly polarized laser beam BM outputted from the prism DPM by λ/4, the laser beam BM outputted from the phase retardation plate QWP has elliptical polarization. Accordingly, the laser device LD may output only the laser beam BM having elliptical polarization despite the rotation. Thus, it is possible to minimize differences in processability of the substrate SUB of the display panel 100 depending on the polarization of the laser beam BM.

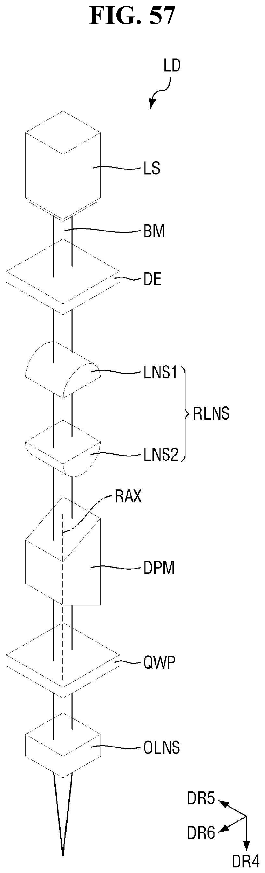

FIG. 57 is a perspective view showing a laser device according to still another embodiment.

Since the embodiment of FIG. 57 differs from the embodiment of FIG. 55 only in that the relay lens RLNS is located between the diffractive element DE and the prism DPM, the description of FIG. 57 will be omitted.

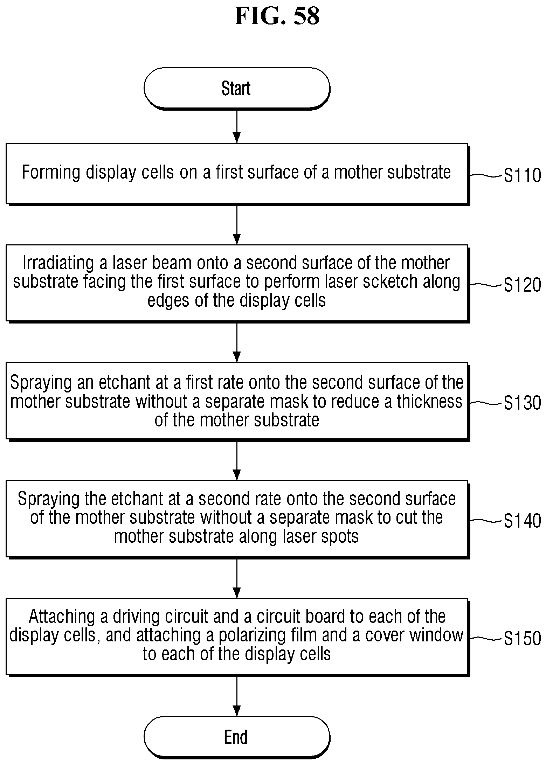

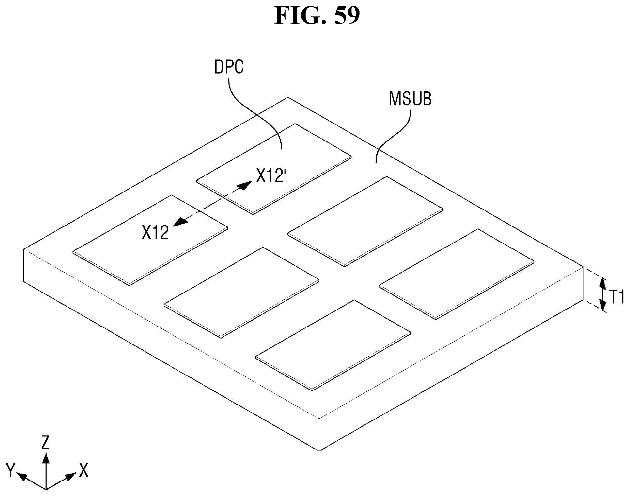

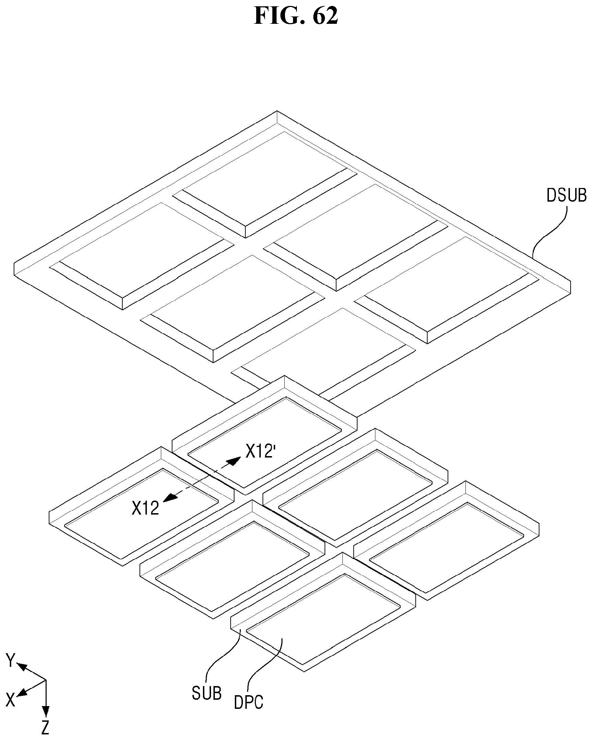

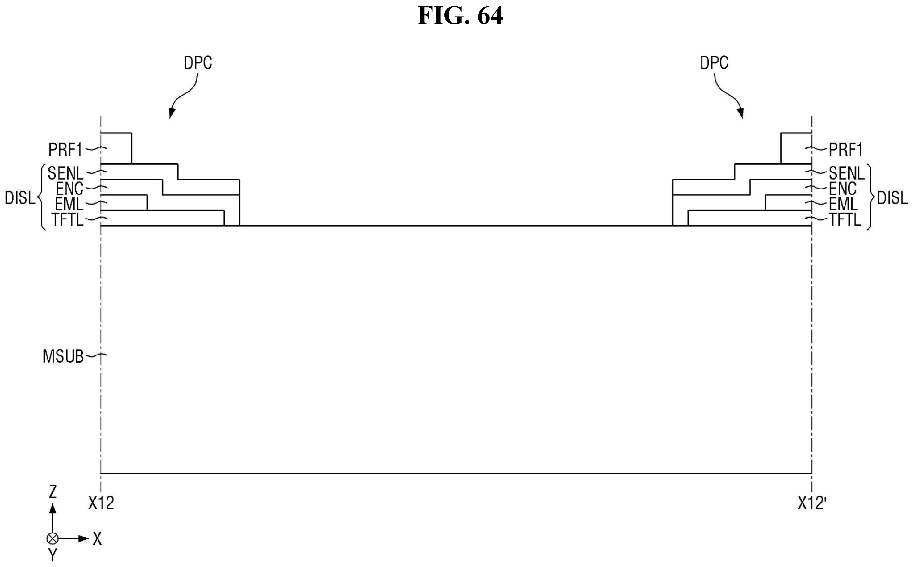

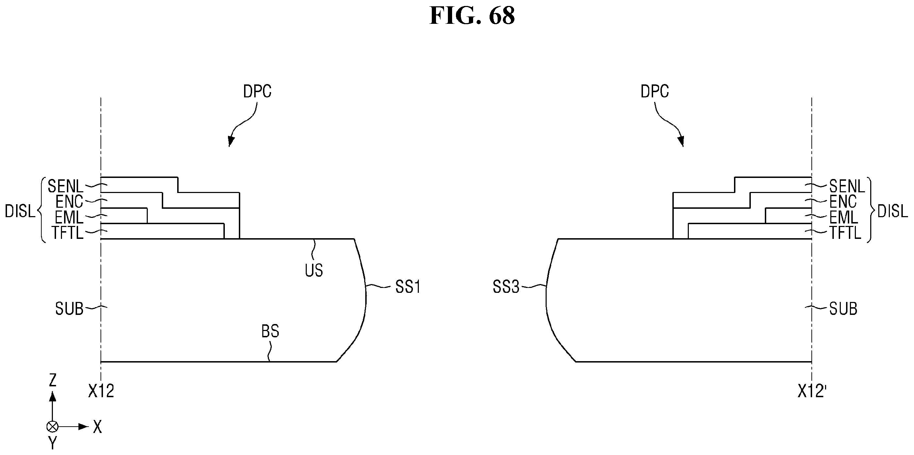

FIG. 58 is a flowchart illustrating a method for fabricating a display device according to one embodiment. FIGS. 59 to 63 are perspective views illustrating a method for fabricating a display device according to one embodiment. FIGS. 64 to 68 are cross-sectional views taken along line X12-X12', illustrating a method for fabricating a display device according to one embodiment.

FIGS. 59 to 63 illustrate perspective views of a mother substrate MSUB and a plurality of display cells DPC located on the mother substrate MSUB. FIGS. 64 to 68 illustrate one example of cross-sections of the mother substrate MSUB and the plurality of display cells DPC taken along line X12-X12' of FIGS. 59 to 62. Hereinafter, a method for fabricating the side surfaces SS1, SS2, SS3, and SS4 of the substrate SUB described with reference to FIGS. 25A to 25D will be described in detail with reference to FIGS. 59 to 68.

First, as shown in FIGS. 59 and 64, the plurality of display cells DPC are formed on a first surface of the mother substrate MSUB (step S110 of FIG. 58).

The display layer DISL of each of the plurality of display cells DPC is formed on the first surface of the mother substrate MSUB. The display layer DISL includes the thin film transistor layer TFTL, the light emitting element layer EML, the encapsulation layer ENC, and the sensor electrode layer SENL.

Then, a plurality of first protective films PRF1 are attached onto the plurality of display cells DPC.

Specifically, a first protective film layer is attached to cover the plurality of display cells DPC and the mother substrate MSUB located between the plurality of display cells DPC. Then, by removing a portion of the first protective film layer located on the mother substrate MSUB, the plurality of first protective films PRF1 may be located on the plurality of display cells DPC, respectively. That is, a part of the first protective film layer may be removed, and the remainder may be the plurality of first protective films PRF1. Accordingly, the plurality of first protective films PRF1 may be located on the plurality of display cells DPC, respectively. That is, the plurality of first protective films PRF1 may be located in a one-to-one correspondence with the plurality of display cells DPC.

Each of the plurality of first protective films PRF1 may be a buffer film for protecting the plurality of display cells DPC from external impact. The plurality of first protective films PRF1 may include a transparent material.

Then, the plurality of display cells DPC are inspected using an inspection device. After connecting a probe to a plurality of test pads provided on each of the plurality of display cells DPC, a lighting test of each of the plurality of display cells DPC may be performed.

When the lighting test is performed after separating the plurality of display cells DPC from the mother substrate MSUB by the cutting process, an additional process for removing the plurality of test pads is required after completing the lighting test. On the other hand, when the lighting test is performed on the mother substrate MSUB, the plurality of test pads are removed when the plurality of display cells DPC are separated from the mother substrate MSUB through laser irradiation and etching later. Accordingly, when the lighting test is performed on the mother substrate MSUB, there is an advantage in that no additional process for removing the plurality of test pads is required.

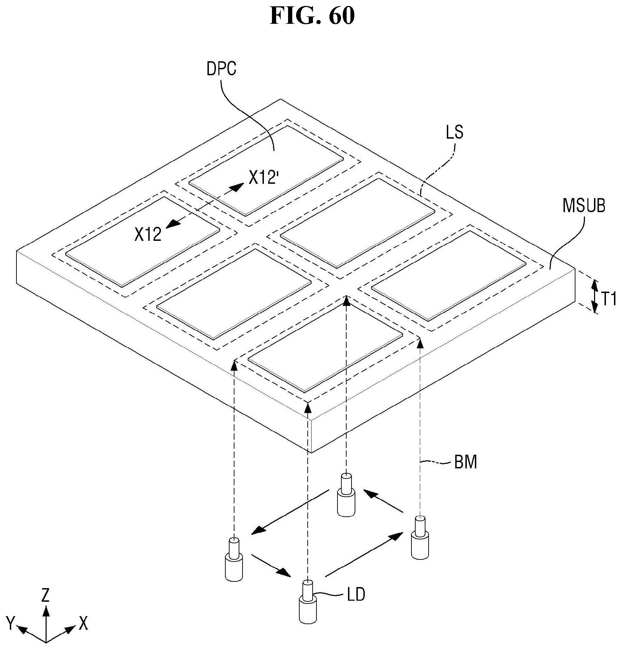

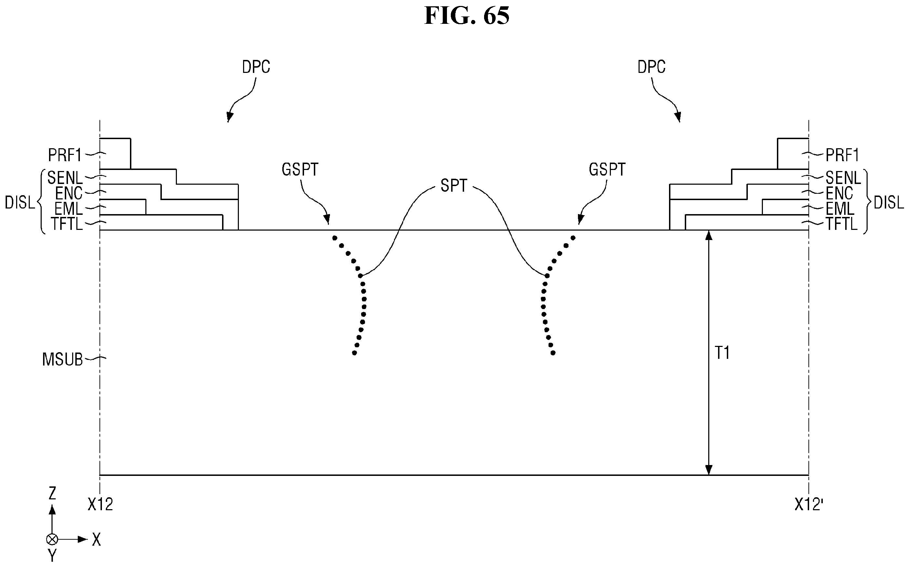

Second, as shown in FIGS. 60 and 65, the laser beam BM is irradiated onto a second surface facing the first surface of the mother substrate MSUB to perform laser scketch LS or laser modulation along the edges of the plurality of display cells DPC (step S120 of FIG. 58).

The laser beam BM may be outputted from the laser device LD according to one embodiment described with reference to FIGS. 52 to 57.

Referring to FIGS. 60 and 65, the laser beam BM may be irradiated on the second surface of the mother substrate MSUB. However, embodiments of the present disclosure are not limited thereto. The laser beam BM may also be irradiated on the first surface of the mother substrate MSUB.

The laser scketch LS refers to forming a plurality of spot groups GSPT each including a plurality of laser spots SPT. The laser scketch LS may be defined as forming a plurality of laser spots SPT along the edges of the plurality of display cells DPC by irradiating the laser beam BM.

The laser device LD irradiates the laser beam BM to form a first group of laser spots SPT, moves by a selected distance, and then irradiates the laser beam BM again to form a second group of laser spots SPT. That is, the laser device LD irradiates the laser beam BM at every selected distance to form one group of laser spots SPT, thereby completing the laser scketch LS. The selected distance is the distance between the first group of laser spots SPT and the second group of laser spots SPT in the scanning direction of the laser device LD, and may be in a range of approximately 2 µm to 7 µm.

When the length of the mother substrate MSUB in the third direction (Z-axis direction) is approximately 500 µm, the length over which the plurality of laser spots SPT are arranged in the third direction (Z-axis direction) may be in a range of approximately 200 µm to 300 µm. That is, the length over which the plurality of laser spots SPT are arranged in the third direction (Z-axis direction) may be in a range of approximately 0.4 to 0.6 times the length of the mother substrate MSUB in the third direction (Z-axis direction). The length of the mother substrate MSUB in the third direction (Z-axis direction) may be the thickness of the mother substrate MSUB.

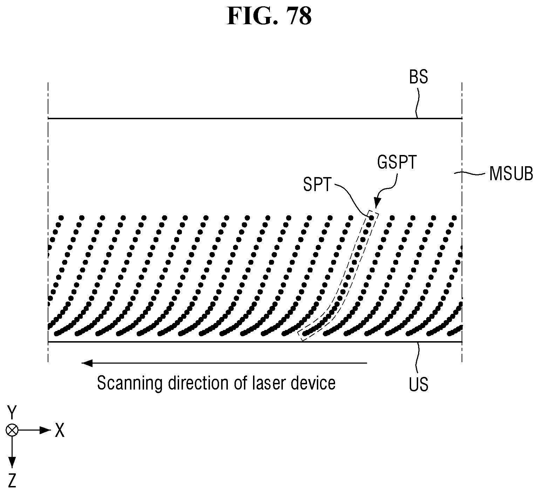

In a plane defined by the first direction (X-axis direction) and the third direction (Z-axis direction), the side surfaces SS1, SS2, SS3, and SS4 of the substrate SUB according to the embodiment of FIGS. 25A to 25D have a curved shape, so that the plurality of laser spots SPT may also be arranged in a curved shape in a plane defined by the first direction (X-axis direction) and the third direction (Z-axis direction). The arrangement of the plurality of laser spots SPT formed on the mother substrate MSUB by the laser device LD, which enables the side surfaces SS1, SS2, SS3, and SS4 of the substrate SUB according to the embodiment of FIGS. 25A to 25D to have a curved shape in a plane defined by the first direction (X-axis direction) and the third direction (Z-axis direction), will be described later in detail with reference to FIG. 78.

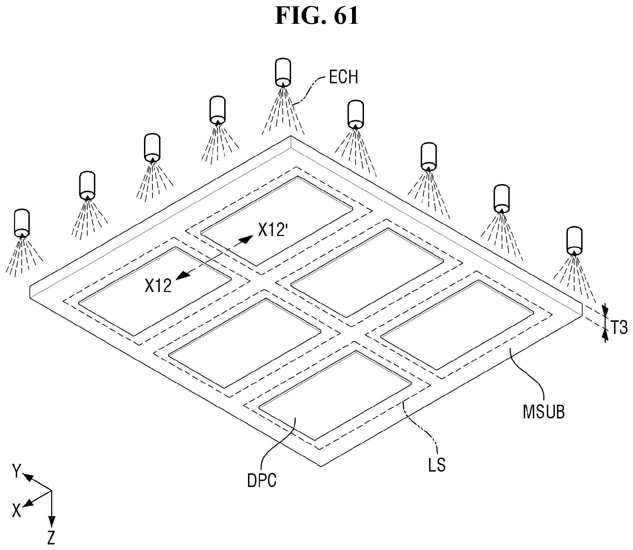

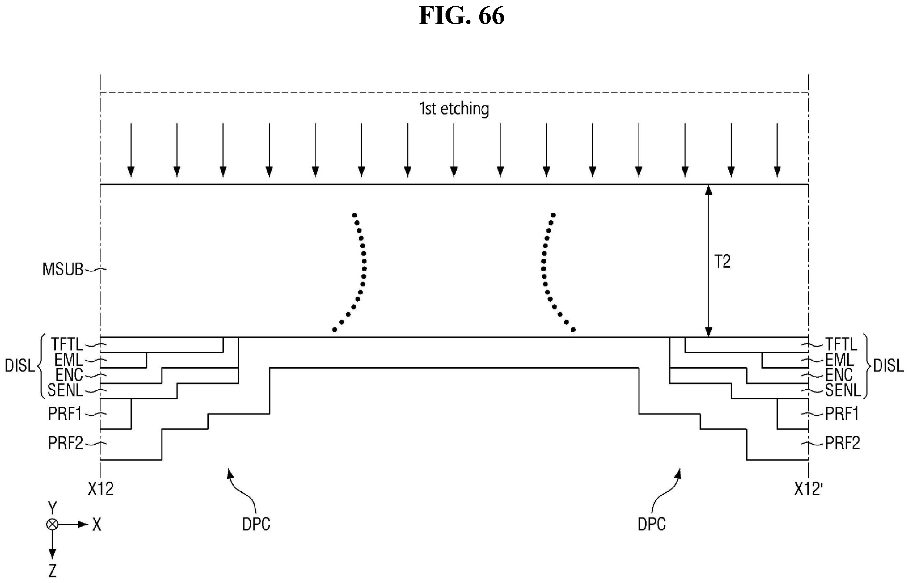

Third, as shown in FIGS. 61 and 66, an etchant is sprayed at a first rate onto the second surface of the mother substrate MSUB without a separate mask to reduce the thickness of the mother substrate MSUB (step S130 of FIG. 58).

Before spraying the etchant onto the second surface of the mother substrate MSUB, a second protective film PRF2 is attached onto the plurality of first protective films PRF1.

The second protective film PRF2 may be attached onto the plurality of first protective films PRF1 and the first surface of the mother substrate MSUB that is exposed without being covered by the plurality of first protective films PRF1. The second protective film PRF2 may be an acid-resistant film for protecting the plurality of display cells DPC from the etchant during the etching process of the mother substrate MSUB.

When the etchant is sprayed onto the second surface of the mother substrate MSUB, the thickness of the mother substrate MSUB may be reduced from a first thickness T1 to a second thickness T2. Since the mother substrate MSUB is etched without a separate mask, isotropic etching in which all regions of the second surface of the mother substrate MSUB are uniformly etched may be performed.

The first rate may be in a range of approximately 7 µm/min to 10 µm/min. That is, the thickness of the mother substrate MSUB may be reduced by approximately 7 µm to 10 µm for approximately 1 minute by the etchant. When the thickness of the mother substrate MSUB is approximately 500 µm, the thickness of the mother substrate MSUB reduced at the first rate may be in a range of approximately 200 µm to 250 µm, but the embodiment of the present disclosure is not limited thereto.

Fourth, as shown in FIGS. 61, 62, 67, and 68, the etchant is sprayed at a second rate onto the second surface of the mother substrate MSUB without a separate mask to cut the mother substrate MSUB along the plurality of laser spots SPT (step S140 of FIG. 58).

The plurality of laser spots SPT may include physical holes formed by the laser beam BM and regions whose physical properties are changed by the laser beam BM around the physical holes. Alternatively, the plurality of laser spots SPT may be regions whose physical properties are changed by the laser beam BM without physical holes. Accordingly, an etch rate by the etchant at the plurality of laser spots SPT may be higher than an etch rate by the etchant in other regions of the mother substrate MSUB to which the laser is not irradiated.

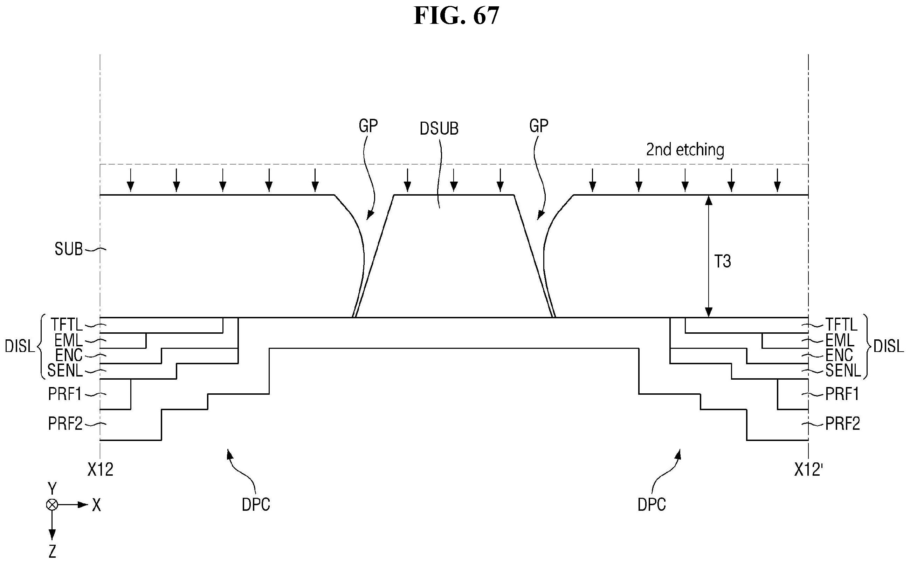

While the thickness of the mother substrate MSUB is reduced from the second thickness T2 to a third thickness T3 by the etchant, when the etchant penetrates into the plurality of laser spots SPT formed by the laser beam BM, a difference in etch rate may occur between a region where the laser spots SPT are formed and a region where the laser spots SPT are not formed, due to the plurality of laser spots SPT. That is, the mother substrate MSUB may undergo anisotropic etching in which the etch rate in the region where the laser spots SPT are formed is higher than the etch rate in the region where the laser spots SPT are not formed. As a result, as shown in FIG. 67, a gap GP may occur between the bottom surface BS of the substrate SUB and a dummy substrate DSUB, which are separated from the mother substrate MSUB.

The second rate may be lower than the first rate. For example, the second rate may be in a range of approximately 1 µm/min to 5 µm/min, but is not limited thereto. That is, the thickness of the mother substrate MSUB may be reduced by approximately 1 µm to 5 µm for approximately 1 minute by the etchant. The thickness of the mother substrate MSUB reduced at the second rate may be in a range of approximately 50 µm to 100 µm, but the embodiment of the present disclosure is not limited thereto.

As the second rate decreases by 1 µm/min, the length of the gap GP in the first direction (X-axis direction) may increase by 20 µm to 30 µm. The etch rate may be adjusted by changing the etchant, adjusting an etching temperature, or adjusting the concentration of an etchant material.

When the thickness T3 of the substrate SUB in the third direction (Z-axis direction) is approximately 200 µm, the maximum length of the gap GP in the third direction (Z-axis direction) may be in a range of approximately 100 µm to 150 µm. That is, the maximum length of the gap GP in the third direction (Z-axis direction) may be in a range of approximately 0.5 to 0.75 times the thickness T3 of the substrate SUB in the third direction (Z-axis direction).

The roughness of at least a partial region of each of the side surfaces SS1 and SS3 of the substrate SUB that is exposed to the gap GP and healed by the etchant may be smaller than the roughness of the remaining region of each of the side surfaces SS1 and SS3 of the substrate SUB that is not exposed to the gap GP. As the second rate decreases, the gap GP becomes larger, and as a result, the area of the at least partial region of each of the side surfaces SS1 and SS3 of the substrate SUB healed by the etchant may increase. Therefore, the length of the at least partial region of each of the side surfaces SS1 and SS3 of the substrate SUB etched by the etchant may be in a range of approximately 0.5 to 0.8 times the total length of each of the side surfaces SS1 and SS3.

Since the distance between the substrate SUB and the dummy substrate DSUB at the bottom surface BS is greater than the distance between the substrate SUB and the dummy substrate DSUB at the top surface US, the dummy substrate DSUB may be separated in a direction opposite to the third direction (Z-axis direction) in order to minimize or prevent damage to the side surface of the substrate SUB by the dummy substrate DSUB when the dummy substrate DSUB is separated from the substrate SUB.

As described above, as the etchant penetrates into the plurality of laser spots SPT formed by the laser beam BM, the substrate SUB may be separated along the laser scketch LS. That is, the substrate SUB of each of the plurality of display cells DPC may be separated from the dummy substrate DSUB. In addition, after the etching process is completed, the second protective film PRF2 may be detached.

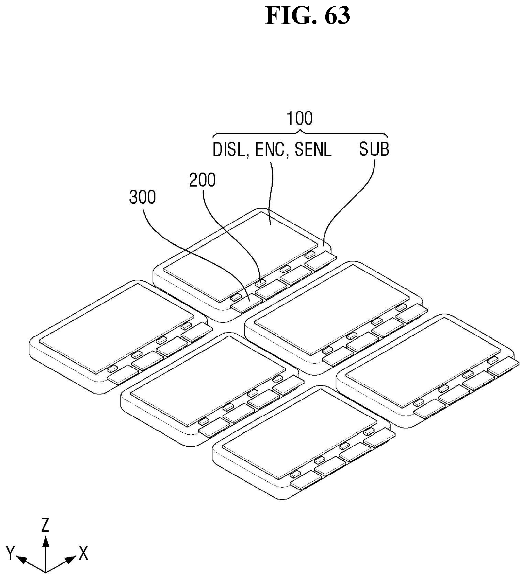

Fifth, as shown in FIG. 63, the driving circuit 200 and the circuit board 300 are attached to each of the plurality of display cells DPC, and the polarizing film PF and the cover window CW are attached to each of the plurality of display cells DPC (step S150 of FIG. 58).

As described above, since the etching process may be used not only to reduce the thickness of the mother substrate MSUB but also to separate the substrate SUB of each of the plurality of display cells DPC from the mother substrate MSUB, the efficiency of the fabricating process may be improved.

In addition, the laser device LD may output the laser beam BM such that the plurality of laser spots SPT are arranged along a curve in a plane defined by the first direction (X-axis direction) and the third direction (Z-axis direction). In this case, by spraying the etchant to perform etching, the side surfaces SS1, SS2, SS3, and SS4 of each of the plurality of display cells DPC may be formed in a curved shape having a curvature. That is, since the side surfaces SS1, SS2, SS3, and SS4 of each of the plurality of display cells DPC may have a curved shape without a separate polishing process, the efficiency of the fabricating process may be improved.

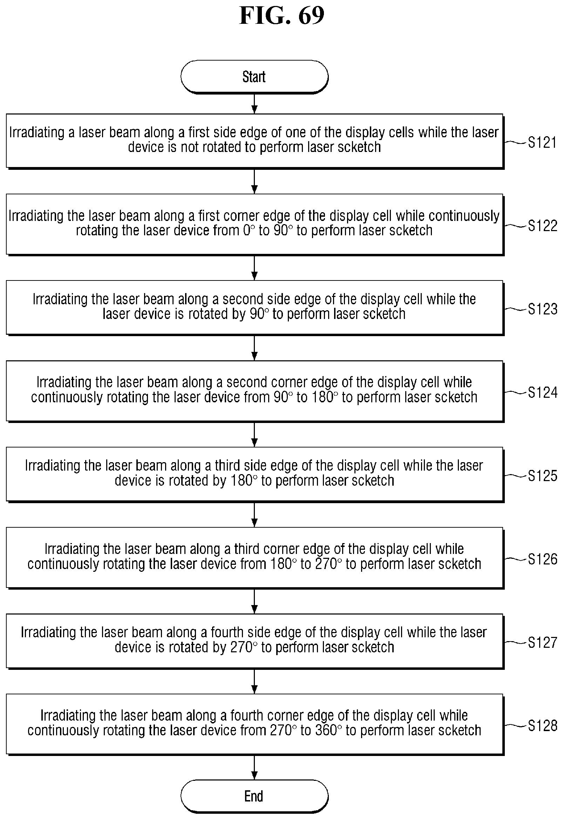

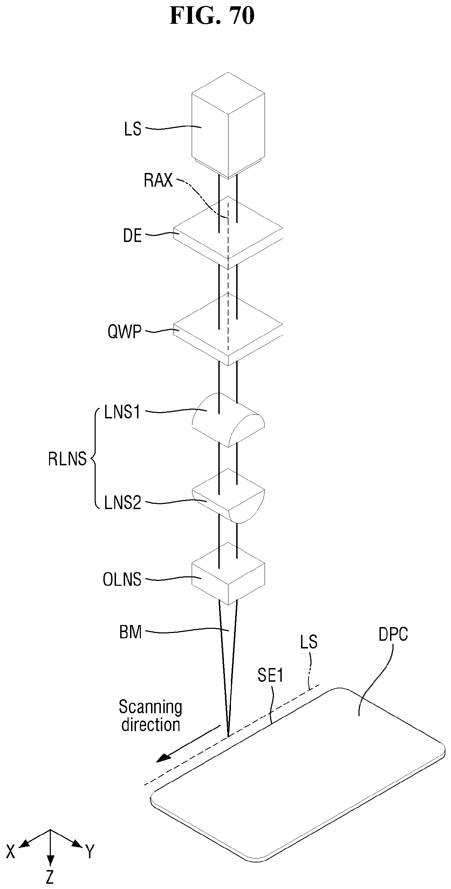

FIG. 69 is a flowchart showing step S120 of FIG. 58 in detail. FIGS. 70 to 77 are views illustrating rotation of the laser device according to the embodiments of FIGS. 52 to 54 for a laser scribe line surrounding the edge of a display cell.

FIGS. 70 to 77 illustrate that a first side edge SE1 of the display cell DPC is the left edge of the display cell DPC, a second side edge SE2 of the display cell DPC is the lower edge of the display cell DPC, a third side edge SE3 of the display cell DPC is the right edge of the display cell DPC, and a fourth side edge SE4 of the display cell DPC is the upper edge of the display cell DPC, but the embodiment of the present disclosure is not limited thereto.

Hereinafter, the laser scketch of the display cell DPC in step S120 of FIG. 58 will be described in detail with reference FIGS. 69 to 77.

First, as shown in FIG. 70, in a state in which the laser device LD is not rotated, the laser beam BM is irradiated along the first side edge SE1 of one of the plurality of display cells DPC to perform the laser scketch LS (step S121 of FIG. 69).

The laser device LD scans the laser beam BM from one end to the other end of the first side edge SE1 of the display cell DPC. That is, the scanning direction of the laser device LD may be parallel to the first direction (X-axis direction). Since the laser device LD moves along a straight path while irradiating the laser beam BM, the scan speed of the laser device LD may be in a range of approximately 10 mm/sec to 500 mm/sec.

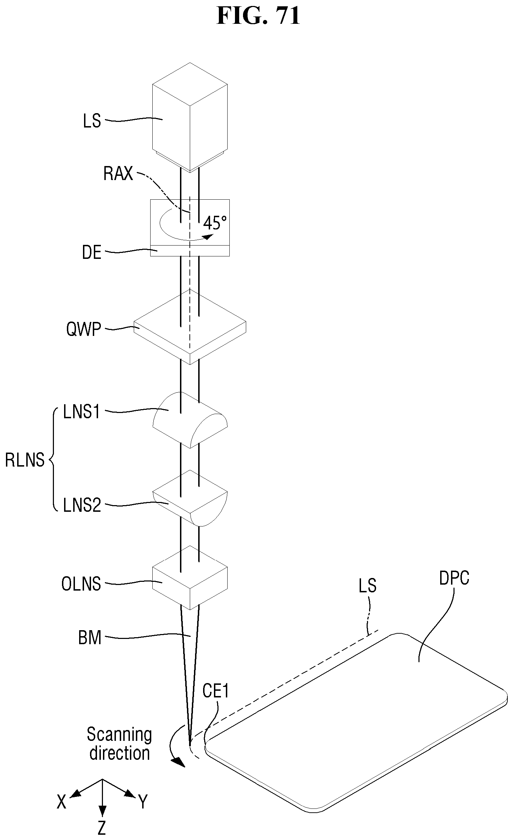

Second, as shown in FIG. 71, while the laser device LD continuously rotates counterclockwise from 0° to 90°, the laser beam BM is irradiated along a first corner edge CE1 of the display cell DPC to perform the laser scketch LS (step S122 of FIG. 69).

The first corner edge CE1 may be located between the first side edge SE1 and the second side edge SE2 of the display cell DPC. The laser device LD scans the laser beam BM at the first corner edge CE1 of the display cell DPC in a direction from the first side edge SE1 to the second side edge SE2. Since the laser device LD moves along a curved path while irradiating the laser beam BM, the scan speed of the laser device LD may be in a range of approximately 10 mm/sec to 100 mm/sec. The scan speed of the laser device LD at the first side edge SE1 of the display cell DPC may be higher than the scan speed of the laser device LD at the first corner edge CE1 of the display cell DPC.

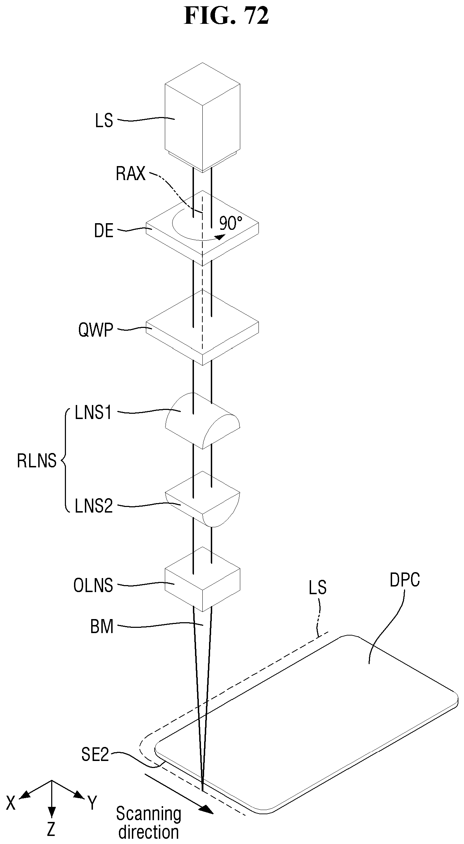

Third, as shown in FIG. 72, in a state in which the laser device LD is rotated counterclockwise by 90°, the laser beam BM is irradiated along the second side edge SE2 of the display cell DPC to perform the laser scketch LS (step S123 of FIG. 69).

The laser device LD outputs the laser beam BM from one end to the other end of the second side edge SE2 of the display cell DPC. That is, the scanning direction of the laser device LD may be parallel to the second direction (Y-axis direction). Since the scan path of the laser device LD is straight, the scan speed of the laser device LD may be in a range of approximately 10 mm/sec to 500 mm/sec.

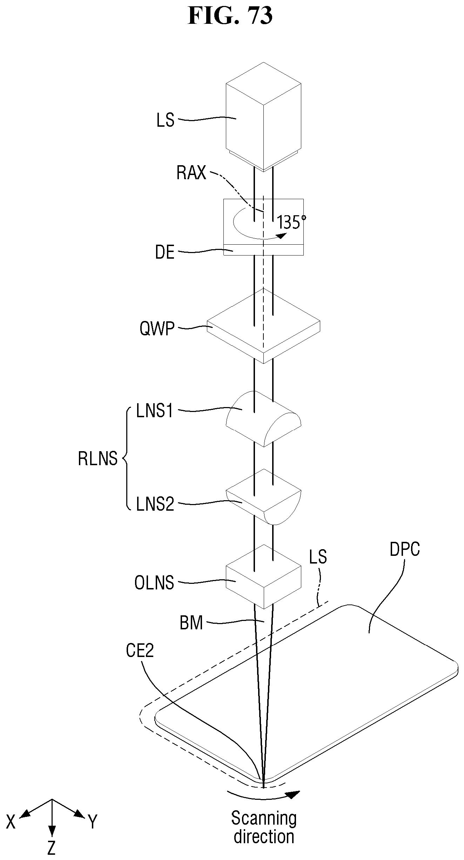

Fourth, as shown in FIG. 73, while the laser device LD continuously rotates counterclockwise from 90° to 180°, the laser beam BM is irradiated along a second corner edge CE2 of the display cell DPC to perform the laser scketch LS (step S124 of FIG. 69).

The second corner edge CE2 may be located between the second side edge SE2 and the third side edge SE3 of the display cell DPC. The laser device LD scans the laser beam BM at the second corner edge CE2 of the display cell DPC in a direction from the second side edge SE2 toward the third side edge SE3. Since the scan path of the laser device LD is curved, the scan speed of the laser device LD may be in a range of approximately 10 mm/sec to 100 mm/sec. The scan speed of the laser device LD at the second side edge SE2 of the display cell DPC may be higher than the scan speed of the laser device LD at the second corner edge CE2 of the display cell DPC.

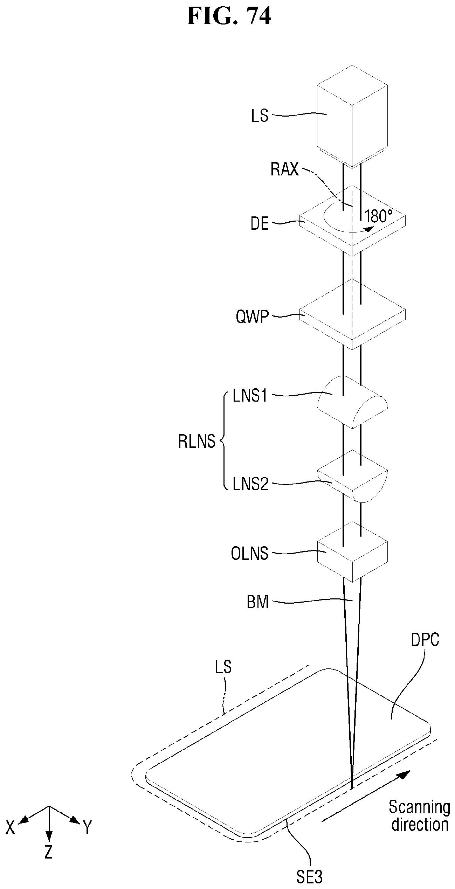

Fifth, as shown in FIG. 74, in a state in which the laser device LD is rotated counterclockwise by 180°, the laser beam BM is irradiated along the third side edge SE3 of the display cell DPC to perform the laser scketch LS (step S125 of FIG. 69).

The laser device LD outputs the laser beam BM from one end to the other end of the third side edge SE3 of the display cell DPC. That is, the scanning direction of the laser device LD may be parallel to the first direction (X-axis direction). Since the scan path of the laser device LD is straight, the scan speed of the laser device LD may be in a range of approximately 10 mm/sec to 500 mm/sec.

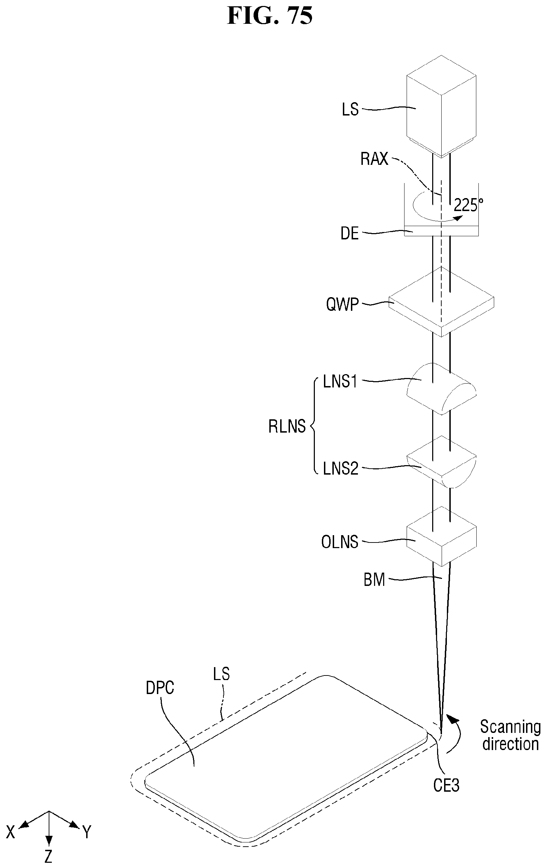

Sixth, as shown in FIG. 75, while the laser device LD continuously rotates counterclockwise from 180° to 270°, the laser beam BM is irradiated along a third corner edge CE3 of the display cell DPC to perform the laser scketch LS (step S126 of FIG. 69).

The third corner edge CE3 may be located between the third side edge SE3 and the fourth side edge SE4 of the display cell DPC. The laser device LD scans the laser beam BM at the third corner edge CE3 of the display cell DPC in a direction from the third side edge SE3 toward the fourth side edge SE4. Since the scan path of the laser device LD is curved, the scan speed of the laser device LD may be in a range of approximately 10 mm/sec to 100 mm/sec. The scan speed of the laser device LD at the third side edge SE3 of the display cell DPC may be higher than the scan speed of the laser device LD at the third corner edge CE3 of the display cell DPC.

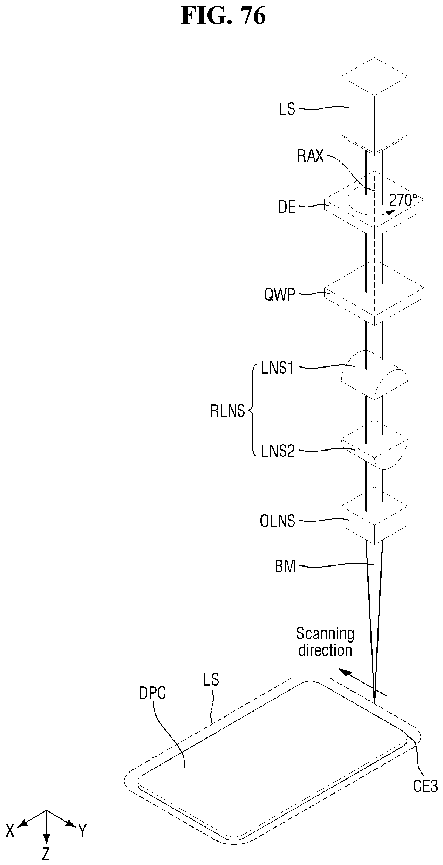

Seventh, as shown in FIG. 76, in a state in which the laser device LD is rotated counterclockwise by 270°, the laser beam BM is irradiated along the fourth side edge SE4 of the display cell DPC to perform the laser scketch LS (step S127 of FIG. 69).

The laser device LD outputs the laser beam BM from one end to the other end of the fourth side edge SE4 of the display cell DPC. That is, the scanning direction of the laser device LD may be parallel to the second direction (Y-axis direction). Since the scan path of the laser device LD is straight, the scan speed of the laser device LD may be in a range of approximately 10 mm/sec to 500 mm/sec.

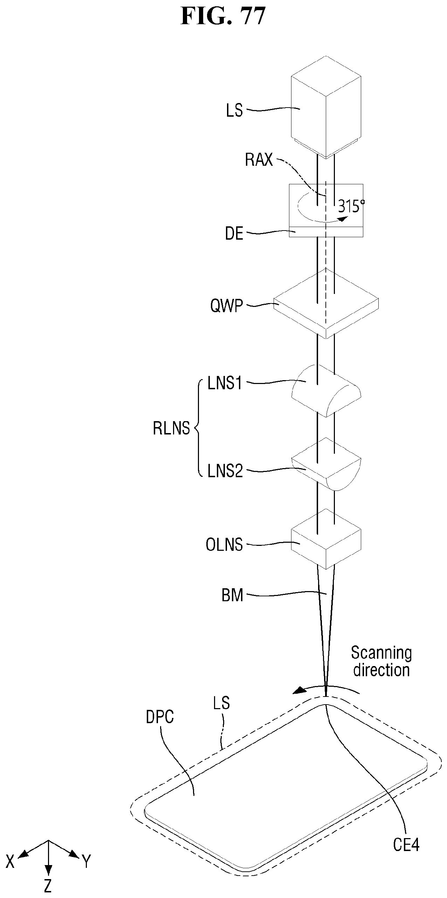

Eighth, as shown in FIG. 77, while the laser device LD continuously rotates counterclockwise from 270° to 360°, the laser beam BM is irradiated along a fourth corner edge CE4 of the display cell DPC to perform the laser scketch LS (step S128 of FIG. 69).

The fourth corner edge CE4 may be located between the fourth side edge SE4 and the first side edge SE1 of the display cell DPC. The laser device LD scans the laser beam BM at the fourth corner edge CE4 of the display cell DPC in a direction from the fourth side edge SE4 toward the first side edge SE1. Since the scan path of the laser device LD is curved, the scan speed of the laser device LD may be in a range of approximately 10 mm/sec to 100 mm/sec. The scan speed of the laser device LD at the fourth side edge SE4 of the display cell DPC may be higher than the scan speed of the laser device LD at the fourth corner edge CE4 of the display cell DPC.

As shown in FIGS. 53 and 54, since the phase retardation plate QWP retards the phase of the linearly polarized, elliptically polarized, or circularly polarized laser beam BM incident thereon by λ/4, the laser beam BM outputted from the phase retardation plate QWP has elliptical polarization. Therefore, regardless of the rotation of the laser device LD, the laser device LD outputs elliptically polarized light.

As shown in FIGS. 69 to 77, since the elliptically polarized laser beam BM is irradiated counterclockwise along the first side edge SE1, the first corner edge CE1, the second side edge SE2, the second corner edge CE2, the third side edge SE3, the third corner edge CE3, the fourth side edge ES4, and the fourth corner edge CE4 of the display cell DPC to perform the laser scketch, it is possible to minimize or prevent differences in processability of the substrate SUB of the display panel 100. As a result, it is possible to minimize or prevent differences in the shape, for example, the radius of curvature, of the side surfaces SS1, SS2, SS3, and SS4 of the substrate SUB of the display panel 100, or differences in mechanical strength depending on the positions of the side surfaces SS1, SS2, SS3, and SS4 of the substrate SUB. Therefore, the side surfaces SS1, SS2, SS3, and SS4 of the substrate SUB of the display panel 100 may have uniform quality against external impact.

FIG. 78 is a side view illustrating arrangement of laser spots formed according to a scanning direction of a laser beam. FIG. 78 shows the laser spots SPT formed along the third side edge SE3 of the display cell DPC by the laser beam BM of the laser device LD.

Referring to FIG. 78, the plurality of spot groups GSPT are spaced apart from each other at selected intervals in the first direction (X-axis direction). Each of the plurality of spot groups GSPT may include the same number of laser spots SPT. A distance between the spot groups GPST adjacent in the first direction (X-axis direction) among the plurality of spot groups GSPT may be in a range of approximately 2 µm to 7 µm. The spot groups GSPT adjacent in the first direction (X-axis direction) may overlap each other in the third direction (Z-axis direction). A distance between adjacent laser spots SPT in each of the plurality of spot groups GSPT may be in a range of approximately 3 µm to 20 µm.

In each of the plurality of spot groups GSPT, the plurality of laser spots SPT may be arranged in the first direction (X-axis direction) from the bottom surface BS toward the top surface US of the mother substrate MSUB. That is, among the plurality of laser spots SPT in each of the plurality of spot groups GSPT, the laser spot SPT located closest to the top surface US of the mother substrate MSUB may be protruded further in the first direction (X-axis direction) than the laser spot SPT located closest to the bottom surface BS of the mother substrate MSUB.

The laser device LD is located on the bottom surface BS of the mother substrate MSUB and irradiates the laser beam BM onto the mother substrate MSUB to form the plurality of spot groups GSPT. Therefore, when the laser spot SPT located closest to the top surface of the mother substrate MSUB among the plurality of laser spots SPT in each of the plurality of spot groups GSPT is formed, if the laser spot SPT of an adjacent spot group GSPT has already been formed, interference may occur due to the already formed laser spot SPT. Therefore, the scanning direction of the laser device LD may be determined in consideration of this. For example, as shown in FIG. 78, by setting the scanning direction of the laser device LD to the first direction (X-axis direction), the laser spot SPT located closest to the top surface of the mother substrate MSUB in the spot group GSPT currently being formed by the laser device LD may be prevented from overlapping, in the third direction (Z-axis direction), the laser spots SPT of each of the other already formed spot groups GSPT.

Alternatively, among the plurality of laser spots SPT in each of the plurality of spot groups GSPT, the laser spot SPT located closest to the top surface of the mother substrate MSUB may be protruded further in a direction opposite to the first direction (X-axis direction) than the laser spot SPT located closest to the bottom surface of the mother substrate MSUB. In this case, by setting the scanning direction of the laser device LD to the direction opposite to the first direction (X-axis direction), the laser spot SPT located closest to the top surface of the mother substrate MSUB in the spot group GSPT currently being formed by the laser device LD may be prevented from overlapping, in the third direction (Z-axis direction), the laser spots SPT of each of the other already formed spot groups GSPT.

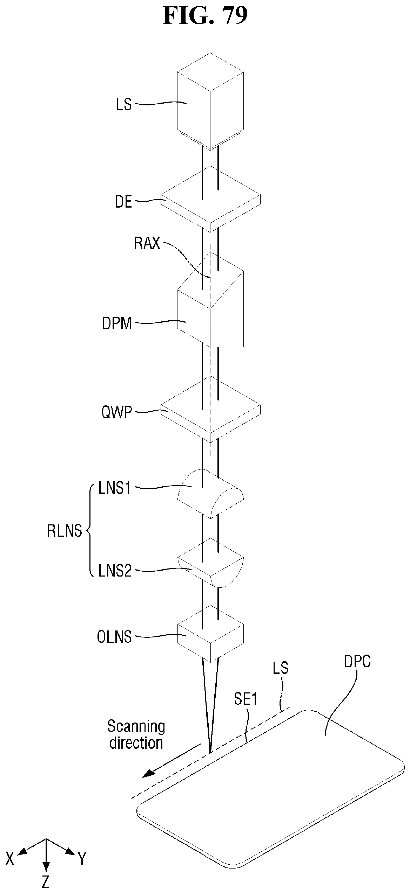

FIGS. 79 to 86 are views illustrating rotation of the laser device according to the embodiment of FIGS. 55 and 56 for a laser scribe line surrounding the edge of a display cell.

FIGS. 79 to 86 illustrate that the first side edge SE1 of the display cell DPC is the left edge of the display cell DPC, the second side edge SE2 of the display cell DPC is the lower edge of the display cell DPC, the third side edge SE3 of the display cell DPC is the right edge of the display cell DPC, and the fourth side edge SE4 of the display cell DPC is the upper edge of the display cell DPC, but the embodiment of the present disclosure is not limited thereto.

First, as shown in FIG. 79, in a state in which the laser device LD is not rotated, the laser beam BM is irradiated along the first side edge SE1 of one of the plurality of display cells DPC to perform the laser scketch LS.

The laser device LD scans the laser beam BM from one end to the other end of the first side edge SE1 of the display cell DPC. That is, the scanning direction of the laser device LD may be parallel to the first direction (X-axis direction). Since the laser device LD moves along a straight path while irradiating the laser beam BM, the scan speed of the laser device LD may be in a range of approximately 10 mm/sec to 500 mm/sec.

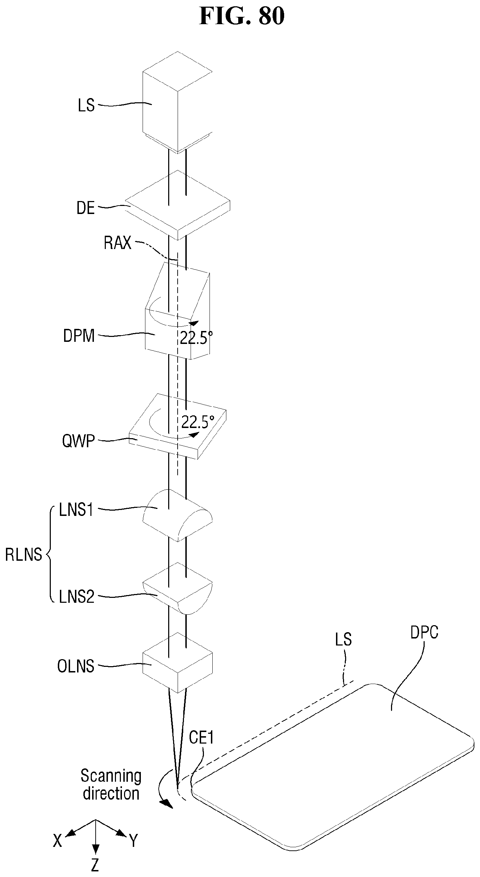

Second, as shown in FIG. 80, while the laser device LD continuously rotates counterclockwise from 0° to 45°, the laser beam BM is irradiated along the first corner edge CE1 of the display cell DPC to perform the laser scketch LS. FIG. 80 shows a state in which the laser device LD is rotated counterclockwise by 22.5°.

When the prism DPM is a Dove prism having trapezoidal faces as shown in FIGS. 48A and 48B, the rotation angle of the laser beam BM is twice the rotation angle of the prism DPM, so that when the prism DPM continuously rotates from 0° to 45°, the laser beam BM continuously rotates from 0° to 90°.

The first corner edge CE1 may be located between the first side edge SE1 and the second side edge SE2 of the display cell DPC. The laser device LD scans the laser beam BM at the first corner edge CE1 of the display cell DPC in a direction from the first side edge SE1 toward the second side edge SE2. Since the laser device LD moves along a curved path while irradiating the laser beam BM, the scan speed of the laser device LD may be in a range of approximately 10 mm/sec to 100 mm/sec. The scan speed of the laser device LD at the first side edge SE1 of the display cell DPC may be higher than the scan speed of the laser device LD at the first corner edge CE1 of the display cell DPC.

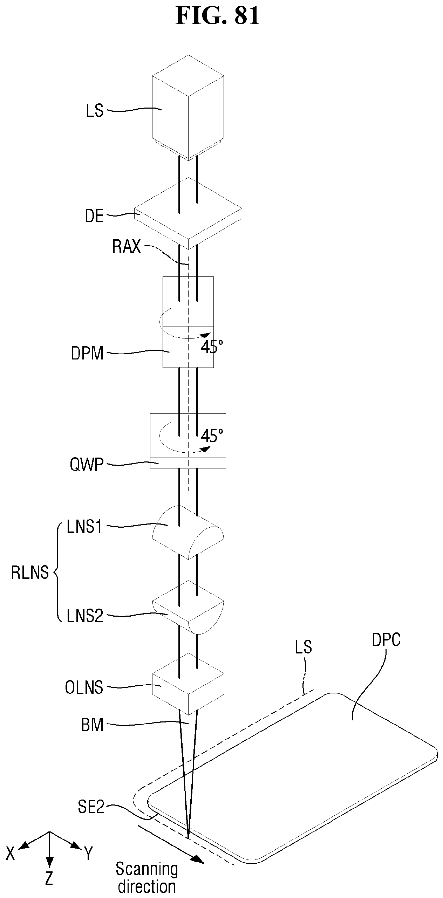

Third, as shown in FIG. 81, in a state in which the laser device LD is rotated counterclockwise by 45°, the laser beam BM is irradiated along the second side edge SE2 of the display cell DPC to perform the laser scketch LS.

When the prism DPM is a Dove prism having trapezoidal faces as shown in FIGS. 48A and 48B, the rotation angle of the laser beam BM is twice the rotation angle of the prism DPM, so that when the prism DPM is at a rotation angle of 45°, the laser beam BM may be at a rotation angle of 90°.

The laser device LD outputs the laser beam BM from one end to the other end of the second side edge SE2 of the display cell DPC. That is, the scanning direction of the laser device LD may be parallel to the second direction (Y-axis direction). Since the scan path of the laser device LD is straight, the scan speed of the laser device LD may be in a range of approximately 10 mm/sec to 500 mm/sec.

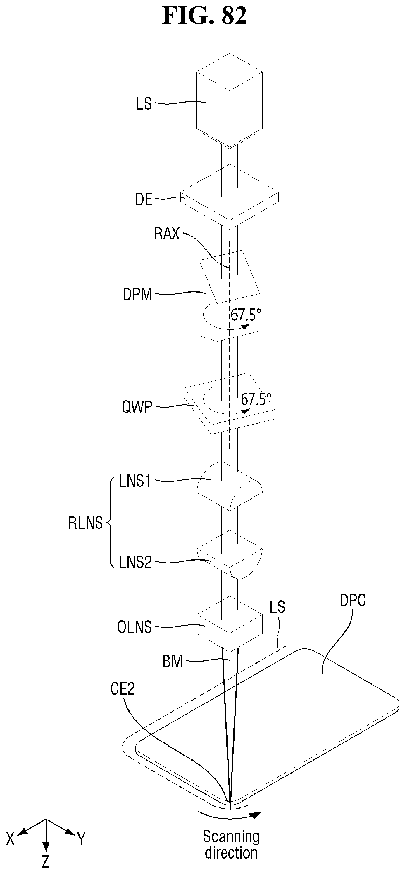

Fourth, as shown in FIG. 82, while the laser device LD continuously rotates counterclockwise from 45° to 90°, the laser beam BM is irradiated along the second corner edge CE2 of the display cell DPC to perform the laser scketch LS. FIG. 82 shows a state in which the laser device LD is rotated counterclockwise by 67.5°.

When the prism DPM is a Dove prism having trapezoidal faces as shown in FIGS. 48A and 48B, the rotation angle of the laser beam BM is twice the rotation angle of the prism DPM, so that when the prism DPM continuously rotates from 45° to 90°, the laser beam BM continuously rotates from 90° to 180°.

The second corner edge CE2 may be located between the second side edge SE2 and the third side edge SE3 of the display cell DPC. The laser device LD scans the laser beam BM at the second corner edge CE2 of the display cell DPC in a direction from the second side edge SE2 toward the third side edge SE3. Since the scan path of the laser device LD is curved, the scan speed of the laser device LD may be in a range of approximately 10 mm/sec to 100 mm/sec. The scan speed of the laser device LD at the second side edge SE2 of the display cell DPC may be higher than the scan speed of the laser device LD at the second corner edge CE2 of the display cell DPC.

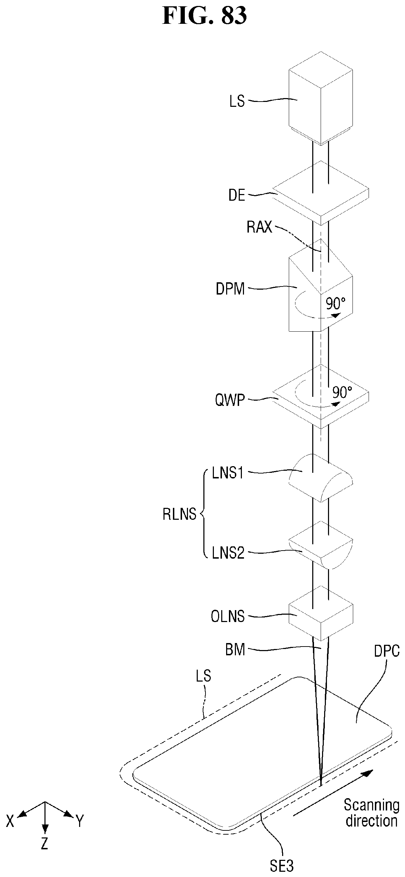

Fifth, as shown in FIG. 83, in a state in which the laser device LD is rotated counterclockwise by 90°, and the laser beam BM is irradiated along the third side edge SE3 of the display cell DPC to perform the laser scketch LS.

When the prism DPM is a Dove prism having trapezoidal faces as shown in FIGS. 48A and 48B, the rotation angle of the laser beam BM is twice the rotation angle of the prism DPM, so that when the prism DPM is at a rotation angle of 90°, the laser beam BM may be at a rotation angle of 180°.

The laser device LD outputs the laser beam BM from one end to the other end of the third side edge SE3 of the display cell DPC. That is, the scanning direction of the laser device LD may be parallel to the first direction (X-axis direction). Since the scan path of the laser device LD is straight, the scan speed of the laser device LD may be in a range of approximately 10 mm/sec to 500 mm/sec.

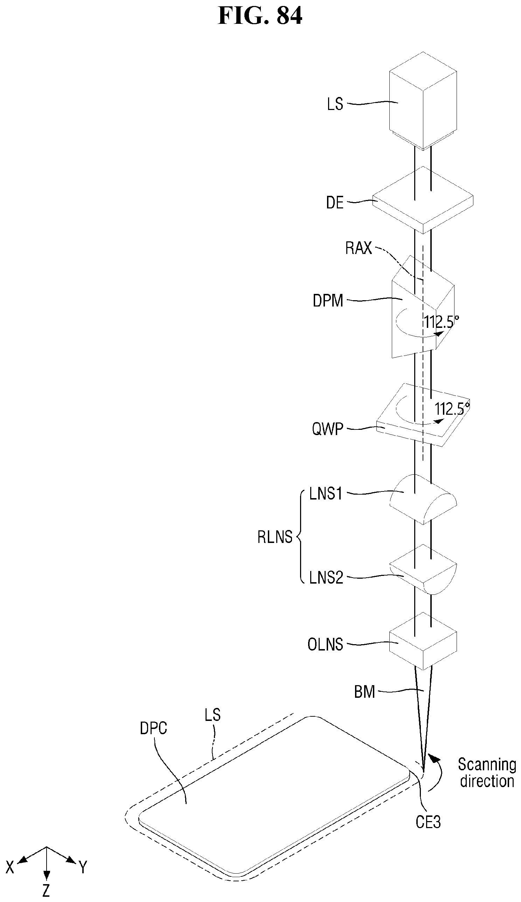

Sixth, as shown in FIG. 84, while the laser device LD continuously rotates counterclockwise from 90° to 135°, the laser beam BM is irradiated along the third corner edge CE3 of the display cell DPC to perform the laser scketch LS. FIG. 84 shows a state in which the laser device LD is rotated counterclockwise by 112.5°.

When the prism DPM is a Dove prism having trapezoidal faces as shown in FIGS. 48A and 48B, the rotation angle of the laser beam BM is twice the rotation angle of the prism DPM, so that when the prism DPM continuously rotates from 90° to 135°, the laser beam BM continuously rotates from 180° to 270°.

The third corner edge CE3 may be located between the third side edge SE3 and the fourth side edge SE4 of the display cell DPC. The laser device LD scans the laser beam BM at the third corner edge CE3 of the display cell DPC in a direction from the third side edge SE3 toward the fourth side edge SE4. Since the scan path of the laser device LD is curved, the scan speed of the laser device LD may be in a range of approximately 10 mm/sec to 100 mm/sec. The scan speed of the laser device LD at the third side edge SE3 of the display cell DPC may be higher than the scan speed of the laser device LD at the third corner edge CE3 of the display cell DPC.

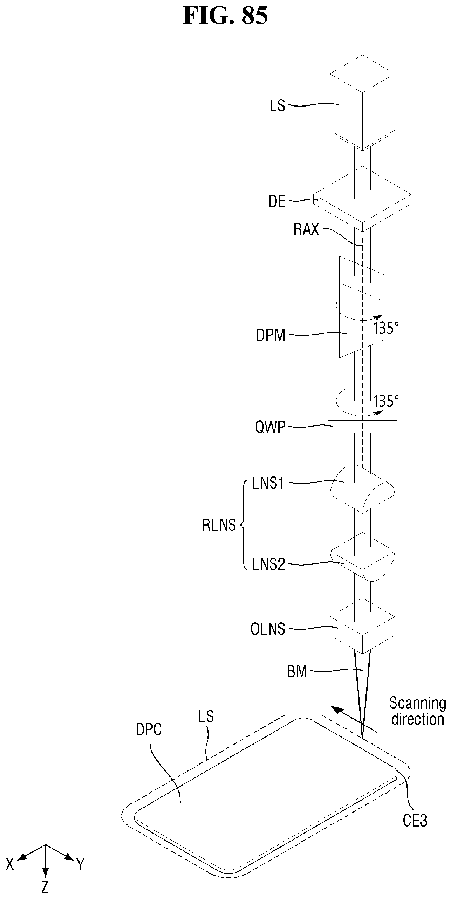

Seventh, as shown in FIG. 85, in a state in which the laser device LD is rotated counterclockwise by 135°, the laser beam BM is irradiated along the fourth side edge SE4 of the display cell DPC to perform the laser scketch LS.

When the prism DPM is a Dove prism having trapezoidal faces as shown in FIGS. 48A and 48B, the rotation angle of the laser beam BM is twice the rotation angle of the prism DPM, so that when the prism DPM is at a rotation angle of 135°, the laser beam BM may be at a rotation angle of 270°.

The laser device LD outputs the laser beam BM from one end to the other end of the fourth side edge SE4 of the display cell DPC. That is, the scanning direction of the laser device LD may be parallel to the second direction (Y-axis direction). Since the scan path of the laser device LD is straight, the scan speed of the laser device LD may be in a range of approximately 10 mm/sec to 500 mm/sec.

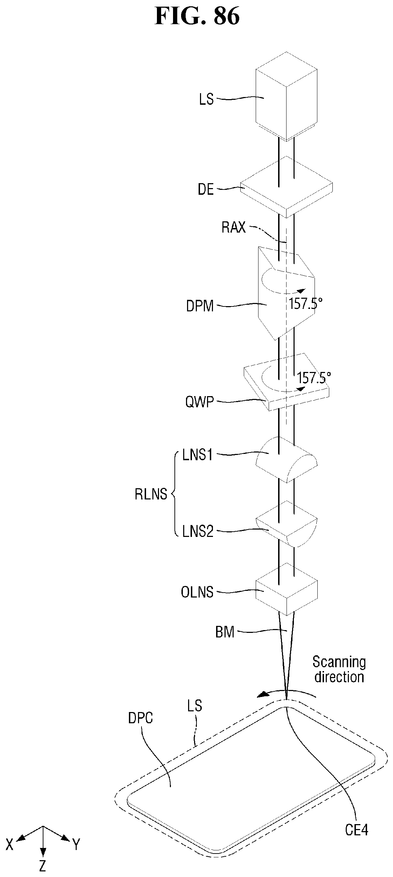

Eighth, as shown in FIG. 86, while the laser device LD continuously rotates counterclockwise from 135° to 180°, the laser beam BM is irradiated along the fourth corner edge CE4 of the display cell DPC to perform the laser scketch LS. FIG. 85 shows a state in which the laser device LD is rotated counterclockwise by 157.5°.

When the prism DPM is a Dove prism having trapezoidal faces as shown in FIGS. 48A and 48B, the rotation angle of the laser beam BM is twice the rotation angle of the prism DPM, so that when the prism DPM continuously rotates from 135° to 180°, the laser beam BM continuously rotates from 270° to 360°.

The fourth corner edge CE4 may be located between the fourth side edge SE4 and the first side edge SE1 of the display cell DPC. The laser device LD scans the laser beam BM at the fourth corner edge CE4 of the display cell DPC in a direction from the fourth side edge SE4 toward the first side edge SE1. Since the scan path of the laser device LD is curved, the scan speed of the laser device LD may be in a range of approximately 10 mm/sec to 100 mm/sec. The scan speed of the laser device LD at the fourth side edge SE4 of the display cell DPC may be higher than the scan speed of the laser device LD at the fourth corner edge CE4 of the display cell DPC.

As shown in FIG. 56, since the phase retardation plate QWP retards the phase of the linearly polarized, elliptically polarized, or circularly polarized laser beam BM incident thereon by λ/4, the laser beam BM outputted from the phase retardation plate QWP has elliptical polarization. Therefore, regardless of the rotation of the laser device LD, the laser device LD outputs elliptically polarized light.

As shown in FIGS. 76 to 86, since the elliptically polarized laser beam BM is irradiated counterclockwise along the first side edge SE1, the first corner edge CE1, the second side edge SE2, the second corner edge CE2, the third side edge SE3, the third corner edge CE3, the fourth side edge ES4, and the fourth corner edge CE4 of the display cell DPC to perform the laser scketch, it is possible to minimize or prevent differences in processability of the substrate SUB of the display panel 100. As a result, it is possible to minimize or prevent differences in the shape, for example, the radius of curvature, of the side surfaces SS1, SS2, SS3, and SS4 of the substrate SUB of the display panel 100, or differences in mechanical strength depending on the positions of the side surfaces SS1, SS2, SS3, and SS4 of the substrate SUB. Therefore, the side surfaces SS1, SS2, SS3, and SS4 of the substrate SUB of the display panel 100 may have uniform quality against external impact.

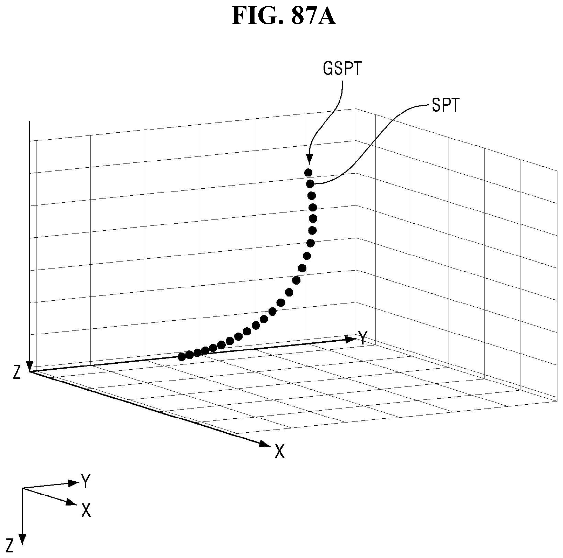

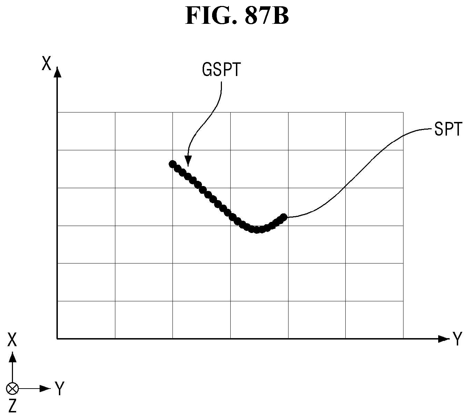

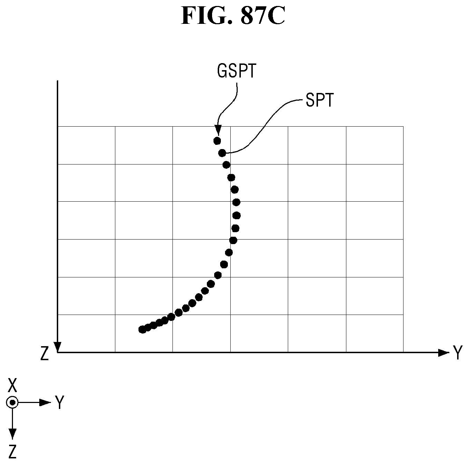

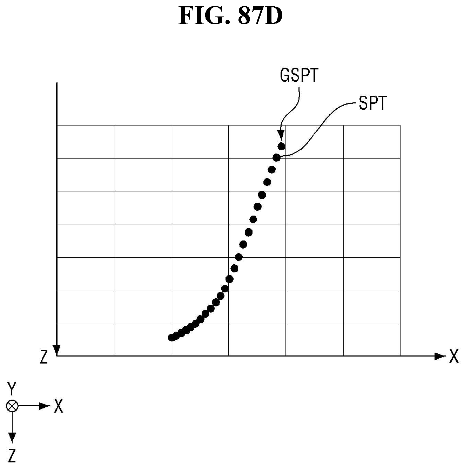

FIGS. 87A to 87D are views illustrating arrangements, in an XYZ plane, an XY plane, an XZ plane, and a YZ plane, of laser spots irradiated by a laser device according to one embodiment. FIGS. 87A to 87D show the plurality of laser spots SPT of the spot group GSPT in the XYZ plane, the XY plane, the XZ plane, and the YZ plane formed along the third side edge SE3 of the display cell DPC as shown in FIGS. 74 and 83.

Referring to FIGS. 87A to 87D, the length in the first direction (X-axis direction) of the plurality of laser spots SPT arranged in the spot group GPST may be in a range of approximately 0 µm to 150 µm. The length in the second direction (Y-axis direction) of the plurality of laser spots SPT arranged in the spot group GPST may be in a range of approximately 0 µm to 150 µm. The plurality of laser spots SPT arranged in the spot group GPST may not overlap each other in the third direction (Z-axis direction). Therefore, one of the length in the first direction (X-axis direction) and the length in the second direction (Y-axis direction) of the plurality of laser spots SPT arranged in the spot group GPST may not be 0 µm.

When the length of the mother substrate MSUB in the third direction (Z-axis direction) is approximately 500 µm, the length over which the plurality of laser spots SPT of the spot group GPST are arranged in the third direction (Z-axis direction) may be in a range of approximately 200 µm to 300 µm. That is, the length over which the plurality of laser spots SPT of the spot group GPST are arranged in the third direction (Z-axis direction) may be in a range of approximately 0.4 to 0.6 times the length of the mother substrate MSUB in the third direction (Z-axis direction). The length of the mother substrate MSUB in the third direction (Z-axis direction) may be the thickness of the mother substrate MSUB.

It should be noted that the arrangement of the plurality of laser spots SPT of the spot group GSPT in the XYZ plane, XY plane, the XZ plane, and the YZ plane shown in FIGS. 87A to 87D is merely one embodiment, and the embodiment of the present disclosure is not limited thereto.

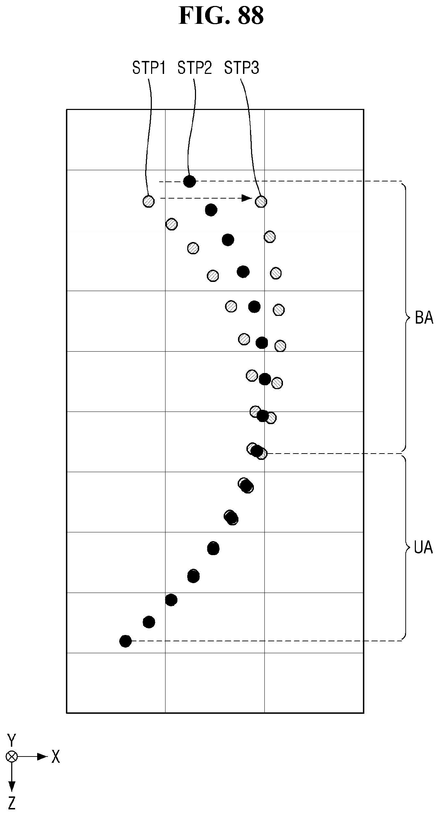

FIG. 88 is a view illustrating in detail an arrangement in an XZ plane of laser spots irradiated by a laser device according to one embodiment.

Referring to FIG. 88, the XZ plane may be defined as a two-dimensional plane defined by the first direction (X-axis direction) and the third direction (Z-axis direction). FIG. 88 shows first laser spots SPT1 having a first radius of curvature, second laser spots SPT2 having a second radius of curvature, and third laser spots SPT3 having a third radius of curvature. The first radius of curvature may be smaller than the second radius of curvature, and the second radius of curvature may be smaller than the third radius of curvature.

In a first region UA, the laser spots SPT may be arranged in the same pattern as the first laser spots SPT1 having the first radius of curvature. In a second region BA, the laser spots SPT may be arranged in the same pattern as the second laser spots SPT2 having the second radius of curvature or the third laser spots SPT3 having the third radius of curvature. The first region UA may be a region corresponding to the half of the laser spots SPT closer to the top surface US of the mother substrate MSUB, and the second region BA may be a region corresponding to the other half of the laser spots SPT closer to the bottom surface BS of the mother substrate MSUB.

As the radius of curvature of the laser spots SPT arranged in the second region BA increases, the area of the gap GP between the substrate SUB and the dummy substrate DSUB formed by etching may decrease.

Since the radius of curvature of the laser spots SPT arranged in the first region UA differs from the radius of curvature of the laser spots SPT arranged in the second region BA, the arrangement of the laser spots SPT in the first region UA and the arrangement of the laser spots SPT in the second region BA may be asymmetric.

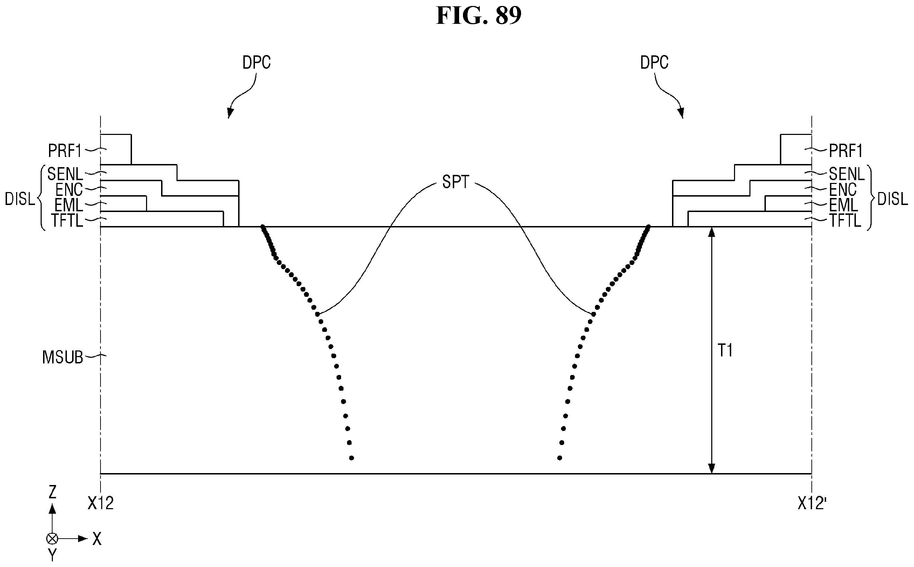

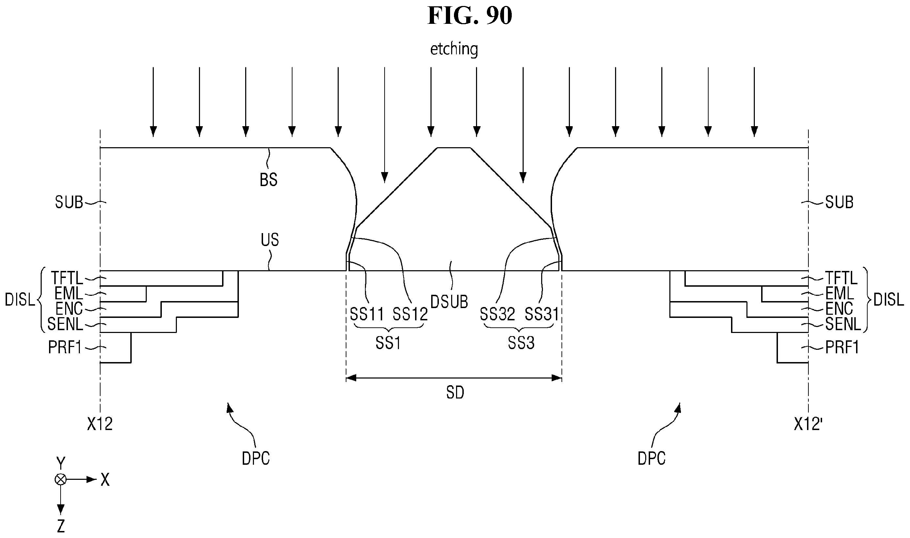

FIGS. 89 and 90 are cross-sectional views taken along line X12-X12' of FIGS. 59 to 62, illustrating a method for fabricating a display device according to another embodiment. FIGS. 89 and 90 show another example of cross-sections taken along line X12-X12' in steps S120 to S140.

The cross-sectional shape of the side surfaces SS1, SS2, SS3, and SS4 of the substrate SUB depends on the arrangement pattern of the laser spots SPT. Hereinafter, a method for fabricating the side surfaces SS1, SS2, SS3, and SS4 of the substrate SUB according to the embodiment of FIGS. 26A to 26D will be described with reference to FIGS. 89 and 90.

As shown in FIG. 89, the length over which the plurality of laser spots SPT are arranged in the third direction (Z-axis direction) may be substantially equal to the length of the mother substrate MSUB in the third direction (Z-axis direction). For example, when the length of the mother substrate MSUB in the third direction (Z-axis direction) is approximately 500 µm, the length over which the plurality of laser spots SPT are arranged in the third direction (Z-axis direction) may be approximately 500 µm.

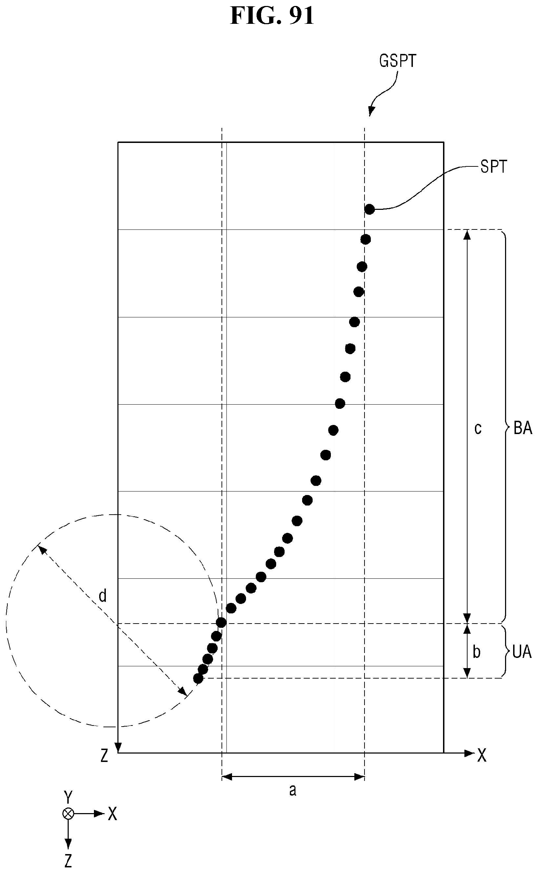

In a plane defined by the first direction (X-axis direction) and the third direction (Z-axis direction), the side surfaces SS1, SS2, SS3, and SS4 of the substrate SUB according to the embodiment of FIGS. 26A to 26D may have two sub-side surfaces, and to this end, the plurality of laser spots SPT may also be divided into two regions having two radii of curvature in a plane defined by the first direction (X-axis direction) and the third direction (Z-axis direction). A detailed description will be given later with reference to FIG. 91 regarding the arrangement of the plurality of laser spots SPT formed on the mother substrate MSUB by the laser device LD, which enables the side surfaces SS1, SS2, SS3, and SS4 of the substrate SUB according to the embodiment of FIGS. 26A to 26D to have two sub-side surfaces in a plane defined by the first direction (X-axis direction) and the third direction (Z-axis direction).

As shown in FIG. 90, since the length over which the plurality of laser spots SPT are arranged in the third direction (Z-axis direction) is substantially equal to the length of the mother substrate MSUB in the third direction (Z-axis direction), the etchant may directly penetrate into the plurality of laser spots SPT. Therefore, the area of the gap GP between the bottom surface BS of the substrate SUB and the dummy substrate DSUB, which are separated from the mother substrate MSUB, may increase compared to that in the embodiment of FIG. 67. Therefore, the area of at least a partial region of each of the side surfaces SS1 and SS3 of the substrate SUB healed by the etchant may also increase compared to that in the embodiment of FIG. 67. In addition, due to the increase in the gap GP, damage to the side surface of the substrate SUB by the dummy substrate DSUB when the dummy substrate DSUB is separated from the substrate SUB may be reduced compared to that in the embodiment of FIG. 67.

FIG. 91 is a view illustrating laser spots irradiated by a laser device according to one embodiment. FIG. 91 shows the laser spots SPT in the XZ plane formed to form the first side surface SS1 of the substrate SUB in FIGS. 89 and 90.

Referring to FIG. 91, the XZ plane may be defined as a two-dimensional plane defined by the first direction (X-axis direction) and the third direction (Z-axis direction). In the XZ plane, a curve formed by the plurality of laser spots SPT includes the first region UA having the first radius of curvature and the second region BA having the second radius of curvature. The second radius of curvature may be smaller than the first radius of curvature. The first region UA may be an upper region of the mother substrate MSUB, and the second region BA may be a lower region of the mother substrate MSUB.

A spacing between the laser spots SPT in the second region BA may be greater than a spacing between the laser spots SPT in the first region UA. The spacing between the laser spots SPT in the second region BA may increase from the bottom to the top. The spacing between the laser spots SPT in the first region UA and the second region BA may be in a range of approximately 3 µm to 20 µm.

A length a of the second region BA in the first direction (X-axis direction) may be in a range of approximately 80 µm to 150 µm. A length b of the first region UA in the third direction (Z-axis direction) may be smaller than a length c of the second region BA in the third direction (Z-axis direction). For example, when the thickness of the mother substrate MSUB is approximately 500 µm, the length b of the first region UA in the third direction (Z-axis direction) may be in a range of approximately 30 µm to 70 µm, and the length c of the second region BA in the third direction (Z-axis direction) may be in a range of approximately 430 µm to 470 µm. The second radius of curvature d may be in a range of approximately 200 µm to 600 µm.

As shown in FIGS. 89 to 91, the curve formed by the laser spots SPT in the first region UA and the curve formed by the laser spots SPT in the second region BA not only have different radii of curvature from each other, but also differ in the spacing between the laser spots SPT. Therefore, the first sub-side surface SS11 may be formed such that the first sub-side surface SS1 has a curved shape or a planar shape different from that of the second sub-side surface SS12. In addition, when the spacing between the laser spots SPT in the first region UA is narrow, the energy density irradiated onto the mother substrate MSUB is high, so that the substrate SUB may be separated from the dummy substrate DSUB at the first side surface SS1 even without the etchant penetrating to the top surface US of the mother substrate MSUB. Alternatively, the substrate SUB may be separated from the dummy substrate DSUB at the first side surface SS1 merely by a small amount of the etchant penetrating into the laser spots SPT. Therefore, it is possible to minimize or prevent the etchant from reaching the display layer DISL of the display cell DPC located on the top surface of the substrate SUB.

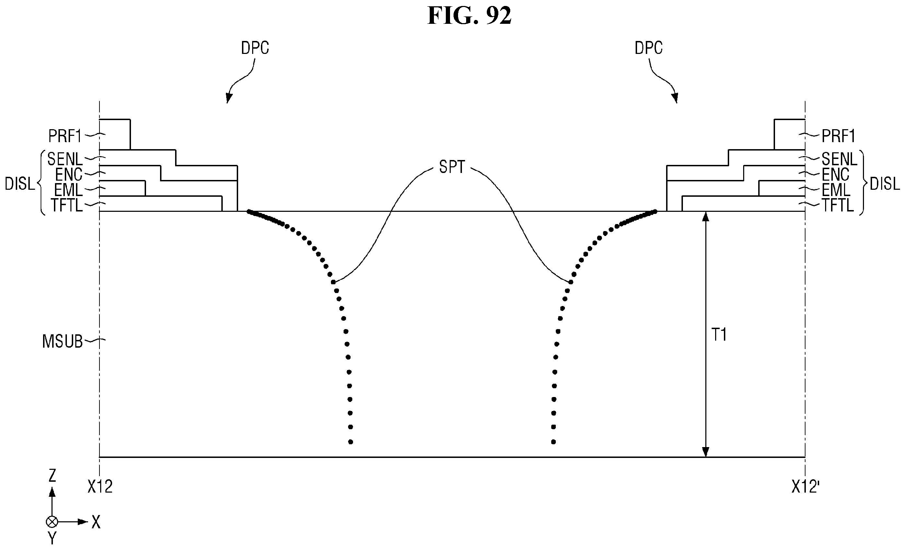

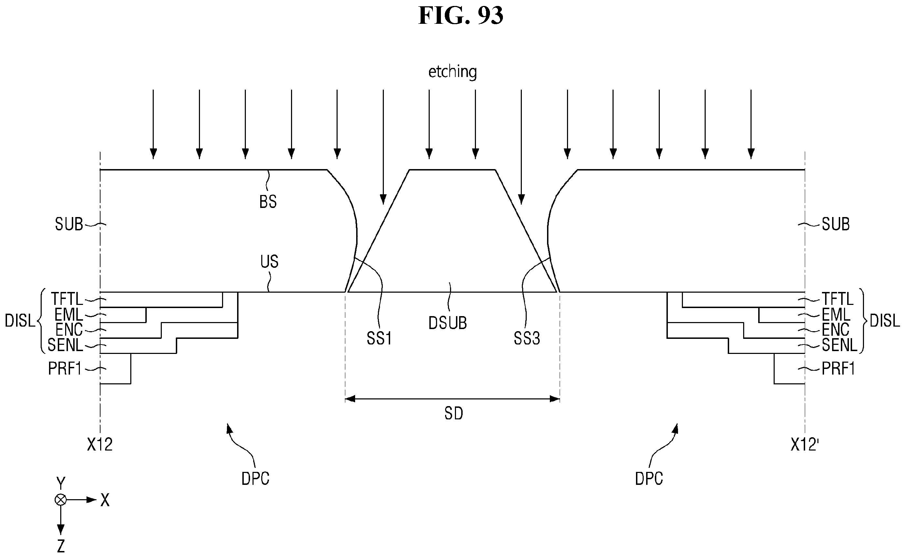

FIGS. 92 and 93 are cross-sectional views taken along line X12-X12', illustrating a method for fabricating a display device according to still another embodiment. FIGS. 92 and 93 show still another example of cross-sections taken along line X12-X12' in steps S120 to S140.

The cross-sectional shape of the side surfaces SS1, SS2, SS3, and SS4 of the substrate SUB depends on the arrangement pattern of the laser spots SPT. Hereinafter, a method for fabricating the side surfaces SS1, SS2, SS3, and SS4 of the substrate SUB according to the embodiment of FIGS. 25A to 25D will be described with reference to FIGS. 92 and 93.

As shown in FIG. 92, the length over which the plurality of laser spots SPT are arranged in the third direction (Z-axis direction) may be substantially equal to the length of the mother substrate MSUB in the third direction (Z-axis direction). For example, when the length of the mother substrate MSUB in the third direction (Z-axis direction) is approximately 500 µm, the length over which the plurality of laser spots SPT are arranged in the third direction (Z-axis direction) may be approximately 500 µm.

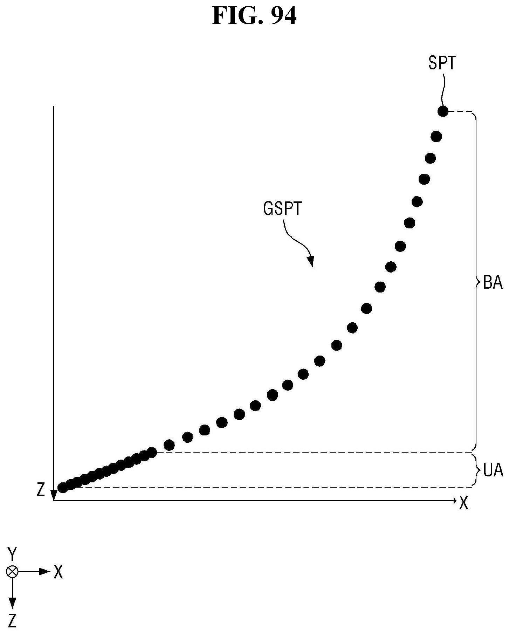

In a plane defined by the first direction (X-axis direction) and the third direction (Z-axis direction), the side surfaces SS1, SS2, SS3, and SS4 of the substrate SUB according to the embodiment of FIGS. 25A to 25D have a curved shape, so that the plurality of laser spots SPT may also be arranged in a curved shape in a plane defined by the first direction (X-axis direction) and the third direction (Z-axis direction). A detailed description will be given later with reference to FIG. 94 regarding the arrangement of the plurality of laser spots SPT formed on the mother substrate MSUB by the laser device LD, which enables the side surfaces SS1, SS2, SS3, and SS4 of the substrate SUB according to the embodiment of FIGS. 25A to 25D to have a curved shape in a plane defined by the first direction (X-axis direction) and the third direction (Z-axis direction).

As shown in FIG. 93, since the length over which the plurality of laser spots SPT are arranged in the third direction (Z-axis direction) is substantially equal to the length of the mother substrate MSUB in the third direction (Z-axis direction), the etchant may directly penetrate into the plurality of laser spots SPT. Therefore, the area of the gap GP between the bottom surface BS of the substrate SUB and the dummy substrate DSUB, which are separated from the mother substrate MSUB, may increase compared to that in the embodiment of FIG. 67. Therefore, the area of at least a partial region of each of the side surfaces SS1, SS3 of the substrate SUB healed by the etchant may also increase compared to that in the embodiment of FIG. 67. In addition, due to the increase in the gap GP, damage to the side surface of the substrate SUB by the dummy substrate DSUB when the dummy substrate DSUB is separated from the substrate SUB may be further reduced compared to that in the embodiment of FIG. 67.

FIG. 94 is a view illustrating laser spots irradiated by a laser device according to one embodiment. FIG. 94 shows the laser spots SPT in the XZ plane formed to form the first side surface SS1 of the substrate SUB in FIGS. 92 and 93.

Referring to FIG. 94, the XZ plane may be defined as a two-dimensional plane defined by the first direction (X-axis direction) and the third direction (Z-axis direction). In the XZ plane, the plurality of laser spots SPT include the first region UA having a spacing smaller than a selected spacing and the second region BA having a spacing greater than the selected spacing. That is, the spacing between the laser spots SPT in the first region UA may be smaller than the spacing between the laser spots SPT in the second region BA. The first region UA may be an upper region of the mother substrate MSUB, and the second region BA may be a lower region of the mother substrate MSUB.

As shown in FIGS. 92 to 94, when the spacing between the laser spots SPT in the first region UA is narrow, the energy density irradiated onto the mother substrate MSUB is high, so that the substrate SUB may be separated from the dummy substrate DSUB at the first side surface SS1 even without the etchant penetrating to the top surface US of the mother substrate MSUB. Alternatively, the substrate SUB may be separated from the dummy substrate DSUB at the first side surface SS1 merely by a small amount of the etchant penetrating into the laser spots SPT. Therefore, it is possible to minimize or prevent the etchant from reaching the display layer DISL of the display cell DPC located on the top surface of the substrate SUB.

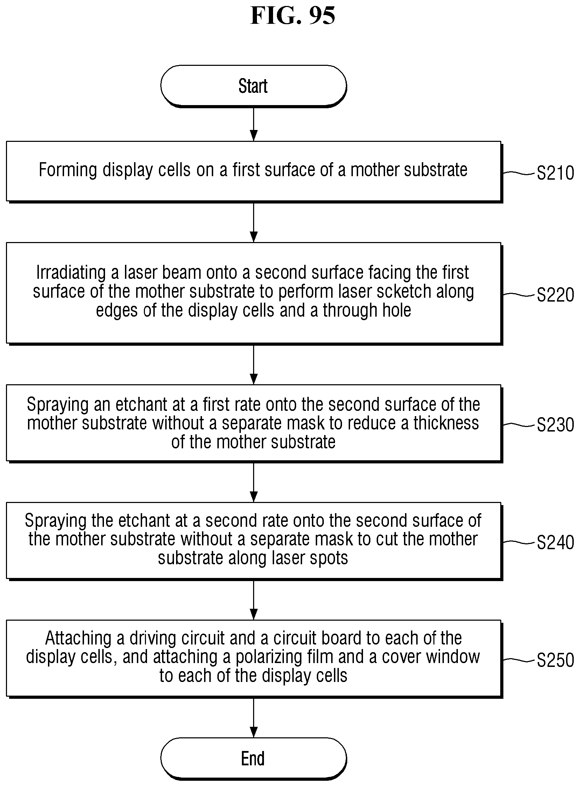

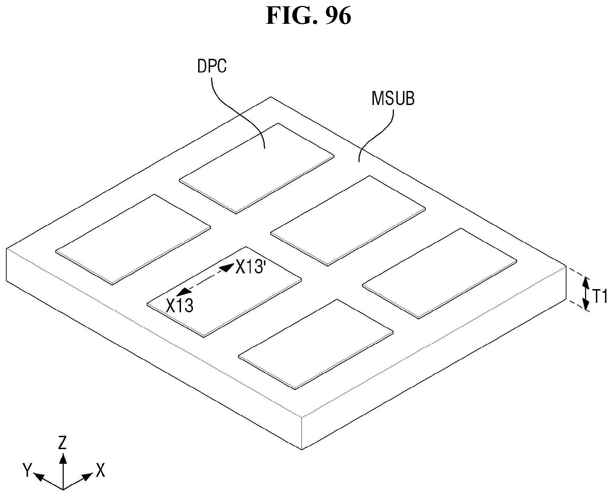

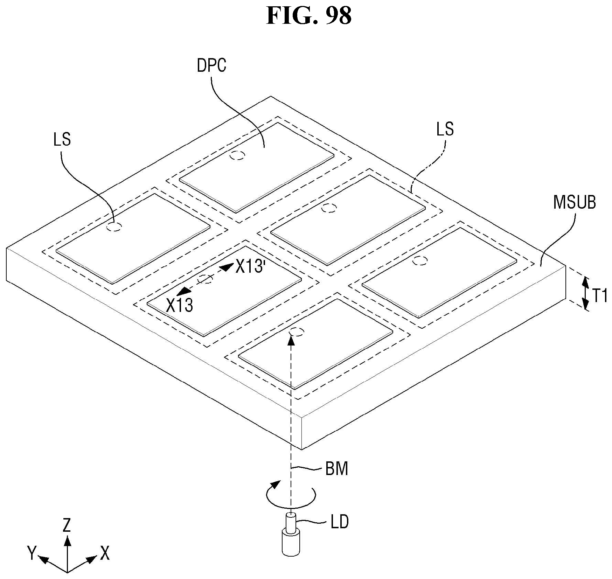

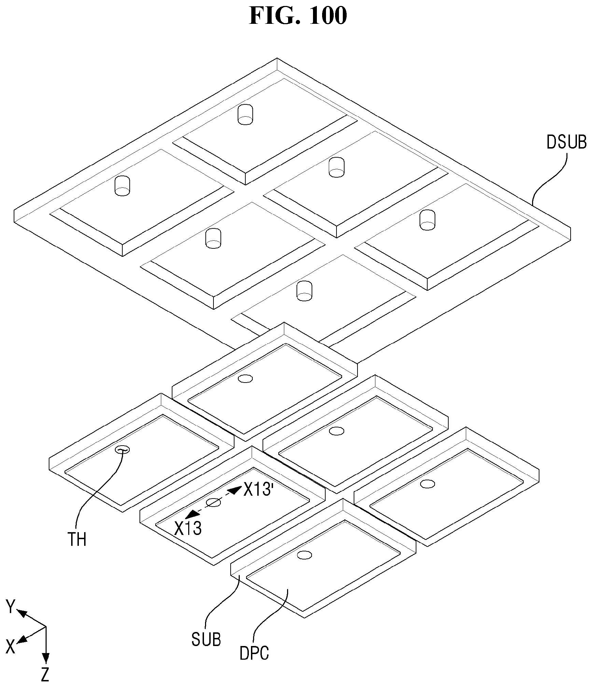

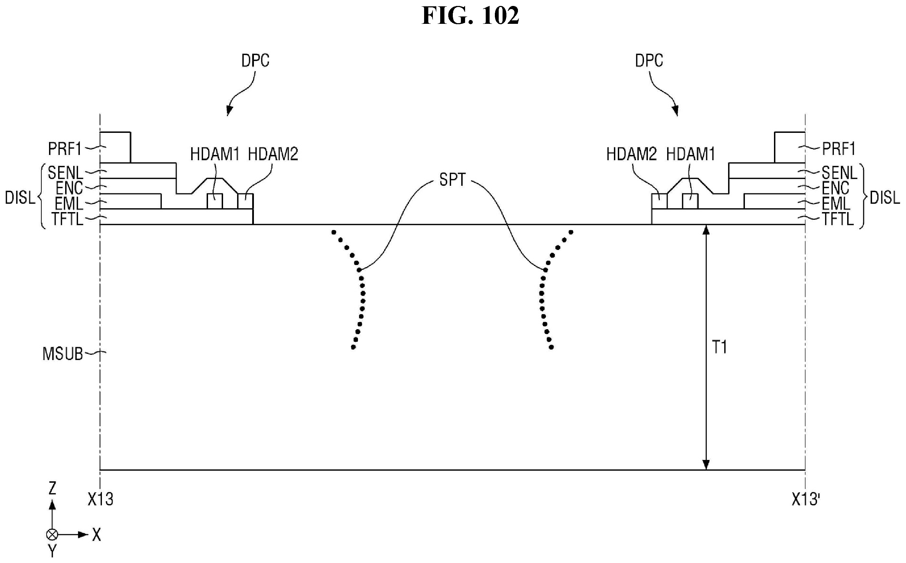

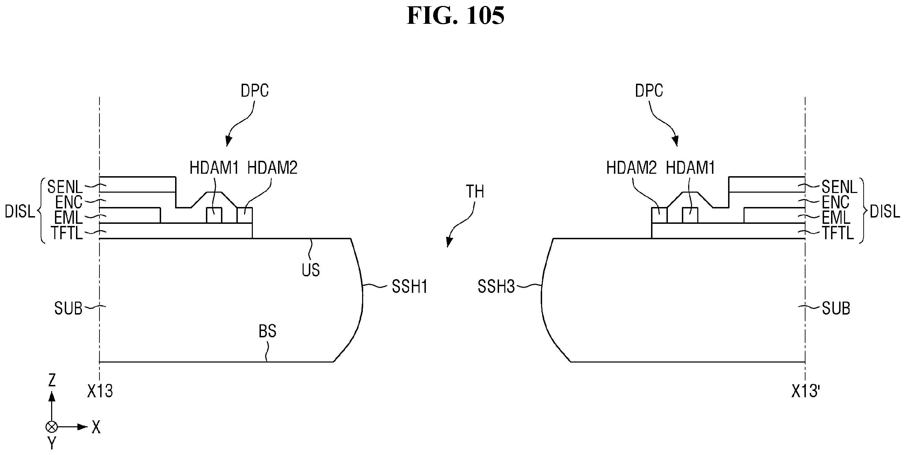

FIG. 95 is a flowchart illustrating a method for fabricating a display device according to one embodiment. FIGS. 96 to 101 are perspective views illustrating a method for fabricating a display device according to one embodiment. FIGS. 102 to 105 are cross-sectional views taken along line X13-X13', illustrating a method for fabricating a display device according to one embodiment.

FIGS. 96 to 101 show perspective views of the mother substrate MSUB and the plurality of display cells DPC. FIGS. 102 to 105 show one example of cross-sections of the mother substrate MSUB and the plurality of display cells DPC taken along line X13-X13' of FIGS. 96 to 100.

Hereinafter, a method for fabricating the hole side surfaces SSH1, SSH2, SSH3, SSH4 of the through hole TH of the substrate SUB described with reference to FIGS. 35A to 35D will be described in detail with reference to FIGS. 96 to 101.

First, as shown in FIGS. 96 and 102, the plurality of display cells DPC are formed on the first surface of the mother substrate MSUB (step S210 of FIG. 95).

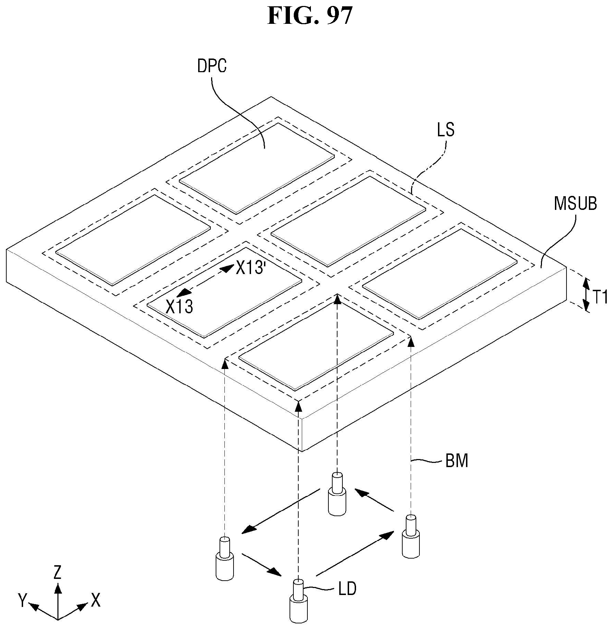

Second, as shown in FIGS. 97, 98, and 102, the laser beam is irradiated onto the second surface facing the first surface of the mother substrate MSUB to perform the laser scketch LS or laser modulation along the edges of the plurality of display cells DPC and the through holes TH (step S220 of FIG. 95).

The laser beam BM may be outputted from the laser device LD according to the embodiments described with reference to FIGS. 52 to 57.

The laser scketch LS refers to forming a plurality of spot groups GSPT each including a plurality of laser spots SPT. The laser scketch LS may be defined as forming a plurality of laser spots SPT along the edges of the plurality of display cells DPC and the through holes TH by irradiating the laser beam BM.

The scanning direction of the laser device LD for performing the laser scketch along the edge of each of the plurality of display cells DPC is counterclockwise, whereas the scanning direction of the laser device LD for performing the laser scketch along the edge of each of the through holes TH may be clockwise. However, the embodiment of the present disclosure is not limited thereto, and the scanning direction of the laser device LD may be set in consideration of whether the laser spots SPT are interfered with by other laser spots SPT when the laser spots SPT are formed, as described with reference to FIG. 78.

When the length of the mother substrate MSUB in the third direction (Z-axis direction) is approximately 500 µm, the length over which the plurality of laser spots SPT are arranged in the third direction (Z-axis direction) may be in a range of approximately 200 µm to 300 µm. That is, the length over which the plurality of laser spots SPT are arranged in the third direction (Z-axis direction) may be in a range of approximately 0.4 to 0.6 times the length of the mother substrate MSUB in the third direction (Z-axis direction).

In a plane defined by the first direction (X-axis direction) and the third direction (Z-axis direction), the hole side surfaces SSH1, SSH2, SSH3, and SSH4 of the through hole TH of the substrate SUB according to the embodiment of FIGS. 35A to 35D have a curved shape, so that the plurality of laser spots SPT may also be arranged in a curved shape in a plane defined by the first direction (X-axis direction) and the third direction (Z-axis direction). The arrangement of the plurality of laser spots SPT formed on the mother substrate MSUB by the laser device LD, which enables the hole side surfaces SSH1, SSH2, SSH3, and SSH4 of the through hole TH of the substrate SUB according to the embodiment of FIGS. 35A to 35D to have a curved shape in a plane defined by the first direction (X-axis direction) and the third direction (Z-axis direction), has already been described above with reference to FIGS. 87A to 87D and FIG. 88.

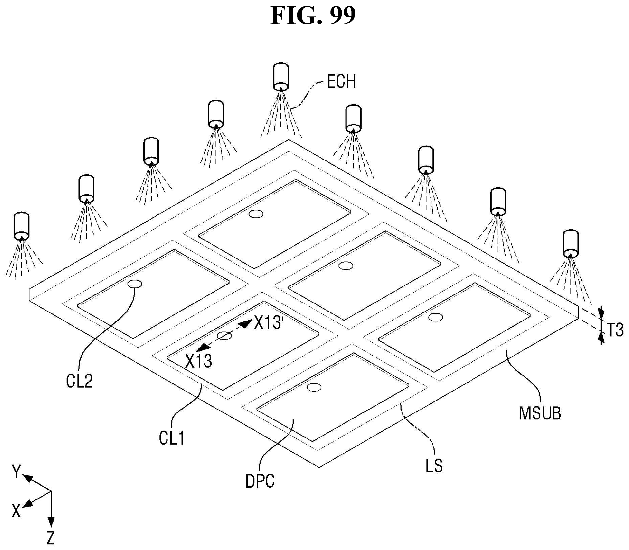

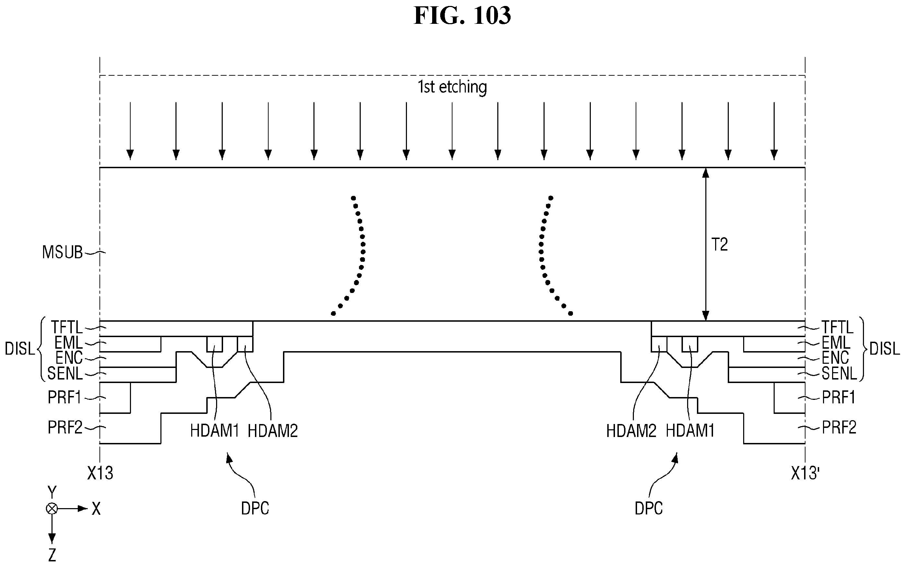

Third, as shown in FIGS. 99 and 103, an etchant is sprayed at the first rate onto the second surface of the mother substrate MSUB without a separate mask to reduce the thickness of the mother substrate MSUB (step S230 of FIG. 95).

Fourth, as shown in FIGS. 99, 100, 104, and 105, the etchant is sprayed at the second rate onto the second surface of the mother substrate MSUB without a separate mask to cut the mother substrate MSUB along the plurality of laser spots SPT (step S240 of FIG. 95).

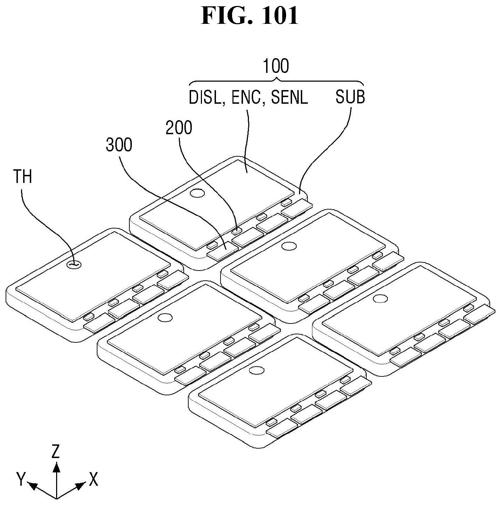

Fifth, as shown in FIG. 101, the driving circuit 200 and the circuit board 300 are attached to each of the plurality of display cells DPC, and the polarizing film PF and the cover window CW are attached to each of the plurality of display cells DPC (step S250 of FIG. 95).

As described above, since the laser and etching process may be used not only to reduce the thickness of the mother substrate MSUB and separate the substrate SUB of each of the plurality of display cells DPC from the mother substrate MSUB, but also to form the through hole TH, the efficiency of the fabricating process may be improved.

In addition, the laser device LD may output the laser beam BM such that the plurality of laser spots SPT are arranged along a curve in a plane defined by the first direction (X-axis direction) and the third direction (Z-axis direction). In this case, by spraying the etchant to perform etching, the hole side surfaces SSH1, SSH2, SSH3, and SSH4 of the through hole TH of each of the plurality of display cells DPC may be formed in a curved shape having a curvature. That is, since the hole side surfaces SSH1, SSH2, SSH3, and SSH4 of the through hole TH of each of the plurality of display cells DPC may have a curved shape without a separate polishing process, the efficiency of the fabricating process may be improved.

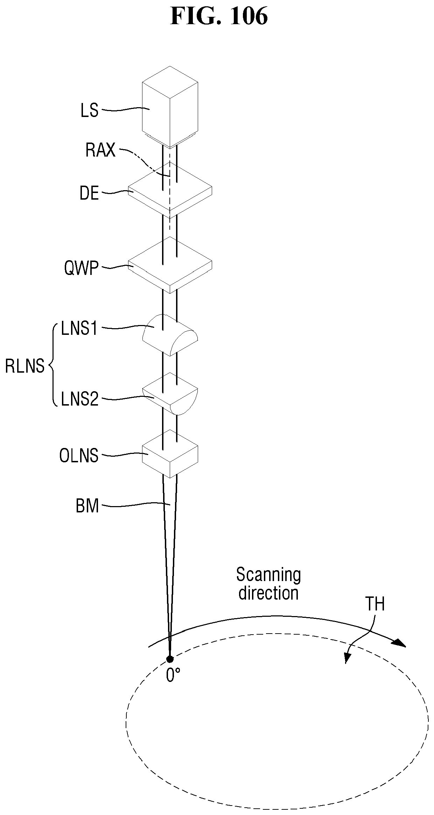

FIGS. 106 to 109 are views illustrating rotation of the laser device according to the embodiment of FIGS. 52 to 54 for a laser scribe line surrounding the edge of a through hole of a display cell.

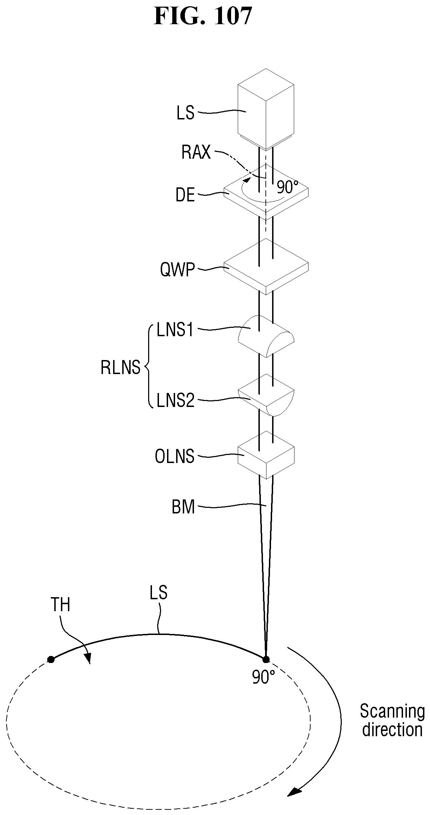

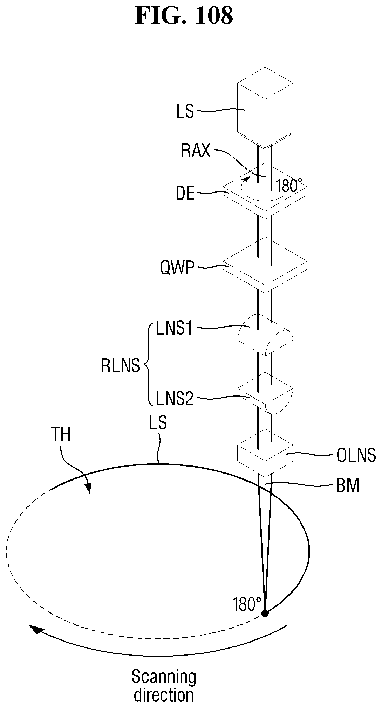

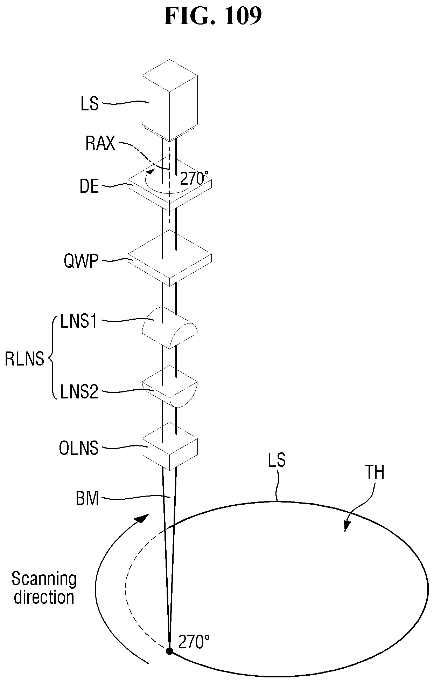

FIG. 106 shows a state in which the laser device LD is not rotated, FIG. 107 shows a state in which the laser device LD is rotated clockwise by 90°, FIG. 108 shows a state in which the laser device LD is rotated clockwise by 180°, and FIG. 109 shows a state in which the laser device LD is rotated clockwise by 270°.

Hereinafter, the laser scketch for the through hole TH of the display cell DPC will be described in detail with reference to FIGS. 106 to 109.

First, as shown in FIGS. 106 and 107, while the laser device LD continuously rotates clockwise from 0° to 90°, the laser beam BM is irradiated along a first edge of the through hole TH of the display cell DPC to perform the laser scketch LS. Since the laser device LD moves along a curved path while irradiating the laser beam BM, the scan speed of the laser device LD may be in a range of approximately 10 mm/sec to 100 mm/sec. The scan speed of the laser device LD at the first side edge SE1, the second side edge SE2, the third side edge SE3, and the fourth side edge SE4 of the display cell DPC may be higher than the scan speed of the laser device LD at the first edge of the through hole TH. In addition, the scan speed of the laser device LD at the first corner edge CE1, the second corner edge CE2, the third corner edge CE3, and the fourth corner edge CE4 of the display cell DPC may be substantially equal to the scan speed of the laser device LD at the first edge of the through hole TH.

Second, as shown in FIGS. 107 and 108, while the laser device LD continuously rotates clockwise from 90° to 180°, the laser beam BM is irradiated along a second edge of the through hole TH of the display cell DPC to perform the laser scketch LS. Since the laser device LD moves along a curved path while irradiating the laser beam BM, the scan speed of the laser device LD may be in a range of approximately 10 mm/sec to 100 mm/sec. The scan speed of the laser device LD at the first side edge SE1, the second side edge SE2, the third side edge SE3, and the fourth side edge SE4 of the display cell DPC may be higher than the scan speed of the laser device LD at the second edge of the through hole TH. In addition, the scan speed of the laser device LD at the first corner edge CE1, the second corner edge CE2, the third corner edge CE3, and the fourth corner edge CE4 of the display cell DPC may be substantially equal to the scan speed of the laser device LD at the second edge of the through hole TH.

Third, as shown in FIGS. 108 and 109, while the laser device LD continuously rotates clockwise from 180° to 270°, the laser beam BM is irradiated along a third edge of the through hole TH of the display cell DPC to perform the laser scketch LS. Since the laser device LD moves along a curved path while irradiating the laser beam BM, the scan speed of the laser device LD may be in a range of approximately 10 mm/sec to 100 mm/sec. The scan speed of the laser device LD at the first side edge SE1, the second side edge SE2, the third side edge SE3, and the fourth side edge SE4 of the display cell DPC may be higher than the scan speed of the laser device LD at the third edge of the through hole TH. In addition, the scan speed of the laser device LD at the first corner edge CE1, the second corner edge CE2, the third corner edge CE3, and the fourth corner edge CE4 of the display cell DPC may be substantially equal to the scan speed of the laser device LD at the third edge of the through hole TH.

Fourth, as shown in FIGS. 109 and 106, while the laser device LD continuously rotates clockwise from 270° to 360°, the laser beam BM is irradiated along a fourth edge of the through hole TH of the display cell DPC to perform the laser scketch LS. Since the laser device LD moves along a curved path while irradiating the laser beam BM, the scan speed of the laser device LD may be in a range of approximately 10 mm/sec to 100 mm/sec. The scan speed of the laser device LD at the first side edge SE1, the second side edge SE2, the third side edge SE3, and the fourth side edge SE4 of the display cell DPC may be higher than the scan speed of the laser device LD at the fourth edge of the through hole TH. In addition, the scan speed of the laser device LD at the first corner edge CE1, the second corner edge CE2, the third corner edge CE3, and the fourth corner edge CE4 of the display cell DPC may be substantially equal to the scan speed of the laser device LD at the fourth edge of the through hole TH.

As shown in FIGS. 106 to 109, since the elliptically polarized laser beam BM is irradiated clockwise along the edge of the through hole TH of the display cell DPC to perform the laser scketch, it is possible to minimize or prevent differences in processability of the substrate SUB of the display panel 100. As a result, it is possible to minimize or prevent differences in the shape, for example, the radius of curvature, of the hole side surfaces SSH1, SSH2, SSH3, and SSH4 of the substrate SUB of the display panel 100, or differences in mechanical strength depending on the positions of the hole side surfaces SSH1, SSH2, SSH3, and SSH4 of the substrate SUB. Therefore, the hole side surfaces SSH1, SSH2, SSH3, and SSH4 of the substrate SUB of the display panel 100 may have uniform quality against external impact.

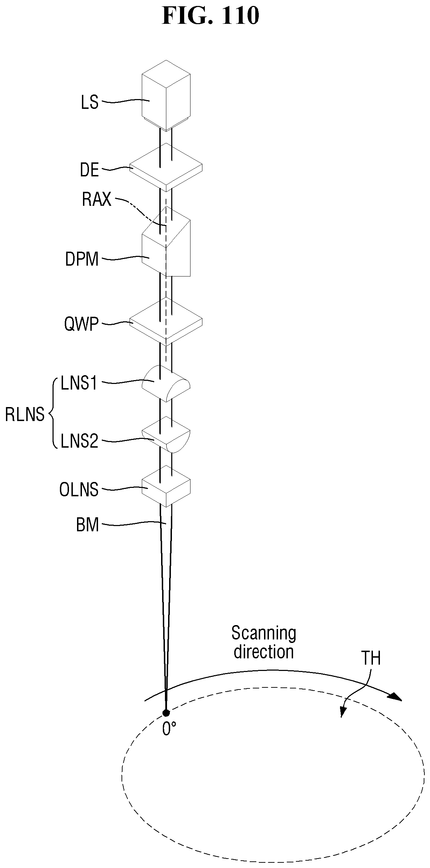

FIGS. 110 to 113 are views illustrating rotation of the laser device according to the embodiments of FIGS. 55 and 56 for a laser scribe line surrounding the edge of a through hole of a display cell.

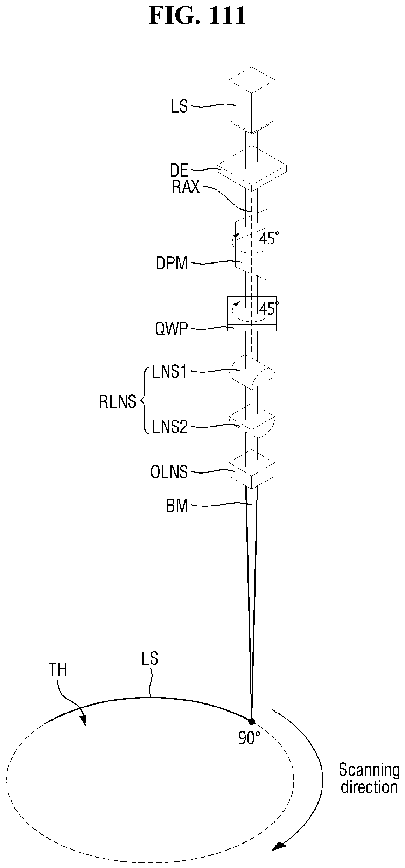

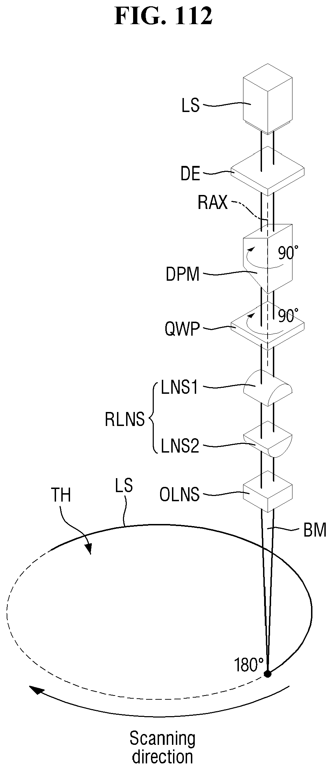

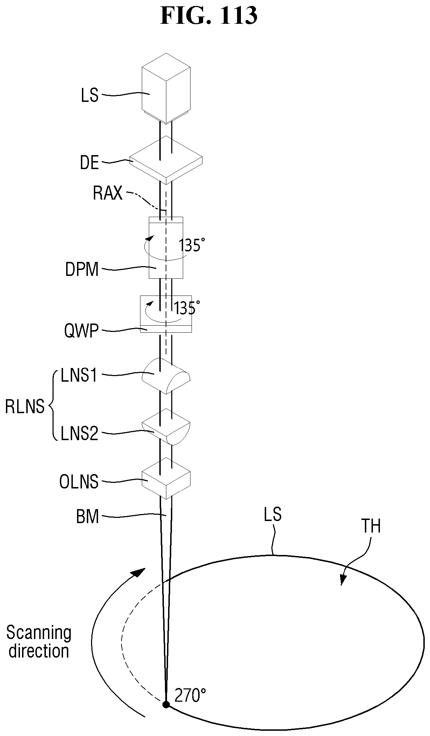

FIG. 110 shows a state in which the laser device LD is not rotated, FIG. 111 shows a state in which the laser device LD is rotated clockwise by 45°, FIG. 112 shows a state in which the laser device LD is rotated clockwise by 90°, and FIG. 113 shows a state in which the laser device LD is rotated clockwise by 135°.

Hereinafter, the laser scketch for the through hole TH of the display cell DPC will be described in detail with reference to FIGS. 110 to 113.

First, as shown in FIGS. 110 and 111, while the laser device LD continuously rotates clockwise from 0° to 45°, the laser beam BM is irradiated along the first edge of the through hole TH of the display cell DPC to perform the laser scketch LS. When the prism DPM is a Dove prism having trapezoidal faces as shown in FIGS. 48A and 48B, the rotation angle of the laser beam BM is twice the rotation angle of the prism DPM, so that when the prism DPM continuously rotates from 0° to 45°, the laser beam BM continuously rotates from 45° to 90°.

Since the laser device LD moves along a curved path while irradiating the laser beam BM, the scan speed of the laser device LD may be in a range of approximately 10 mm/sec to 100 mm/sec. The scan speed of the laser device LD at the first side edge SE1, the second side edge SE2, the third side edge SE3, and the fourth side edge SE4 of the display cell DPC may be higher than the scan speed of the laser device LD at the first edge of the through hole TH. In addition, the scan speed of the laser device LD at the first corner edge CE1, the second corner edge CE2, the third corner edge CE3, and the fourth corner edge CE4 of the display cell DPC may be substantially equal to the scan speed of the laser device LD at the first edge of the through hole TH.

Second, as shown in FIGS. 111 and 112, while the laser device LD continuously rotates clockwise from 45° to 90°, the laser beam BM is irradiated along the second edge of the through hole TH of the display cell DPC to perform the laser scketch LS. When the prism DPM is a Dove prism having trapezoidal faces as shown in FIGS. 48A and 48B, the rotation angle of the laser beam BM is twice the rotation angle of the prism DPM, so that when the prism DPM continuously rotates from 45° to 90°, the laser beam BM continuously rotates from 90° to 180°.

Since the laser device LD moves along a curved path while irradiating the laser beam BM, the scan speed of the laser device LD may be in a range of approximately 10 mm/sec to 100 mm/sec. The scan speed of the laser device LD at the first side edge SE1, the second side edge SE2, the third side edge SE3, and the fourth side edge SE4 of the display cell DPC may be higher than the scan speed of the laser device LD at the second edge of the through hole TH. In addition, the scan speed of the laser device LD at the first corner edge CE1, the second corner edge CE2, the third corner edge CE3, and the fourth corner edge CE4 of the display cell DPC may be substantially equal to the scan speed of the laser device LD at the second edge of the through hole TH.

Third, as shown in FIGS. 112 and 113, while the laser device LD continuously rotates clockwise from 90° to 135°, the laser beam BM is irradiated along the third edge of the through hole TH of the display cell DPC to perform the laser scketch LS. When the prism DPM is a Dove prism having trapezoidal faces as shown in FIGS. 48A and 48B, the rotation angle of the laser beam BM is twice the rotation angle of the prism DPM, so that when the prism DPM continuously rotates from 90° to 135°, the laser beam BM continuously rotates from 180° to 270°.

Since the laser device LD moves along a curved path while irradiating the laser beam BM, the scan speed of the laser device LD may be in a range of approximately 10 mm/sec to 100 mm/sec. The scan speed of the laser device LD at the first side edge SE1, the second side edge SE2, the third side edge SE3, and the fourth side edge SE4 of the display cell DPC may be higher than the scan speed of the laser device LD at the third edge of the through hole TH. In addition, the scan speed of the laser device LD at the first corner edge CE1, the second corner edge CE2, the third corner edge CE3, and the fourth corner edge CE4 of the display cell DPC may be substantially equal to the scan speed of the laser device LD at the third edge of the through hole TH.

Fourth, as shown in FIG. 113, while the laser device LD continuously rotates clockwise from 135° to 180°, the laser beam BM is irradiated along the fourth edge of the through hole TH of the display cell DPC to perform the laser scketch LS. When the prism DPM is a Dove prism having trapezoidal faces as shown in FIGS. 48A and 48B, the rotation angle of the laser beam BM is twice the rotation angle of the prism DPM, so that when the prism DPM continuously rotates from 135° to 180°, the laser beam BM continuously rotates from 270° to 360°.

Since the laser device LD moves along a curved path while irradiating the laser beam BM, the scan speed of the laser device LD may be in a range of approximately 10 mm/sec to 100 mm/sec. The scan speed of the laser device LD at the first side edge SE1, the second side edge SE2, the third side edge SE3, and the fourth side edge SE4 of the display cell DPC may be higher than the scan speed of the laser device LD at the fourth edge of the through hole TH. In addition, the scan speed of the laser device LD at the first corner edge CE1, the second corner edge CE2, the third corner edge CE3, and the fourth corner edge CE4 of the display cell DPC may be substantially equal to the scan speed of the laser device LD at the fourth edge of the through hole TH.

As shown in FIGS. 110 to 113, since the elliptically polarized laser beam BM is irradiated clockwise along the edge of the through hole TH of the display cell DPC to perform the laser scketch, it is possible to minimize or prevent differences in processability of the substrate SUB of the display panel 100. As a result, it is possible to minimize or prevent differences in the shape, for example, the radius of curvature, of the hole side surfaces SSH1, SSH2, SSH3, and SSH4 of the substrate SUB of the display panel 100, or differences in mechanical strength depending on the positions of the hole side surfaces SSH1, SSH2, SSH3, and SSH4 of the substrate SUB. Therefore, the hole side surfaces SSH1, SSH2, SSH3, and SSH4 of the substrate SUB of the display panel 100 may have uniform quality against external impact.

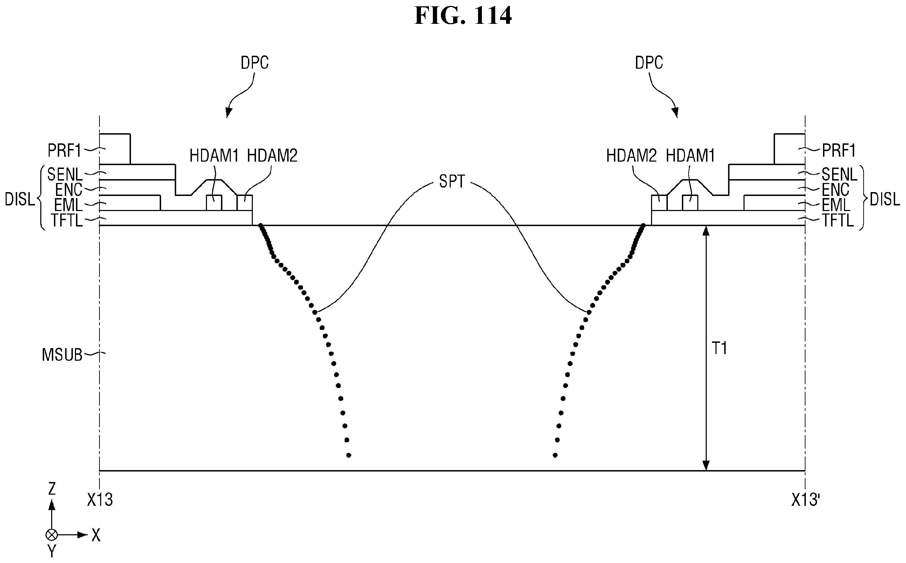

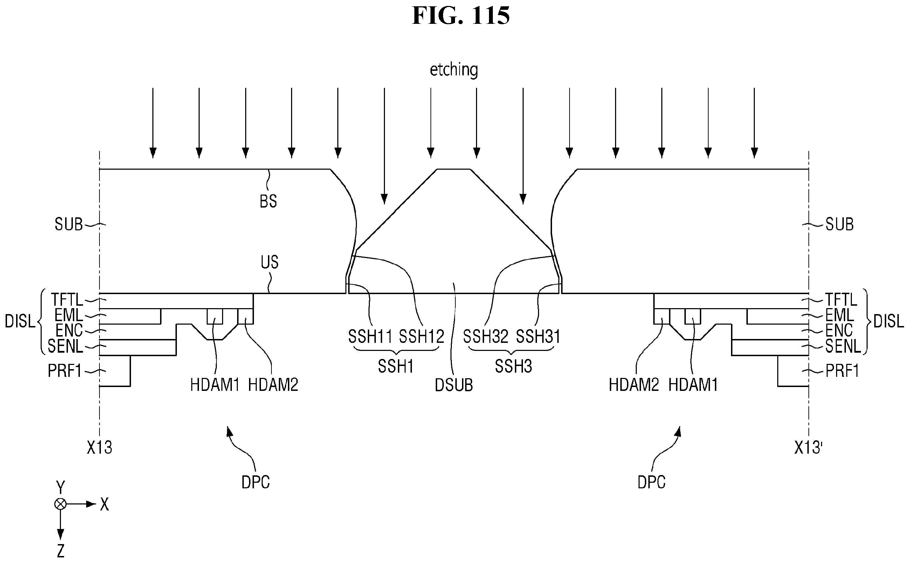

FIGS. 114 and 115 are cross-sectional views taken along line X13-X13', illustrating a method for fabricating a display device according to another embodiment. FIGS. 114 and 115 show another example of cross-sections taken along line X13-X13' in steps S220 to S240 of FIG. 95.

The cross-sectional shape of the hole side surfaces SSH1, SSH2, SSH3, and SSH4 of the through hole TH of the substrate SUB depends on the arrangement pattern of the laser spots SPT. Hereinafter, a method for fabricating the hole side surfaces SSH1, SSH2, SSH3, and SSH4 of the through hole TH of the substrate SUB according to the embodiment of FIGS. 36A to 36D will be described with reference to FIGS. 114 and 115.

As shown in FIG. 114, the length over which the plurality of laser spots SPT are arranged in the third direction (Z-axis direction) may be substantially equal to the length of the mother substrate MSUB in the third direction (Z-axis direction). For example, when the length of the mother substrate MSUB in the third direction (Z-axis direction) is approximately 500 µm, the length over which the plurality of laser spots SPT are arranged in the third direction (Z-axis direction) may be approximately 500 µm.

In a plane defined by the first direction (X-axis direction) and the third direction (Z-axis direction), the hole side surfaces SSH1, SSH2, SSH3, and SSH4 of the through hole TH of the substrate SUB according to the embodiment of FIGS. 36A to 36D have two sub-side surfaces, and to this end, the plurality of laser spots SPT may also be divided into two regions having two radii of curvature in a plane defined by the first direction (X-axis direction) and the third direction (Z-axis direction).

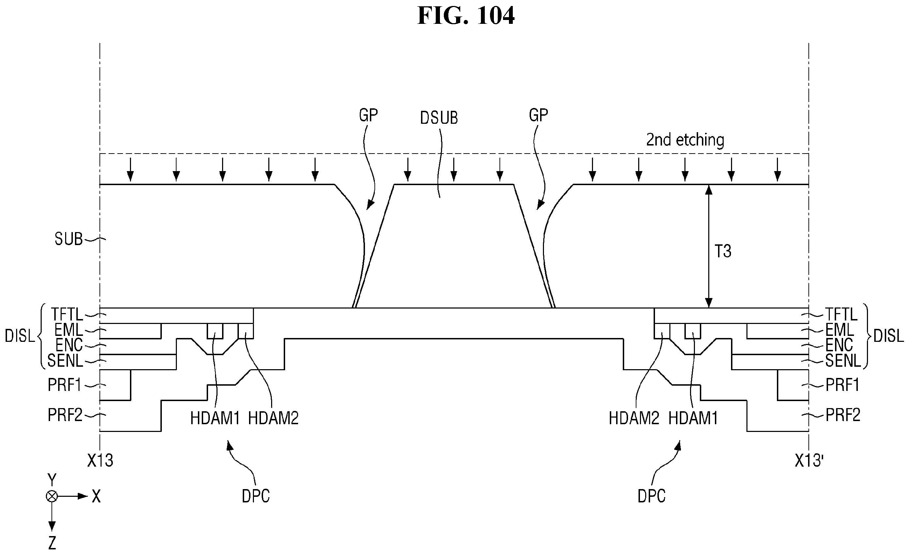

As shown in FIG. 115, since the length over which the plurality of laser spots SPT are arranged in the third direction (Z-axis direction) is substantially equal to the length of the mother substrate MSUB in the third direction (Z-axis direction), the etchant may directly penetrate into the plurality of laser spots SPT. Therefore, the area of the gap GP between the bottom surface BS of the substrate SUB and the dummy substrate DSUB, which are separated from the mother substrate MSUB, may increase compared to that in the embodiment of FIG. 104. Therefore, the area of at least a partial region of each of the hole side surfaces SSH1, SSH3 of the through hole TH of the substrate SUB healed by the etchant may also increase compared to that in the embodiment of FIG. 104. In addition, due to the increase in the gap GP, damage to the side surface of the substrate SUB by the dummy substrate DSUB when the dummy substrate DSUB is separated from the substrate SUB may be reduced compared to that in the embodiment of FIG. 104.

In addition, the arrangement of the plurality of laser spots SPT formed on the mother substrate MSUB by the laser device LD, which enables the hole side surfaces SSH1, SSH2, SSH3, and SSH4 of the through hole TH of the substrate SUB according to the embodiment of FIGS. 36A to 36D to have two sub-side surfaces in a plane defined by the first direction (X-axis direction) and the third direction (Z-axis direction), has already been described above with reference to FIG. 91. As shown in FIGS. 91, 114, and 115, since the laser spots SPT in the first region UA and the laser spots SPT in the second region BA not only have different radii of curvature from each other but also differ in the spacing between the laser spots SPT, the first hole side surface SSH1 may be formed such that the first sub-hole side surface SSH11 has a curved shape or a planar shape different from that of the second sub-hole side surface SSH12. In addition, when the spacing between the laser spots SPT in the first region UA is narrow, the energy density irradiated onto the mother substrate MSUB is high, so that the substrate SUB may be separated from the dummy substrate DSUB at the first sub-hole side surface SSH11 of the first hole side surface SSH1 even without the etchant penetrating to the top surface US of the mother substrate MSUB. Alternatively, the substrate SUB may be separated from the dummy substrate DSUB at the first sub-hole side surface SSH11 of the first hole side surface SSH1 merely by a small amount of the etchant penetrating into the laser spots SPT. Therefore, it is possible to minimize or prevent the etchant from reaching the display layer DISL of the display cell DPC located on the top surface of the substrate SUB.

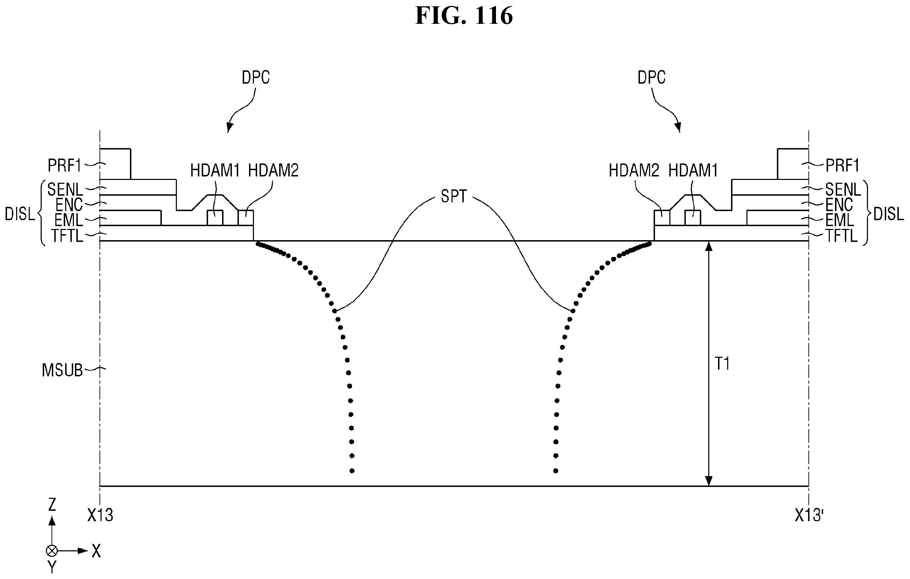

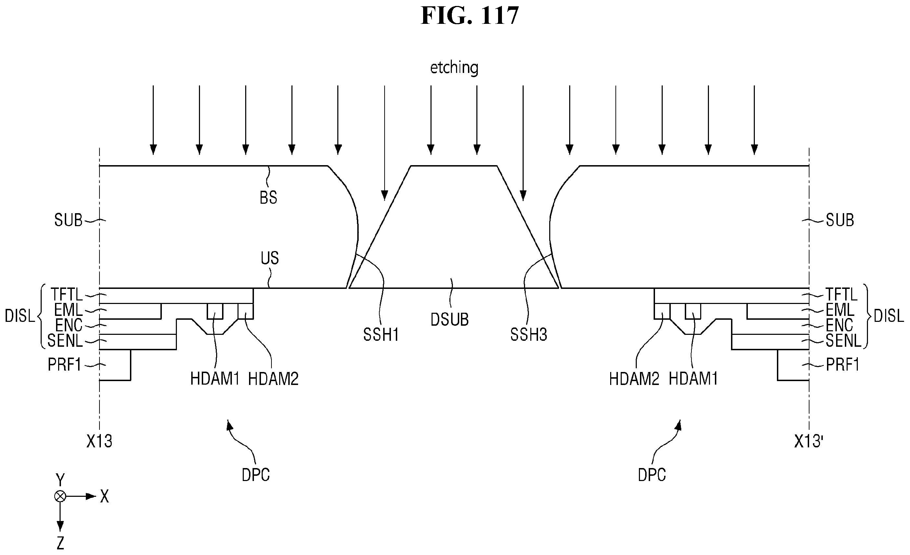

FIGS. 116 and 117 are cross-sectional views taken along line X13-X13', illustrating a method for fabricating a display device according to still another embodiment. FIGS. 116 and 117 show still another example of cross-sections taken along line X13-X13' in steps S220 to S240 of FIG. 95.

The cross-sectional shape of the hole side surfaces SSH1, SSH2, SSH3, and SSH4 of the through hole TH of the substrate SUB depends on the arrangement pattern of the laser spots SPT. Hereinafter, a method for fabricating the hole side surfaces SSH1, SSH2, SSH3, and SSH4 of the through hole TH of the substrate SUB according to the embodiment of FIGS. 35A to 35D will be described with reference to FIGS. 116 and 117.

As shown in FIG. 116, the length over which the plurality of laser spots SPT are arranged in the third direction (Z-axis direction) may be substantially equal to the length of the mother substrate MSUB in the third direction (Z-axis direction). For example, when the length of the mother substrate MSUB in the third direction (Z-axis direction) is approximately 500 µm, the length over which the plurality of laser spots SPT are arranged in the third direction (Z-axis direction) may be approximately 500 µm.

In a plane defined by the first direction (X-axis direction) and the third direction (Z-axis direction), the hole side surfaces SSH1, SSH2, SSH3, and SSH4 of the through hole TH of the substrate SUB according to the embodiment of FIGS. 35A to 35D have a curved shape, so that the plurality of laser spots SPT may also be arranged in a curved shape in a plane defined by the first direction (X-axis direction) and the third direction (Z-axis direction).

As shown in FIG. 117, since the length over which the plurality of laser spots SPT are arranged in the third direction (Z-axis direction) is substantially equal to the length of the mother substrate MSUB in the third direction (Z-axis direction), the etchant may directly penetrate into the plurality of laser spots SPT. Therefore, the area of the gap GP between the bottom surface BS of the substrate SUB and the dummy substrate DSUB, which are separated from the mother substrate MSUB, may increase compared to that in the embodiment of FIG. 104. Therefore, the area of at least a partial region of each of the hole side surfaces SSH1, SSH3 of the through hole TH of the substrate SUB healed by the etchant may also increase compared to that in the embodiment of FIG. 104. In addition, due to the increase in the area of the gap GP, damage to the side surface of the substrate SUB by the dummy substrate DSUB when the dummy substrate DSUB is separated from the substrate SUB may be reduced compared to that in the embodiment of FIG. 104.

The arrangement of the plurality of laser spots SPT formed on the mother substrate MSUB by the laser device LD, which enables the hole side surfaces SSH1, SSH2, SSH3, and SSH4 of the through hole TH of the substrate SUB according to the embodiment of FIGS. 35A to 35D to have a curved shape in a plane defined by the first direction (X-axis direction) and the third direction (Z-axis direction), has already been described above with reference to FIG. 94. As shown in FIGS. 94, 116, and 117, when the spacing between the laser spots SPT in the first region UA is narrow, the energy density irradiated onto the mother substrate MSUB is high, so that the substrate SUB may be separated from the dummy substrate DSUB at the first hole side surface SSH1 even without the etchant penetrating to the top surface US of the mother substrate MSUB. Alternatively, the substrate SUB may be separated from the dummy substrate DSUB at the first hole side surface SSH1 merely by a small amount of the etchant penetrating into the laser spots SPT. Therefore, it is possible to minimize or prevent the etchant from reaching the display layer DISL of the display cell DPC located on the top surface of the substrate SUB.

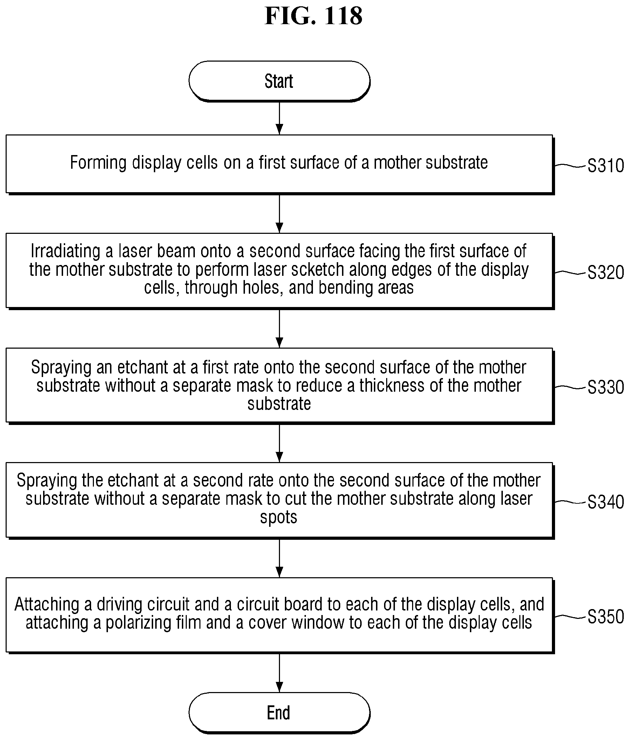

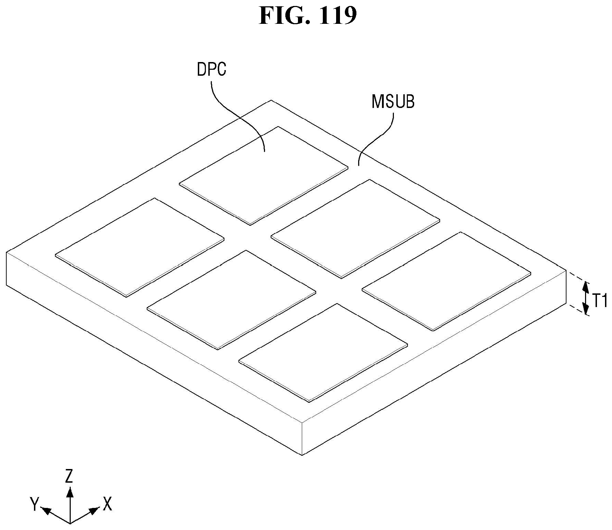

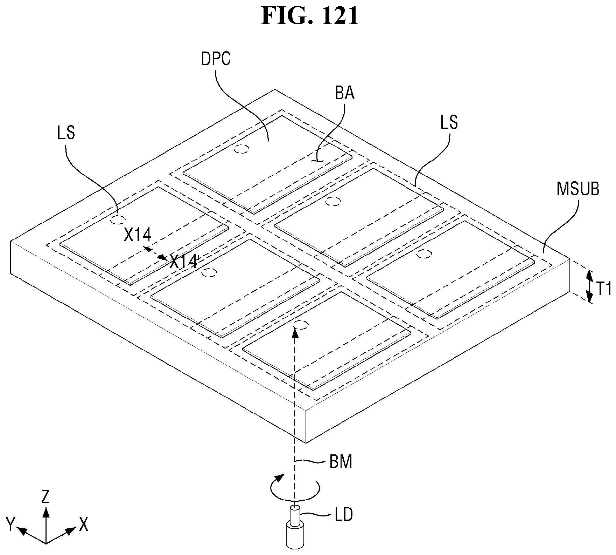

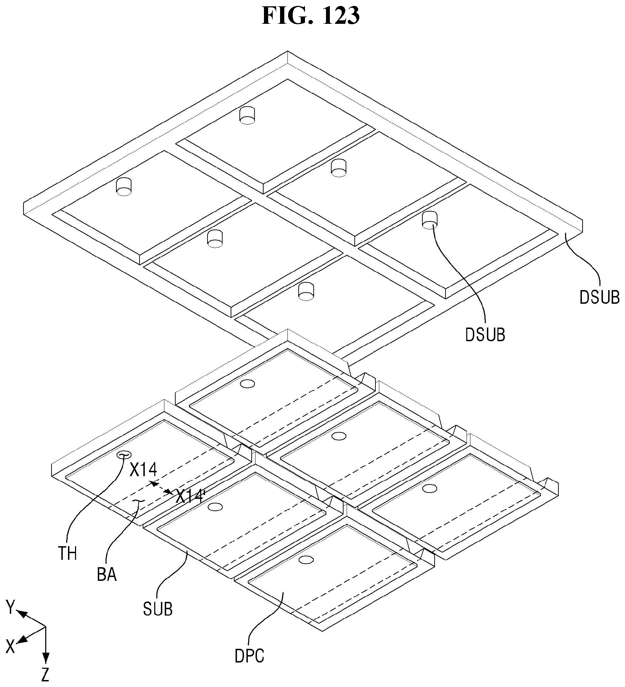

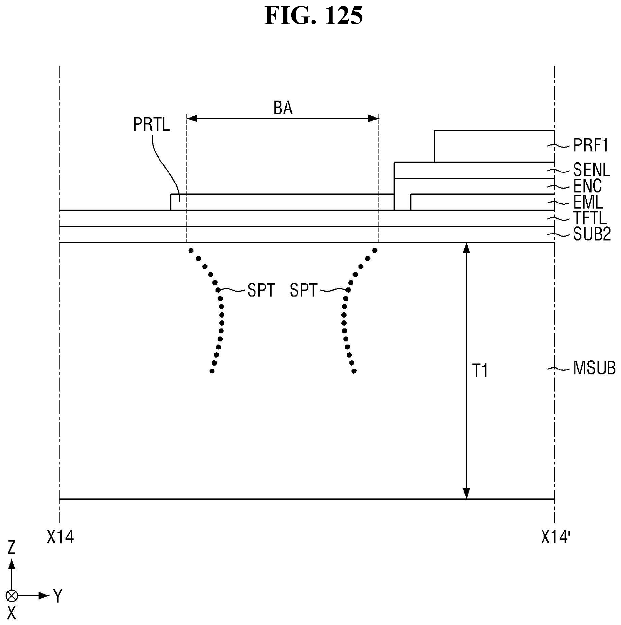

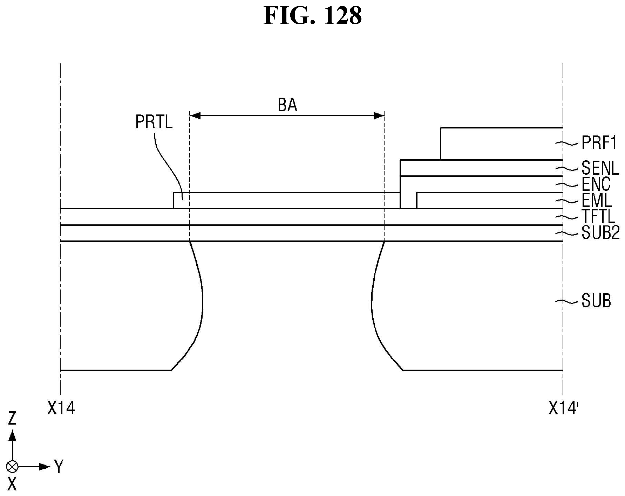

FIG. 118 is a flowchart illustrating a method for fabricating the display device according to one embodiment. FIGS. 119 to 124 are perspective views illustrating a method for fabricating a display device according to one embodiment. FIGS. 125 to 128 are cross-sectional views taken along line X14-X14', illustrating a method for fabricating a display device according to one embodiment.

FIGS. 119 to 124 show perspective views of the mother substrate MSUB and the plurality of display cells DPC located on the mother substrate MSUB. FIGS. 125 to 128 show one example of cross-sections of the mother substrate MSUB and the plurality of display cells DPC taken along line X14-X14' of FIGS. 119 to 123.

Hereinafter, a method for fabricating the first to fourth side surfaces SS1_1, SS2_1, SS3_1, and SS4_1 of the first sub-substrate SSUB1 and the first to fourth side surfaces SS1_2, SS2_2, SS3_2, and SS4_2 of the second sub-substrate SSUB2 described with reference to FIGS. 43A to 43D and FIGS. 44A to 44D will be described in detail with reference to FIGS. 118 to 128.

First, as shown in FIGS. 119 and 125, the plurality of display cells DPC are formed on the first surface of the mother substrate MSUB (step S310 of FIG. 118).

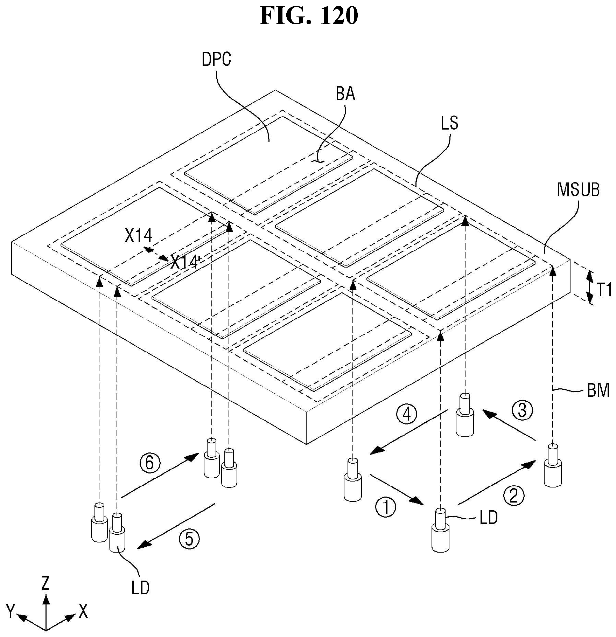

Second, as shown in FIGS. 120, 121, and 125, the laser beam is irradiated onto the second surface facing the first surface of the mother substrate MSUB to perform the laser scketch LS or laser modulation along the edges of the plurality of display cells DPC, the through holes TH, and the bending area BA (step S320 of FIG. 118).

The laser beam BM may be outputted from the laser device LD according to the embodiments described with reference to FIGS. 52 to 57.

The laser scketch LS refers to forming a plurality of spot groups GSPT each including a plurality of laser spots SPT. The laser scketch LS may be defined as forming a plurality of laser spots SPT along the edges of the plurality of display cells DPC, the through holes TH, and the bending area BA by irradiating the laser beam BM.

When the length of the mother substrate MSUB in the third direction (Z-axis direction) is approximately 500 µm, the length over which the plurality of laser spots SPT are arranged in the third direction (Z-axis direction) may be in a range of approximately 200 µm to 300 µm. That is, the length over which the plurality of laser spots SPT are arranged in the third direction (Z-axis direction) may be in a range of approximately 0.4 to 0.6 times the length of the mother substrate MSUB in the third direction (Z-axis direction).

In a plane defined by the first direction (X-axis direction) and the third direction (Z-axis direction), the side surfaces SS1_1, SS2_1, SS3_1, and SS4_1 of the first sub-substrate SSUB1 and the side surfaces SS1_2, SS2_2, SS3_2, and SS4_2 of the second sub-substrate SSUB2 of the substrate SUB according to the embodiment of FIGS. 43A to 43D and FIGS. 44A to 44D have a curved shape, so that the plurality of laser spots SPT may also be arranged in a curved shape in a plane defined by the first direction (X-axis direction) and the third direction (Z-axis direction). The arrangement of the plurality of laser spots SPT formed on the mother substrate MSUB by the laser device LD, which enables the side surfaces SS1_1, SS2_1, SS3_1, SS4_1 of the first sub-substrate SSUB1 and the side surfaces SS1_2, SS2_2, SS3_2, SS4_2 of the second sub-substrate SSUB2 according to the embodiments of FIGS. 43A to 43D and FIGS. 44A to 44D to have a curved shape in a plane defined by the first direction (X-axis direction) and the third direction (Z-axis direction), has already been described above with reference to FIGS. 87A to 87D and FIG. 88.

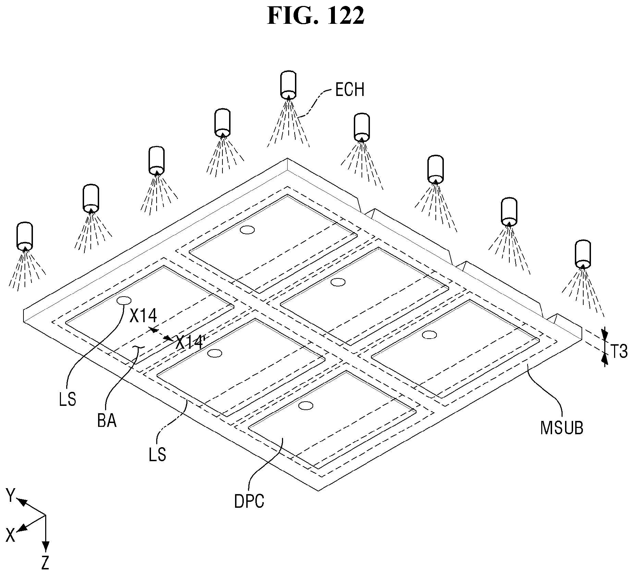

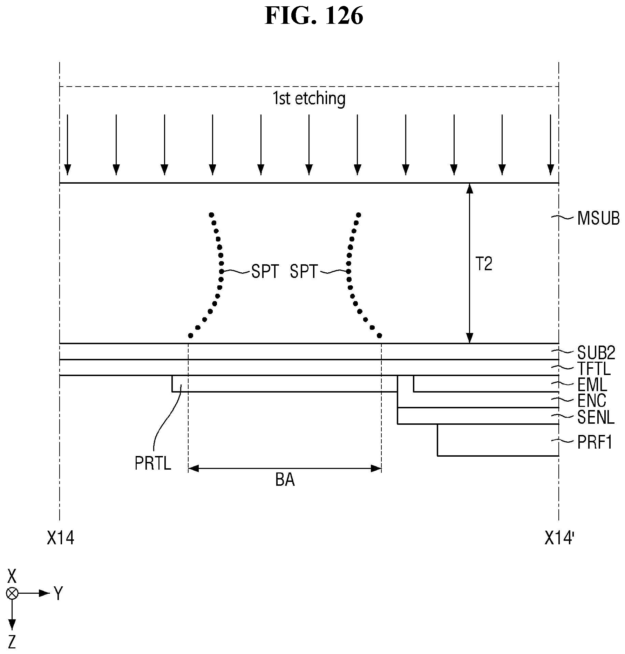

Third, as shown in FIGS. 122 and 126, the etchant is sprayed at the first rate onto the second surface of the mother substrate MSUB without a separate mask to reduce the thickness of the mother substrate MSUB (step S330 of FIG. 118).

Fourth, as shown in FIGS. 122, 123, 127, and 128, the etchant is sprayed at the second rate onto the second surface of the mother substrate MSUB without a separate mask to cut the mother substrate MSUB along the plurality of laser spots SPT (step S340 of FIG. 118).

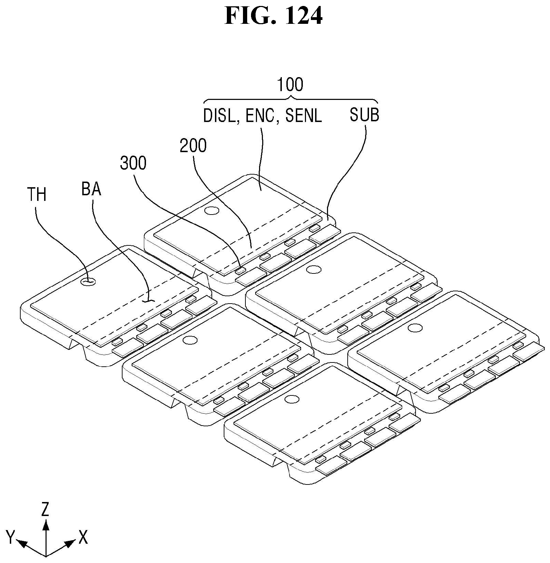

Fifth, as shown in FIG. 124, the driving circuit 200 and the circuit board 300 are attached to each of the plurality of display cells DPC, and the polarizing film PF and the cover window CW are attached to each of the plurality of display cells DPC (step S350 of FIG. 118).

As described above, since the laser and etching process may be used not only to reduce the thickness of the mother substrate MSUB and separate each of the plurality of display cells DPC from the mother substrate MSUB, but also to form the through hole TH and the bending area BA, the efficiency of the fabricating process may be improved.

In addition, the laser device LD may output the laser beam BM such that the plurality of laser spots SPT are arranged along a curve in a plane defined by the first direction (X-axis direction) and the third direction (Z-axis direction). In this case, by spraying the etchant to perform etching, the side surfaces SS1_1, SS2_1, SS3_1, and SS4_1 of the first sub-substrate SSUB1 and the side surfaces SS1_2, SS2_2, SS3_2, and SS4_2 of the second sub-substrate SSUB2 of each of the plurality of display cells DPC may be formed in a curved shape having a curvature. That is, since the side surfaces SS1_1, SS2_1, SS3_1, and SS4_1 of the first sub-substrate SSUB1 and the side surfaces SS1_2, SS2_2, SS3_2, and SS4_2 of the second sub-substrate SSUB2 of each of the plurality of display cells DPC may have a curved shape without a separate polishing process, the efficiency of the fabricating process may be improved.

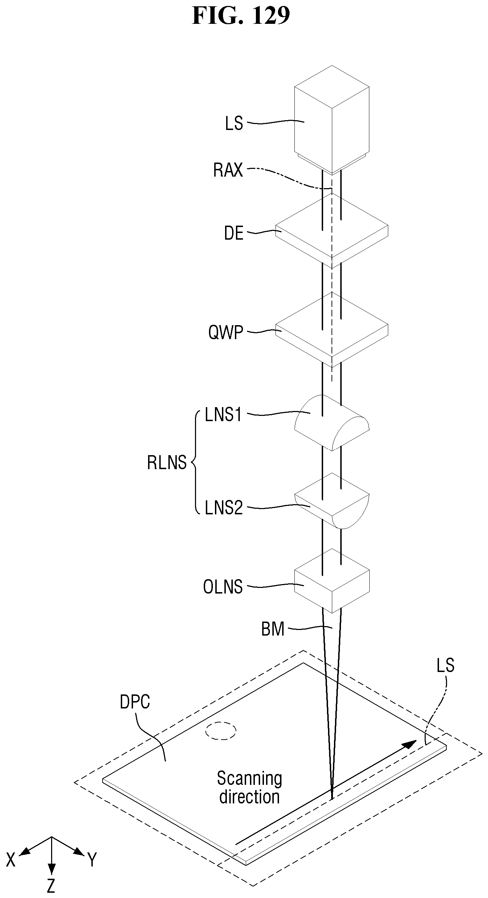

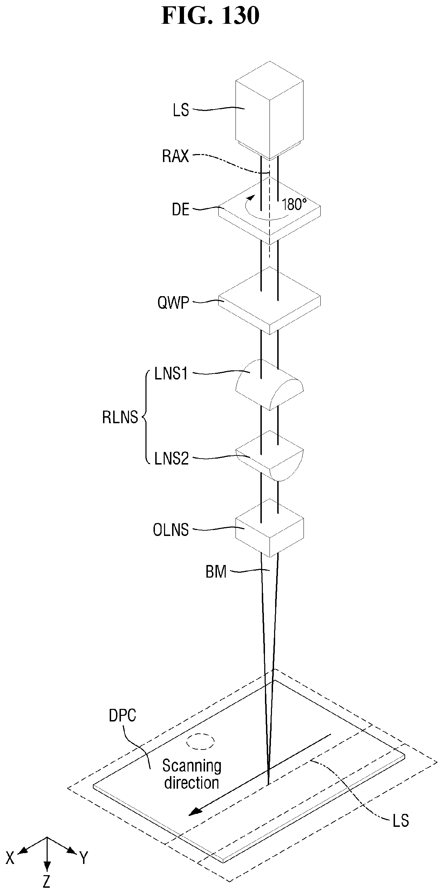

FIGS. 129 and 130 are views illustrating rotation of the laser device according to the embodiment of FIGS. 52 to 54 for laser scketch of a bending area of a display cell. Hereinafter, the laser scketch LS of the bending area BA of the display cell DPC will be described in detail with reference to FIGS. 129 and 130.

First, the laser scketch LS of the edge of the display cell DPC may be performed as described with reference to FIGS. 70 to 77.

Then, as shown in FIG. 129, in a state in which the laser device LD is rotated by 0°, the laser beam BM is irradiated along one side edge of the bending area BA to perform the laser scketch LS. The one side edge of the bending area BA may be one side edge of the second sub-substrate SSUB2 facing the first sub-substrate SSUB1.

The laser device LD outputs the laser beam BM from one end to the other end of the one side edge of the bending area BA. That is, the scanning direction of the laser device LD may be parallel to the first direction (X-axis direction). Since the scan path of the laser device LD is straight, the scan speed of the laser device LD may be in a range of approximately 10 mm/sec to 500 mm/sec.

Then, as shown in FIG. 130, in a state in which the laser device LD is rotated clockwise by 180°, the laser beam BM is irradiated along the other side edge of the bending area BA to perform the laser scketch LS. The other side edge of the bending area BA may be one side edge of the first sub-substrate SSUB1 facing the second sub-substrate SSUB2.

The laser device LD outputs the laser beam BM from one end to the other end of the other side edge of the bending area BA. That is, the scanning direction of the laser device LD may be parallel to the first direction (X-axis direction). Since the scan path of the laser device LD is straight, the scan speed of the laser device LD may be in a range of approximately 10 mm/sec to 500 mm/sec.

As shown in FIGS. 129 and 130, since the elliptically polarized laser beam BM is irradiated along the first side edge SE1, the second side edge SE2, the third side edge SE3, and the fourth side edge ES4 of the display cell DPC, and the one side edge and the other side edge of the bending area BA to perform the laser scketch, it is possible to minimize or prevent differences in processability of the substrate SUB of the display panel 100. As a result, it is possible to minimize or prevent differences in the shape, for example, the radius of curvature, of the side surfaces SS1_1, SS2_1, SS3_1, and SS4_1 of the first sub-substrate SSUB1 and the side surfaces SS1_2, SS2_2, SS3_2, and SS4_2 of the second sub-substrate SSUB2 of the display panel 100, or differences in mechanical strength depending on the positions of the side surfaces SS1_1, SS2_1, SS3_1, and SS4_1 of the first sub-substrate SSUB1 and the side surfaces SS1_2, SS2_2, SS3_2, and SS4_2 of the second sub-substrate SSUB2. Therefore, the side surfaces SS1_1, SS2_1, SS3_1, and SS4_1 of the first sub-substrate SSUB1 and the side surfaces SS1_2, SS2_2, SS3_2, and SS4_2 of the second sub-substrate SSUB2 of the display panel 100 may have uniform quality against external impact.

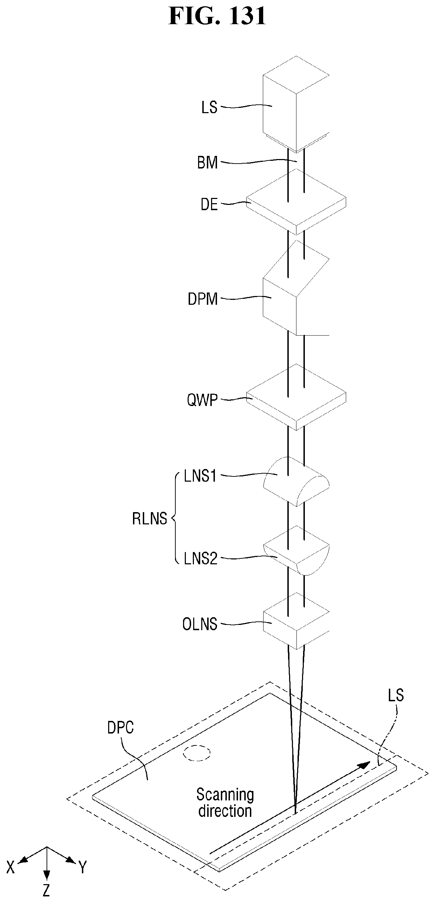

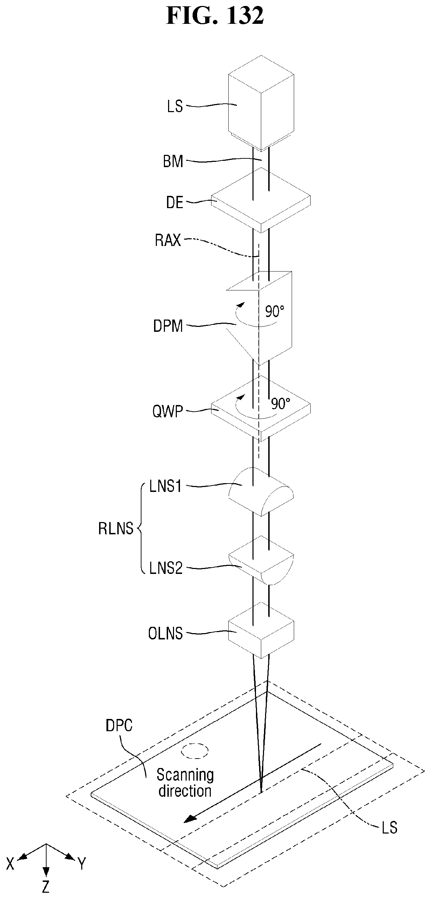

FIGS. 131 and 132 are views illustrating rotation of the laser device according to the embodiment of FIGS. 55 and 56 for laser scketch of the bending area of a display cell. Hereinafter, the laser scketch LS of the bending area BA of the display cell DPC will be described in detail with reference to FIGS. 131 and 132.

First, the laser scketch LS of the edge of the display cell DPC may be performed as described with reference to FIGS. 79 to 86.

Then, as shown in FIG. 131, in a state in which the laser device LD is rotated by 0°, the laser beam BM is irradiated along one side edge of the bending area BA to perform the laser scketch LS. The one side edge of the bending area BA may be one side edge of the second sub-substrate SSUB2 facing the first sub-substrate SSUB1.

The laser device LD outputs the laser beam BM from one end to the other end of the one side edge of the bending area BA. That is, the scanning direction of the laser device LD may be parallel to the first direction (X-axis direction). Since the scan path of the laser device LD is straight, the scan speed of the laser device LD may be in a range of approximately 10 mm/sec to 500 mm/sec.

Then, as shown in FIG. 130, in a state in which the laser device LD is rotated clockwise by 90°, the laser beam BM is irradiated along the other side edge of the bending area BA to perform the laser scketch LS. The other side edge of the bending area BA may be one side edge of the first sub-substrate SSUB1 facing the second sub-substrate SSUB2.

When the prism DPM is a Dove prism having trapezoidal faces as shown in FIGS. 48A and 48B, the rotation angle of the laser beam BM is twice the rotation angle of the prism DPM, so that when the prism DPM is at a rotation angle of 90°, the laser beam BM may be at a rotation angle of 180°.

The laser device LD outputs the laser beam BM from one end to the other end of the other side edge of the bending area BA. That is, the scanning direction of the laser device LD may be parallel to the first direction (X-axis direction). Since the scan path of the laser device LD is straight, the scan speed of the laser device LD may be in a range of approximately 10 mm/sec to 500 mm/sec.

As shown in FIGS. 131 and 132, since the elliptically polarized laser beam BM is irradiated along the first side edge SE1, the second side edge SE2, the third side edge SE3, and the fourth side edge ES4 of the display cell DPC, and a first side edge BSE1 and a second side edge BSE2 of the bending area BA to perform the laser scketch, it is possible to minimize or prevent differences in processability of the substrate SUB of the display panel 100. As a result, it is possible to minimize or prevent differences in the shape, for example, the radius of curvature, of the side surfaces SS1_1, SS2_1, SS3_1, and SS4_1 of the first sub-substrate SSUB1 and the side surfaces SS1_2, SS2_2, SS3_2, and SS4_2 of the second sub-substrate SSUB2 of the display panel 100, or differences in mechanical strength depending on the positions of the side surfaces SS1_1, SS2_1, SS3_1, and SS4_1 of the first sub-substrate SSUB1 and the side surfaces SS1_2, SS2_2, SS3_2, and SS4_2 of the second sub-substrate SSUB2 of the substrate SUB. Therefore, the side surfaces SS1_1, SS2_1, SS3_1, and SS4_1 of the first sub-substrate SSUB1 and the side surfaces SS1_2, SS2_2, SS3_2, and SS4_2 of the second sub-substrate SSUB2 of the display panel 100 may have uniform quality against external impact.

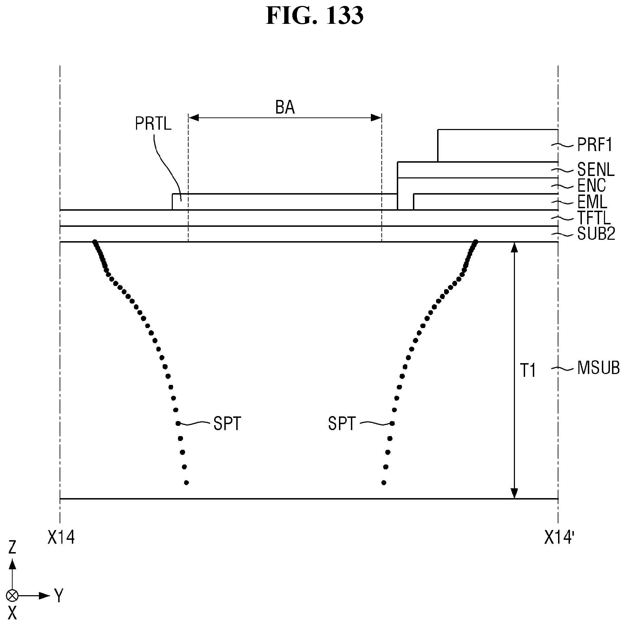

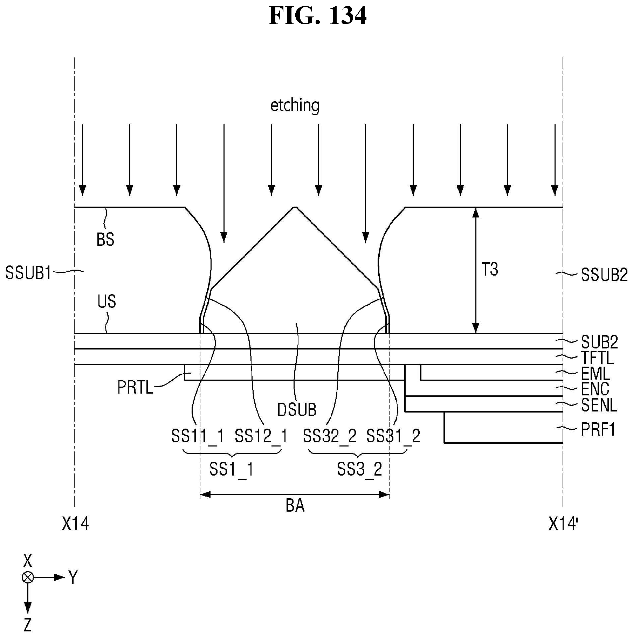

FIGS. 133 and 134 are cross-sectional views taken along line X14-X14', illustrating a method for fabricating a display device according to another embodiment. FIGS. 133 and 134 show another example of cross-sections taken along line X14-X14' in steps S320 to S340 of FIG. 118.

The cross-sectional shape of the first to fourth side surfaces SS1_1, SS2_1, SS3_1, and SS4_1 of the first sub-substrate SSUB1 and the first to fourth side surfaces SS1_2, SS2_2, SS3_2, and SS4_2 of the second sub-substrate SSUB2 depends on the arrangement pattern of the laser spots SPT. Hereinafter, a method for fabricating the first to fourth side surfaces SS1_1, SS2_1, SS3_1, and SS4_1 of the first sub-substrate SSUB1 and the first to fourth side surfaces SS1_2, SS2_2, SS3_2, and SS4_2 of the second sub-substrate SSUB2 according to the embodiment of FIGS. 45A to 45D and FIGS. 46A to 46D will be described with reference to FIGS. 133 and 134.

As shown in FIG. 133, the length over which the plurality of laser spots SPT are arranged in the third direction (Z-axis direction) may be substantially equal to the length of the mother substrate MSUB in the third direction (Z-axis direction). For example, when the length of the mother substrate MSUB in the third direction (Z-axis direction) is approximately 500 µm, the length over which the plurality of laser spots SPT are arranged in the third direction (Z-axis direction) may be approximately 500 µm.

In a plane defined by the first direction (X-axis direction) and the third direction (Z-axis direction), the first to fourth side surfaces SS1_1, SS2_1, SS3_1, and SS4_1 of the first sub-substrate SSUB1 and the first to fourth side surfaces SS1_2, SS2_2, SS3_2, and SS4_2 of the second sub-substrate SSUB2 according to the embodiment of FIGS. 45A to 45D and FIGS. 46A to 46D have two sub-side surfaces, and to this end, the plurality of laser spots SPT may also be divided into two regions having two radii of curvature in a plane defined by the first direction (X-axis direction) and the third direction (Z-axis direction).

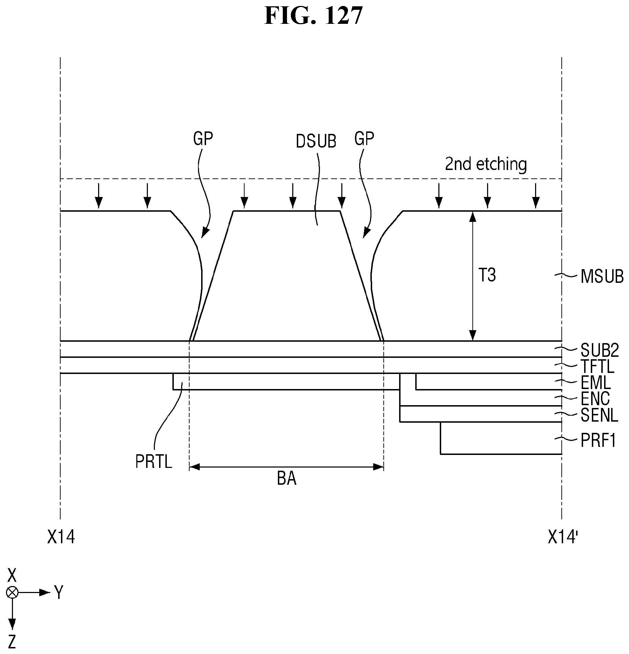

As shown in FIG. 134, since the length over which the plurality of laser spots SPT are arranged in the third direction (Z-axis direction) is substantially equal to the length of the mother substrate MSUB in the third direction (Z-axis direction), the etchant may directly penetrate into the plurality of laser spots SPT. Therefore, the area of the gap GP between the bottom surface BS of the substrate SUB and the dummy substrate DSUB, which are separated from the mother substrate MSUB, may increase compared to that in the embodiment of FIG. 127. Accordingly, the area of at least a partial region of each of the first to fourth side surfaces SS1_1, SS2_1, SS3_1, and SS4_1 of the first sub-substrate SSUB1 and the first to fourth side surfaces SS1_2, SS2_2, SS3_2, and SS4_2 of the second sub-substrate SSUB2 healed by the etchant may also increase compared to that in the embodiment of FIG. 127. In addition, due to the increase in the gap GP, damage to the side surface of the substrate SUB by the dummy substrate DSUB when the dummy substrate DSUB is separated from the substrate SUB may be reduced compared to that in the embodiment of FIG. 127.

The arrangement of the plurality of laser spots SPT formed on the mother substrate MSUB by the laser device LD, which enables the first to fourth side surfaces SS1_1, SS2_1, SS3_1, and SS4_1 of the first sub-substrate SSUB1 and the first to fourth side surfaces SS1_2, SS2_2, SS3_2, and SS4_2 of the second sub-substrate SSUB2 according to the embodiment of FIGS. 45A to 45D and FIGS. 46A to 46D to have two sub-side surfaces in a plane defined by the first direction (X-axis direction) and the third direction (Z-axis direction), has already been described above with reference to FIG. 91. As shown in FIGS. 91, 133, and 134, since the laser spots SPT in the first region UA and the laser spots SPT in the second region BA not only have different radii of curvature from each other but also differ in the spacing between the laser spots SPT, the first side surface SS1_1 of the first sub-substrate SSUB1 may be formed such that the first sub-side surface SS11_1 has a curved shape or a planar shape different from that of the second sub-side surface SS12_1. In addition, when the spacing between the laser spots SPT in the first region UA is narrow, the energy density irradiated onto the mother substrate MSUB is high, so that the first sub-substrate SSUB1 may be separated from the dummy substrate DSUB at the first sub-side surface SS11_1 of the first side surface SS1_1 even without the etchant penetrating to the top surface US of the mother substrate MSUB. Alternatively, the first sub-substrate SSUB1 may be separated from the dummy substrate DSUB at the first sub-side surface SS11_1 of the first side surface SS1_1 merely by a small amount of the etchant penetrating into the laser spots SPT. Therefore, it is possible to minimize or prevent the etchant from reaching the display layer DISL of the display cell DPC located on the top surface of the first sub-substrate SSUB1.

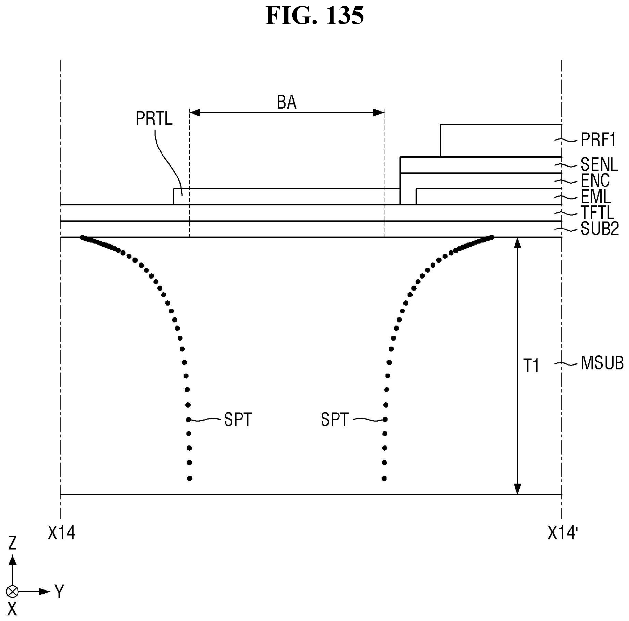

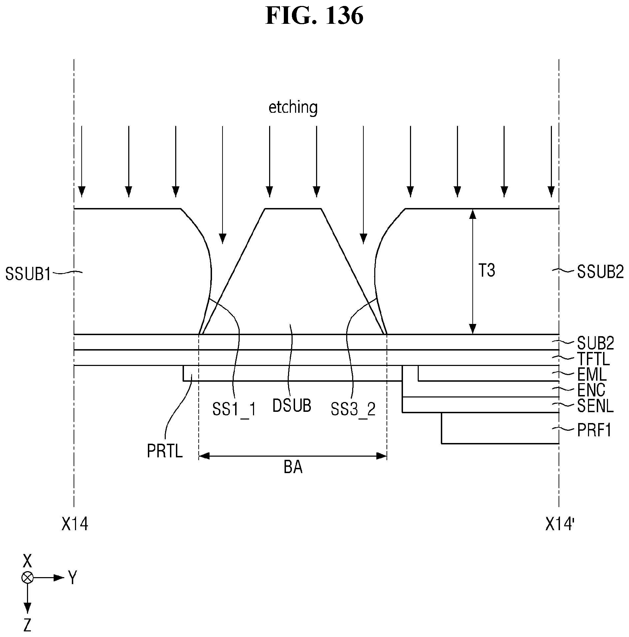

FIGS. 135 and 136 are cross-sectional views taken along line X14-X14', illustrating a method for fabricating a display device according to still another embodiment. FIGS. 135 and 136 show still another example of cross-sections taken along line X14-X14' in steps S320 to S340 of FIG. 118.

The cross-sectional shape of the first to fourth side surfaces SS1_1, SS2_1, SS3_1, and SS4_1 of the first sub-substrate SSUB1 and the first to fourth side surfaces SS1_2, SS2_2, SS3_2, and SS4_2 of the second sub-substrate SSUB2 depends on the arrangement pattern of the laser spots SPT. Hereinafter, a method for fabricating the first to fourth side surfaces SS1_1, SS2_1, SS3_1, and SS4_1 of the first sub-substrate SSUB1 and the first to fourth side surfaces SS1_2, SS2_2, SS3_2, and SS4_2 of the second sub-substrate SSUB2 according to the embodiment of FIGS. 43A to 43D and FIGS. 44A to 44D will be described with reference to FIGS. 135 and 136.

As shown in FIG. 135, the length over which the plurality of laser spots SPT are arranged in the third direction (Z-axis direction) may be substantially equal to the length of the mother substrate MSUB in the third direction (Z-axis direction). For example, when the length of the mother substrate MSUB in the third direction (Z-axis direction) is approximately 500 µm, the length over which the plurality of laser spots SPT are arranged in the third direction (Z-axis direction) may be approximately 500 µm.

In a plane defined by the first direction (X-axis direction) and the third direction (Z-axis direction), the first to fourth side surfaces SS1_1, SS2_1, SS3_1, and SS4_1 of the first sub-substrate SSUB1 and the first to fourth side surfaces SS1_2, SS2_2, SS3_2, and SS4_2 of the second sub-substrate SSUB2 according to the embodiment of FIGS. 43A to 43D and FIGS. 44A to 44D have a curved shape, so that the plurality of laser spots SPT may also be arranged in a curved shape in a plane defined by the first direction (X-axis direction) and the third direction (Z-axis direction).

As shown in FIG. 136, since the length over which the plurality of laser spots SPT are arranged in the third direction (Z-axis direction) is substantially equal to the length of the mother substrate MSUB in the third direction (Z-axis direction), the etchant may directly penetrate into the plurality of laser spots SPT. Therefore, the area of the gap GP between the bottom surface of the substrate SUB and the dummy substrate DSUB, which are separated from the mother substrate MSUB, may increase compared to that in the embodiment of FIG. 127. Therefore, the area of at least a partial region of each of the first to fourth side surfaces SS1_1, SS2_1, SS3_1, and SS4_1 of the first sub-substrate SSUB1 and the first to fourth side surfaces SS1_2, SS2_2, SS3_2, and SS4_2 of the second sub-substrate SSUB2 healed by the etchant may also increase compared to that in the embodiment of FIG. 127. In addition, due to the increase in the the gap GP, damage to the side surface of the substrate SUB by the dummy substrate DSUB when the dummy substrate DSUB is separated from the substrate SUB may be reduced compared to that in the embodiment of FIG. 127.

The arrangement of the plurality of laser spots SPT formed on the mother substrate MSUB by the laser device LD, which enables the first to fourth side surfaces SS1_1, SS2_1, SS3_1, and SS4_1 of the first sub-substrate SSUB1 and the first to fourth side surfaces SS1_2, SS2_2, SS3_2, and SS4_2 of the second sub-substrate SSUB2 according to the embodiment of FIGS. 43A to 43D and FIGS. 44A to 44D to have a curved shape in a plane defined by the first direction (X-axis direction) and the third direction (Z-axis direction), has already been described with reference to FIG. 94. As shown in FIGS. 94, 135, and 136, when the spacing between the laser spots SPT in the first region UA is narrow, the energy density irradiated onto the mother substrate MSUB is high, so that the first sub-substrate SSUB1 may be separated from the dummy substrate DSUB at the first side surface SS1_1 even without the etchant penetrating to the top surface US of the mother substrate MSUB. Alternatively, the first sub-substrate SSUB1of the substrate SUB may be separated from the dummy substrate DSUB at the first side surface SS1_1 merely by a small amount of the etchant penetrating into the laser spots SPT. Therefore, it is possible to minimize or prevent the etchant from reaching the display layer DISL of the display cell DPC located on the top surface of the substrate SUB.

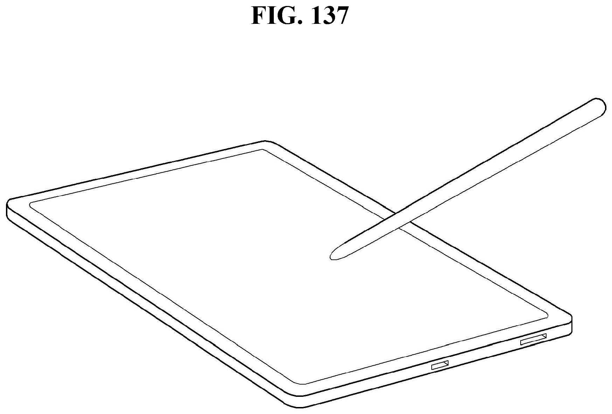

FIG. 137 is a view illustrating an electronic device including a display device according to one embodiment. FIG. 137 shows a tablet to which the display device 10 according to one embodiment is applied, as one example of an electronic device.

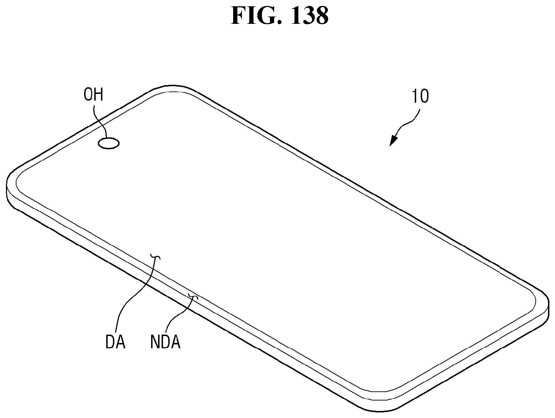

FIG. 138 is a view illustrating an electronic device including a display device according to one embodiment. FIG. 138 shows a smartphone to which the display device 10 according to one embodiment is applied, as one example of an electronic device.

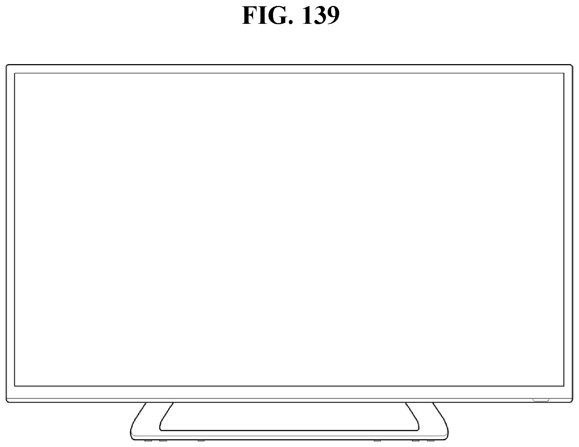

FIG. 139 is a view illustrating an electronic device including a display device according to one embodiment. FIG. 139 illustrates a TV to which a display device according to one embodiment is applied, as one example of an electronic device.

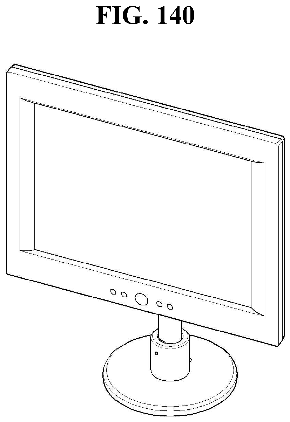

FIG. 140 is a view illustrating an electronic device including a display device according to one embodiment. FIG. 140 illustrates a monitor to which a display device according to one embodiment is applied, as one example of an electronic device.

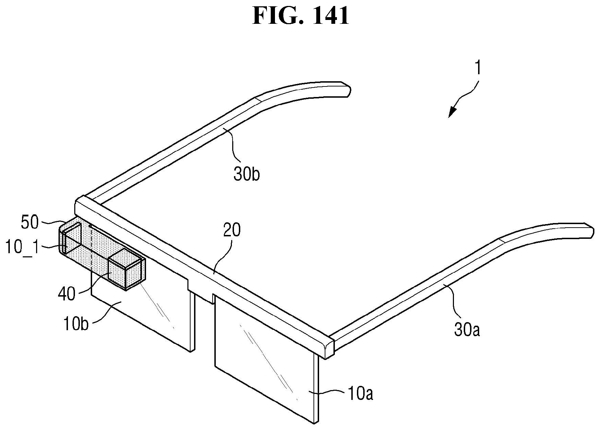

FIG. 141 is a view illustrating an electronic device including a display device according to one embodiment.

Referring to FIG. 141, a display device 10_1 according to one embodiment may be applied to a smart watch 1 that is one of the smart devices. The planar shape of a clock display unit of the smart watch 1 may follow the planar shape of the display device 10_1. For example, when the display device 10_1 according to one embodiment has a rectangular planar shape, the clock display unit of the smart watch 1 may have a rectangular planar shape. Alternatively, when the display device 10_1 according to one embodiment has a circular or elliptical planar shape, the watch display unit of the smart watch 1 may have a circular or elliptical planar shape. However, the embodiments of the present disclosure are not limited thereto, and the clock display unit of the smart watch 1 may not follow the planar shape of the display device 10_1.

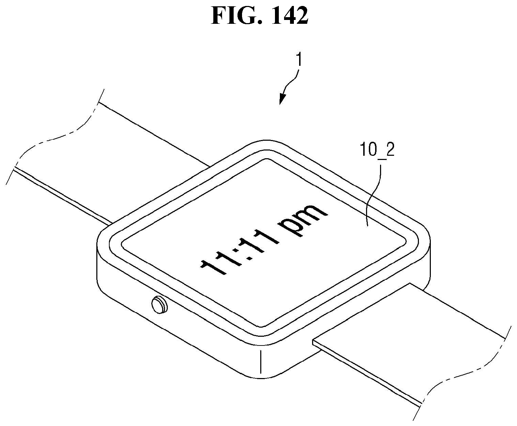

FIG. 142 is a view illustrating a virtual reality device including a display device according to one embodiment. FIG. 142 illustrates an example of a virtual reality device 1 to which a display device 10_2 according to one embodiment is applied.

Referring to FIG. 142, the virtual reality device 1 according to one embodiment may be a glass-type device. The virtual reality device 1 according to one embodiment may include the display device 10_2, a left eye lens 10a, a right eye lens 10b, a support frame 20, temples 30a and 30b, a reflective member 40, and a display device housing 50.

Although FIG. 142 illustrates the virtual reality device 1 including the temples 30a and 30b, the virtual reality device 1 according to one embodiment may be applied to a head mounted display including a head mounted band that may be worn on a head, instead of the temples 30a and 30b.

The display device housing 50 may include the display device 10_2 and the reflective member 40. An image displayed on the display device 10_2 may be reflected by the reflective member 40 and provided to the user's right eye through the right eye lens 10b. As a result, the user may view a virtual reality image displayed on the display device 10_2 with the right eye.

FIG. 142 illustrates that the display device housing 50 is located at the end of the right side of the support frame 20, but the embodiment of the present specification is not limited thereto. For example, the display device housing 50 may be located at the left end of the support frame 20. In this case, an image displayed on the display device 10_2 may be reflected by the reflective member 40, and provided to the user's left eye through the left eye lens 10a. As a result, the user may view the virtual reality image displayed on the display device 10_2 through the left eye. Alternatively, the display device housings 50 may be located at both the left and right ends of the support frame 20. In this case, the user views a virtual reality image displayed on the display device 10_2 with both the left and right eyes.

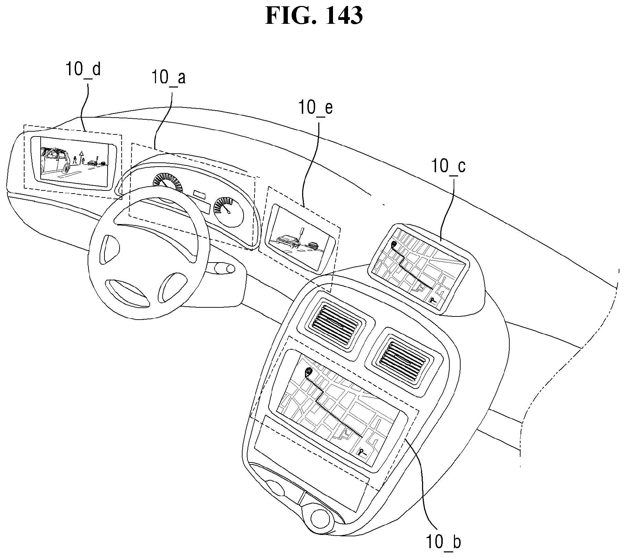

FIG. 143 is a view illustrating a vehicle instrument panel and a center fascia including a display device according to one embodiment. FIG. 143 illustrates a vehicle to which display devices 10_a, 10_b, 10_c, 10_d, and 10_e according to one embodiment are applied.

Referring to FIG. 143, the display devices 10_a, 10_b, and 10_c according to one embodiment may be applied to an instrument panel of a vehicle, a center fascia of the vehicle, or a center information display (CID) placed on a dashboard of the vehicle. In addition, the display devices 10_d and 10_e according to one embodiment may be applied to a room mirror display that replaces side mirrors of a vehicle.

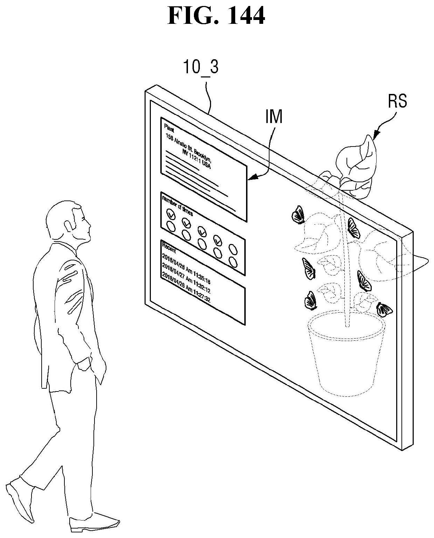

FIG. 144 is a view illustrating a transparent display device including a display device according to one embodiment.

Referring to FIG. 144, a display device 10_3 according to one embodiment may be applied to the transparent display device. The transparent display device may display an image IM, and also may transmit light. Thus, a user located on the front side of the transparent display device can view an object RS or a background on the rear side of the transparent display device as well as the image IM displayed on the display device 10_3. When the display device 10_3 is applied to the transparent display device, the substrate SUB of the display device 10_3 may include a light transmitting portion capable of transmitting light or may include a material capable of transmitting light.

In concluding the detailed description, those skilled in the art will appreciate that many variations and modifications can be made to the preferred embodiments without substantially departing from the principles of the present disclosure. Therefore, the disclosed preferred embodiments of the invention are used in a generic and descriptive sense only and not for purposes of limitation.

## Claims

1. A display device comprising:
a glass substrate comprising a first surface, a second surface facing the first surface, and a plurality of side surfaces located between the first surface and the second surface; and
a light emitting element layer located on the first surface of the glass substrate and comprising light emitting elements that emit light,
wherein the plurality of side surfaces of the glass substrate comprise a first side surface and a second side surface,
a radius of curvature measured at a center of the first side surface, an upper end of the first side surface, and an upper center between the center and the upper end of the first side surface is defined as a first upper radius of curvature,
a radius of curvature measured at a center of the second side surface, an upper end of the second side surface, and an upper center between the center and the upper end of the second side surface is defined as a second upper radius of curvature, and
a difference between the first upper radius of curvature and the second upper radius of curvature is 30 µm or less.

2. The display device of claim 1, wherein a radius of curvature measured at the center of the first side surface, a lower end of the first side surface, and a lower center between the center and the lower end of the first side surface is defined as a first lower radius of curvature, and
the first lower radius of curvature is different from the first upper radius of curvature.

3. The display device of claim 2, wherein the first lower radius of curvature is less than the first upper radius of curvature.

4. The display device of claim 1, wherein the plurality of side surfaces of the glass substrate further comprise a third side surface,
a radius of curvature measured at a center of the third side surface, an upper end of the third side surface, and an upper center between the center and the upper end of the third side surface is defined as a third upper radius of curvature, and
a difference between the first upper radius of curvature and the third upper radius of curvature, and a difference between the second upper radius of curvature and the third upper radius of curvature are each 30 µm or less.

5. The display device of claim 4, wherein a radius of curvature measured at the center of the second side surface, a lower end of the second side surface, and a lower center between the center and the lower end of the second side surface is defined as a second lower radius of curvature, and
the second lower radius of curvature is different from the second upper radius of curvature.

6. The display device of claim 5, wherein the second lower radius of curvature is less than the second upper radius of curvature.

7. The display device of claim 4, wherein the plurality of side surfaces of the glass substrate further comprise a fourth side surface,
a radius of curvature measured at a center of the fourth side surface, an upper end of the fourth side surface, and an upper center between the center and the upper end of the fourth side surface is defined as a fourth upper radius of curvature, and
a difference between the first upper radius of curvature and the fourth upper radius of curvature, a difference between the second upper radius of curvature and the fourth upper radius of curvature, and a difference between the third upper radius of curvature and the fourth upper radius of curvature are each 30 µm or less.

8. The display device of claim 7, wherein a radius of curvature measured at the center of the third side surface, a lower end of the third side surface, and a lower center between the center and the lower end of the third side surface is defined as a third lower radius of curvature, and
the third lower radius of curvature is different from the third upper radius of curvature.

9. The display device of claim 8, wherein the third lower radius of curvature is less than the third upper radius of curvature.

10. The display device of claim 1, wherein the glass substrate further comprises a through hole penetrating the first surface and the second surface,
a radius of curvature measured at a center of a first hole side surface of the through hole, an upper end of the first hole side surface, and an upper center between the center and the upper end of the first hole side surface is defined as a first hole upper radius of curvature, and
a difference between the first upper radius of curvature and the first hole upper radius of curvature, and a difference between the second upper radius of curvature and the first hole upper radius of curvature are each 30 µm or less.

11. The display device of claim 10, wherein a radius of curvature measured at the center of the first hole side surface, a lower end of the first hole side surface, and a lower center between the center and the lower end of the first hole side surface is defined as a first hole lower radius of curvature, and
the first hole lower radius of curvature is different from the first hole upper radius of curvature.

12. The display device of claim 11, wherein the first hole lower radius of curvature is less than the first hole upper radius of curvature.

13. The display device of claim 10, wherein a radius of curvature measured at a center of a second hole side surface of the through hole, an upper end of the second hole side surface, and an upper center between the center and the upper end of the second hole side surface is defined as a second hole upper radius of curvature, and
a difference between the first hole upper radius of curvature and the second hole upper radius of curvature is 30 µm or less.

14. The display device of claim 13, wherein a difference between the first upper radius of curvature and the second hole upper radius of curvature, and a difference between the second upper radius of curvature and the second hole upper radius of curvature are each 30 µm or less.

15. The display device of claim 13, wherein a radius of curvature measured at the center of the second hole side surface, a lower end of the second hole side surface, and a lower center between the center and the lower end of the second hole side surface is defined as a second hole lower radius of curvature, and
the second hole lower radius of curvature is different from the second hole upper radius of curvature.

16. The display device of claim 15, wherein the second hole lower radius of curvature is less than the second hole upper radius of curvature.

17. A display device comprising:
a glass substrate comprising a first surface, a second surface facing the first surface, and a plurality of side surfaces located between the first surface and the second surface; and
a light emitting element layer located on the first surface of the glass substrate and comprising light emitting elements that emit light,
wherein each of the plurality of side surfaces of the glass substrate comprises a first sub-side surface having a planar shape and a second sub-side surface having a curved shape,
a length of the second sub-side surface is greater than a length of the first sub-side surface,
the first sub-side surface is in contact with the first surface, and the second sub-side surface is in contact with the second surface.

18. The display device of claim 17, wherein a radius of curvature measured at a center of the second sub-side surface, an upper end of the second sub-side surface, and an upper center of the second sub-side surface is defined as an upper radius of curvature,
a radius of curvature measured at the center of the second sub-side surface, a lower end of the second sub-side surface, and a lower center of the second sub-side surface is defined as a lower radius of curvature, and
the lower radius of curvature is different from the upper radius of curvature.

19. The display device of claim 18, wherein the lower radius of curvature is less than the upper radius of curvature.

20. The display device of claim 18, wherein the glass substrate further comprises a through hole penetrating the first surface and the second surface,
a radius of curvature measured at a center of a hole side surface of the through hole, an upper end of the hole side surface, and an upper center between the center and the upper end of the hole side surface is defined as a hole upper radius of curvature,
a radius of curvature measured at the center of the hole side surface, a lower end of the hole side surface, and a lower center of the hole side surface is defined as a hole lower radius of curvature, and
the hole lower radius of curvature is different from the hole upper radius of curvature.

21. The display device of claim 20, wherein the hole lower radius of curvature is less than the hole upper radius of curvature.

22. The display device of claim 20, wherein a difference between the upper radius of curvature and the hole upper radius of curvature is 30 µm or less.

23. A display device comprising:
a first substrate comprising a first surface and a second surface facing the first surface;
a second substrate located on the first surface of the first substrate; and
a light emitting element layer located on one surface of the second substrate and comprising light emitting elements that emit light,
wherein the first substrate comprises glass and the second substrate comprises a polymer resin,
the first substrate comprises a first sub-substrate and a second sub-substrate spaced apart from each other,
a radius of curvature measured at a center of a first side surface of the first sub-substrate, an upper end of the first side surface, and an upper center between the center and the upper end of the first side surface is defined as a first upper radius of curvature,
a radius of curvature measured at a center of a second side surface of the first sub-substrate, an upper end of the second side surface, and an upper center between the center and the upper end of the second side surface is defined as a second upper radius of curvature, and
a difference between the first upper radius of curvature and the second upper radius of curvature is 30 µm or less.

24. The display device of claim 23, wherein an area of the first sub-substrate is greater than an area of the second sub-substrate.

25. The display device of claim 23, wherein a radius of curvature measured at the center of the first side surface, a lower end of the first side surface, and a lower center between the center and the lower end of the first side surface is defined as a first lower radius of curvature, and
the first lower radius of curvature is different from the first upper radius of curvature.

26. The display device of claim 25, wherein the first lower radius of curvature is less than the first upper radius of curvature.

27. The display device of claim 23, wherein the second sub-substrate comprises a third side surface and a fourth side surface,
a radius of curvature measured at a center of the third side surface, an upper end of the third side surface, and an upper center between the center and the upper end of the third side surface is defined as a third upper radius of curvature, and
a difference between the first upper radius of curvature and the third upper radius of curvature, and a difference between the second upper radius of curvature and the third upper radius of curvature are each 30 µm or less.

28. The display device of claim 27, wherein a radius of curvature measured at a center of the fourth side surface, an upper end of the fourth side surface, and an upper center between the center and the upper end of the fourth side surface is defined as a fourth upper radius of curvature, and
a difference between the third upper radius of curvature and the fourth upper radius of curvature is 30 µm or less.

29. The display device of claim 28, wherein a difference between the first upper radius of curvature and the fourth upper radius of curvature, and a difference between the second upper radius of curvature and the fourth upper radius of curvature are each 30 µm or less.

30. The display device of claim 27, wherein the first substrate further comprises a through hole penetrating the first surface and the second surface,
a radius of curvature measured at a center of a hole side surface of the through hole, an upper end of the hole side surface, and an upper center between the center and the upper end of the hole side surface is defined as a hole upper radius of curvature, and
a difference between the first upper radius of curvature and the hole upper radius of curvature, a difference between the second upper radius of curvature and the hole upper radius of curvature, and a difference between the third upper radius of curvature and the hole upper radius of curvature are each 30 µm or less.

31. The display device of claim 30, wherein a radius of curvature measured at the center of the hole side surface, a lower end of the hole side surface, and a lower center between the center and the lower end of the hole side surface is defined as a hole lower radius of curvature, and
the hole lower radius of curvature is different from the hole upper radius of curvature.

32. The display device of claim 31, wherein the hole lower radius of curvature is less than the hole upper radius of curvature.

33. A display device comprising:
a first substrate comprising a first surface and a second surface facing the first surface;
a second substrate located on the first surface of the first substrate; and
a light emitting element layer located on one surface of the second substrate and comprising light emitting elements that emit light,
wherein the first substrate comprises glass and the second substrate comprises a polymer resin,
the first substrate comprises a first sub-substrate and a second sub-substrate spaced apart from each other,
each of a plurality of side surfaces of the first sub-substrate comprises a first sub-side surface having a planar shape and a second sub-side surface having a curved shape,
a length of the second sub-side surface is greater than a length of the first sub-side surface, and
the first sub-side surface is in contact with the first surface, and the second sub-side surface is in contact with the second surface.

34. The display device of claim 33, wherein a radius of curvature measured at a center of the second sub-side surface, an upper end of the second sub-side surface, and an upper center of the second sub-side surface is defined as a first upper radius of curvature,
a radius of curvature measured at the center of the second sub-side surface, a lower end of the second sub-side surface, and a lower center of the second sub-side surface is defined as a first lower radius of curvature, and
the first lower radius of curvature is different from the first upper radius of curvature.

35. The display device of claim 34, wherein the first lower radius of curvature is less than the first upper radius of curvature.

36. The display device of claim 34, wherein each of a plurality of side surfaces of the second sub-substrate comprises a third sub-side surface having a planar shape and a fourth sub-side surface having a curved shape,
a length of the fourth sub-side surface is greater than a length of the third sub-side surface, and
the third sub-side surface is in contact with the first surface, and the fourth sub-side surface is in contact with the second surface.

37. The display device of claim 36, wherein a radius of curvature measured at a center of the fourth sub-side surface, an upper end of the fourth sub-side surface, and an upper center of the fourth sub-side surface is defined as a second upper radius of curvature,
a radius of curvature measured at the center of the fourth sub-side surface, a lower end of the fourth sub-side surface, and a lower center of the fourth sub-side surface is defined as a second lower radius of curvature, and
the second lower radius of curvature is different from the second upper radius of curvature.

38. The display device of claim 37, wherein the second lower radius of curvature is less than the second upper radius of curvature.

39. The display device of claim 37, wherein a difference between the first upper radius of curvature and the second upper radius of curvature is 30 µm or less.

40. The display device of claim 37, wherein the first substrate further comprises a through hole penetrating the first surface and the second surface,
a radius of curvature measured at a center of a hole side surface of the through hole, an upper end of the hole side surface, and an upper center between the center and the upper end of the hole side surface is defined as a hole upper radius of curvature,
a radius of curvature measured at the center of the hole side surface, a lower end of the hole side surface, and a lower center of the hole side surface is defined as a hole lower radius of curvature, and
the hole lower radius of curvature is different from the hole upper radius of curvature.

41. The display device of claim 40, wherein the hole lower radius of curvature is less than the hole upper radius of curvature.

42. The display device of claim 40, wherein a difference between the first upper radius of curvature and the hole upper radius of curvature, and a difference between the second upper radius of curvature and the hole upper radius of curvature are each 30 µm or less.

43. A laser device comprising:
a light source configured to output a laser beam;
a diffractive element comprising diffraction patterns configured to diffract the laser beam;
a relay lens configured to transmit the laser beam diffracted by the diffraction patterns at a selected ratio;
a phase retardation plate configured to retard a phase of the laser beam incident from the diffractive element; and
an objective lens configured to focus the laser beam incident from the phase retardation plate,
wherein the diffractive element is rotated by a selected angle.

44. The laser device of claim 43, wherein the light source outputs a laser beam having linear polarization or circular polarization, and
the laser beam outputted from the objective lens has elliptical polarization.

45. The laser device of claim 43, wherein the phase retardation plate is a quarter-wave plate.

46. The laser device of claim 43, further comprising a relay lens configured to transmit the laser beam diffracted by the diffraction patterns at a selected ratio.

47. The laser device of claim 46, wherein the relay lens is located between the phase retardation plate and the objective lens.

48. The laser device of claim 46, wherein the relay lens is located between the light source and the diffractive element.

49. A laser device comprising:
a light source configured to output a laser beam;
a diffractive element comprising diffraction patterns configured to diffract the laser beam;
a prism configured to rotate so as to rotate a laser beam incident from the diffractive element;
a phase retardation plate configured to retard a phase of the laser beam incident from the prism; and
an objective lens configured to focus the laser beam incident from the phase retardation plate,
wherein the prism and the phase retardation plate are rotated simultaneously by a selected angle.

50. The laser device of claim 49, wherein the prism is a Dove prism having a trapezoidal cross-section.

51. The laser device of claim 49, wherein the light source outputs a laser beam having circular polarization, and
the laser beam passing through the objective lens has elliptical polarization.

52. The laser device of claim 49, wherein the phase retardation plate is a quarter-wave plate.

53. The laser device of claim 49, further comprising a relay lens configured to transmit the laser beam diffracted by the diffraction patterns at a selected ratio.

54. The laser device of claim 53, wherein the relay lens is located between the phase retardation plate and the objective lens.

55. The laser device of claim 53, wherein the relay lens is located between the diffractive element and the prism.

56. A method for fabricating a display device, comprising:
forming a plurality of display cells on a first surface of a mother substrate;
forming a plurality of laser spots arranged along edges of the plurality of display cells by irradiating a laser beam on a second surface of the mother substrate facing the first surface using a laser device;
reducing a thickness of the mother substrate by spraying an etchant onto the second surface of the mother substrate at a first rate without a mask; and
reducing the thickness of the mother substrate by spraying the etchant onto the second surface of the mother substrate at a second rate without the mask,
wherein the first rate is higher than the second rate.

57. The method of claim 56, wherein the first rate is in a range of 7 µm/min to 10 µm/min, and the second rate is in a range of 1 µm/min to 5 µm/min.

58. The method of claim 56, wherein a pulse duration of the laser beam is in a range of 3 ps to 10 ps.

59. The method of claim 56, wherein a burst pulse of the laser beam is in a range of 1 to 10 pulses.

60. The method of claim 56, wherein a pulse energy of the laser beam is in a range of 2 µJ/spot to 4 µJ/spot.

61. The method of claim 56, wherein a repetition rate of the laser beam is in a range of approximately 10 kHz to 500 kHz.

62. The method of claim 56, wherein a length over which the plurality of laser spots are arranged in a thickness direction of the mother substrate is in a range of 0.4 to 0.6 times the thickness of the mother substrate.

63. The method of claim 56, wherein the plurality of laser spots comprise a first group of laser spots and a second group of laser spots spaced apart from each other in a scanning direction of the laser device, and
a distance between the first group of laser spots and the second group of laser spots in the scanning direction of the laser device is in a range of 2 µm to 7 µm.

64. The method of claim 56, wherein in a two-dimensional plane defined by a thickness direction of the mother substrate and one side direction of the mother substrate, an arrangement of laser spots in a first region and an arrangement of laser spots in a second region among the plurality of laser spots are asymmetric.

65. The method of claim 64, wherein a radius of curvature of a curve formed by the laser spots arranged in the first region is different from a radius of curvature of a curve formed by the laser spots arranged in the second region.

66. The method of claim 64, wherein a radius of curvature of a curve formed by the laser spots arranged in the first region and a radius of curvature of a curve formed by the laser spots arranged in the second region are in a range of 100 µm to 300 µm.

67. The method of claim 56, wherein a length over which the plurality of laser spots are arranged in a thickness direction of the mother substrate is equal to the thickness of the mother substrate.

68. The method of claim 56, wherein in a two-dimensional plane defined by a thickness direction of the mother substrate and one side direction of the mother substrate, the plurality of laser spots comprise laser spots arranged in a first region and laser spots arranged in a second region.

69. The method of claim 68, wherein a radius of curvature of a curve formed by the laser spots arranged in the first region is less than a radius of curvature of a curve formed by the laser spots arranged in the second region.

70. The method of claim 68, wherein a spacing between the laser spots in the second region is greater than a spacing between the laser spots in the first region.

71. The method of claim 68, wherein a spacing between the laser spots in the second region increases from a bottom to a top.

72. The method of claim 68, wherein a spacing between the laser spots is in a range of 3 µm to 20 µm.

73. The method of claim 68, wherein a length of the second region in the thickness direction of the mother substrate is greater than a length of the first region.

74. The method of claim 68, wherein a length of the second region in one side direction of the mother substrate is in a range of 80 µm to 150 µm, a length of the second region in the thickness direction of the mother substrate is in a range of 430 µm to 470 µm, a length of the first region is in a range of 30 µm to 70 µm, and a radius of curvature of the first region is in a range of 200 µm to 600 µm.

75. The method of claim 56, wherein the forming of the plurality of laser spots arranged along the edges of the plurality of display cells by irradiating the laser beam on the second surface of the mother substrate facing the first surface using the laser device comprises:
scanning a laser beam in a first direction along a first side edge of any one of the plurality of display cells;
continuously rotating the laser device from 0° to a first angle and scanning the laser beam along a first corner edge located between the first side edge and a second side edge of the display cell; and
scanning a laser beam along the second side edge of the display cell in a second direction intersecting the first direction in a state in which the laser device is rotated by the first angle.

76. The method of claim 75, wherein an elliptically polarized laser beam is provided to the first side edge, the first corner edge, and the second side edge of the display cell.

77. The method of claim 56, wherein the forming of the plurality of laser spots arranged along the edges of the plurality of display cells by irradiating the laser beam on the second surface of the mother substrate facing the first surface comprises:
forming a plurality of laser spots arranged along edges of a through hole penetrating the first surface and the second surface of the mother substrate together with the plurality of display cells by irradiating the laser beam of the laser device on the second surface of the mother substrate.

78. The method of claim 77, further comprising:
irradiating the laser beam along the edges of the plurality of display cells by rotating the laser device in one direction selected from a clockwise direction and a counterclockwise direction; and
irradiating the laser beam along the edges of the through hole by rotating the laser device in another direction not selected as the one direction from the clockwise direction and the counterclockwise direction.

79. The method of claim 77, wherein the forming of the plurality of laser spots arranged along the edges of the through hole penetrating the first surface and the second surface of the mother substrate together with the plurality of display cells by irradiating the laser beam of the laser device on the second surface of the mother substrate comprises:
continuously rotating the laser device from 0° to 360° and scanning the laser beam along the edges of the through hole.

80. The method of claim 78, wherein an elliptically polarized laser beam is provided to the edges of the through hole.

81. An electronic device comprising a display device configured to display an image,
wherein the display device comprises:
a glass substrate comprising a first surface, a second surface facing the first surface, and a plurality of side surfaces located between the first surface and the second surface; and
a light emitting element layer located on the first surface of the glass substrate and comprising light emitting elements that emit light,
wherein the plurality of side surfaces of the glass substrate comprise a first side surface and a second side surface,
a radius of curvature measured at a center of the first side surface, an upper end of the first side surface, and an upper center between the center and the upper end of the first side surface is defined as a first upper radius of curvature,
a radius of curvature measured at a center of the second side surface, an upper end of the second side surface, and an upper center between the center and the upper end of the second side surface is defined as a second upper radius of curvature, and
a difference between the first upper radius of curvature and the second upper radius of curvature is 30 µm or less.
